# EUROPEAN PATENT SPECIFICATION

(11) **EP 3 415 520 B1**
(45) Date of publication and mention of the grant of the patent: **24.07.2024**
(21) Application number: 18177713.7
(22) Date of filing: 14.06.2018
(51) Int. Cl.: C07F 15/00, H10K 85/30, H10K 101/10

(54) **ORGANOMETALLIC COMPOUND, ORGANIC LIGHT-EMITTING DEVICE INCLUDING THE ORGANOMETALLIC COMPOUND, AND DIAGNOSTIC COMPOSITION INCLUDING THE ORGANOMETALLIC COMPOUND**
ORGANOMETALLISCHE VERBINDUNG, ORGANISCHE LICHTEMITTIERENDE VORRICHTUNG MIT DER ORGANOMETALLISCHEN VERBINDUNG UND DIAGNOSTISCHE ZUSAMMENSETZUNG MIT DER ORGANOMETALLISCHEN VERBINDUNG
COMPOSÉ ORGANOMÉTALLIQUE, DISPOSITIF ÉLECTROLUMINESCENT ORGANIQUE LE COMPRENANT ET COMPOSITION DE DIAGNOSTIC COMPRENANT LE COMPOSÉ ORGANOMÉTALLIQUE

(30) Priority: 16.06.2017 KR 20170076822
(43) Date of publication of application: 19.12.2018
(73) Proprietor: Samsung Electronics Co., Ltd., Gyeonggi-do 16677 (KR)
(72) Inventor: HWANG, Kyuyoung, 16678 Gyeonggi-do, (KR); KIM, Sangdong, 16678 Gyeonggi-do, (KR); KIM, Sungjun, 16678 Gyeonggi-do, (KR); KIM, Soyeon, 16678 Gyeonggi-do, (KR); LEE, Jungin, 16678 Gyeonggi-do, (KR); LEE, Jiyoun, 16678 Gyeonggi-do, (KR); KWAK, Yoonhyun, 16678 Gyeonggi-do, (KR); KWON, Ohyun, 16678 Gyeonggi-do, (KR)
(74) Representative: Elkington and Fife LLP

(56) References cited:
- EP-A2- 1 683 804
- EP-A2- 2 711 999
- GANG CHENG ET AL: "Structurally robust phosphorescent [Pt(O^N^C^N)] emitters for high performance organic light-emitting devices with power efficiency up to 126 lm W -1 and external quantum efficiency over 20%", CHEMICAL SCIENCE, vol. 5, no. 12, 1 January 2014 (2014-01-01), United Kingdom, pages 4819 - 4830, XP055512462, ISSN: 2041-6520, DOI: 10.1039/C4SC01105H
- SHIU-LUN LAI ET AL: "High Efficiency White Organic Light-Emitting Devices Incorporating Yellow Phosphorescent Platinum(II) Complex and Composite Blue Host", ADVANCED FUNCTIONAL MATERIALS, WILEY - V C H VERLAG GMBH & CO. KGAA, DE, vol. 23, no. 41, 6 November 2013 (2013-11-06), pages 5168 - 5176, XP001586999, ISSN: 1616-301X, [retrieved on 20130502], DOI: 10.1002/ADFM.201300281

## Description

### FIELD OF THE INVENTION

One or more embodiments relate to an organometallic compound, an organic light-emitting device including the organometallic compound, and a diagnostic composition including the organometallic compound.

### BACKGROUND OF THE INVENTION

Organic light-emitting devices (OLEDs) are self-emission devices, which have superior characteristics in terms of a viewing angle, a response time, a brightness, a driving voltage, and a response speed, and which produce full-color images.

In an example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Meanwhile, luminescent compounds may be used to monitor, sense, or detect a variety of biological materials including cells and proteins. An example of the luminescent compounds includes a phosphorescent luminescent compound.

Various types of organic light emitting devices are known. However, there still remains a need in OLEDs having low driving voltage, high efficiency, high brightness, and long lifespan.

In G. Cheng et al., Chem. Sci., 2014,5, 4819-4830, a series of platinum(II) complexes supported by tetradentate O^N^C^N ligands with tert-butyl groups, a bridging tertiary amine or a biphenyl group with a spiro linkage at the periphery of the [O^N^C^N] ligand scaffold was prepared.

EP 1 683 804 discloses a platinum complex which is useful as a material for a light-emitting device.

In, S-L. Lai et al., a new class of charge neutral, luminescent cyclometalated platinum(II) complexes supported by dianionic tetradentate ligand were synthesized.

EP 2 711 999 discloses metal complexes and devices, such as organic light emitting devices, that comprise such metal complexes.

### SUMMARY OF THE INVENTION

Aspects of the present disclosure provide an organometallic compound, an organic light-emitting device including the organometallic compound, and a diagnostic composition including the organometallic compound.

Additional aspects will be set forth in part in the description which follows and, in part, will be apparent from the description, or may be learned by practice of the presented embodiments.

The present invention is directed towards an organometallic compound in accordance with claim 1.

An embodiment of the present invention provides an organic light-emitting device including:
a first electrode;
a second electrode; and
an organic layer disposed between the first electrode and the second electrode,
wherein the organic layer includes an emission layer, and
wherein the organic layer includes at least one organometallic compound.

The organometallic compounds may act as a dopant in the organic layer.

Another embodiment of the present invention provides a diagnostic composition including at least one organometallic compound represented by Formula 1.

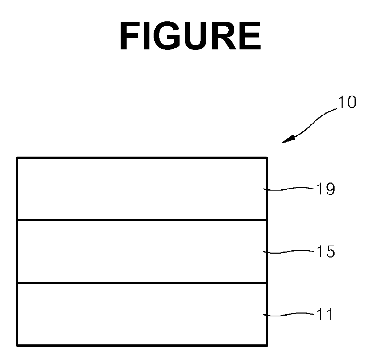

### BRIEF DESCRIPTION OF THE DRAWING

These and/or other aspects will become apparent and more readily appreciated from the following description of the embodiments, taken in conjunction with the FIGURE which is a schematic view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

An organometallic compound according to an embodiment is represented by Formula 1 below:

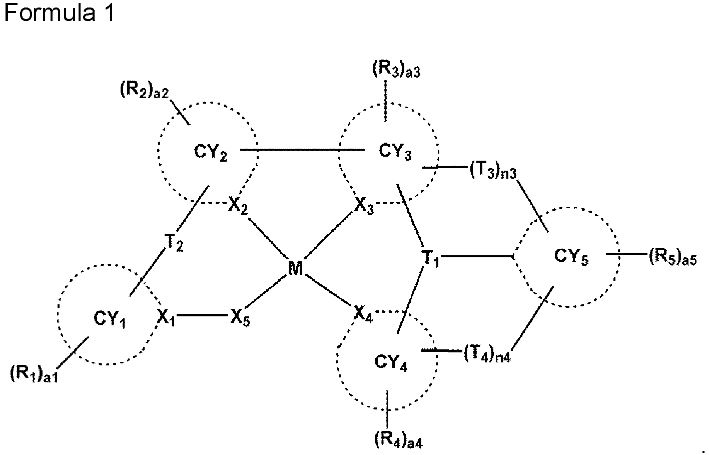

M in Formula 1 is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

In an embodiment, M may be palladium or platinum, but embodiments of the present disclosure are not limited thereto.

In Formula 1, X₁ to X₄ are each independently N or C, and X₅ is a single bond, O, S, B(R'), N(R'), P(R'), C(R')(R"), Si(R')(R"), Ge(R')(R"), C(=O), B(R')(R"), N(R')(R"), or P(R')(R"). R' and R" are the same as described herein.

In an embodiment, in Formula 1, i) X₁, X₂, and X₄ may each be N, and X₃ may be C, or ii) X₂ and X₄ may each be N, and X₁ and X₃ may each be C, but embodiments of the present disclosure are not limited thereto.

In one or more embodiments, X₅ may be a single bond (for example, a covalent bond or a coordinate bond), O, or S, but embodiments of the present disclosure are not limited thereto.

In Formula 1, two bonds selected from a bond between X₁ or X₅ and M, a bond between X₂ and M, a bond between X₃ and M, and a bond between X₄ and M are each a covalent bond, and the other bonds selected from a bond between X₁ or X₅ and M, a bond between X₂ and M, a bond between X₃ and M, and a bond between X₄ and M are each a coordinate bond. Thus, the organometallic compound represented by Formula 1 may be electrically neutral.

In an embodiment, in Formula 1, i) a bond between X₁ or X₅ and M and a bond between X₃ and M may each be a covalent bond, and a bond between X₂ and M and a bond between X₄ and M may each be a coordinate bond, or ii) a bond between X₁ or X₅ and M and a bond between X₂ and M may each be a covalent bond, and a bond between X₃ and M and a bond between X₄ and M may each be a coordinate bond.

CY₁ to CY₅ in Formula 1 are each independently a C₅-C₃₀ carbocyclic group or a C₁-C₃₀ heterocyclic group.

For example, rings CY₁ to CY₅ may each independently be selected from a benzene group, a naphthalene group, an anthracene group, a phenanthrene group, a triphenylene group, a pyrene group, a chrysene group, a cyclopentadiene group, a 1 ,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an indazole group, a benzofluorene group, a benzocarbazole group, a naphthobenzofuran group, a naphthobenzothiophene group, and a naphtobenzosilole group.

In an embodiment, at least one of rings CY₁ and CY₂ may each independently be a condensed ring including at least one 5-membered ring condensed with at least one 6-membered ring, rings CY₃ to CY₅ may each independently be a 6-membered ring or a condensed ring including two or more 6-membered rings condensed with each other, the 5-membered ring may be selected from a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group, and the 6-membered ring may be selected from a cyclohexane group, a cyclohexene group, a benzene group, a pyridine group, a pyrimidine group, a pyrazine group, a pyridazine group, and a triazine group, but embodiments of the present disclosure are not limited thereto.

In Formula 1, T₁ is B, N, or P, T₂ to T₄ are each independently selected from a single bond, a double bond, *-N(R₇)-*', *-B(R₇)-*', *-P(R₇)-*', *-C(R₇)(R₈)-*', *-Si(R₇)(R₈)-*', *-Ge(R₇)(R₈)-*', *-S-*', *-Se-*', *-O-*', *-C(=O)-*', *-S(=O)-*', *-S(=O)₂-*', *-C(R₇)=*', *=C(R₇)-*', *-C(R₇)=C(R₈)-*', *-C(=S)-*', and *-C=C-*', and * and *' each indicate a binding site to a neighboring atom. R₇ and R₈ are the same as described herein, and R₇ and R₈ are optionally linked via a single bond, a double bond, or a first linking group to form a substituted or unsubstituted C₅-C₃₀ carbocyclic group or a substituted or unsubstituted C₁-C₃₀ heterocyclic group.

The first linking group may be selected from *-N(R₉)-*', *-B(R₉)-*', *-P(R₉)-*', *-C(R₉)(R₁₀)-*', *-Si(R₉)(R₁₀)-*', *-Ge(R₉)(R₁₀)-*', *-S-*', *-Se-*', *-O-*', *-C(=O)-*', *-S(=O)-*', *-S(=O)₂-*', *-C(R₉)=*', *=C(R₉)-*', *-C(R₉)=C(R₁₀)-*', *-C(=S)-*', and *-C≡C-*', R₉ and R₁₀ are the same as described in connection with R₇, and * and *' each indicate a binding site to a neighboring atom.

In an embodiment, T₂ may be a single bond, but embodiments of the present disclosure are not limited thereto.

n3 and n4 in Formula 1 are each independently 0 or 1, wherein, when n3 is 0, T₃ does not exist and thus CY₃ and CY₅ are not linked to each other, and when n4 is 0, T₄ does not exist and thus CY₄ and CY₅ are not linked to each other. The sum of n3 and n4 is 1 or 2, provided that a) when n3 is 0 and n4 is 1, X₄ is N, b) when n3 is 1 and n4 is 0, X₃ is N, and c) n3 and n4 are 1, at least one of X₃ and X₄ is N.

In an embodiment, in Formula 1,
a) when n3 is 0 and n4 is 1, X₄ may be N, and a bond between X₄ and M may be a coordinate bond,
b) when n3 is 1 and n4 is 0, X₃ may be N, and a bond between X₃ and M may be a coordinate bond, and
c) when n3 and n4 are each 1, i) a bond between X₄ and M may be a coordinate bond, ii) X₃ may be N, and a bond between X₃ and M may be a coordinate bond, or iii) X₃ and X₄ may be N, and at least one of a bond between X₃ and M and a bond between X₄ and M may be a coordinate bond.

R₁ to R₅, R', R", R₇, and R₈ in Formula 1 are each independently selected from hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and - P(=O)(Q₈)(Q₉).

For example, R₁ to R₅, R', R", R₇, and R₈ may each independently be selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, a phenoxy group, and a naphtoxy group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, a phenoxy group, and a naphtoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and -Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

In an embodiment, R₁ to R₅, R', R", R₇, and R₈ may each independently be selected from hydrogen, deuterium, -F, a cyano group, a nitro group, -SF₅, -CH₃, -CD₃, -CD₂H, -CDH₂, -CF₃, -CF₂H, -CFH₂, a C₁-C₁₀ alkoxy group, groups represented by Formulae 9-1 to 9-19, groups represented by Formulae 10-1 to 10-157, -N(Q₁)(Q₂), - Si(Q₃)(Q₄)(Q₅), -B(Q₆)(Q₇), and -P(=O)(Q₈)(Q₉) (wherein Q₁ to Q₉ are the same as described herein), but embodiments of the present disclosure are not limited thereto:

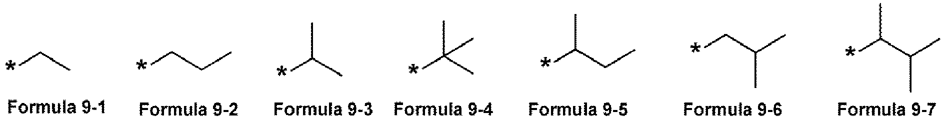

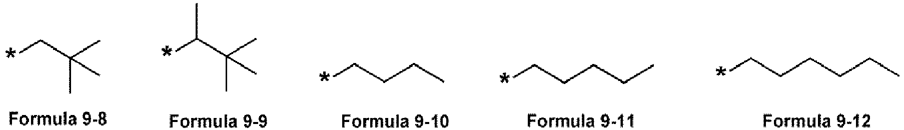

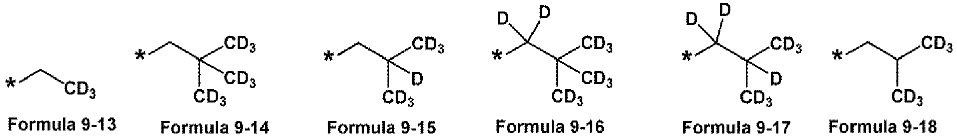

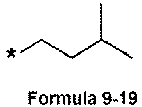

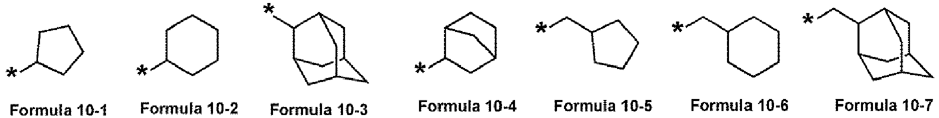

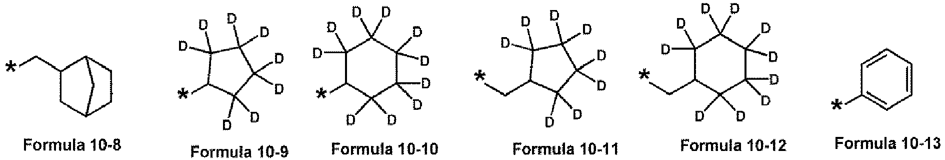

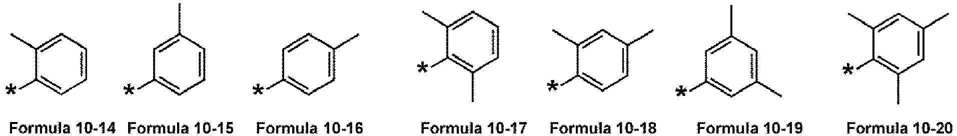

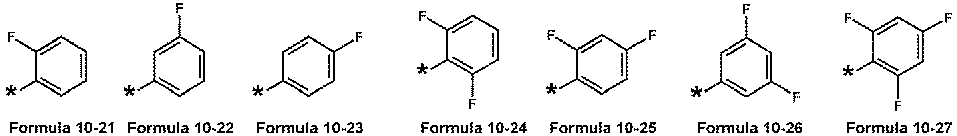

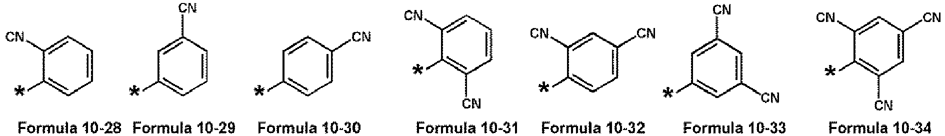

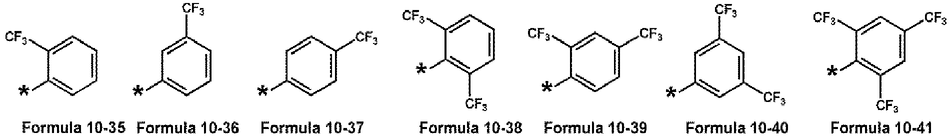

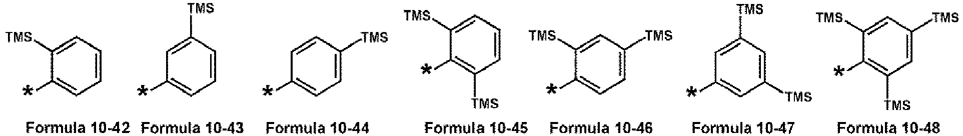

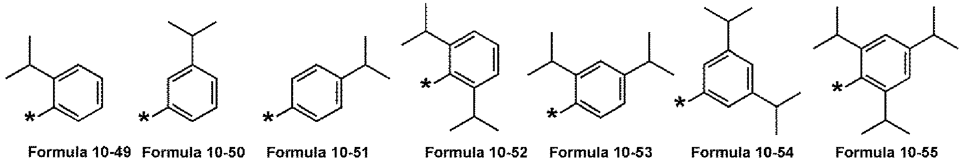

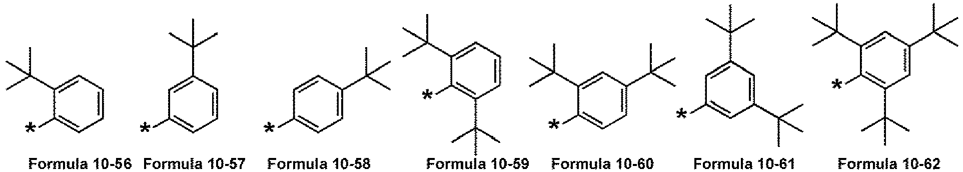

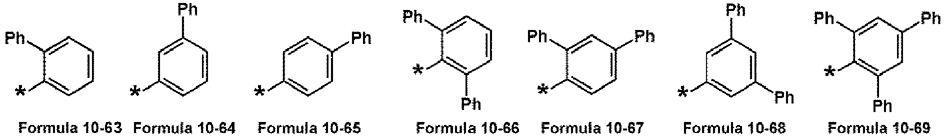

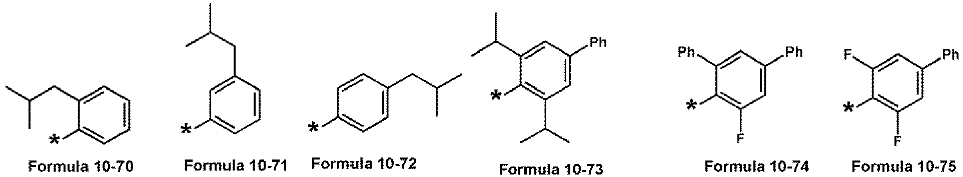

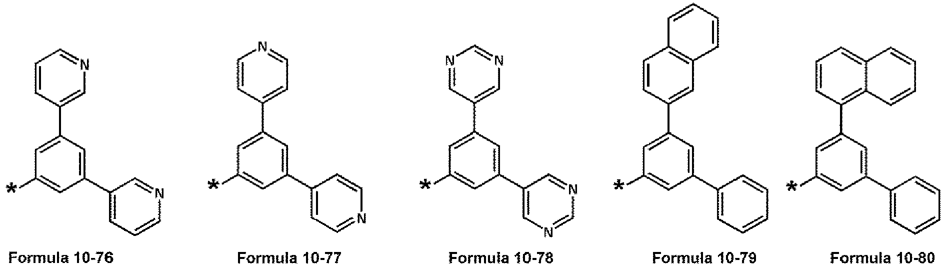

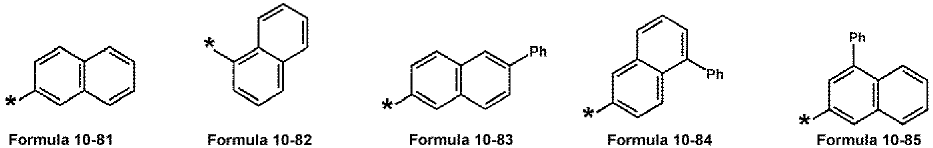

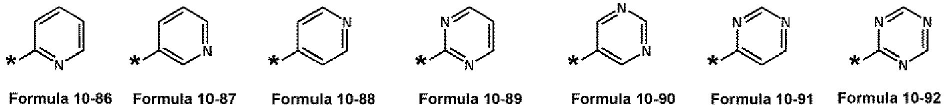

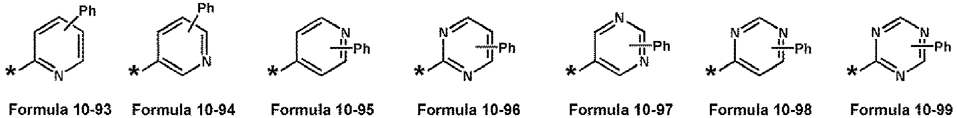

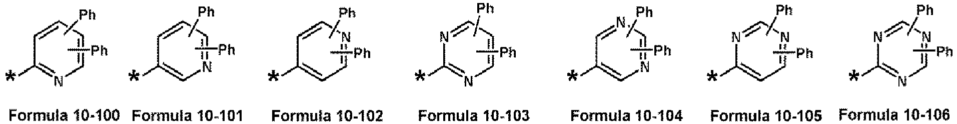

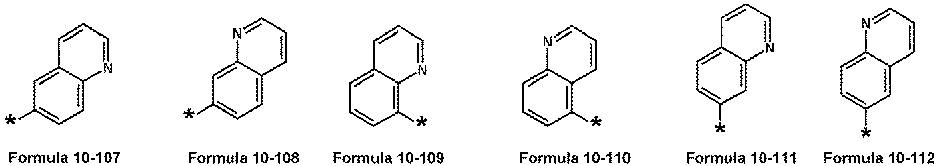

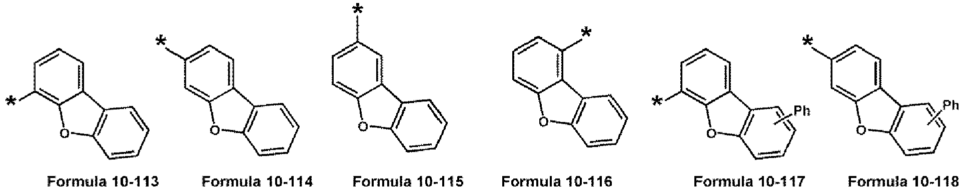

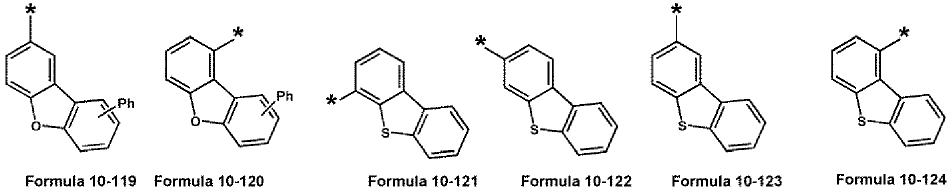

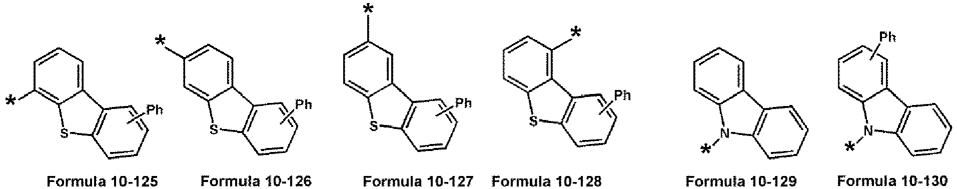

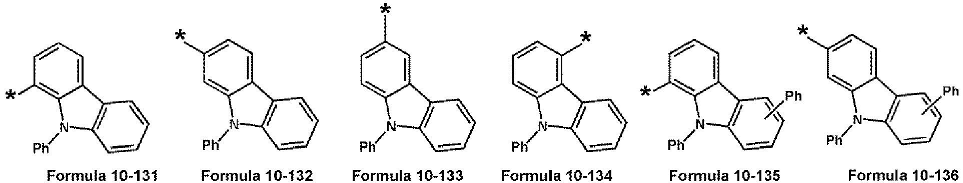

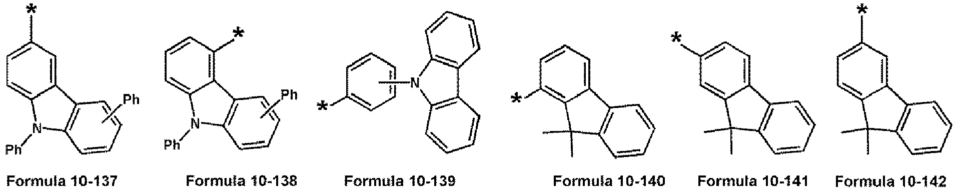

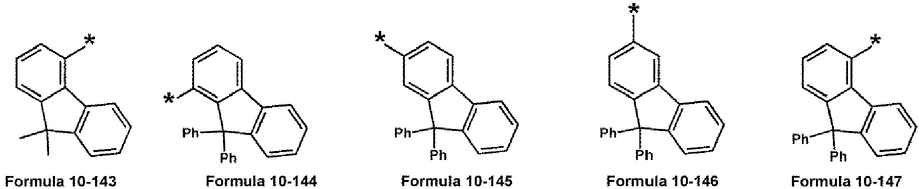

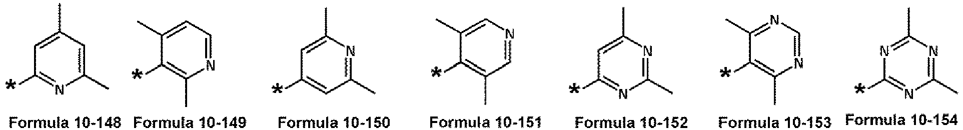

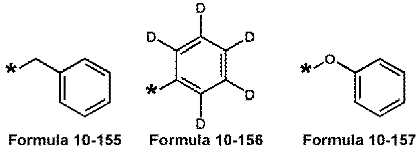

In Formulae 9-1 to 9-19 and 10-1 to 10-157, "Ph" indicates a phenyl group, "TMS" indicates a trimethylsilyl group, and "*" indicates a binding site to a neighboring atom.

a1, a2, a3, a4, and a5 in Formula 1 respectively indicate the number of groups R₁, the number of groups R₂, the number of groups R₃, the number of groups R₄, and the number of groups R₅, and are each independently an integer from 0 to 20 (for example, an integer from 0 to 4). When a1 is two or more, two or more groups R₁ may be identical to or different from each other, when a2 is two or more, two or more groups R₂ may be identical to or different from each other, when a3 is two or more, two or more groups R₃ may be identical to or different from each other, when a4 is two or more, two or more groups R₄ may be identical to or different from each other, and when a5 is two or more, two or more groups R₅ may be identical to or different from each other.

In Formula 1, i) two of a plurality of neighboring groups R₁ may optionally be linked to form a substituted or unsubstituted C₅-C₃₀ carbocyclic group or a substituted or unsubstituted C₁-C₃₀ heterocyclic group, ii) two of a plurality of neighboring groups R₂ may optionally be linked to form a substituted or unsubstituted C₅-C₃₀ carbocyclic group or a substituted or unsubstituted C₁-C₃₀ heterocyclic group, iii) two of a plurality of neighboring groups R₃ may optionally be linked to form a substituted or unsubstituted C₅-C₃₀ carbocyclic group or a substituted or unsubstituted C₁-C₃₀ heterocyclic group, iv) two of a plurality of neighboring groups R₄ may optionally be linked to form a substituted or unsubstituted C₅-C₃₀ carbocyclic group or a substituted or unsubstituted C₁-C₃₀ heterocyclic group, v) two of a plurality of neighboring groups R₅ may optionally be linked to form a substituted or unsubstituted C₅-C₃₀ carbocyclic group or a substituted or unsubstituted C₁-C₃₀ heterocyclic group, and vi) two or more neighboring groups selected from R₁ to R₃ may optionally be linked to form a substituted or unsubstituted C₅-C₃₀ carbocyclic group or a substituted or unsubstituted C₁-C₃₀ heterocyclic group.

For example, i) a substituted or unsubstituted C₅-C₃₀ carbocyclic group or a substituted or unsubstituted C₁-C₃₀ heterocyclic group, formed by linking two of a plurality of neighboring groups R₁, ii) a substituted or unsubstituted C₅-C₃₀ carbocyclic group or a substituted or unsubstituted C₁-C₃₀ heterocyclic group, formed by linking two of a plurality of neighboring groups R₂, iii) a substituted or unsubstituted C₅-C₃₀ carbocyclic group or a substituted or unsubstituted C₁-C₃₀ heterocyclic group, formed by linking two of a plurality of neighboring groups R₃, iv) a substituted or unsubstituted C₅-C₃₀ carbocyclic group or a substituted or unsubstituted C₁-C₃₀ heterocyclic group, formed by linking two of a plurality of neighboring groups R₄, v) a substituted or unsubstituted C₅-C₃₀ carbocyclic group or a substituted or unsubstituted C₁-C₃₀ heterocyclic group, formed by linking two of a plurality of neighboring groups R₅, and vi) a substituted or unsubstituted C₅-C₃₀ carbocyclic group or a substituted or unsubstituted C₁-C₃₀ heterocyclic group, formed by linking two neighboring groups selected from R₁ to R₃, may each independently be selected from:
a pentadiene group, a cyclohexane group, a cycloheptane group, an adamantane group, a bicycloheptane group, a bicyclo-octane group, a benzene group, a pyridine group, a pyrimidine group, a pyrazine group, a pyridazine group, a triazine group, a naphthalene group, an anthracene group, a tetracene group, a phenanthrene group, a dihydronaphthalene group, a phenalene group, a benzothiophene group, a benzofuran group, an indene group, an indole group, a benzosilole group, an azabenzothiophene group, an azabenzofuran group, an azaindene group, an azaindole group, and an azabenzosilole group;
a pentadiene group, a cyclohexane group, a cycloheptane group, an adamantane group, a bicycloheptane group, a bicyclo-octane group, a benzene group, a pyridine group, a pyrimidine group, a pyrazine group, a pyridazine group, a triazine group, a naphthalene group, an anthracene group, a tetracene group, a phenanthrene group, a dihydronaphthalene group, a phenalene group, a benzothiophene group, a benzofuran group, an indene group, an indole group, a benzosilole group, an azabenzothiophene group, an azabenzofuran group, an azaindene group, an azaindole group, and an azabenzosilole group, each substituted with at least one R₁₀ₐ,
but embodiments of the present disclosure are not limited thereto. R₁₀ₐ is the same as described in connection with R₁.

"Azabenzothiophene, azabenzofuran, azaindene, azaindole, azabenzosilole, azadibenzothiophene, azadibenzofuran, azafluorene, azacarbazole, and azadibenzosilole" as used herein mean hetero-rings that respectively have the same backbones as "benzothiophene, benzofuran, indene, indole, benzosilole, dibenzothiophene, dibenzofuran, fluorene, carbazole, and dibenzosilole", provided that at least one of carbons forming rings thereof is substituted with nitrogen.

In an embodiment, in Formula 1,
i) X₅ may not be a single bond, a moiety represented by 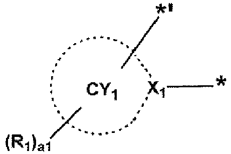 may be represented by Formula A1-1, a moiety represented by 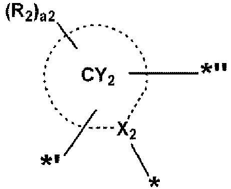 may be represented by Formula A2-1 or A2-2, and T₂ may be a single bond;
ii) X₅ may be a single bond, a moiety represented by 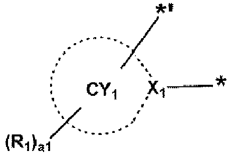 may be represented by Formula A1-2, a moiety represented by 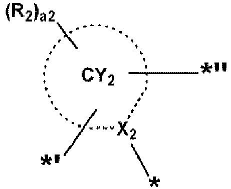 may be represented by Formula A2-1 or A2-2, and T₂ may be a single bond;
iii) X₅ may be a single bond, a moiety represented by 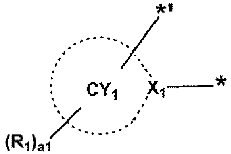 may be represented by Formula A1-1, a moiety represented by 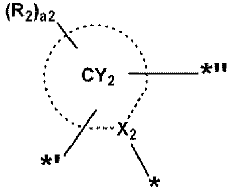 may be represented by Formula A2-1 or A2-2, and T₂ may not be a single bond; or
iv) X₅ may be a single bond, a moiety represented by 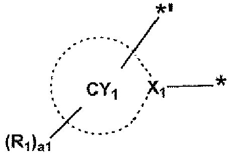 may be represented by Formula A1-1, a moiety represented by 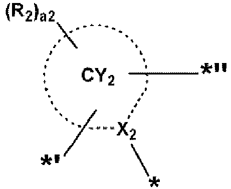 may be represented by Formula A2-3, and T₂ may be a single bond:

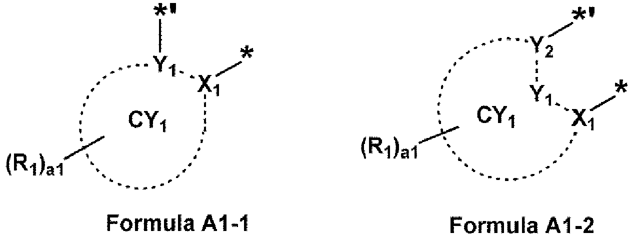

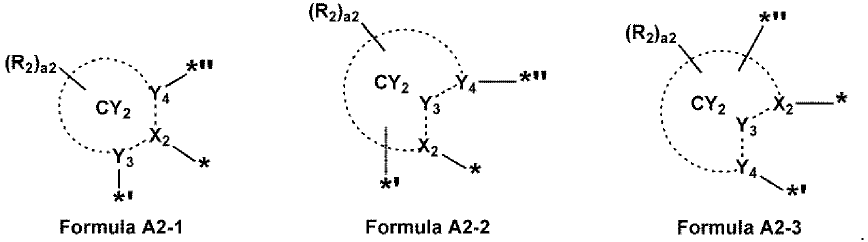

In Formulae A1 -1, A1-2, and A2-1 to A2-3,
X₁, X₂, ring CY₁, ring CY₂, R₁, R₂, a1, and a2 are the same as described herein,
Y₁ to Y₄ may each independently be N or C,
* in Formulae A1-1 and A1-2 indicates a binding site to M in Formula 1,
*' in Formulae A1-1 and A1-2 indicates a binding site to T₂ in Formula 1,
* in Formulae A2-1 to A2-3 indicates a binding site to M in Formula 1,
*' in Formulae A2-1 to A2-3 indicates a binding site to T₂ in Formula 1, and
*" in Formulae A2-1 to A2-3 indicates a binding site to ring CY₃ in Formula 1.

In one or more embodiments, a moiety represented by 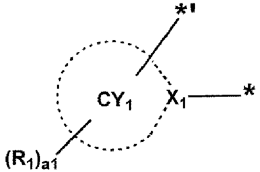 in Formula 1 may be represented by one of Formulae A1-1(1) to A1-1(26) and A1-2(1) to A1-2(76), and
a moiety represented by 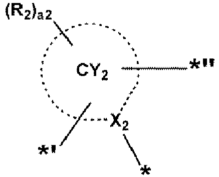 in Formula 1 may be represented by one of Formulae A2-1(1) to A2-1(21), A2-2(1) to A2-2(58), and A2-3(1) to A2-3(58):

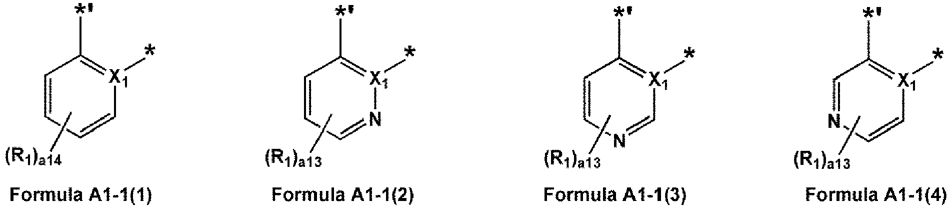

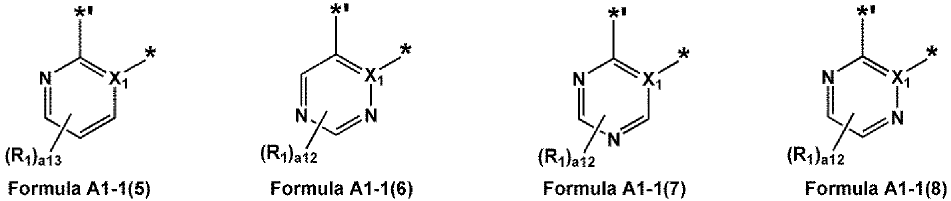

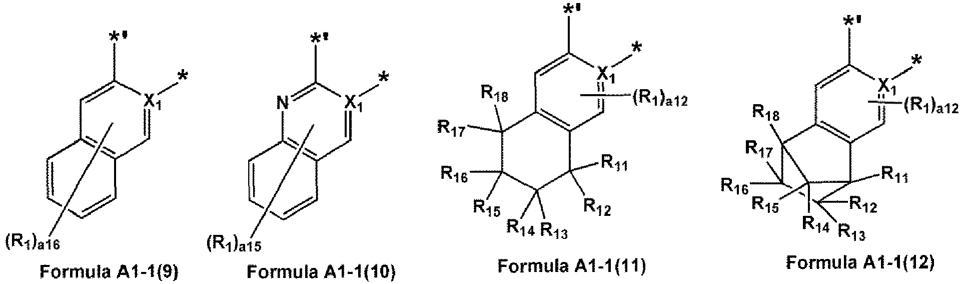

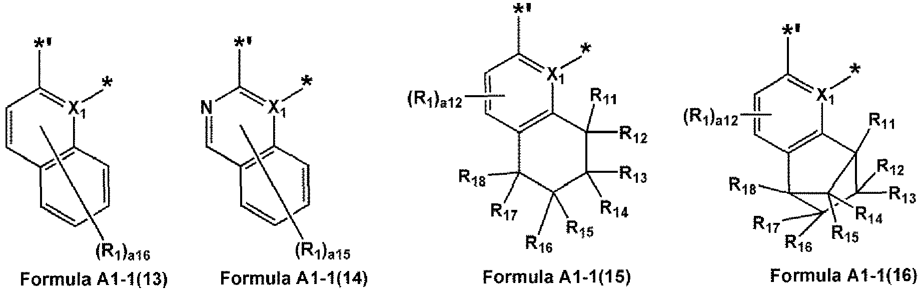

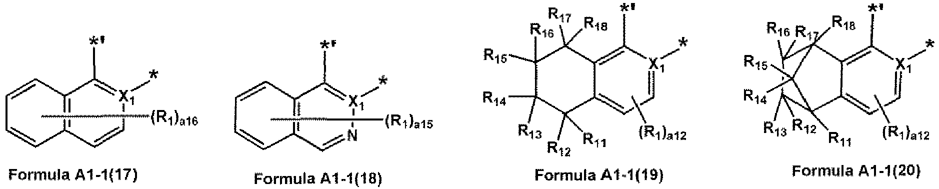

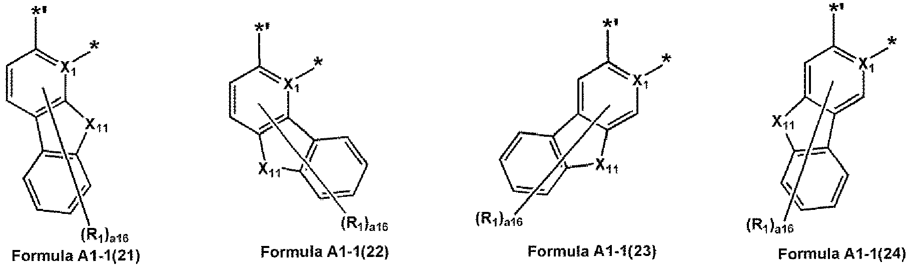

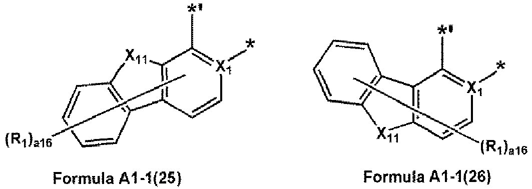

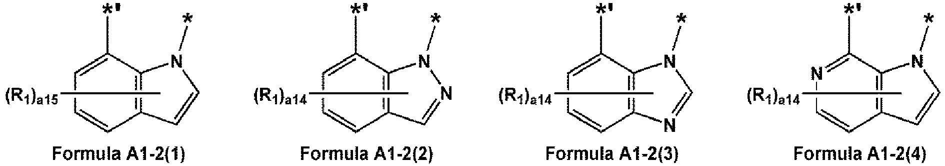

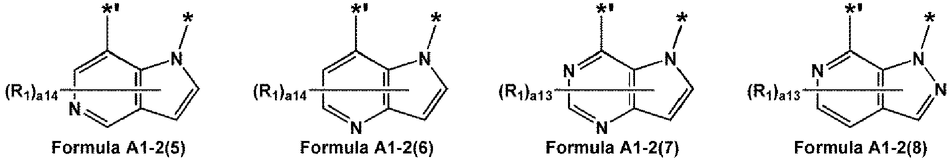

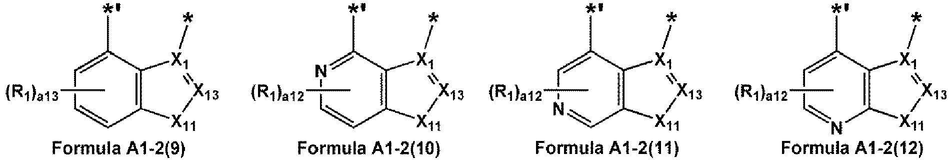

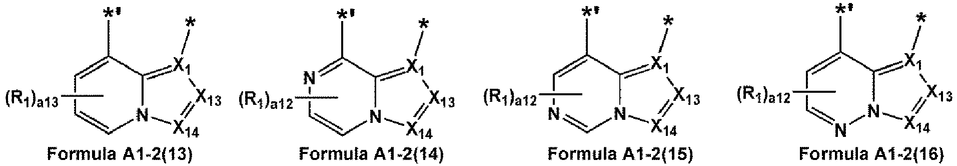

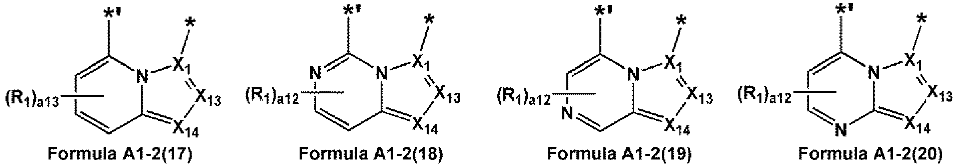

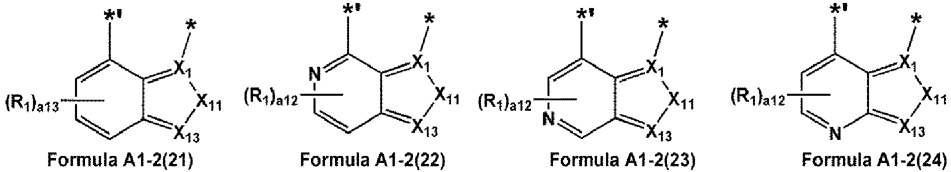

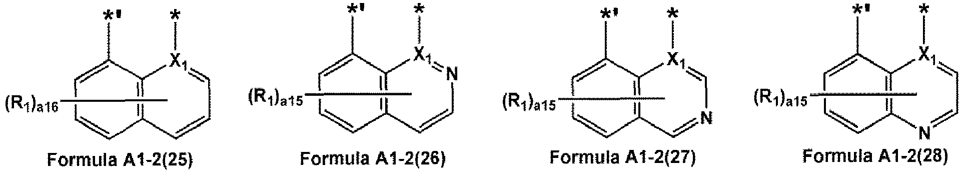

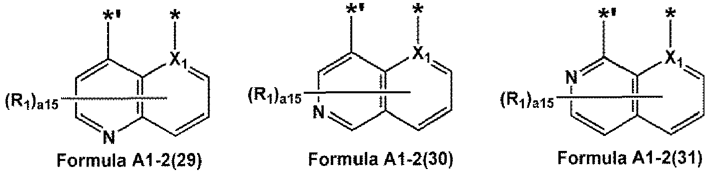

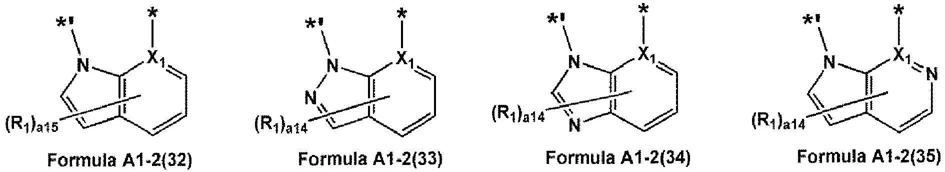

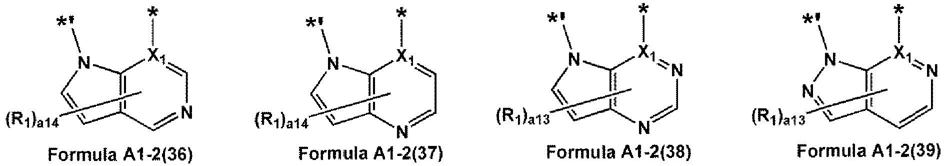

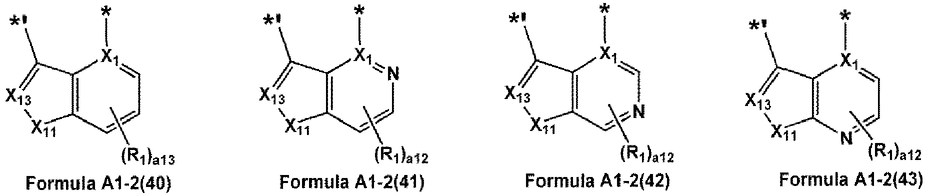

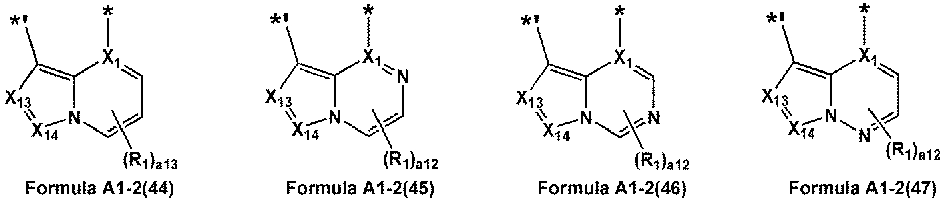

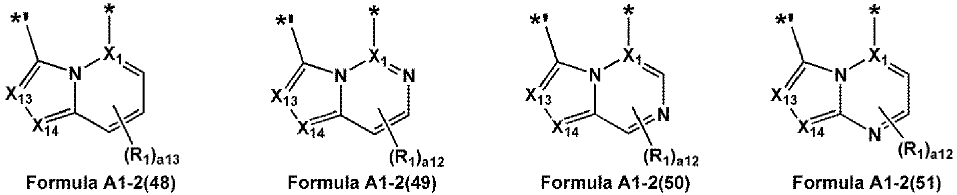

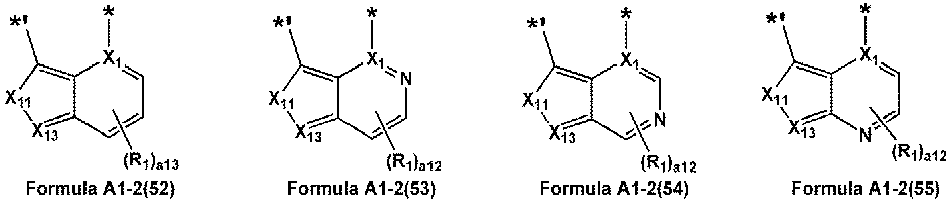

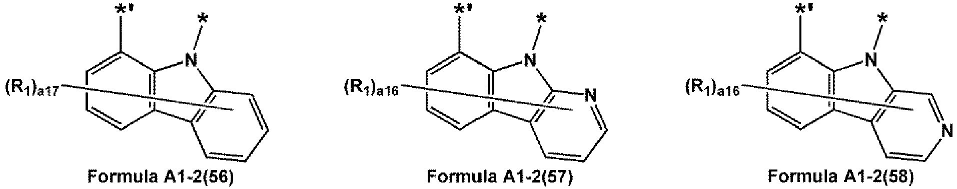

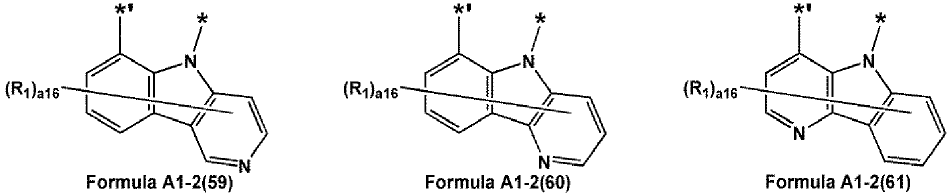

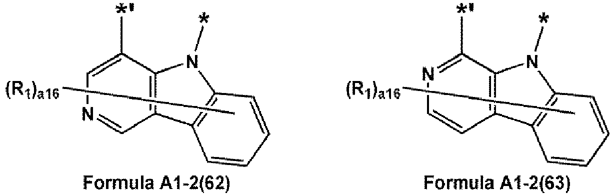

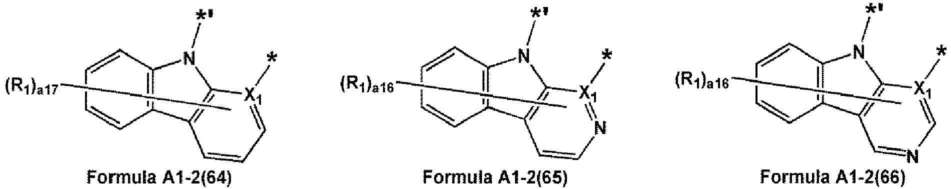

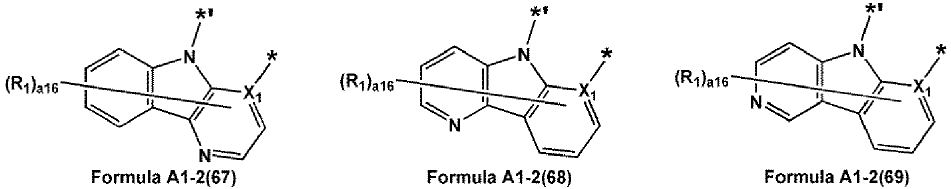

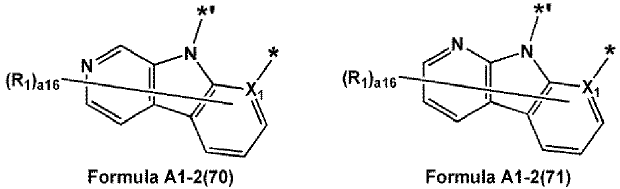

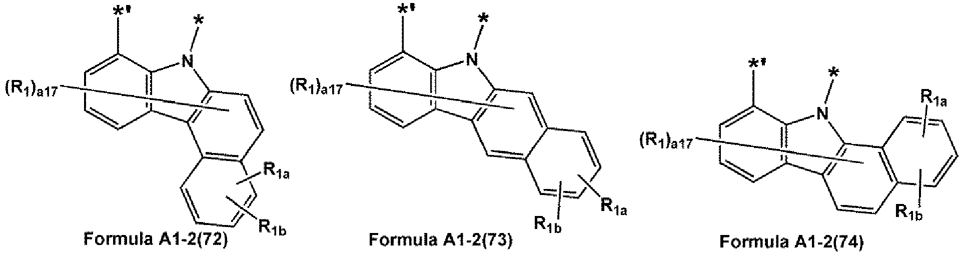

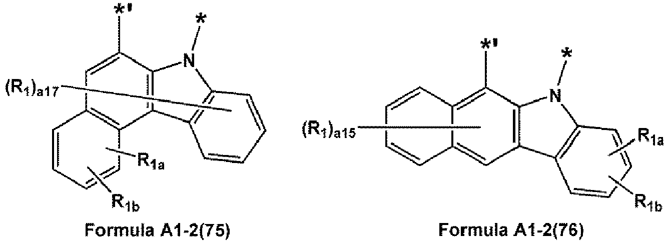

In Formulae A1-1(1) to A1-1(26) and A1-2(1) to A1-2(76),
X₁ and R₁ are the same as described herein,
X₁₁ may be O, S, N(R₁₁), C(R₁₁)(R₁₂), or Si(R₁₁)(R₁₂),
X₁₃ may be N or C(R₁₃),
X₁₄ may be N or C(R₁₄),
R₁ₐ, R_{1b}, and R₁₁ to R₁₈ are the same as described in connection with R₁,
a17 may be an integer from 0 to 7,
a16 may be an integer from 0 to 6,
a15 may be an integer from 0 to 5,
a14 may be an integer from 0 to 4,
a13 may be an integer from 0 to 3,
a12 may be an integer from 0 to 2,
* indicates a binding site to M in Formula 1, and
*' indicates a binding site to T₂ in Formula 1:

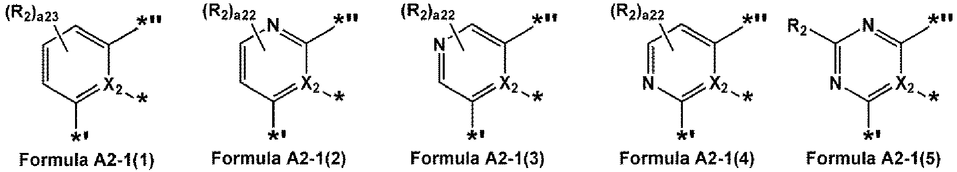

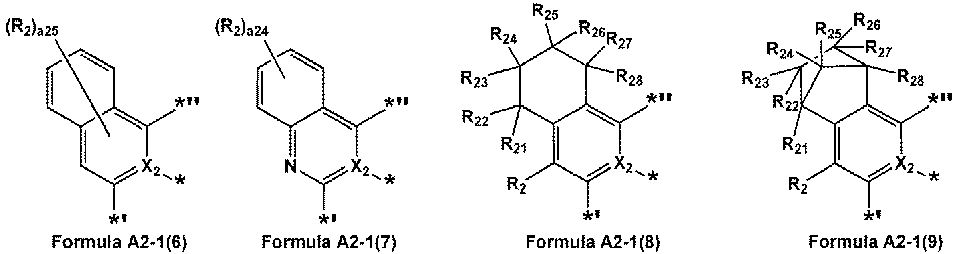

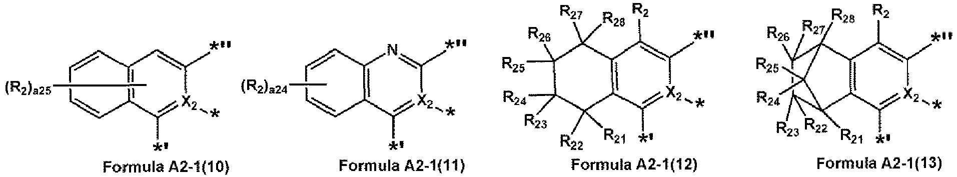

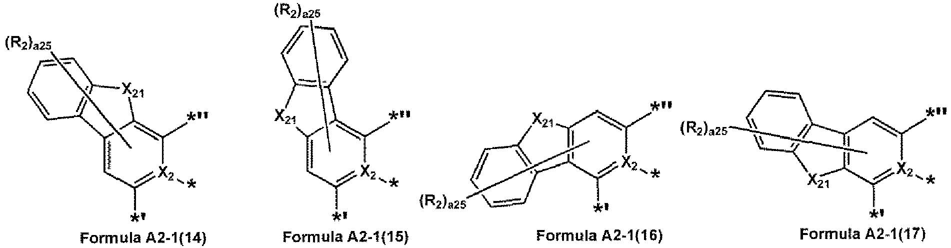

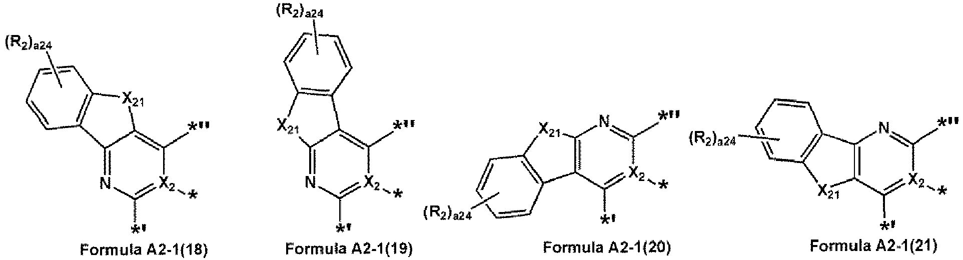

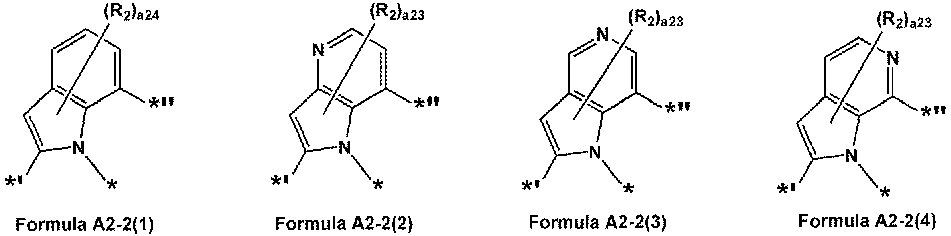

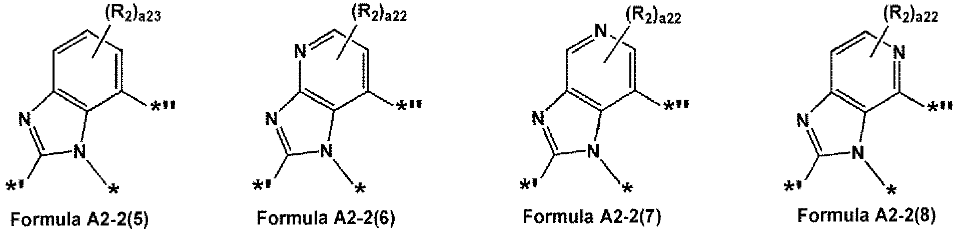

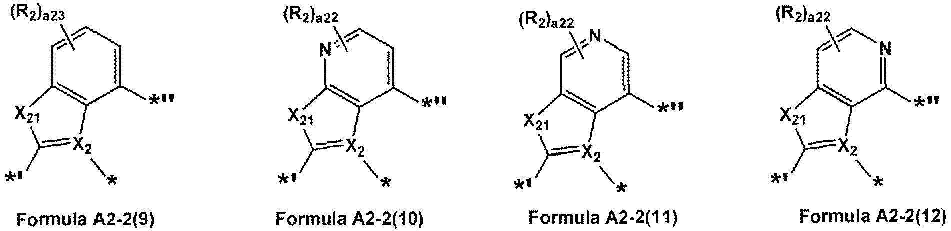

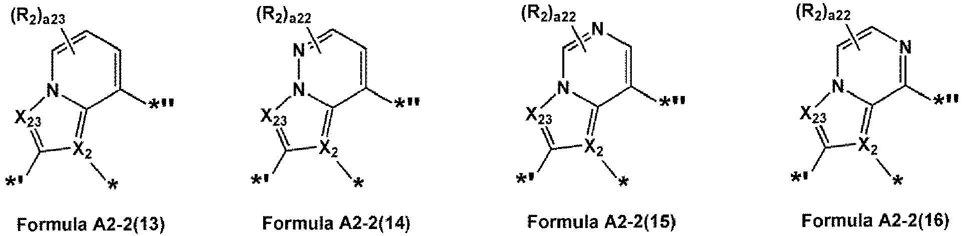

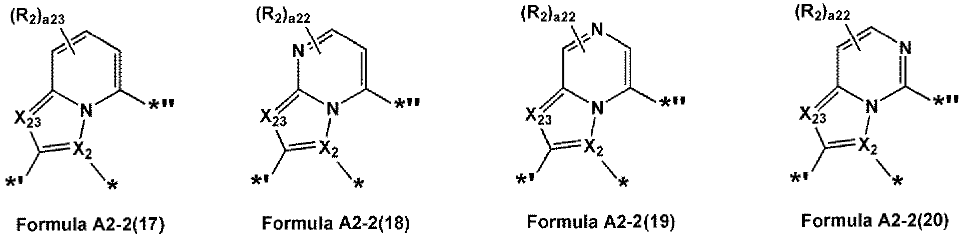

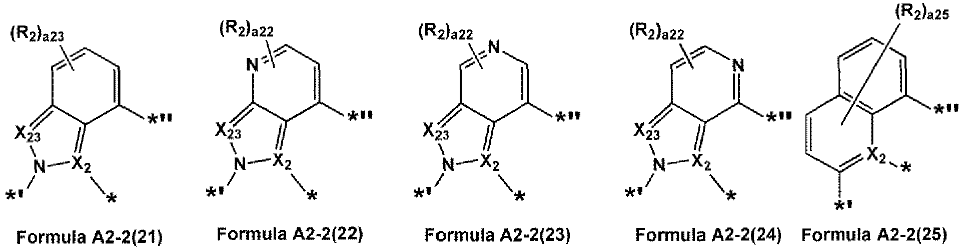

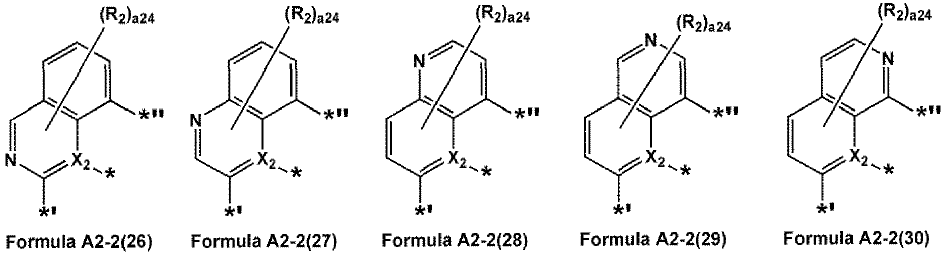

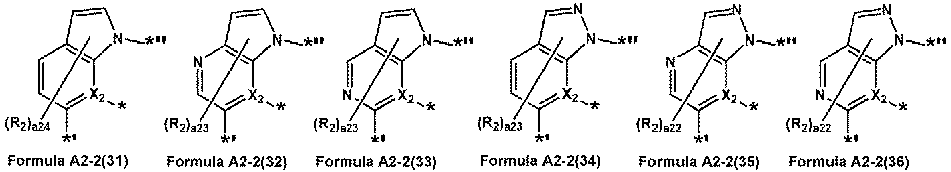

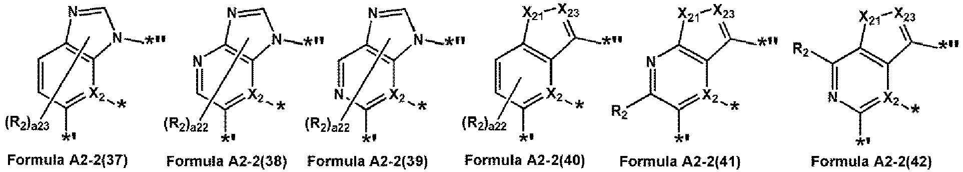

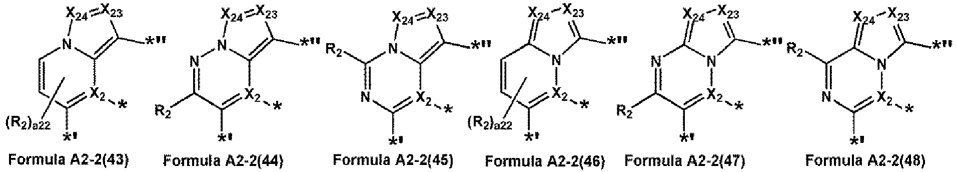

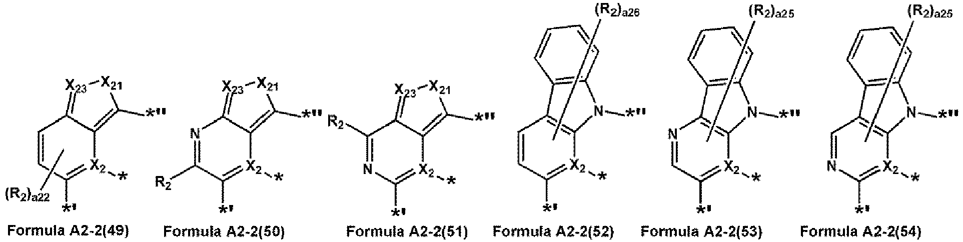

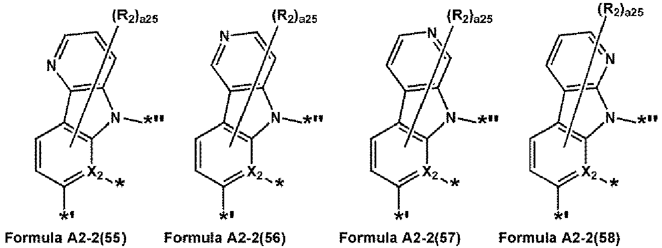

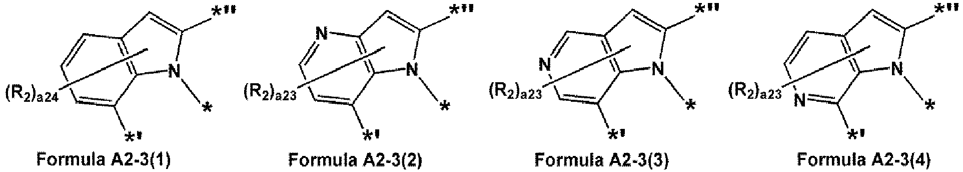

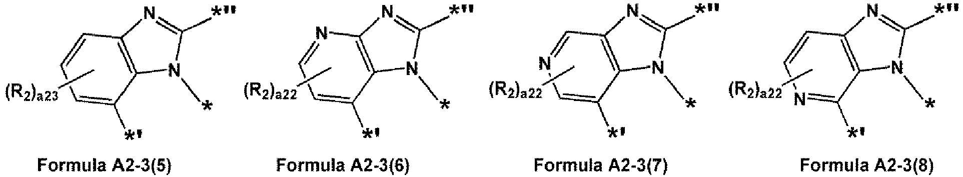

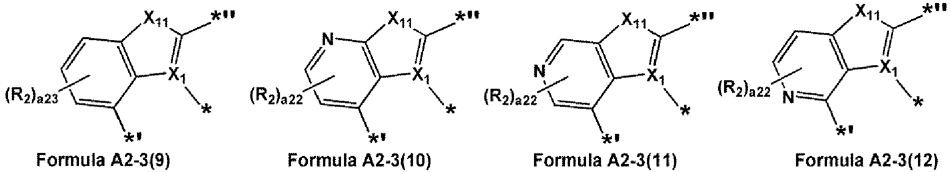

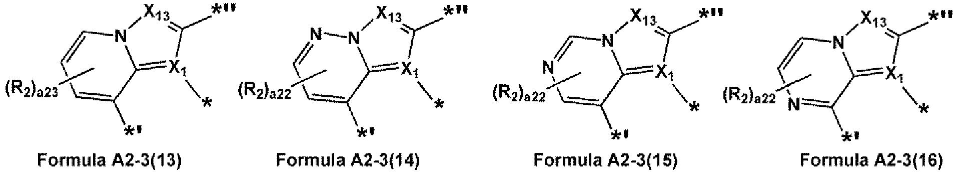

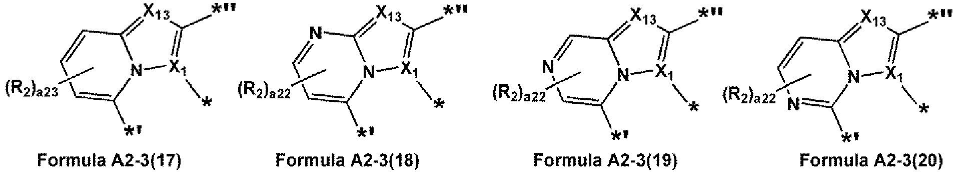

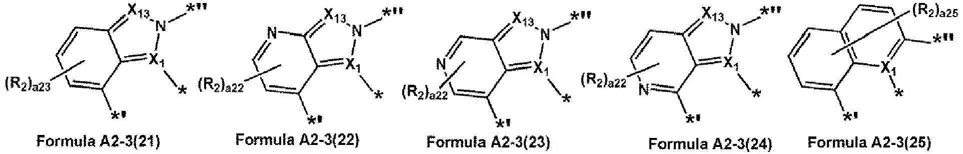

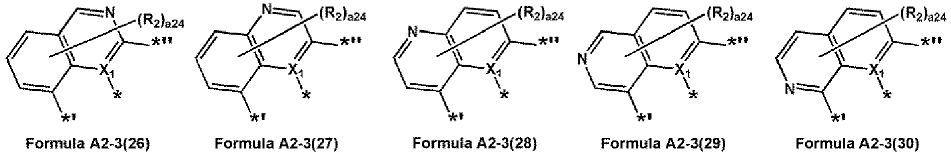

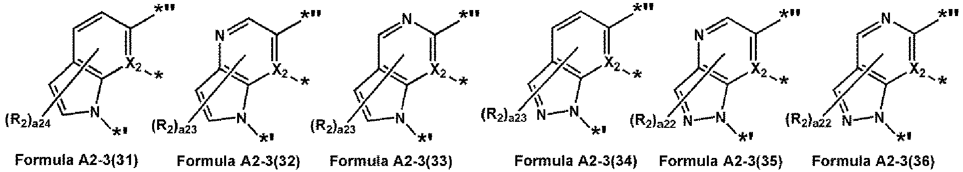

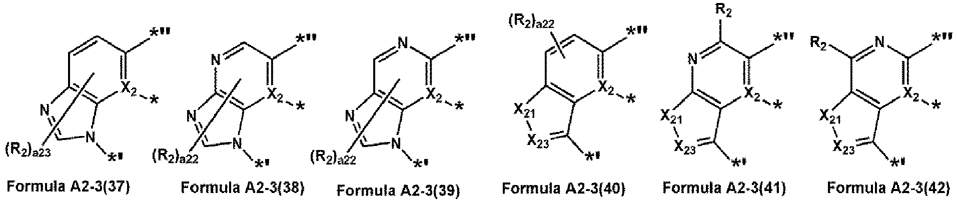

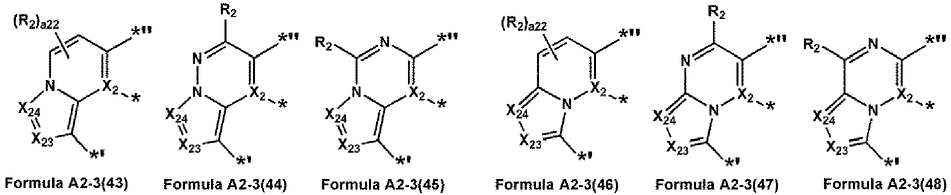

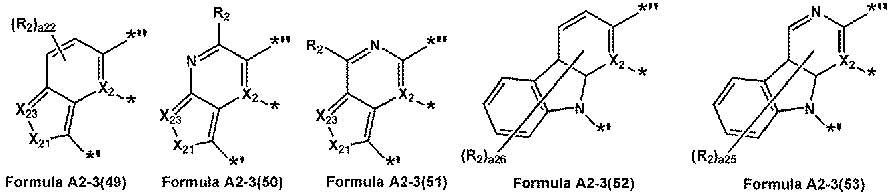

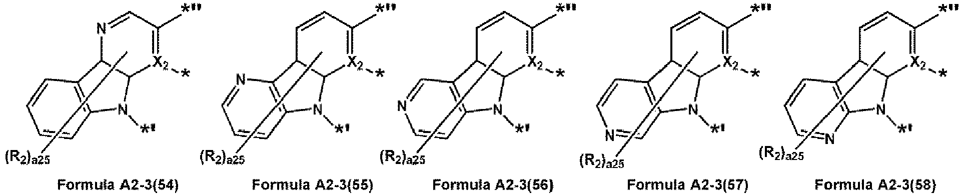

In Formulae A2-1(1) to A2-1(21), A2-2(1) to A2-2(58), and A2-3(1) to A2-3(58),
X₂ and R₂ are the same as described herein,
X₂₁ may be O, S, N(R₂₁), C(R₂₁)(R₂₂), or Si(R₂₁)(R₂₂),
X₂₃ may be N or C(R₂₃),
X₂₄ may be N or C(R₂₄),
R₂₁ to R₂₈ are the same as described in connection with R₂,
a26 may be an integer from 0 to 6,
a25 may be an integer from 0 to 5,
a24 may be an integer from 0 to 4,
a23 may be an integer from 0 to 3,
a22 may be an integer from 0 to 2,
* indicates a binding site to M in Formula 1,
*' indicates a binding site to T₂ in Formula 1, and
*" indicates a binding site to ring CY₃ in Formula 1.

In one or more embodiments, in Formula 1,
i) X₅ may not be a single bond, a moiety represented by 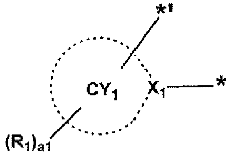 may be represented by one of Formulae A1-1(1) to A1-1(26), a moiety represented by 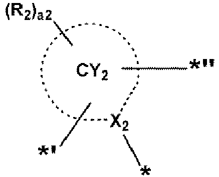 may be represented by one of Formulae A2-1(1) to A2-1(21), and T₂ may be a single bond;
ii) X₅ may be a single bond, a moiety represented by 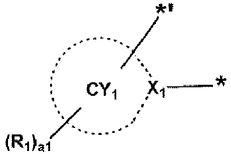 may be represented by one of Formulae A1-2(1) to A1-2(76), a moiety represented by 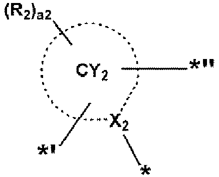 may be represented by one of Formulae A2-1(1) to A2-1(21), and T₂ may be a single bond;
iii) X₅ may be a single bond, a moiety represented by 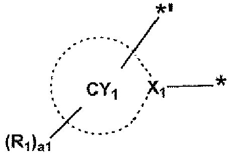 may be represented by one of Formulae A1-1(1) to A1-1(26), a moiety represented by 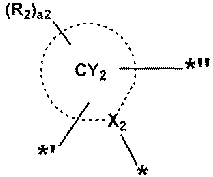 may be represented by one of Formulae A2-1(1) to A2-1(21), and T₂ may not be a single bond; or
iv) X₅ may be a single bond, a moiety represented by 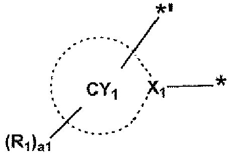 may be represented by one of Formulae A1-1(1) to A1-1(26), a moiety represented by 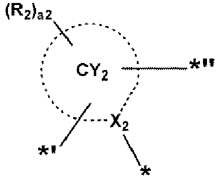 may be represented by one of Formulae A2-3(1) to A2-3(58), and T₂ may be a single bond.

In one or more embodiments, a moiety represented by 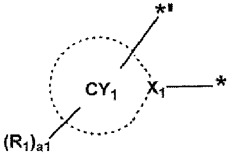 in Formula 1 may be represented by one of Formulae CY1-1 to CY1-39, and a moiety represented by 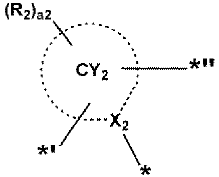 may be represented by one of Formulae CY2-1 to CY2-23:

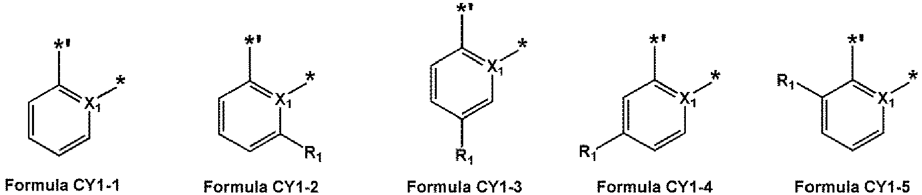

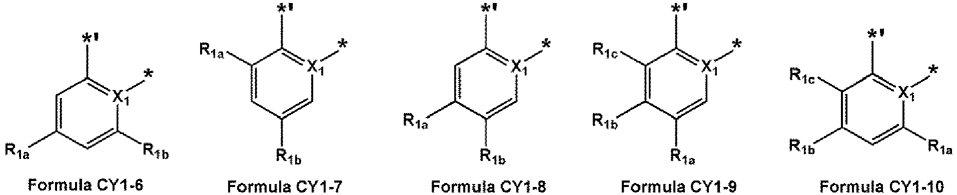

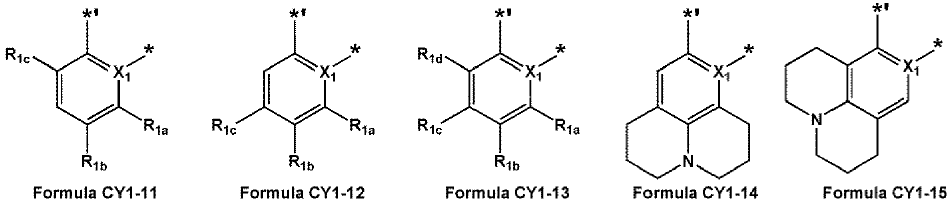

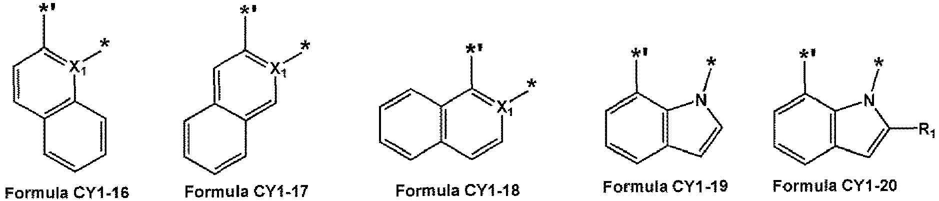

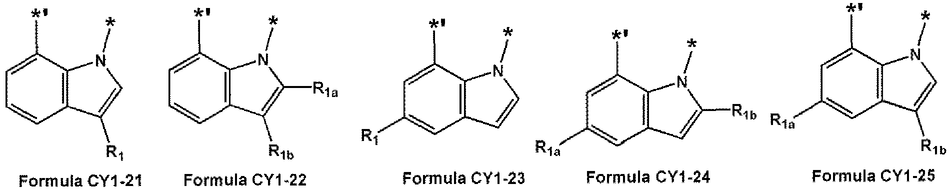

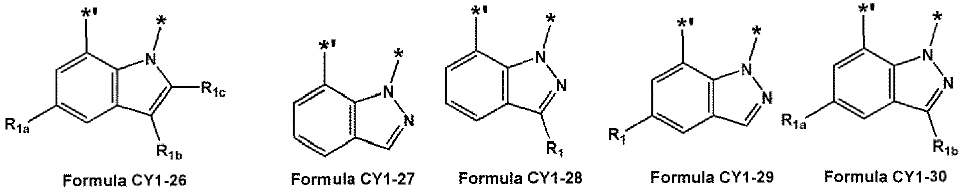

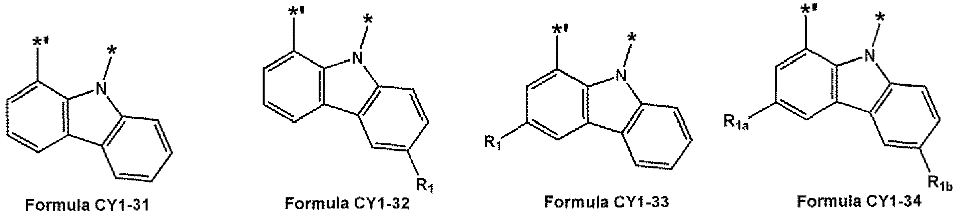

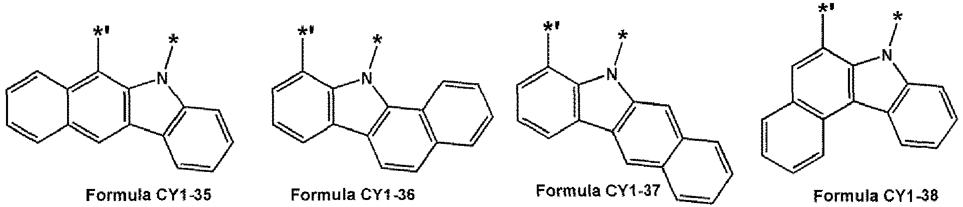

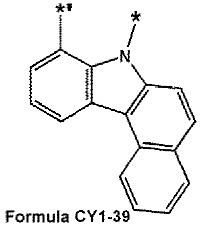

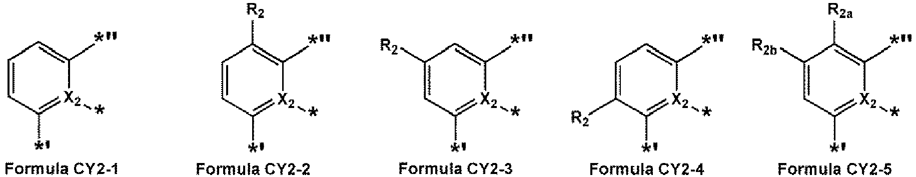

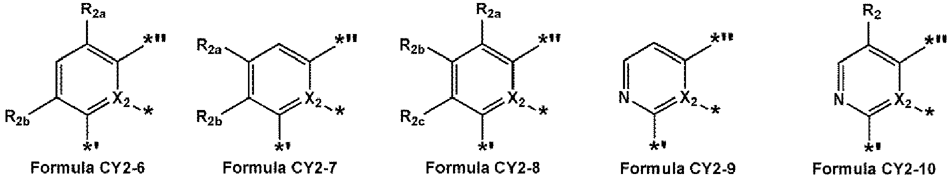

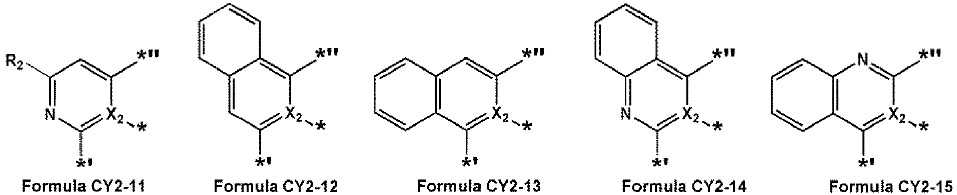

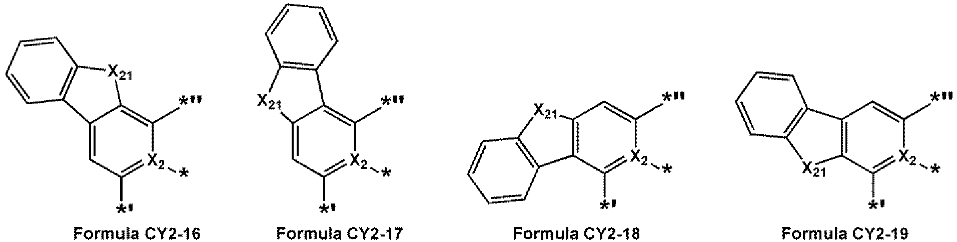

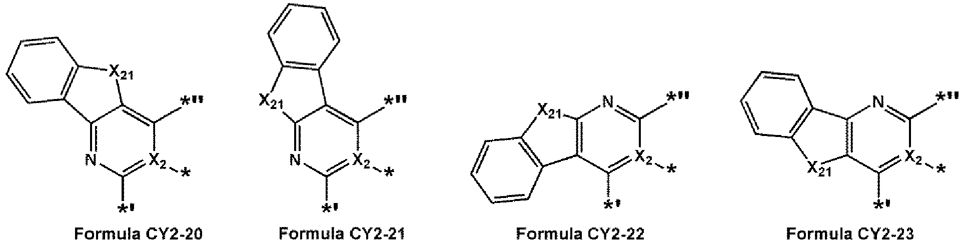

In Formulae CY1-1 to CY1-39 and CY2-1 to CY2-23,
X₁, X₂, R₁, and R₂ are the same as described herein,
X₂₁ may be O, S, N(R₂₁), C(R₂₁)(R₂₂), or Si(R₂₁)(R₂₂),
R₁ₐ to R_{1d} are the same as described in connection with R₁,
R₂ₐ to R_{2c}, R₂₁, and R₂₂ are the same as described in connection with R₂,
R₁, R₁ₐ to R_{1d}, R₂, and R₂ₐ to R_{2c} are not hydrogen,
* in Formulae CY1-1 to CY1-39 indicates a binding site to M in Formula 1,
*' in Formulae CY1-1 to CY1-39 indicates a binding site to T₂ in Formula 1,
* in Formulae CY2-1 to CY2-23 indicates a binding site to M in Formula 1,
*' in Formulae CY2-1 to CY2-23 indicates a binding site to T₂ in Formula 1, and
*" in Formulae CY2-1 to CY2-23 indicates a binding site to ring CY₃ in Formula 1.

In one or more embodiments, a moiety represented by 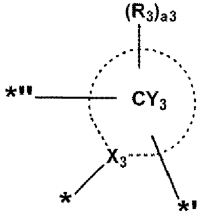 in Formula 1 may be represented by Formula A3-1 or A3-3, and a moiety represented by 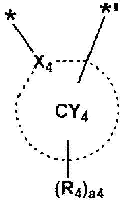 may be represented by Formula A4-1:

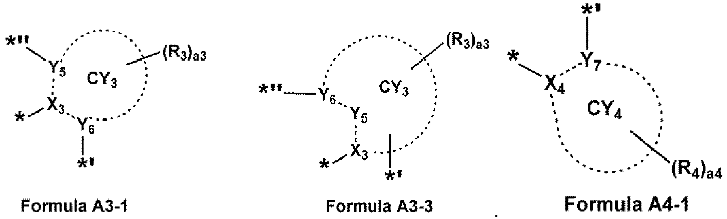

In Formulae A3-1, A3-3, and A4-1, X₃, X₄, ring CY₃, ring CY₄, R₃, R₄, a3, and a4 are the same as described herein, and Y₅ to Y₇ may each independently be N or C. In Formulae A3-1 and A3-3, * indicates a binding site to M in Formula 1, *' indicates a binding site to T₁ in Formula 1, and *" indicates a binding site to ring CY₃ in Formula 1. In Formula A4-1, * indicates a binding site to M in Formula 1, and *' indicates a binding site to T₁ in Formula 1.

In one or more embodiments, a moiety represented by 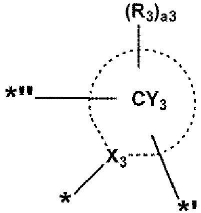 in Formula 1 may be represented by one of Formulae A3-1(1) to A3-1(21) and A3-3(1) to A3-3(58):

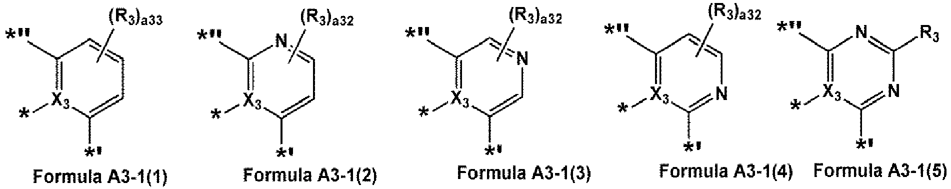

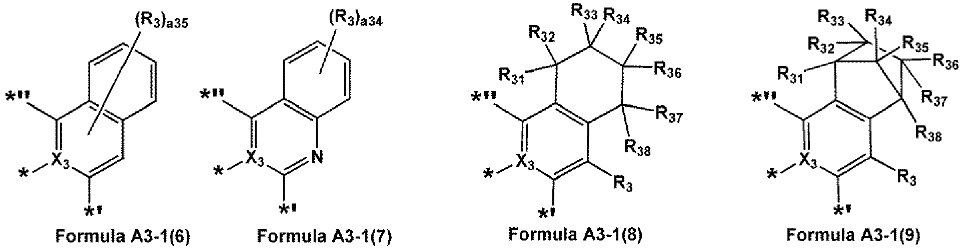

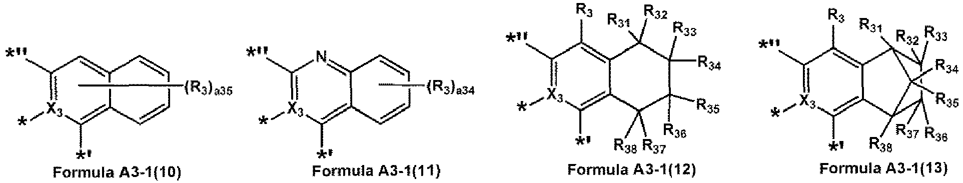

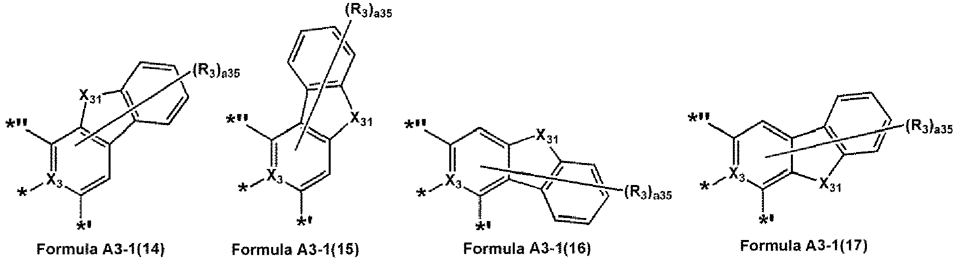

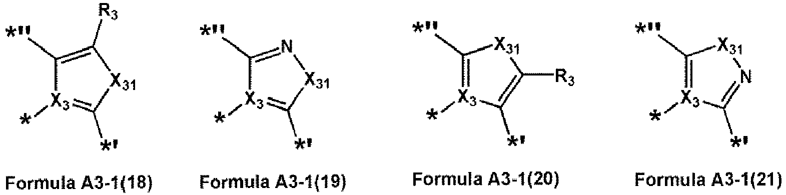

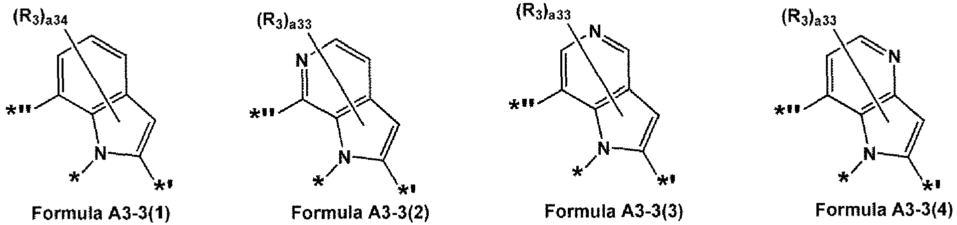

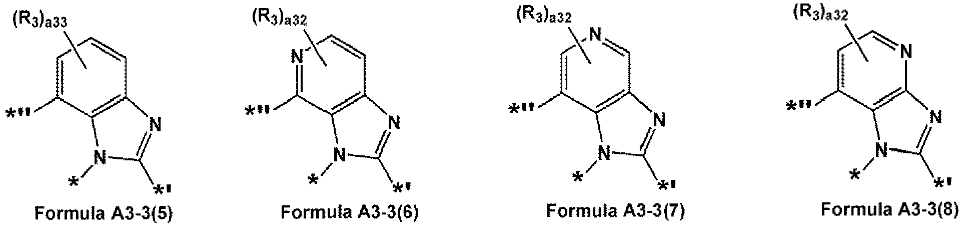

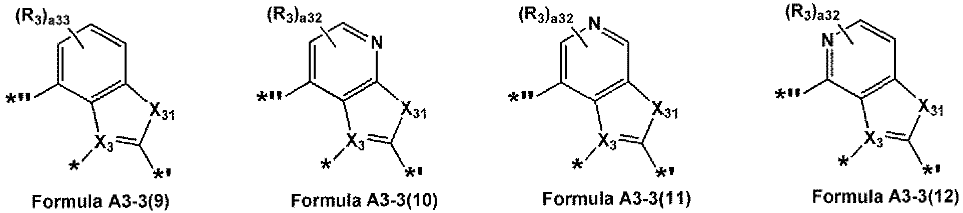

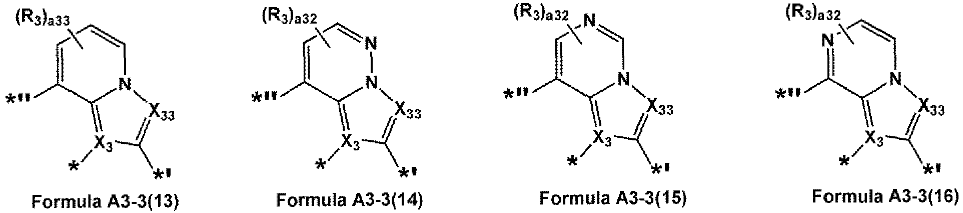

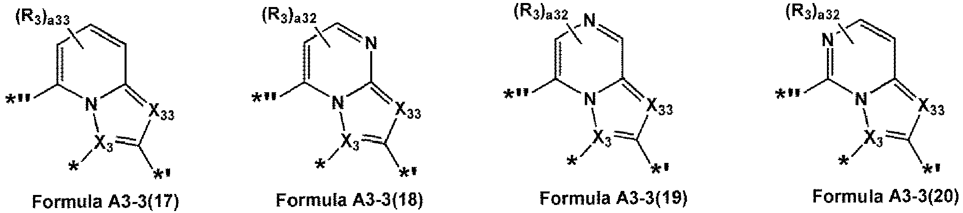

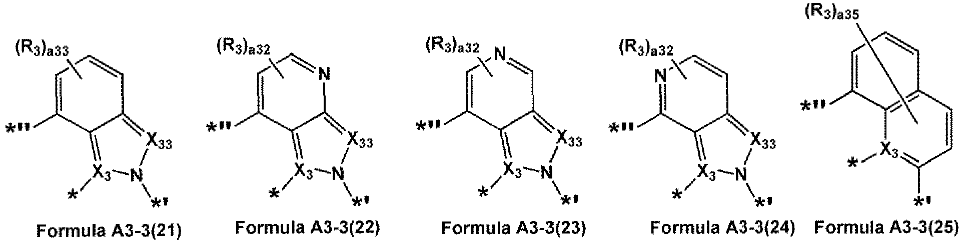

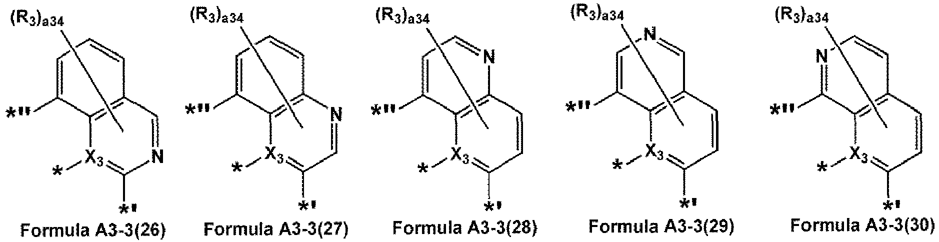

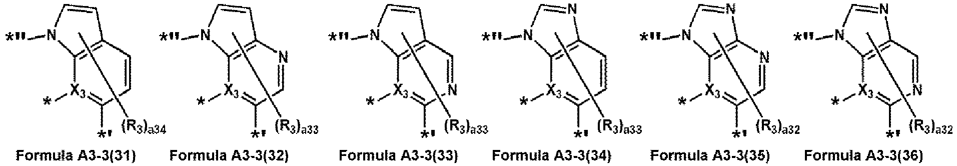

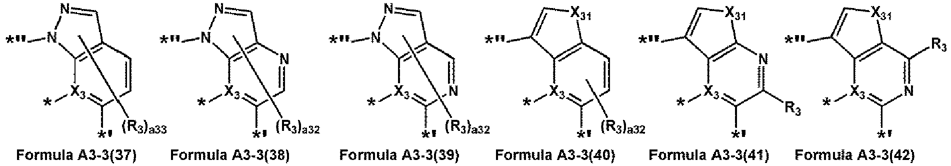

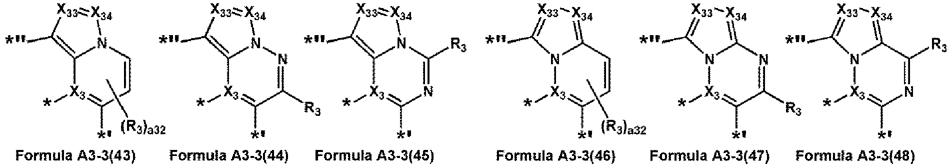

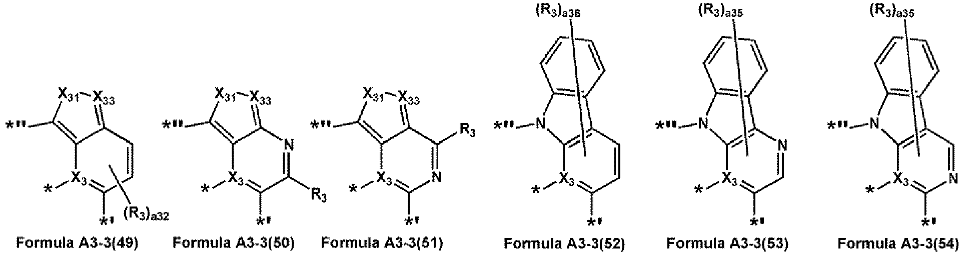

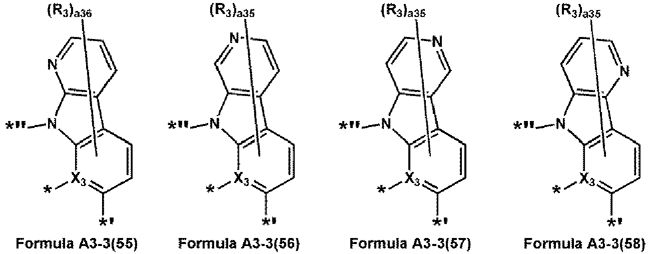

In Formulae A3-1(1) to A3-1(21) and A3-3(1) to A3-3(58),
X₃ and R₃ are the same as described herein,
X₃₁ may be O, S, N(R₃₁), C(R₃₁)(R₃₂), or Si(R₃₁)(R₃₂),
X₃₃ may be N or C(R₃₃),
X₃₄ may be N or C(R₃₄),
R₃₁ to R₃₈ are the same as described in connection with R₃,
a36 may be an integer from 0 to 6,
a35 may be an integer from 0 to 5,
a34 may be an integer from 0 to 4,
a33 may be an integer from 0 to 3,
a32 may be an integer from 0 to 2,
* indicates a binding site to M in Formula 1,
*" indicates a binding site to ring CY₂ in Formula 1, and
*' indicates a binding site to T₁ in Formula 1.

In one or more embodiments, a moiety represented by 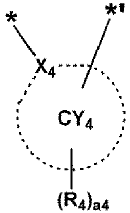 in Formula 1 may be represented by one of Formulae A4-1 (1) to A4-1 (44):

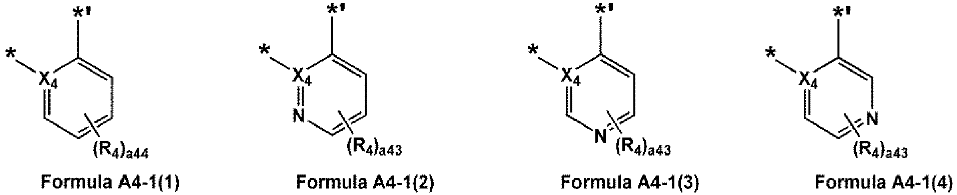

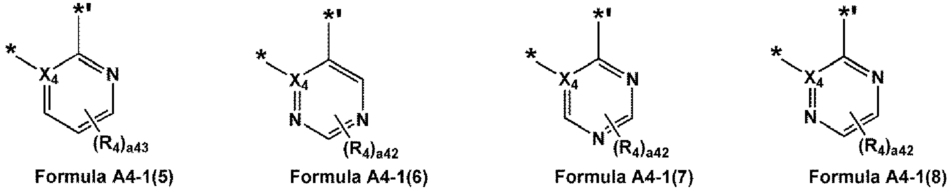

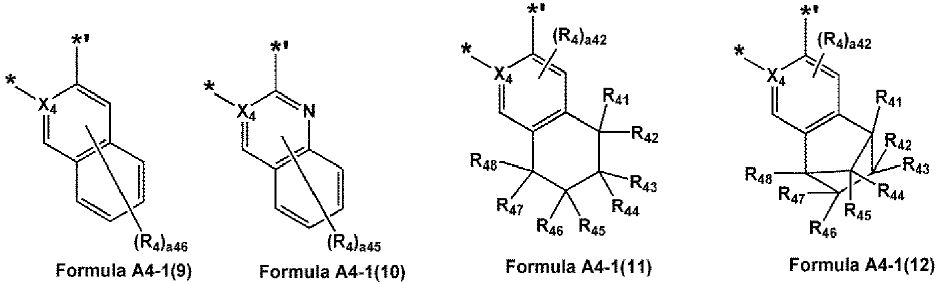

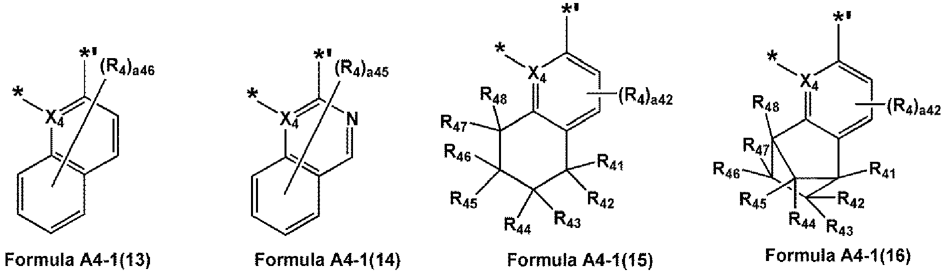

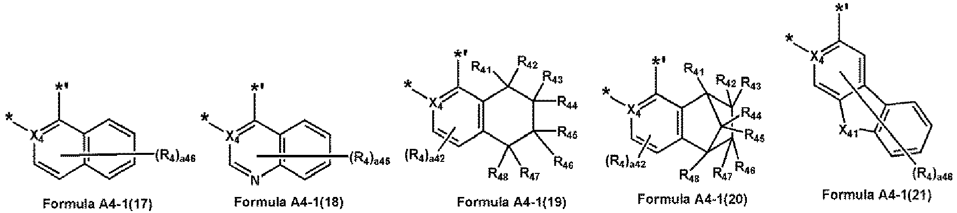

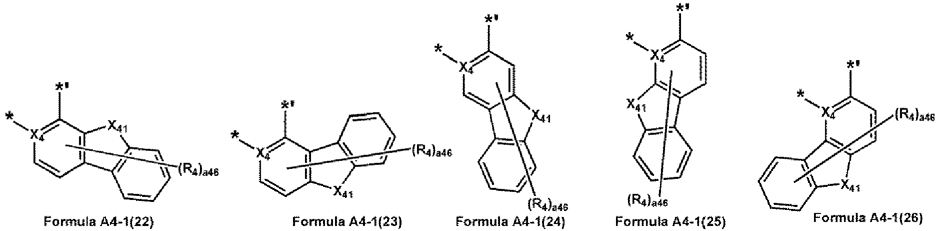

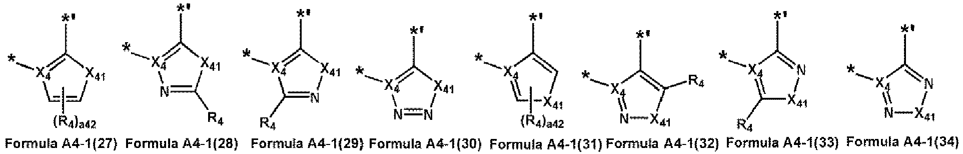

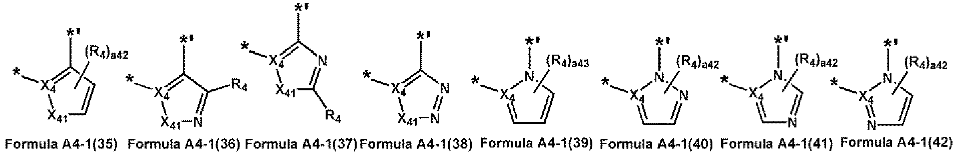

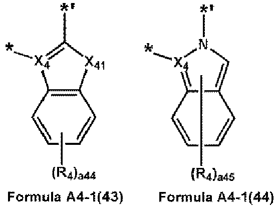

In Formulae A4-1(1) to A4-1(44),
X₄, R₄, *, and *' are the same as described herein,
X₄₁ may be O, S, N(R₄₁), C(R₄₁)(R₄₂), or Si(R₄₁)(R₄₂),
X₄₃ may be N or C(R₄₃),
X₄₄ may be N or C(R₄₄),
R₄₁ to R₄₈ are the same as described in connection with R₄,
a47 may be an integer from 0 to 7,
a46 may be an integer from 0 to 6,
a45 may be an integer from 0 to 5,
a44 may be an integer from 0 to 4,
a43 may be an integer from 0 to 3,
a42 may be an integer from 0 to 2,
* indicates a binding site to M in Formula 1, and
*' indicates a binding site to T₁ in Formula 1.

In one or more embodiments, in Formula 1, a cyclometallated ring formed by M, X₅, ring CY₁, T₂, and ring CY₂ and a cyclometallated ring formed by M, ring CY₄, T₁, and ring CY₃ may each be a 6-membered ring, and a cyclometallated ring formed by M, ring CY₂, and ring CY₃ may be a 5-membered ring.

In one or more embodiments, the organometallic compound may be represented by one of Formulae 1-1 to 1-3:

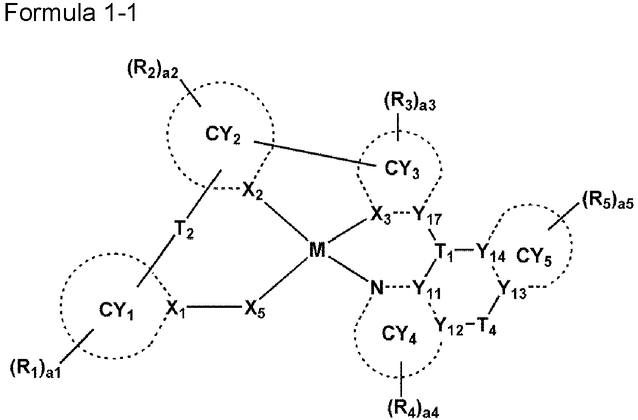

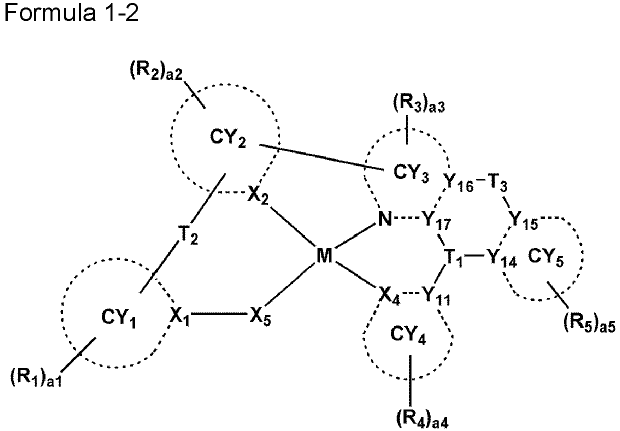

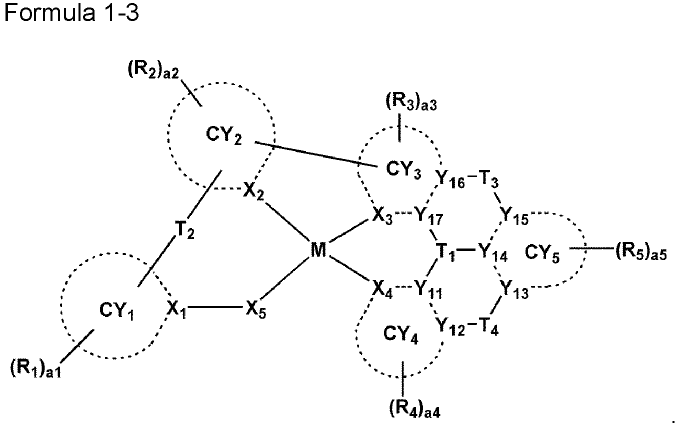

In Formulae 1-1 to 1-3,
M, X₁ to X₅, rings CY₁ to CY₅, T₁ to T₄, R₁ to R₅, and a1 to a5 are the same as described herein, provided that at least one of X₃ and X₄ in Formula 1-3 is N, and
Y₁₁ to Y₁₇ may each independently be C or N.

In one or more embodiments, the organometallic compound may be represented by one of Formulae 1A-1 to 1A-3 and 1B:

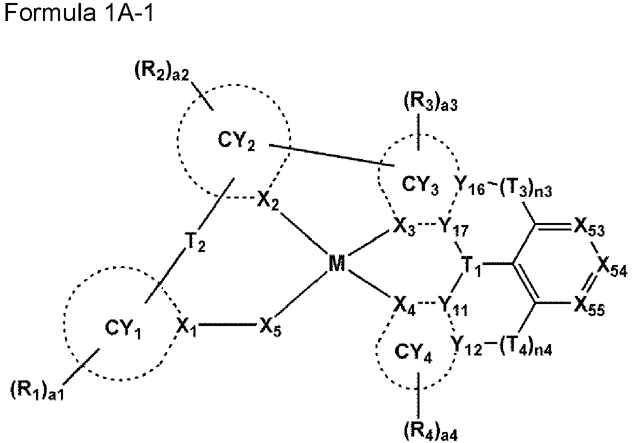

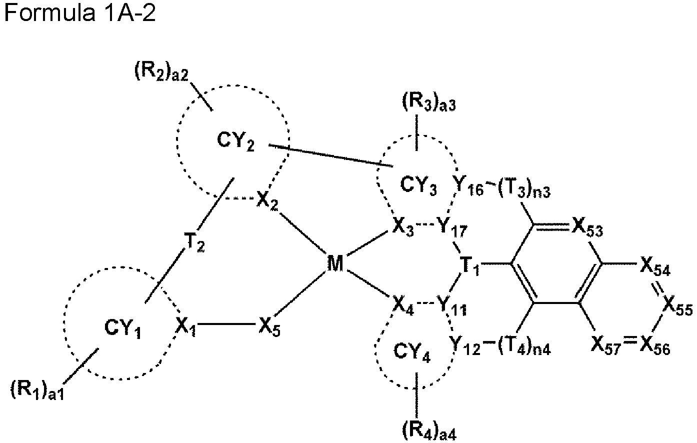

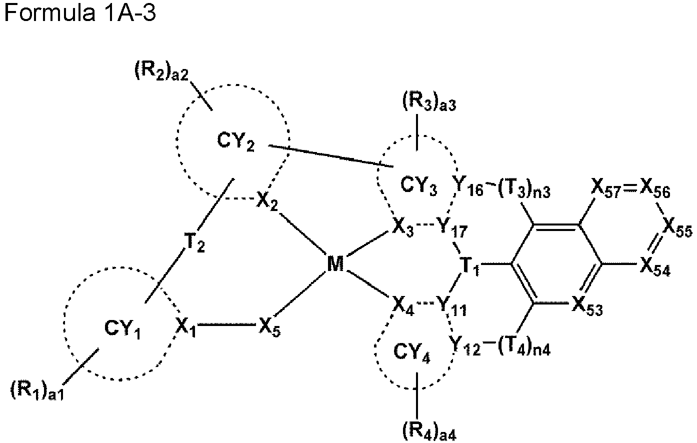

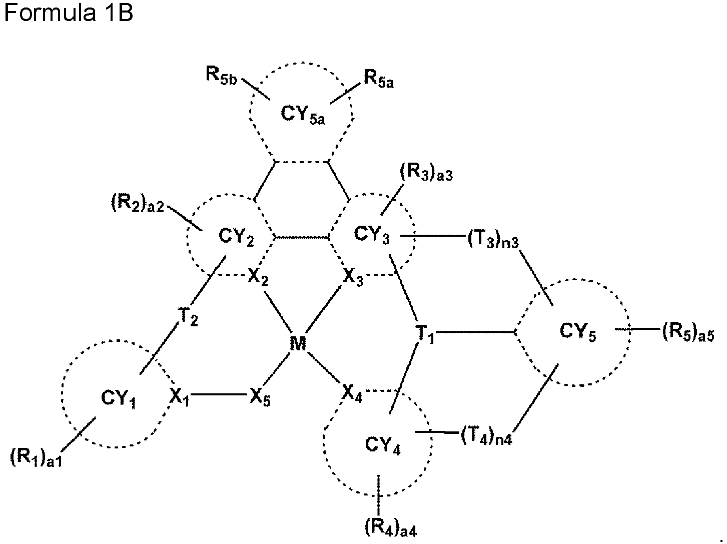

In Formulae 1A-1 to 1A-3 and 1B,
M, X₁ to X₅, ring CY₁, ring CY₂, T₁ to T₄, n3, n4, R₁, R₂, a1, and a2 are the same as described herein,
X₅₃ may be N or C(R₅₃), X₅₄ may be N or C(R₅₄), X₅₅ may be N or C(R₅₅), X₅₆ may be N or C(R₅₆), and X₅₇ may be N or C(R₅₇),
R₅₃ to R₅₇ are the same as described in connection with R₅,
Y₁₁, Y₁₂, Y₁₆, and Y₁₇ may each independently be C or N,
CY₅ₐ is the same as described in connection with CY₅, and
R₅ₐ and R_{5b} are the same as described in connection with R₅.

The organometallic compound may be one of Compounds 1 to 160, but embodiments of the present disclosure are not limited thereto:

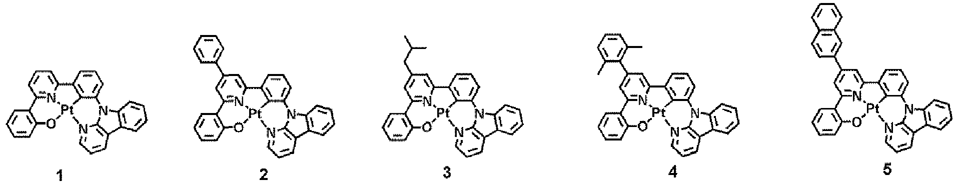

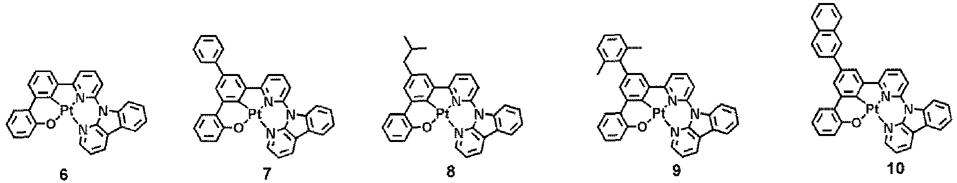

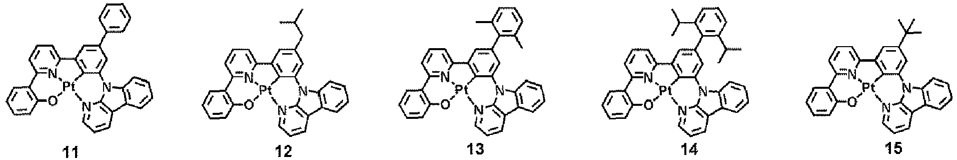

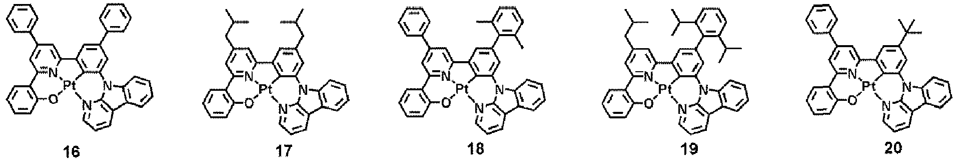

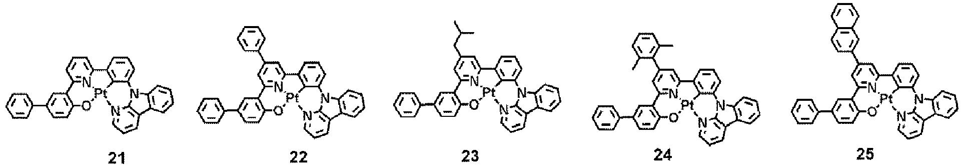

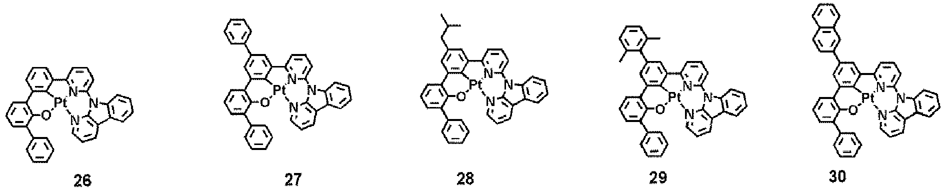

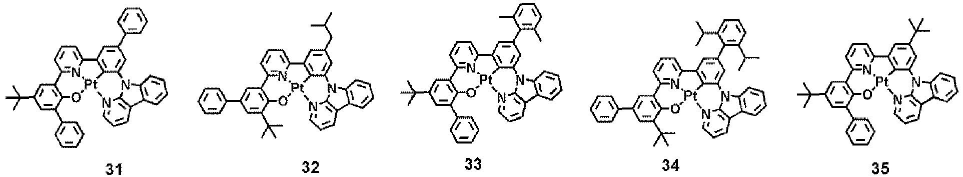

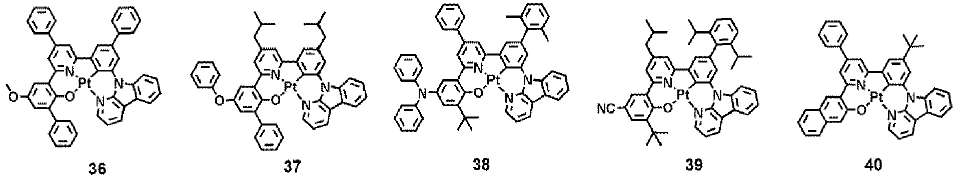

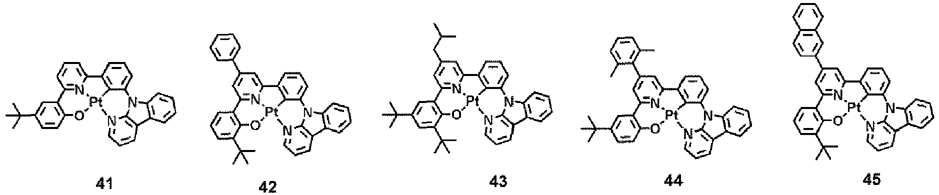

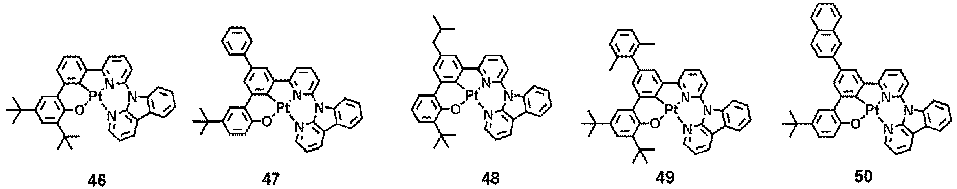

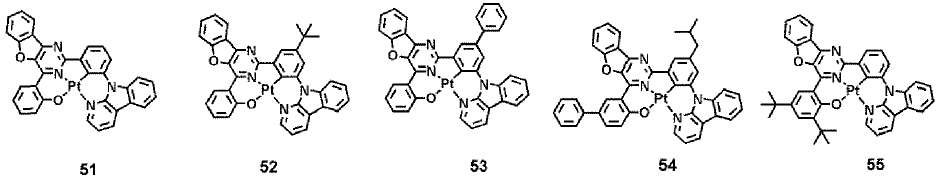

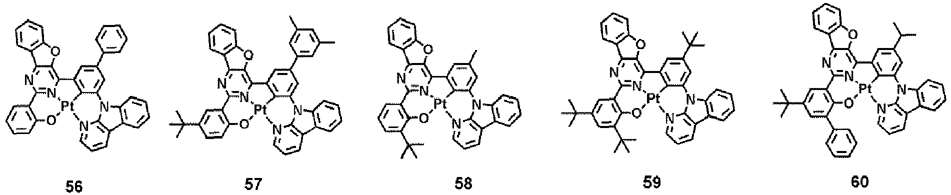

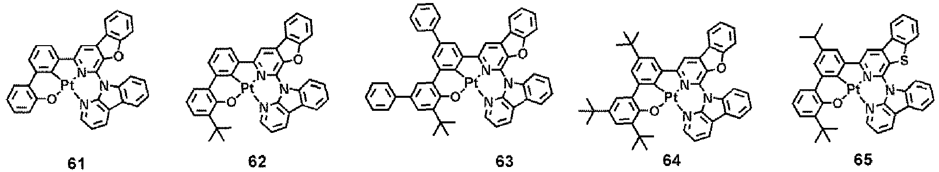

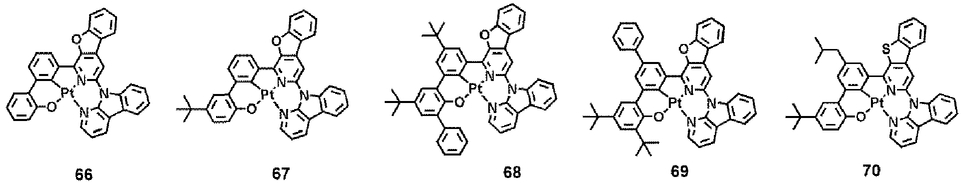

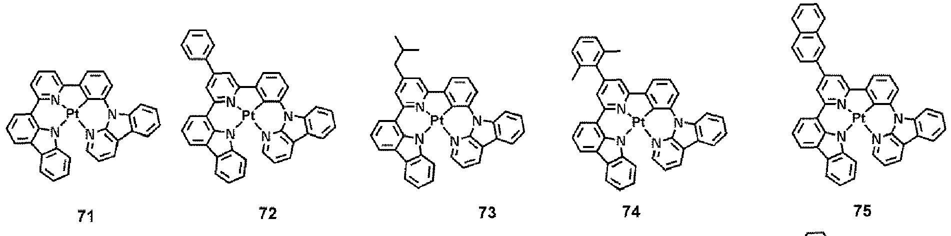

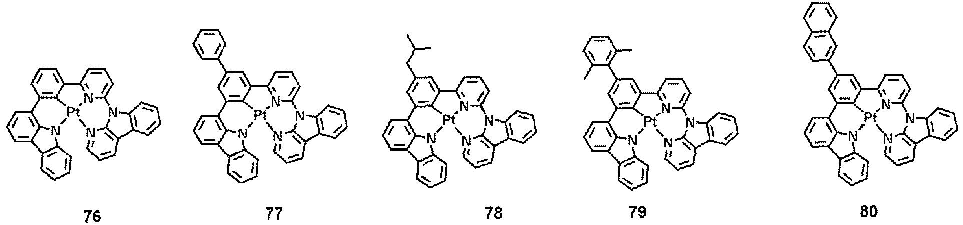

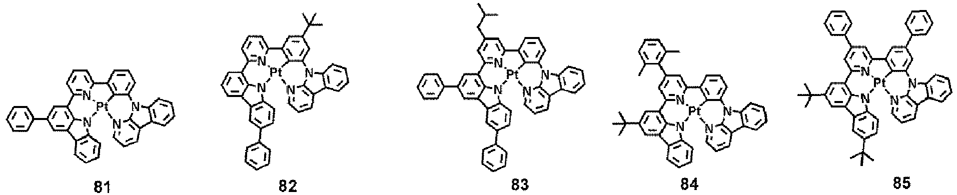

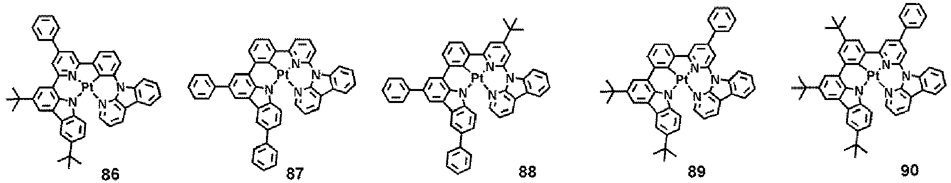

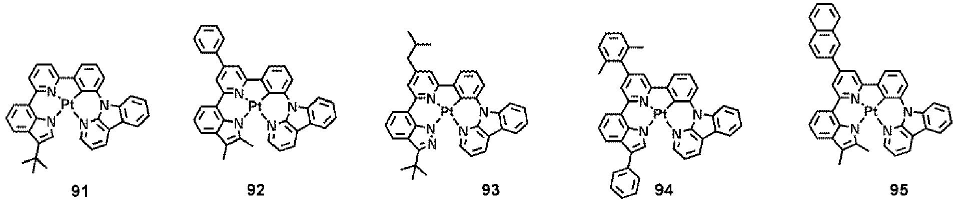

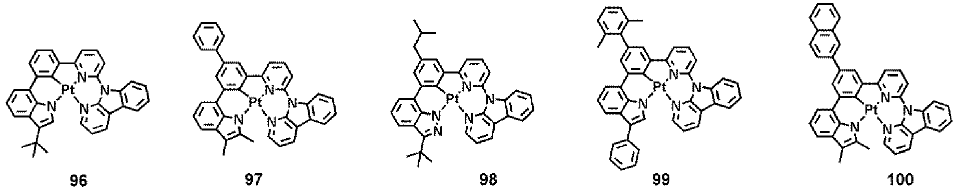

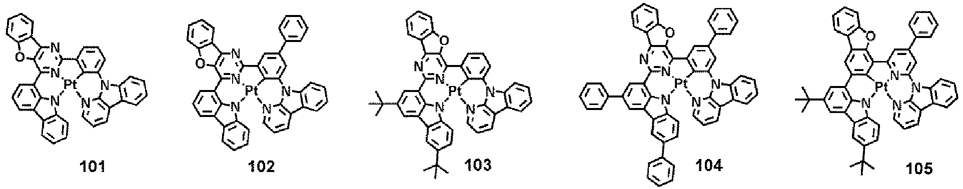

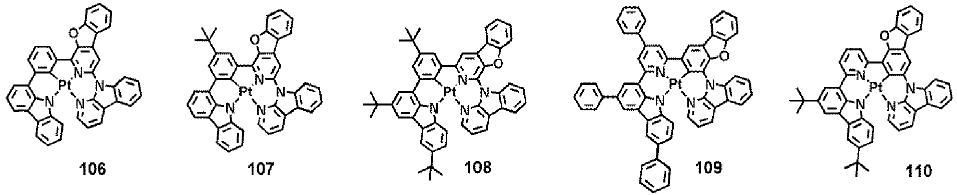

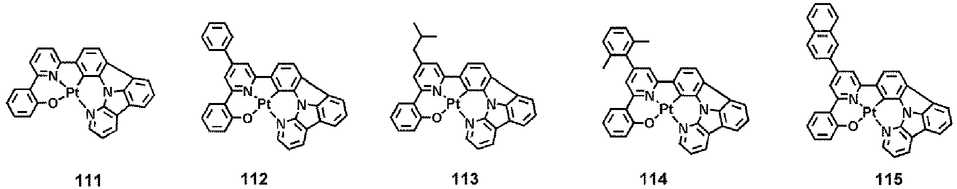

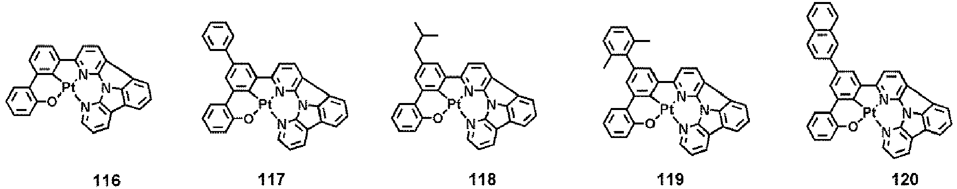

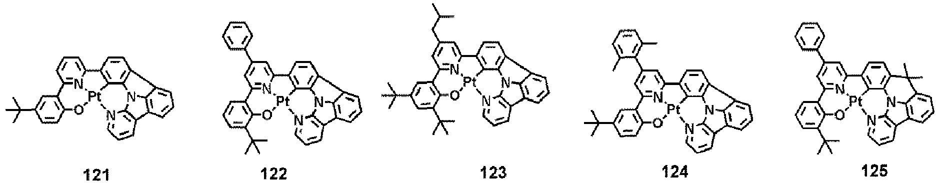

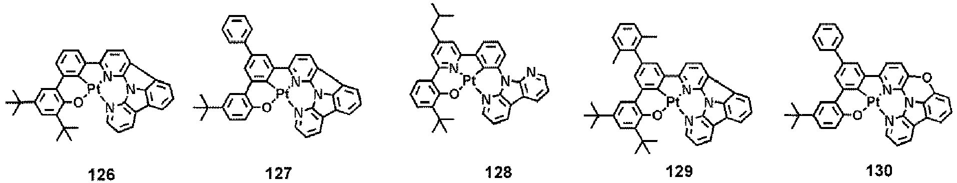

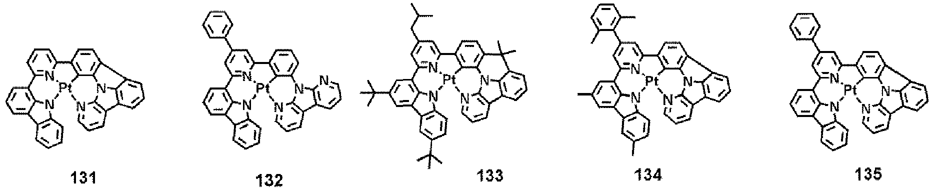

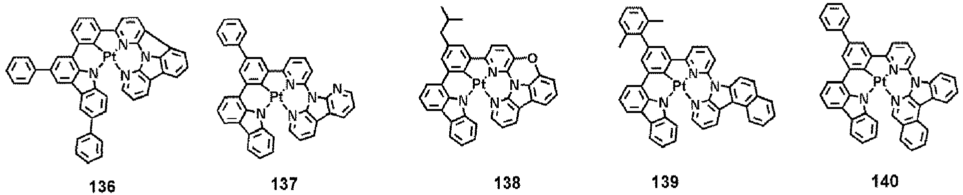

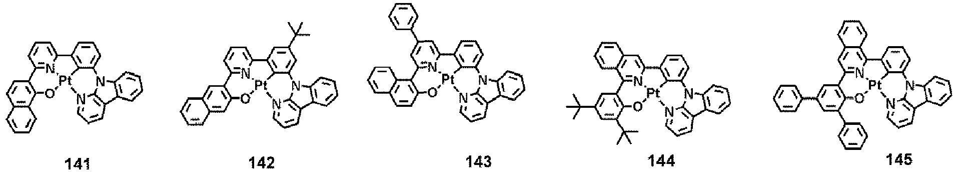

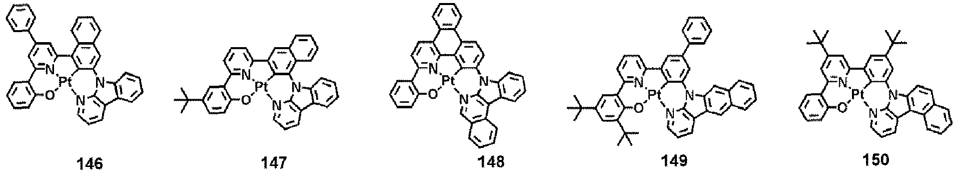

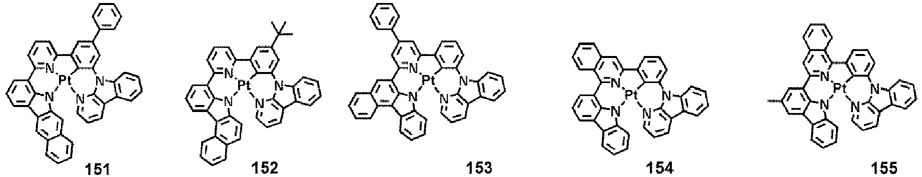

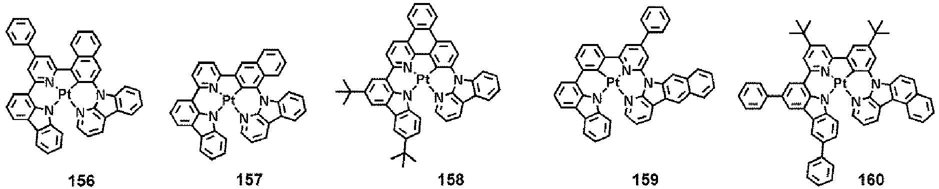

The sum of n3 and n4 in Formula 1 is 1 or 2, provided that a) when n3 is 0 and n4 is 1, X₄ may be N, b) when n3 is 1 and n4 is 0, X₃ may be N, and c) when n3 and n4 are each 1, at least one of X₃ and X₄ may be N. Accordingly, a four-coordinate ligand backbone in Formula 1 essentially includes a carboline group. Due to the carboline group, planarity of the organometallic compound represented by Formula 1 may be improved, and charge transfer characteristics may be improved. Thus, an electronic device, for example, an organic light-emitting device, which includes the organometallic compound, may have improved luminescence efficiency and/or lifespan characteristics.

In addition, since ring CY₂ and ring CY₃ in Formula 1 are linked via a single bond, rigidity of a molecular structure around a metal M in Formula 1 may be increased. Thus, full width at half maximum (FWHM) of a photoluminescence (PL) spectrum of the organometallic compound represented by Formula 1 and/or an electroluminescence (EL) spectrum of an electronic device (for example, an organic light-emitting device) including the organometallic compound represented by Formula 1 may be improved (for example, reduced). An electronic device, for example, an organic light-emitting device, which includes the organometallic compound, may have improved luminescence efficiency and/or lifespan characteristics.

For example, highest occupied molecular orbital (HOMO), lowest unoccupied molecular orbital (LUMO), and triplet (T₁) energy levels of some of the Compounds illustrated above were evaluated by using a DFT method of a Gaussian program (structurally optimized at a level of B3LYP, 6-31G(d,p)), and evaluation results thereof are shown in Table 1.

**Table 1**

| Compound No. | HOMO (eV) | LUMO (eV) | T₁ energy level (eV) |
|---|---|---|---|
| 1 | -4.81 | -1.74 | 2.31 |
| 3 | -4.65 | -1.73 | 2.40 |
| 20 | -4.75 | -1.50 | 2.21 |
| 85 | -4.43 | -1.87 | 1.86 |
| 103 | -4.66 | -2.18 | 1.78 |

From Table 1, it is apparent that the organometallic compound represented by Formula 1 has such electrical characteristics that are suitable for use in an electronic device, for example, for use as a dopant for an organic light-emitting device.

Synthesis methods of the organometallic compound represented by Formula 1 may be recognizable by those of ordinary skill in the art by referring to Synthesis Examples provided below.

The organometallic compound represented by Formula 1 is suitable for use in an organic layer of an organic light-emitting device, for example, for use as a dopant in an emission layer of the organic layer.

Thus, another embodiment provides an organic light-emitting device that includes:
a first electrode;
a second electrode; and
an organic layer that is disposed between the first electrode and the second electrode,
wherein the organic layer includes an emission layer and at least one organometallic compound represented by Formula 1.

The organic light-emitting device may have, due to the inclusion of an organic layer including the organometallic compound represented by Formula 1, a low driving voltage, high efficiency, high power, high quantum efficiency, a long lifespan, a low roll-off ratio, and excellent color purity.

The organometallic compound of Formula 1 may be used between a pair of electrodes of an organic light-emitting device. For example, the organometallic compound represented by Formula 1 may be included in the emission layer. In this embodiment, the organometallic compound may act as a dopant, and the emission layer may further include a host (that is, an amount of the organometallic compound represented by Formula 1 is smaller than an amount of the host).

The expression "(an organic layer) includes at least one of organometallic compounds" as used herein may include an embodiment in which "(an organic layer) includes identical organometallic compounds represented by Formula 1" and an embodiment in which "(an organic layer) includes two or more different organometallic compounds represented by Formula 1."

For example, the organic layer may include, as the organometallic compound, only Compound 1. In this embodiment, Compound 1 may be included in an emission layer of the organic light-emitting device. In one or more embodiments, the organic layer may include, as the organometallic compound, Compound 1 and Compound 2. In this embodiment, Compound 1 and Compound 2 may be included in an identical layer (for example, Compound 1 and Compound 2 all may be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In an embodiment, in the organic light-emitting device, the first electrode is an anode, and the second electrode is a cathode, and the organic layer further includes a hole transport region disposed between the first electrode and the emission layer and an electron transport region disposed between the emission layer and the second electrode, wherein the hole transport region includes a hole injection layer, a hole transport layer, an electron blocking layer, or any combination thereof, and wherein the electron transport region includes a hole blocking layer, an electron transport layer, an electron injection layer, or any combination thereof.

The term "organic layer" as used herein refers to a single layer and/or a plurality of layers between the first electrode and the second electrode of the organic light-emitting device. The "organic layer" may include, in addition to an organic compound, an organometallic complex including metal.

The FIGURE is a schematic view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide (SnO₂), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer, a hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100°C to about 500°C, a vacuum pressure of about 1.33 × 10⁻⁶ Pa (10⁻⁸ torr) to about 0.133 Pa (10⁻³ torr), and a deposition rate of about 0.01 Angstroms per second (Å/sec) to about 0 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below:

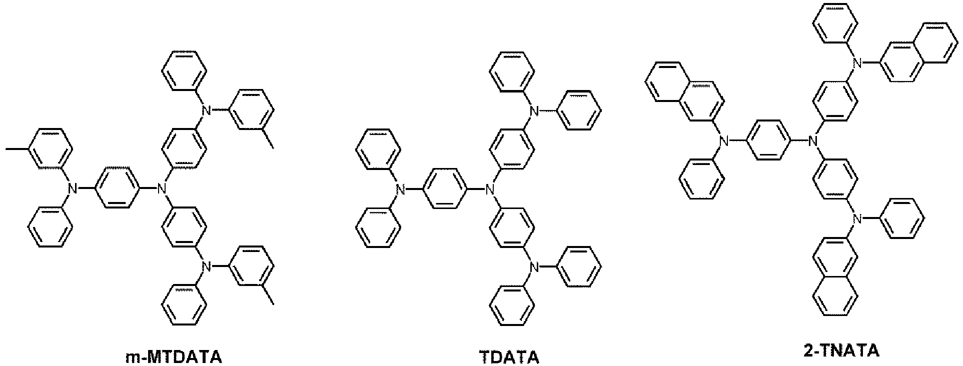

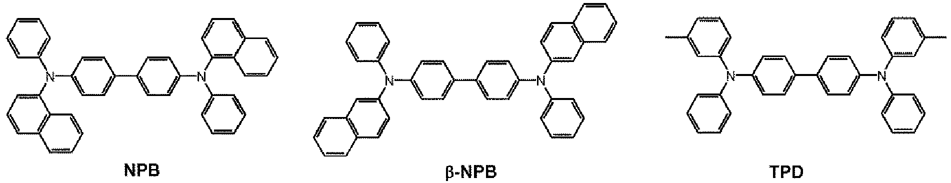

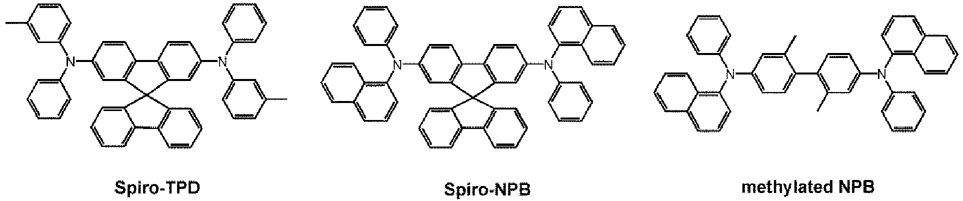

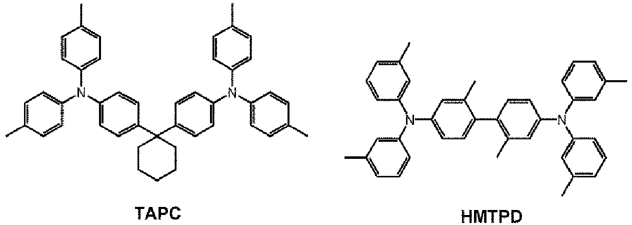

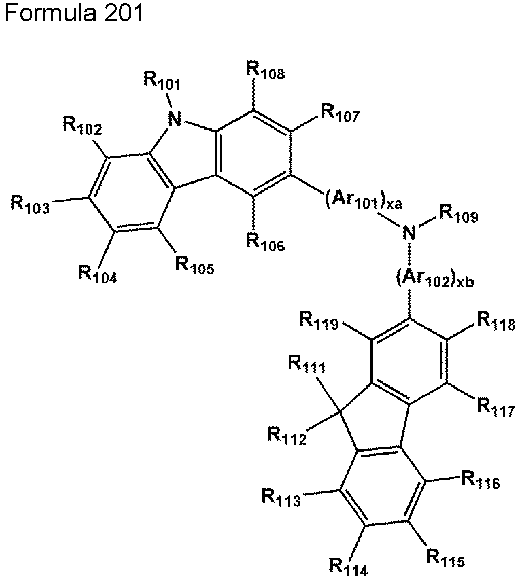

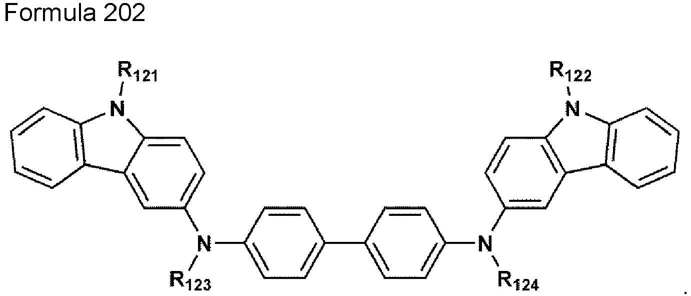

Ar₁₀₁ and Ar₁₀₂ in Formula 201 may each independently be selected from:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

In Formula 201, xa and xb may each independently be an integer from 0 to 5, or may each independently be 0, 1, or 2. For example, xa is 1 and xb is 0, but xa and xb are not limited thereto.

R₁₀₁ to R₁₀₈, R₁₁₁ to R₁₁₉, and R₁₂₁ to R₁₂₄ in Formula 201 and 202 may each independently be selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, and so on), and a C₁-C₁₀ alkoxy group (for example, a methoxy group, an ethoxy group, a propoxy group, a butoxy group, a pentoxy group, and so on);
a C₁-C₁₀ alkyl group and a C₁-C₁₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, and a C₁-C₁₀ alkoxy group,
but embodiments of the present disclosure are not limited thereto. R₁₀₉ in Formula 201 may be selected from:
   a phenyl group, a naphthyl group, an anthracenyl group, and a pyridinyl group; and
   a phenyl group, a naphthyl group, an anthracenyl group, and a pyridinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, and a pyridinyl group.

In an embodiment, the compound represented by Formula 201 may be represented by Formula 201A, but embodiments of the present disclosure are not limited thereto:

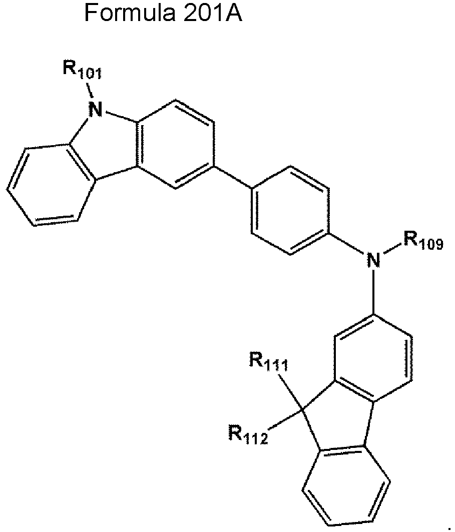

R₁₀₁, R₁₁₁, R₁₁₂, and R₁₀₉ in Formula 201A may be understood by referring to the description provided herein.

For example, the compound represented by Formula 201, and the compound represented by Formula 202 may include compounds HT1 to HT20 illustrated below, but are not limited thereto.

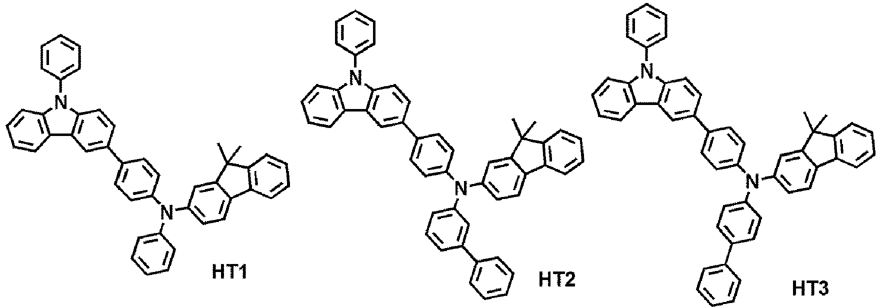

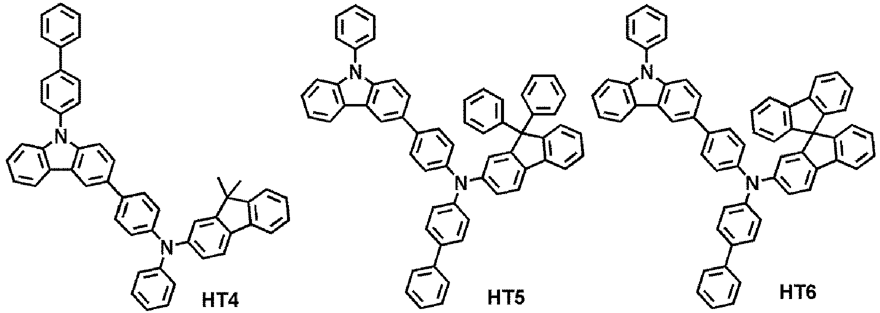

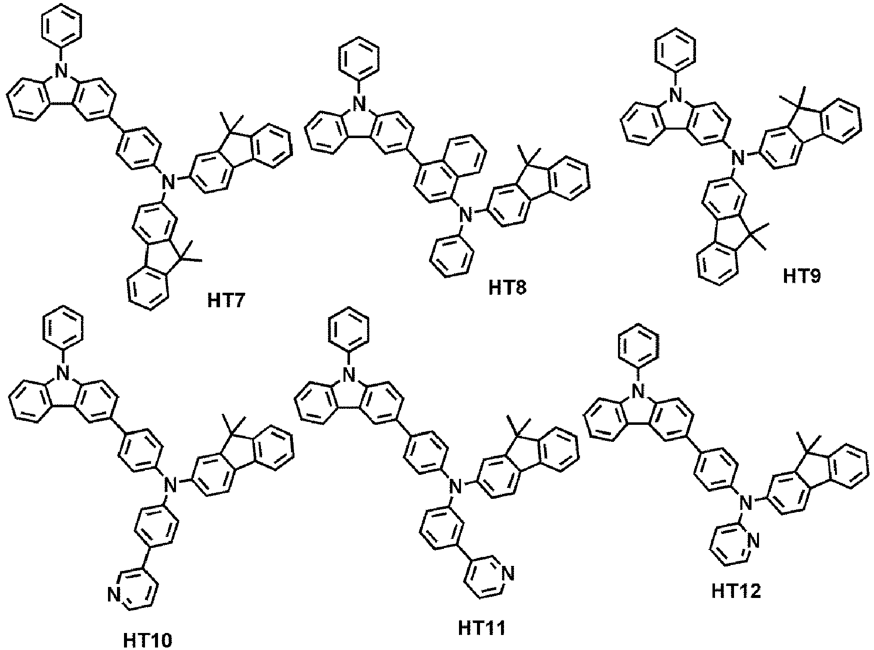

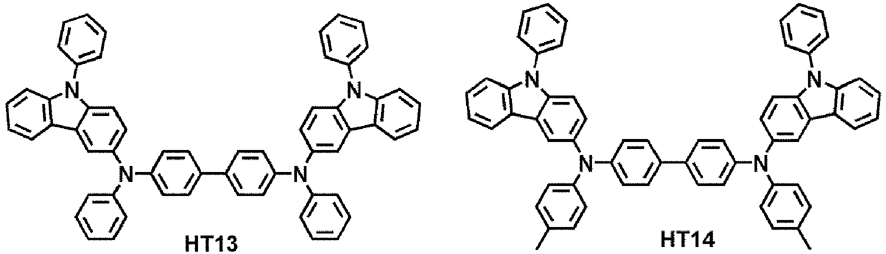

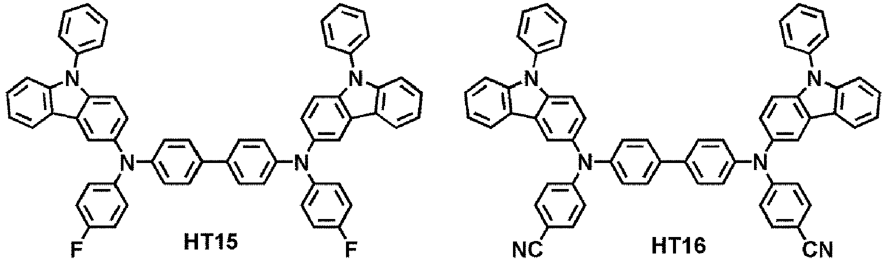

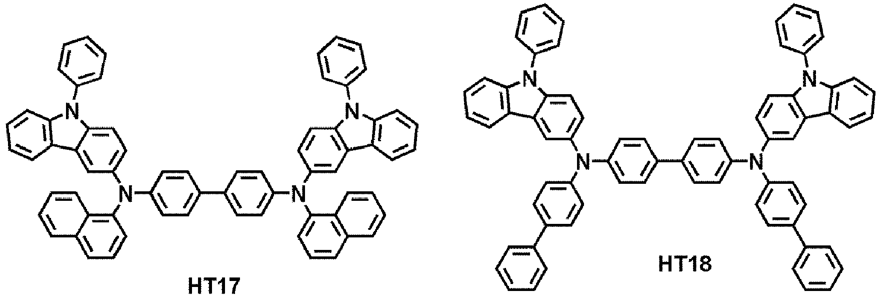

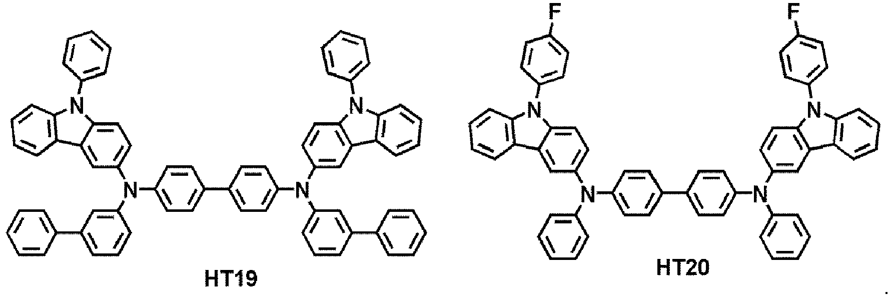

A thickness of the hole transport region may be in a range of about 100 Angstroms (Å) to about 10,000 Å, for example, about 100 Å to about 1,000 Å. When the hole transport region includes at least one of a hole injection layer and a hole transport layer, the thickness of the hole injection layer may be in a range of about 100 Å to about 10,000 Å, for example, about 100 Å to about 1,000 Å, and the thickness of the hole transport layer may be in a range of about 50 Å to about 2,000 Å, for example, about 100 Å to about 1,500 Å. While not wishing to be bound by theory, it is understood that when the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto:

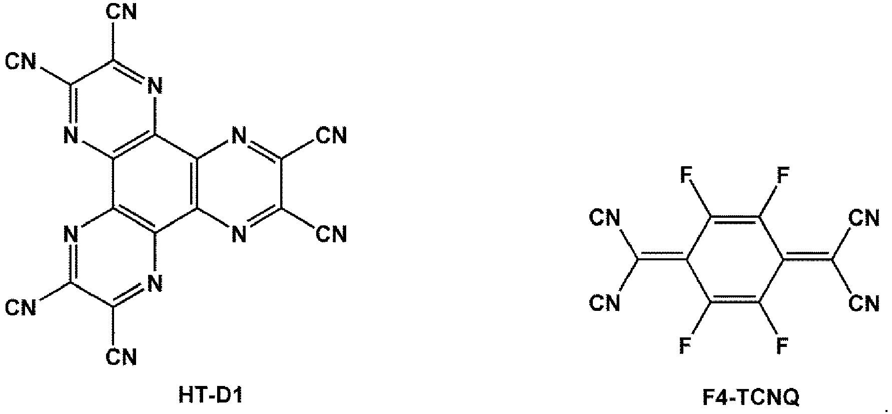

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary depending on a compound that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1.

The host may include at least one selected from TPBi, TBADN, ADN (also referred to as "DNA"), CBP, CDBP, TCP, mCP, Compound H50, and Compound H51:

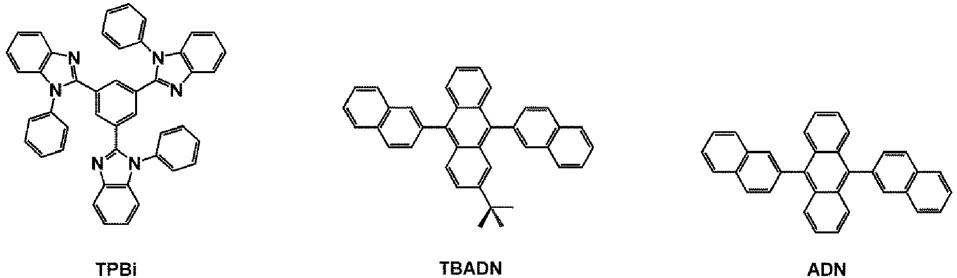

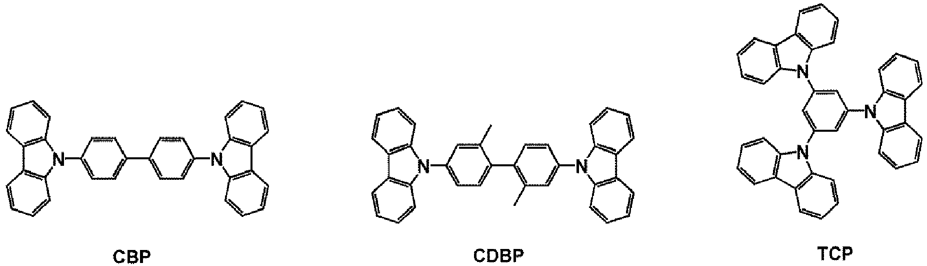

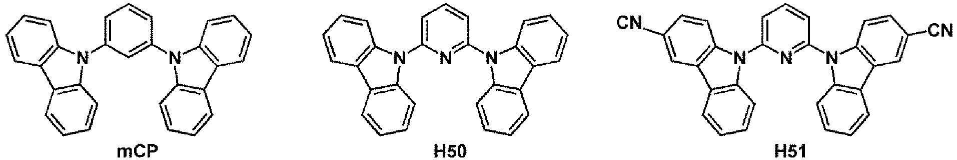

In one or more embodiments, the host may further include a compound represented by Formula 301 below:

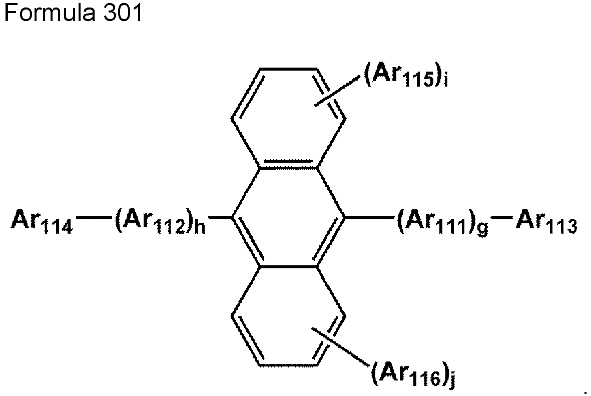

Ar₁₁₁ and Ar₁₁₂ in Formula 301 may each independently be selected from:
a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

Ar₁₁₃ to Ar₁₁₆ in Formula 301 may each independently be selected from:
a C₁-C₁₀ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

g, h, i, and j in Formula 301 may each independently be an integer from 0 to 4, and may each independently be, for example, 0, 1, or 2.

Ar₁₁₃ to Ar₁₁₆ in Formula 301 may each independently be selected from:
a C₁-C₁₀ alkyl group substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a phenyl group, a naphthyl group, an anthracenyl group, a pyrenyl group, a phenanthrenyl group, and a fluorenyl group; and 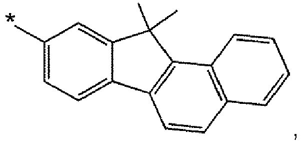
but embodiments of the present disclosure are not limited thereto.

In one or more embodiments, the host may include a compound represented by Formula 302 below:

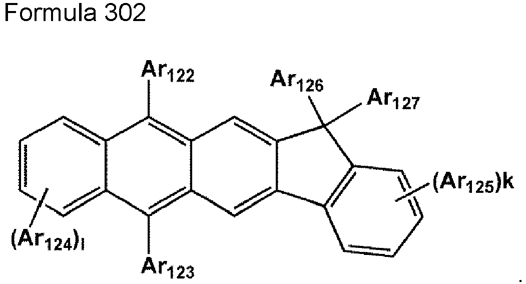

Ar₁₂₂ to Ar₁₂₅ in Formula 302 are the same as described in detail in connection with Ar₁₁₃ in Formula 301.

Ar₁₂₆ and Ar₁₂₇ in Formula 302 may each independently be a C₁-C₁₀ alkyl group (for example, a methyl group, an ethyl group, or a propyl group).

k and I in Formula 302 may each independently be an integer from 0 to 4. For example, k and I may be 0, 1, or 2.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAIq but embodiments of the present disclosure are not limited thereto:

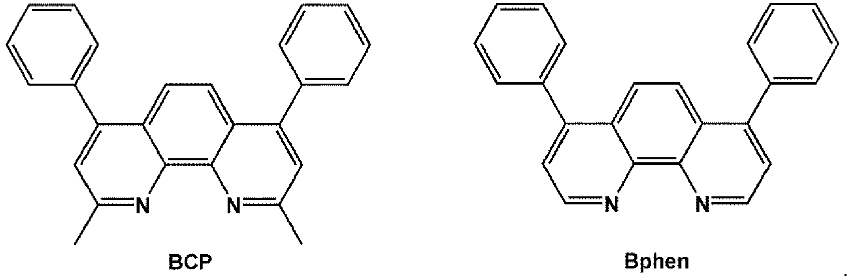

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have improved hole blocking ability without a substantial increase in driving voltage.

The electron transport layer may further include at least one selected from BCP, Bphen, Alq₃, BAIq, TAZ, and NTAZ:

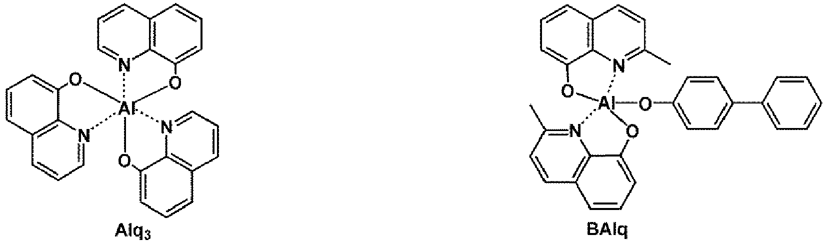

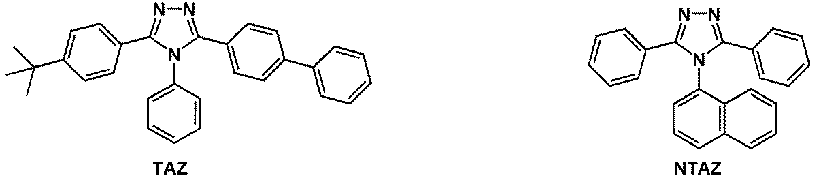

In one or more embodiments, the electron transport layer may include at least one of ET1 and ET25, but are not limited thereto:

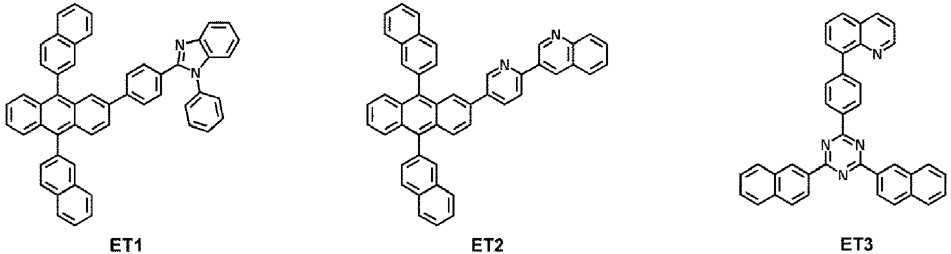

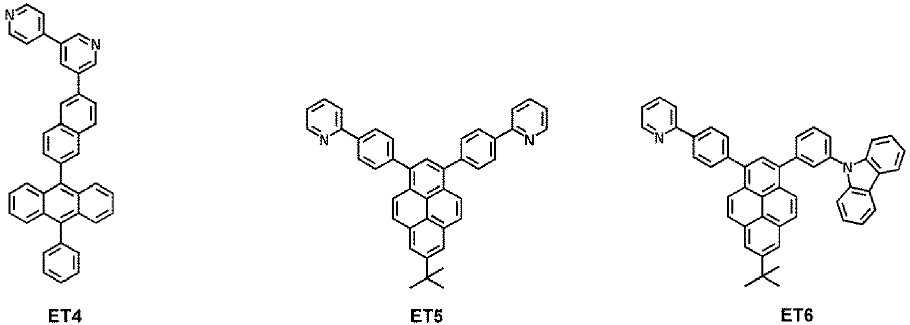

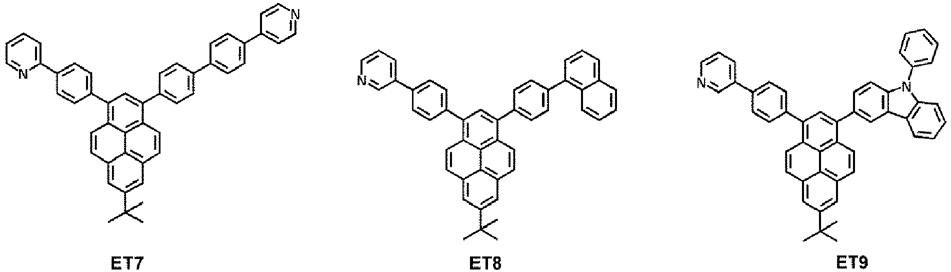

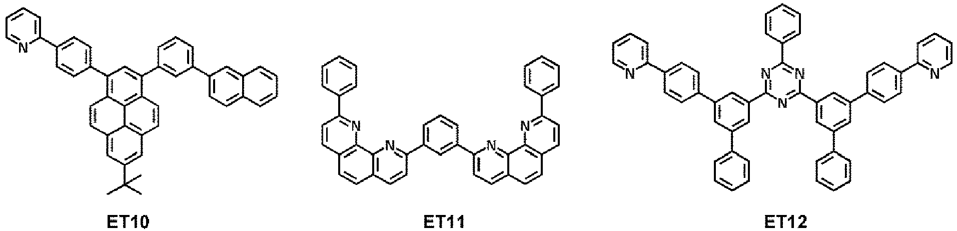

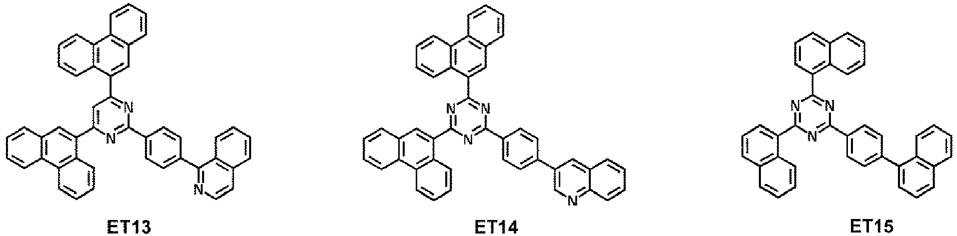

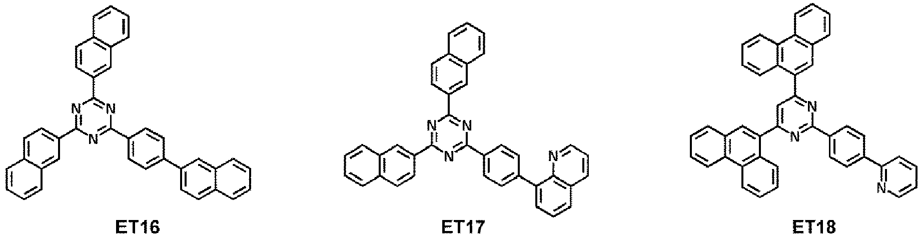

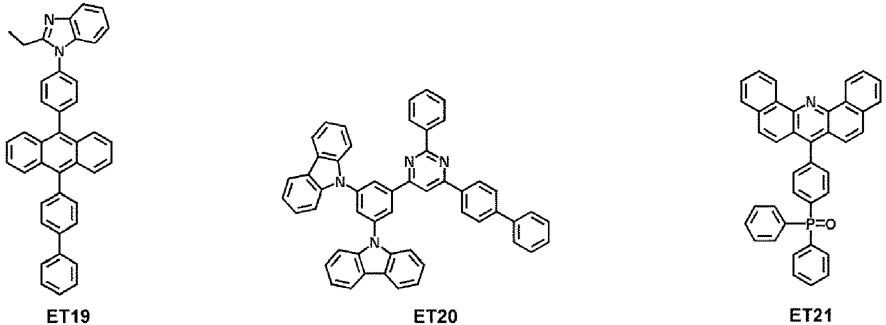

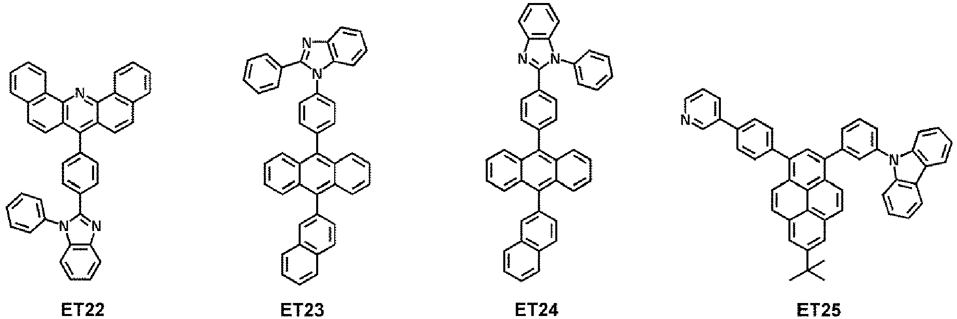

A thickness of the electron transport layer may be in a range of about 100 Å to about 1,000 Å, for example, about 150 Å to about 500 Å. While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium quinolate, LiQ) or ET-D2:

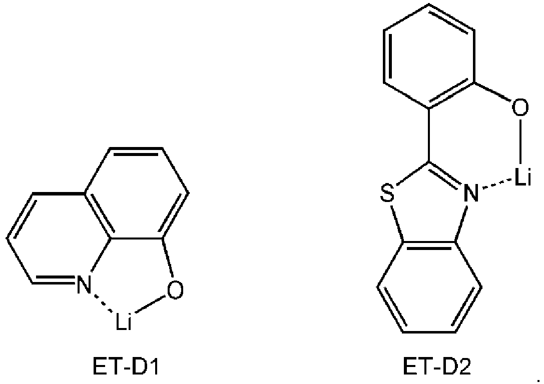

The electron transport region may include an electron injection layer that promotes flow of electrons from the second electrode 19 thereinto.

The electron injection layer may include at least one selected from LiF, NaCl, CsF, Li₂O, and BaO.

A thickness of the electron injection layer may be in a range of about 1 Å to about 100 Å, for example, about 3 Å to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to the FIGURE, but embodiments of the present disclosure are not limited thereto.

Another aspect of the present disclosure provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbon monovalent group having 1 to 60 carbon atoms, and non-limiting examples thereof include a methyl group, an ethyl group, a propyl group, an iso-butyl group, a sec-butyl group, a tert-butyl group, a pentyl group, an iso-amyl group, and a hexyl group. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and non-limiting examples thereof include a methoxy group, an ethoxy group, and an iso-propyloxy group.

The term "C₂-C₆₀ alkenyl group" as used herein refers to a hydrocarbon group formed by including at least one carbon-carbon double bond in the middle or at the terminus of the C₂-C₆₆ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by including at least one carbon-carbon triple bond in the middle or at the terminus of the C₂-C₆₆ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and that has no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The term "C₁-C₆₀ heteroaryl group" as used herein refers to a monovalent group having a carbocyclic aromatic system that has at least one heteroatom selected from N, O, P, Si, and S as a ring-forming atom, and 1 to 60 carbon atoms. The term "C₁-C₆₀ heteroarylene group" as used herein refers to a divalent group having a carbocyclic aromatic system that has at least one heteroatom selected from N, O, P, and S as a ring-forming atom, and 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

The term "C₆-C₆₀ aryloxy group" as used herein indicates -OA₁₀₂ (wherein A₁₀₂ is the C₆-C₆₀ aryl group), and a C₆-C₆₀ arylthio group as used herein indicates -SA₁₀₃ (wherein A₁₀₃ is the C₆-C₆₀ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and having no aromaticity in its entire molecular structure. Examples of the monovalent non-aromatic condensed polycyclic group include a fluorenyl group. The term "divalent non-aromatic condensed polycyclic group," as used herein, refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and having no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group.

The term "C₁-C₃₀ heterocyclic group" as used herein refers to a saturated or unsaturated cyclic group having, as a ring-forming atom, at least one heteroatom selected from N, O, Si, P, and S other than 1 to 30 carbon atoms. The C₁-C₃₀ heterocyclic group may be a monocyclic group or a polycyclic group.

At least one substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be selected from:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and - P(=O)(Q₂₆)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉), and
Q1 to Q9, Q11 to Q19, Q21 to Q29, and Q31 to Q39 may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

When a group containing a specified number of carbon atoms is substituted with any of the groups listed in the preceding paragraph, the number of carbon atoms in the resulting "substituted" group is defined as the sum of the carbon atoms contained in the original (unsubstituted) group and the carbon atoms (if any) contained in the substituent. For example, when the term "substituted C1-C30 alkyl" refers to a C1-C30 alkyl group substituted with C6-C30 aryl group, the total number of carbon atoms in the resulting aryl substituted alkyl group is C7-C60.

Hereinafter, a compound and an organic light-emitting device according to embodiments are described in detail with reference to Synthesis Examples and Examples. However, the organic light-emitting device is not limited thereto. The wording "B was used instead of A" used in describing Synthesis Examples means that an amount of A used was identical to an amount of B used, in terms of a molar equivalent.

### EXAMPLES

### Synthesis Example 1: Synthesis of Compound 3

### Synthesis of Intermediate P2

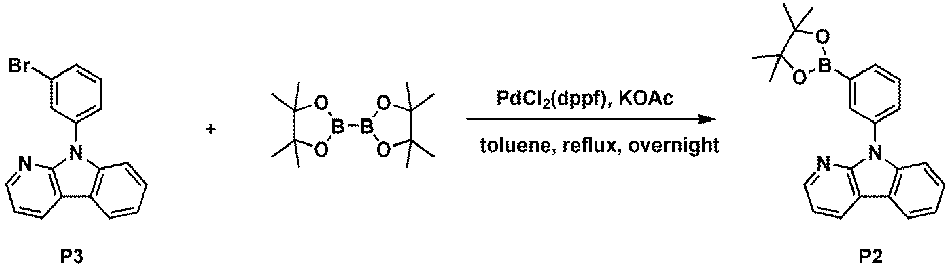

2.2 grams, g (6.8 millimoles, mmol) of Compound P3, 3.4 g (13.5 mmol) of 4,4,4',4',5,5,5',5'-octamethyl-2,2'-bi(1,3,2-dioxaborolane), 0.50 g (0.7 mmol) of PdCl₂(dppf), 1.99 g (20.3 mmol) of potassium acetate, and 150 milliliters (mL) of toluene were mixed and stirred under reflux for 18 hours. After the reaction had been complete, the reaction product was cooled to room temperature. The organic layer was extracted therefrom with methylene chloride (MC), dried with anhydrous magnesium sulfate (MgSO₄), and filtered to obtain a filtrate. The filtrate was then distilled under reduced pressure. The residue obtained therefrom was purified by column chromatography with ethyl acetate (EA):hexane as an eluent to obtain 2.23 g (89%) of Intermediate P2.

### Synthesis of Ligand 3L

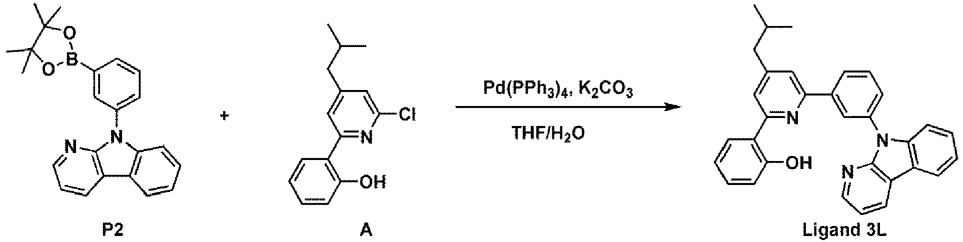

1.7 g (6.3 mmol) of material A, 2.23 g (6.0 mmol) of Intermediate P2, 0.5 g (0.4 mmol) of Pd(PPh₃)₄, 2.5 g (18.1 mmol) of K₂CO₃, 60 mL of tetrahydrofuran (THF), and 20 mL of distilled water were mixed and stirred under reflux for 12 hours. After the resultant mixture was cooled to room temperature, the organic layer was extracted therefrom with MC, dried with anhydrous magnesium sulfate (MgSO₄), and filtered to obtain a filtrate. The filtrate was then distilled under reduced pressure. The residue obtained therefrom was purified by column chromatography with MC:hexane as an eluent to obtain 1.8 g (64%) of Ligand 3L.

### Synthesis of Compound 3

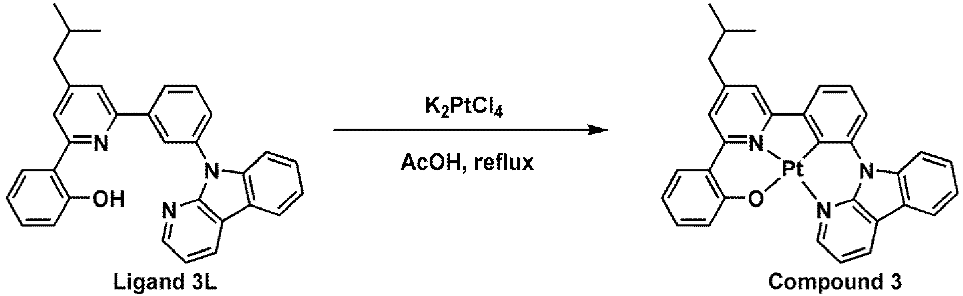

0.9 g (1.9 mmol) of Ligand 3L, 1.0 g (2.18 mmol) of K₂PtCl₄, and 50 mL of acetic acid were mixed and stirred under reflux for 18 hours. After the reaction had been complete, the reaction product was cooled. The solid obtained therefrom was filtered, and purified by column chromatography with MC:hexane as an eluent to obtain 0.4 g (32%) of Compound 3. The obtained product was identified by Mass and HPLC analysis.

HRMS (MALDI) calcd for C₃₂H₂₅N₃OPt: m/z 662.1645, Found: 662.1650.

### Synthesis Example 2 : Synthesis of Compound 86

### Synthesis of Ligand 86L

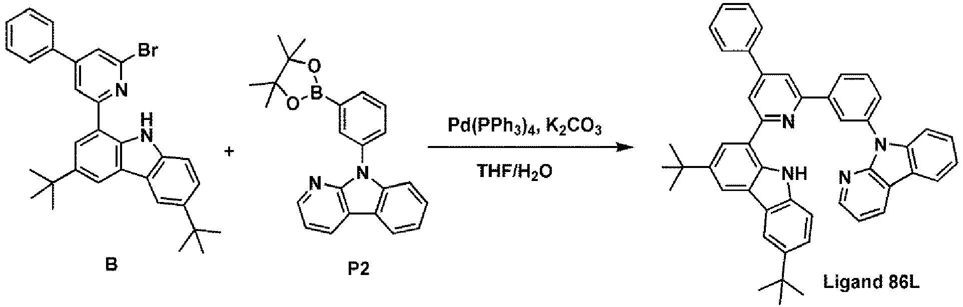

2.4 g (4.7 mmol) of material B, 1.6 g (4.5 mmol) of Intermediate P2, 0.4 g (0.3 mmol) of Pd(PPh₃)₄, 1.8 g (13.3 mmol) of K₂CO₃, 90 mL of THF, and 30 mL of distilled water were mixed and stirred under reflux for 12 hours. After the resultant mixture was cooled to room temperature, the organic layer was extracted therefrom with MC, dried with anhydrous magnesium sulfate (MgSO₄), and filtered to obtain a filtrate. The filtrate was then distilled under reduced pressure. The residue obtained therefrom was purified by column chromatography with MC:hexane as an eluent to obtain 2.3 g (77%) of Ligand 86L.

### Synthesis of Compound 86

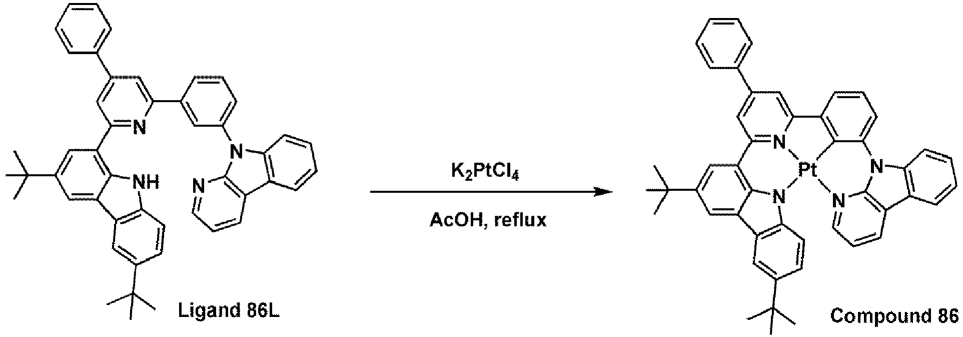

2.6 g (3.9 mmol) of Ligand 86L and 2.0 g (4.3 mmol) of K₂PtCl₄ were mixed with 100 mL of acetic acid and then stirred under reflux for 18 hours. After the reaction had been complete, the reaction product was cooled. The solid obtained therefrom was filtered, and purified by column chromatography with MC:hexane as an eluent to obtain 0.9 g (32%) of Compound 86. The obtained product was identified by Mass and HPLC analysis.

HRMS (MALDI) calcd for C₄₈H₄₀N₄Pt: m/z 867.2901, Found: 867.2904.

### Comparative Synthesis Example 1 : Synthesis of Compound A

### Synthesis of Ligand AL

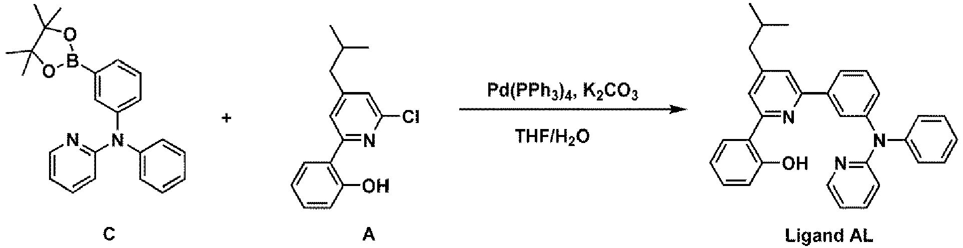

1.7 g (6.7 mmol) of material A, 2.4 g (6.4 mmol) of material C, 0.5 g (0.5 mmol) of Pd(PPh₃)₄, 2.6 g (19.1 mmol) of K₂CO₃, 90 mL of THF, and 30 mL of distilled water were mixed and stirred under reflux for 12 hours. After the resultant mixture was cooled to room temperature, the organic layer was extracted therefrom with MC, dried with anhydrous magnesium sulfate (MgSO₄), and filtered to obtain a filtrate. The filtrate was then distilled under reduced pressure. The residue obtained therefrom was purified by column chromatography with MC:hexane as an eluent to obtain 2.1 g (70%) of Ligand AL.

### Synthesis of Compound A

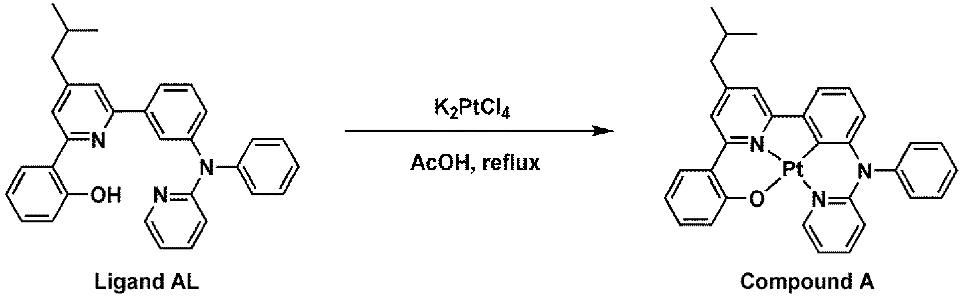

1.4 g (3.0 mmol) of Ligand AL and 1.6 g (3.3 mmol) of K₂PtCl₄ were mixed with 100 mL of acetic acid and stirred under reflux for 18 hours. After the reaction had been complete, the reaction product was cooled. The solid obtained therefrom was filtered, and purified by column chromatography with MC:hexane as an eluent to obtain 0.7 g (35%) of Compound A. The obtained product was identified by Mass and HPLC analysis.

HRMS (MALDI) calcd for C₃₂H₂₇N₃OPt: m/z 664.1802, Found: 664.1798.

### Example 1

As an anode, a glass substrate, on which ITO/Ag/ITO were respectively deposited to thicknesses of 70 Å/1,000 Å/70 Å, was cut to a size of 50 mm x 50 mm x 0.5 mm (mm = millimeter), sonicated with iso-propyl alcohol and pure water each for 5 minutes, and then cleaned by exposure to ultraviolet rays and ozone for 30 minutes. Then, the resultant glass substrate was provided to a vacuum deposition apparatus.

2-TNATA was deposited on the anode to form a hole injection layer having a thickness of 600 Å, and 4,4'-bis[N-(1-naphthyl)-N-phenylamino]biphenyl (NPB) was deposited on the hole injection layer to form a hole transport layer having a thickness of 1,350 Å.

CBP (host) and Compound 3 (dopant) were co-deposited on the hole transport layer at a weight ratio of 90:10 to form an emission layer having a thickness of 400 Å, and BCP was deposited on the emission layer to form a hole blocking layer having a thickness of 50 Å. Then, Alq₃ was deposited on the hole blocking layer to form an electron transport layer having a thickness of 350 Å, LiF was deposited on the electron transport layer to form an electron injection layer having a thickness of 10 Å, and MgAg was deposited on the electron injection layer at a weight ratio of 90:10 to form a cathode having a thickness of 120 Å, thereby completing the manufacture of an organic light-emitting device (emitting red light) having a structure of ITO/Ag/ITO / 2-TNATA (600 Å) / NPB (1,350 Å) / CBP + Compound 3 (10 wt%) (400 Å) / BCP (50 Å) / Alq₃ (350 Å) / LiF (10 Å) / MgAg (120 Å).

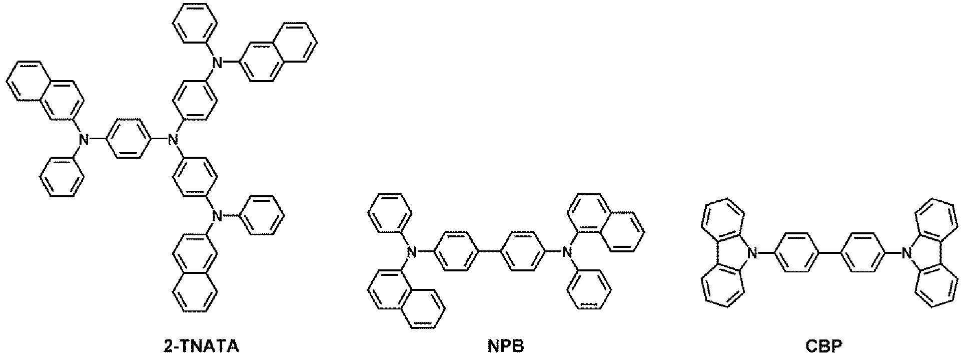

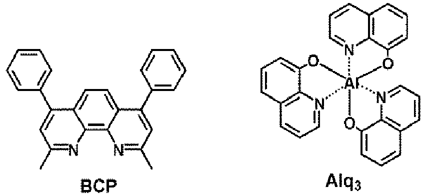

### Example 2 and Comparative Example A

Organic light-emitting devices were manufactured in the same manner as in Example 1, except that Compounds shown in Table 2 were used instead of Compound 3 as a dopant in forming an emission layer.

### Evaluation Example 3: Evaluation of characteristics of organic light-emitting devices.

The driving voltage, maximum photoluminescence quantum yield, and lifespan (T₉₇) of the organic light-emitting devices manufactured according to Examples 1 and 2 and Comparative Example A were evaluated, and evaluation results thereof are shown in Table 2. This evaluation was performed by using a current-voltage meter (Keithley 2400) and a luminance meter (Minolta Cs-1000A). The lifespan (T₉₇) indicates an amount of time (hr) that lapsed when luminance was 97% of initial luminance (100%). The maximum photoluminescence quantum yield and the lifespan (T₉₇) are relative values with respect to those of the organic light-emitting device of Example 1.

**Table 2**

| | Dopant | Driving voltage (V) | Maximum photoluminescence quantum yield (%) (relative value) | T₉₇ (%) (relative value) |
|---|---|---|---|---|
| Example 1 | Compound 3 | 4.29 | 100% | 100% |
| Example 2 | Compound 86 | 4.21 | 97% | 90% |
| Comparative Example A | Compound A | 4.20 | 87% | 10% |

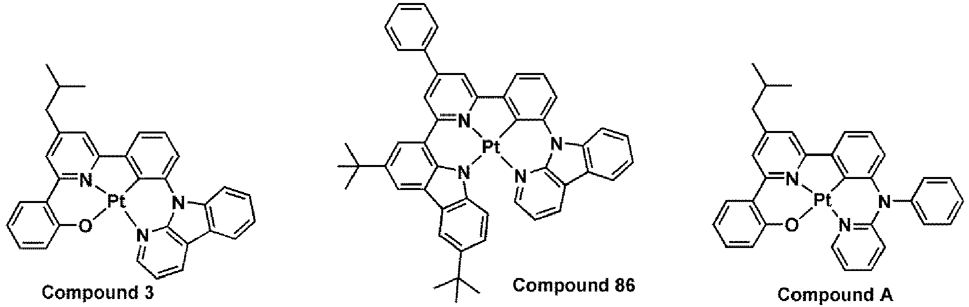

Referring to Table 2, it is confirmed that the organic light-emitting devices of Examples 1 and 2 have improved characteristics, as compared with those of the organic light-emitting device of Comparative Example A.

Since the organometallic compounds have excellent electrical characteristics and thermal stability, organic light-emitting devices including such organometallic compounds may have excellent driving voltage, efficiency, power, color purity, and lifespan characteristics. Also, due to excellent phosphorescent luminescence characteristics, such organometallic compounds may provide a diagnostic composition having high diagnostic efficiency.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present disclosure as defined by the following claims.

## Claims

1. An organometallic compound represented by Formula 1: 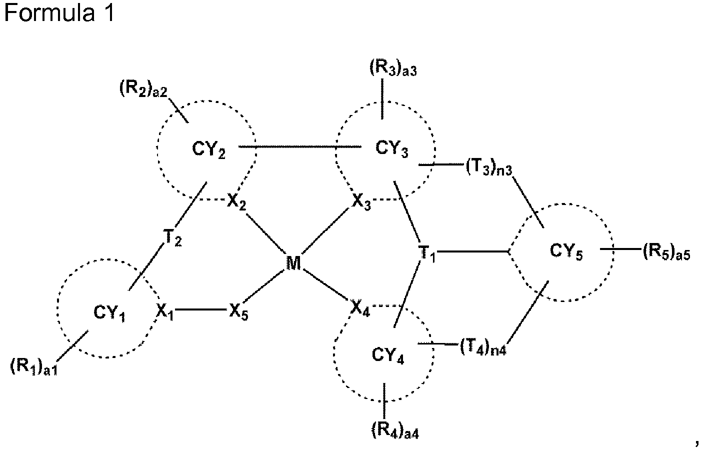 wherein, in Formula 1,
M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),
X₁ to X₄ are each independently N or C,
X₅ is a single bond, O, S, B(R'), N(R'), P(R'), C(R')(R"), Si(R')(R"), Ge(R')(R"), C(=O), B(R')(R"), N(R')(R"), or P(R')(R"),
two bonds selected from a bond between X₁ or X₅ and M, a bond between X₂ and M, a bond between X₃ and M, and a bond between X₄ and M are each a covalent bond, and the other bonds selected from a bond between X₁ or X₅ and M, a bond between X₂ and M, a bond between X₃ and M, and a bond between X₄ and M are each a coordinate bond,
CY₁ to CY₅ are each independently a C₅-C₃₀ carbocyclic group or a C₁-C₃₀ heterocyclic group,
T₁ is B, N, or P,
T₂ to T₄ are each independently selected from a single bond, a double bond, *-N(R₇)-*', *-B(R₇)-*', *-P(R₇)-*', *-C(R₇)(R₈)-*', *-Si(R₇)(R₈)-*', *-Ge(R₇)(R₈)-*', "-S-*', *-Se-*', *-O-*', *-C(=O)-*', *-S(=O)-*', *-S(=O)₂-*', *-C(R₇)=*', *=C(R₇)-*', *-C(R₇)=C(R₈)-*', *-C(=S)-*', and *-C=C-*', and * and *' each indicate a binding site to a neighboring atom,
R₇ and R₈ are optionally linked via a single bond, a double bond, or a first linking group to form a substituted or unsubstituted C₅-C₃₀ carbocyclic group or a substituted or unsubstituted C₁-C₃₀ heterocyclic group,
n3 and n4 are each independently 0 or 1, wherein, when n3 is 0, T₃ does not exist and CY₃ and CY₅ are not linked to each other, and when n4 is 0, T₄ does not exist and CY₄ and CY₅ are not linked to each other,
the sum of n3 and n4 is 1 or 2, provided that a) when n3 is 0 and n4 is 1, X₄ is N, b) when n3 is 1 and n4 is 0, X₃ is N, and c) when n3 and n4 are 1, at least one of X₃ and X₄ is N,
R₁ to R₅, R', R", R₇, and R₈ are each independently selected from hydrogen, deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and - P(=O)(Q₈)(Q₉),
a1 to a5 are each independently an integer from 0 to 20,
two of a plurality of neighboring groups R₁ are optionally linked to form a substituted or unsubstituted C₅-C₃₀ carbocyclic group or a substituted or unsubstituted C₁-C₃₀ heterocyclic group,
two of a plurality of neighboring groups R₂ are optionally linked to form a substituted or unsubstituted C₅-C₃₀ carbocyclic group or a substituted or unsubstituted C₁-C₃₀ heterocyclic group,
two of a plurality of neighboring groups R₃ are optionally linked to form a substituted or unsubstituted C₅-C₃₀ carbocyclic group or a substituted or unsubstituted C₁-C₃₀ heterocyclic group,
two of a plurality of neighboring groups R₄ are optionally linked to form a substituted or unsubstituted C₅-C₃₀ carbocyclic group or a substituted or unsubstituted C₁-C₃₀ heterocyclic group,
two of a plurality of neighboring groups R₅ are optionally linked to form a substituted or unsubstituted C₅-C₃₀ carbocyclic group or a substituted or unsubstituted C₁-C₃₀ heterocyclic group,
two or more neighboring groups selected from R₁ to R₃ are optionally linked to form a substituted or unsubstituted C₅-C₃₀ carbocyclic group or a substituted or unsubstituted C₁-C₃₀ heterocyclic group,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is selected from:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, - F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉), and
Q₁ to Q9, Q11 to Q19, Q21 to Q29, and Q31 to Q39 are each independently selected from hydrogen, deuterium, -F, -Cl, -Br, -I, a hydroxyl group, a cyano group,
a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₁-C₆₀ alkyl group substituted with at least one selected from deuterium, a C₁-C₆₀ alkyl group, and a C₆-C₆₀ aryl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from deuterium, a C₁-C₆₀ alkyl group, and a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group.

2. The organometallic compound of claim 1, wherein
a bond between X₁ or X₅ and M and a bond between X₃ and M are each a covalent bond, and a bond between X₂ and M and a bond between X₄ and M are each a coordinate bond, or
a bond between X₁ or X₅ and M and a bond between X₂ and M are each a covalent bond, and a bond between X₃ and M and a bond between X₄ and M are each a coordinate bond.

3. The organometallic compound of claims 1 or 2, wherein
rings CY₁ to CY₅ are each independently selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an indazole group, a benzofluorene group, a benzocarbazole group, a naphthobenzofuran group, a naphthobenzothiophene group, and a naphtobenzosilole group; and/or
wherein
at least one of rings CY₁ and CY₂ is a condensed ring including at least one 5-membered ring condensed with at least one 6-membered ring,
rings CY₃ to CY₅ are each independently a 6-membered ring or a condensed ring including two or more 6-membered rings condensed with each other,
the 5-membered ring is selected from a cyclopentadiene group, a furan group, a thiophene group, a pyrrole group, a silole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, and a triazasilole group, and
the 6-membered ring is selected from a cyclohexane group, a cyclohexene group, a benzene group, a pyridine group, a pyrimidine group, a pyrazine group, a pyridazine group, and a triazine group.

4. The organometallic compound of any of claims 1-3, wherein
R₁ to R₅, R', R", R₇, and R₃ are each independently selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, a phenoxy group, and a naphtoxy group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, a phenoxy group, and a naphtoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and -Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, and -CD₂CDH₂;
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an iso-butyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group;
preferably wherein
R₁ to R₅, R', R", R₇, and R₈ are each independently selected from hydrogen, deuterium, -F, a cyano group, a nitro group, -SF₅, -CH₃, -CD₃, -CD₂H, -CDH₂, -CF₃, - CF₂H, -CFH₂, a C₁-C₁₀ alkoxy group, groups represented by Formulae 9-1 to 9-19, groups represented by Formulae 10-1 to 10-157, -N(Q₁)(Q₂), -Si(Q₃)(Q₄)(Q₅), - B(Q₆)(Q₇), and -P(=O)(Q₈)(Q₉): 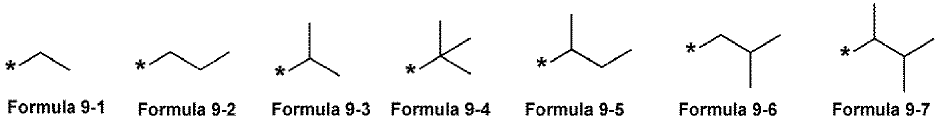 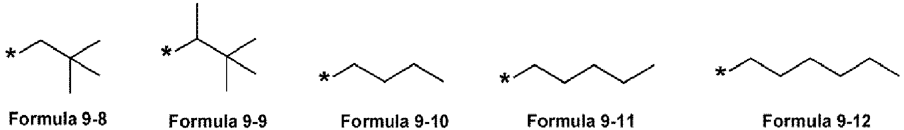 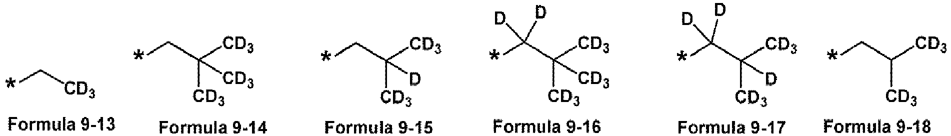 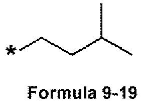 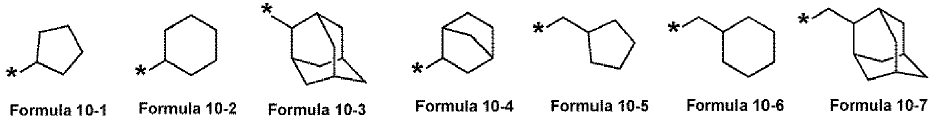 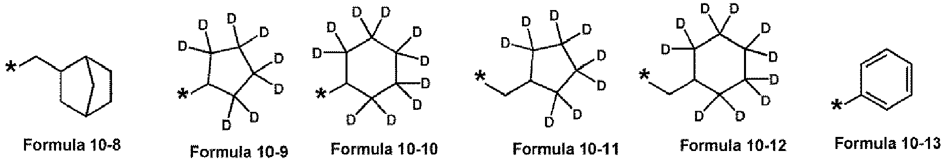 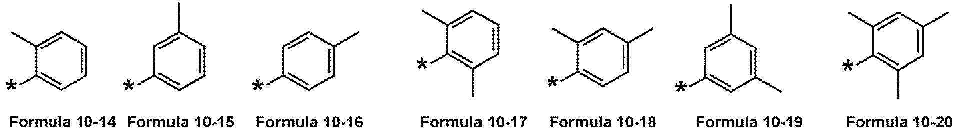 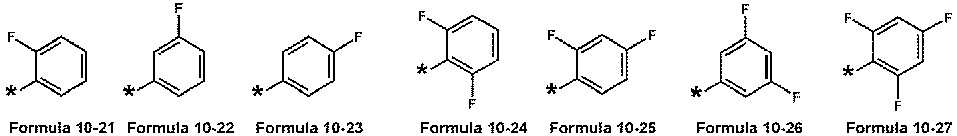 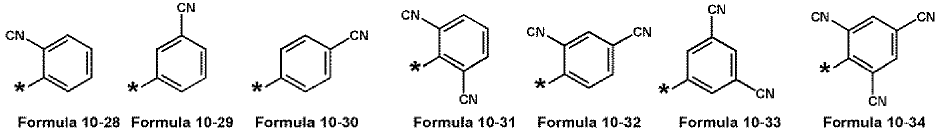 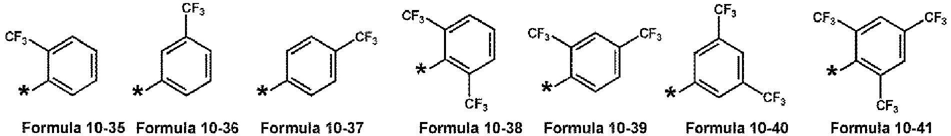 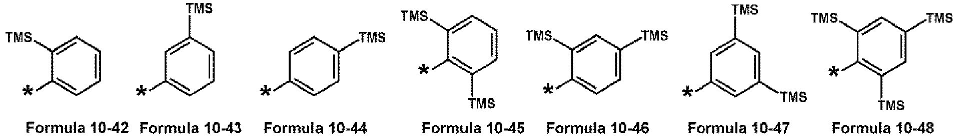 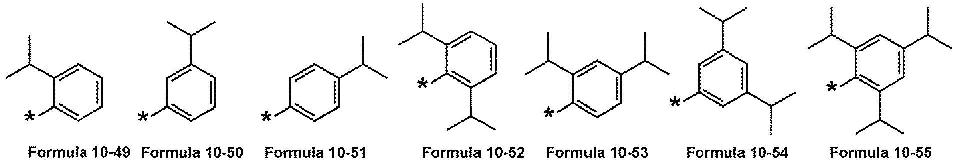 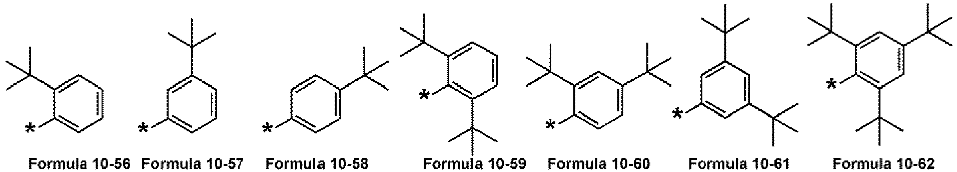 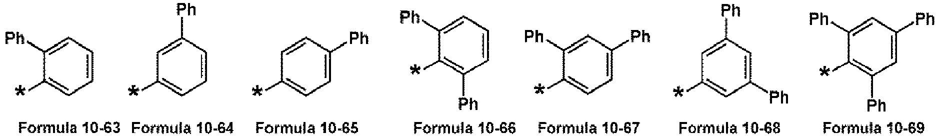 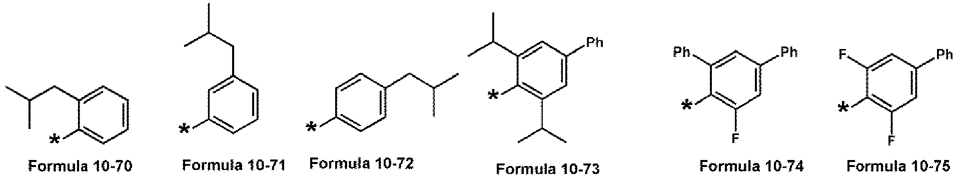 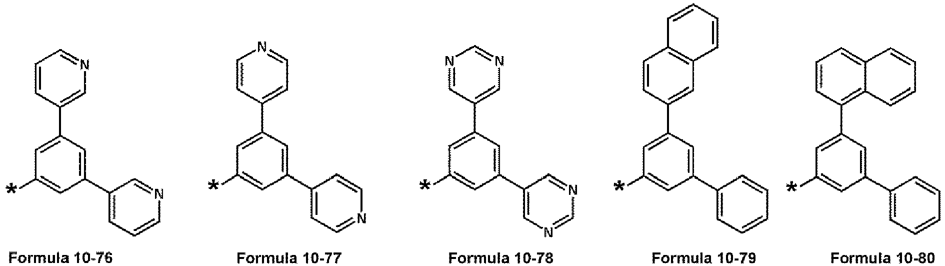 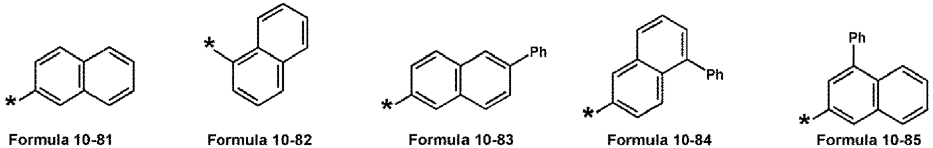 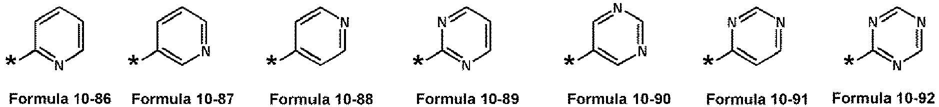 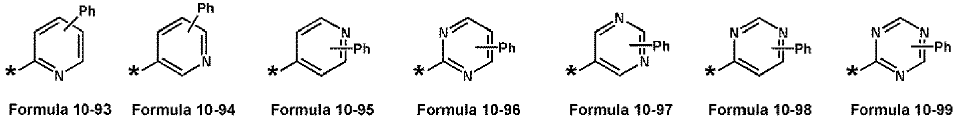 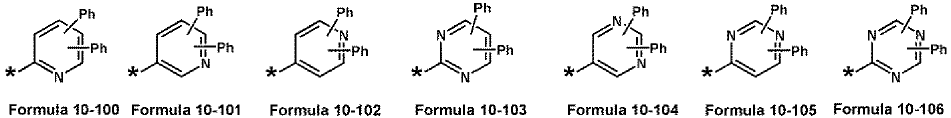 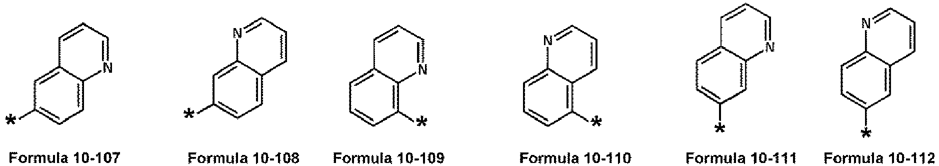 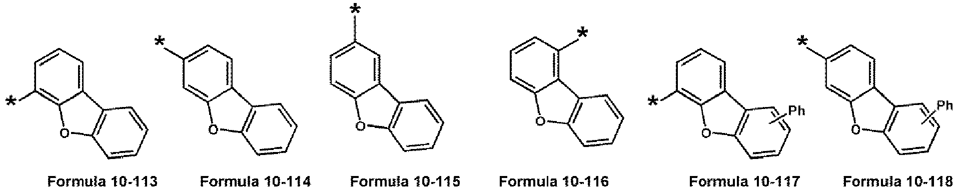 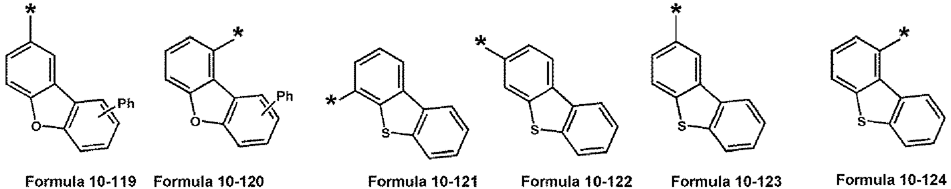 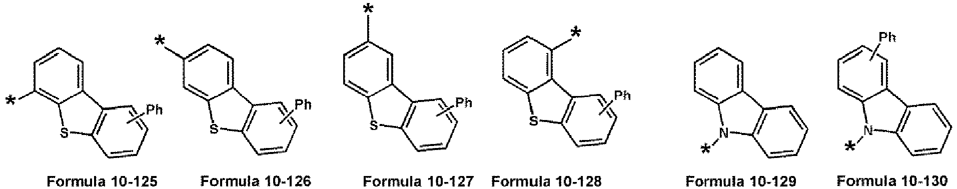 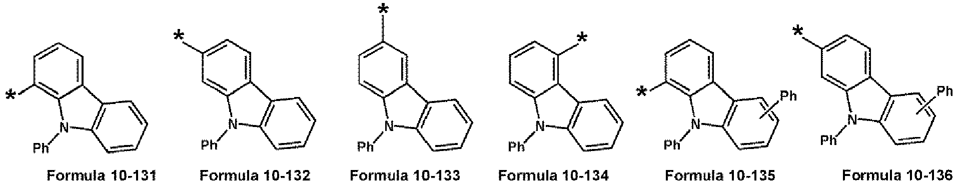 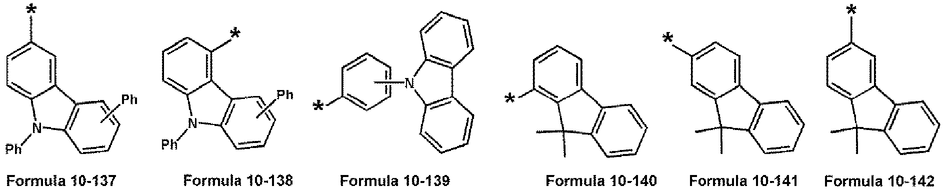 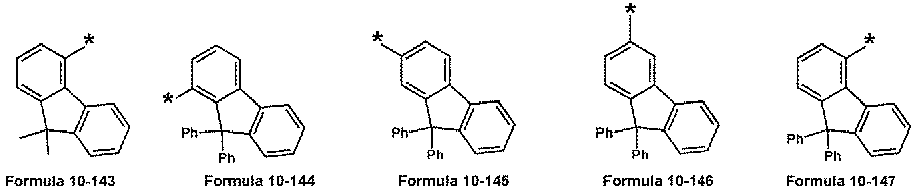 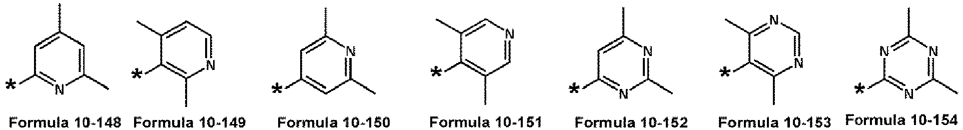 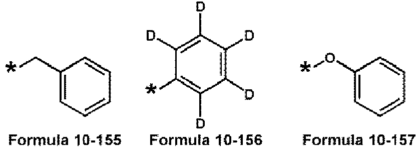
wherein, in Formulae 9-1 to 9-19 and 10-1 to 10-157, "Ph" indicates a phenyl group, "TMS" indicates a trimethylsilyl group, and "*" indicates a binding site to a neighboring atom.

5. The organometallic compound of any of claims 1-4, wherein
i) X₅ is not a single bond, a moiety represented by 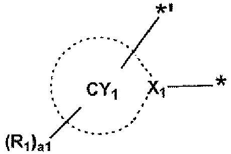 is represented by Formula A1-1, a moiety represented by 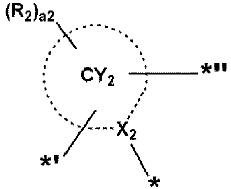 is represented by Formula A2-1 or A2-2, and T₂ is a single bond;
ii) X₅ is a single bond, a moiety represented by 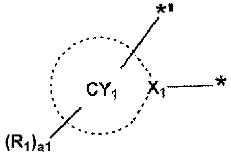 is represented by Formula A1-2, a moiety represented by 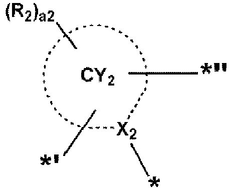 is represented by Formula A2-1 or A2-2, and T₂ is a single bond;
iii) X₅ is a single bond, a moiety represented by 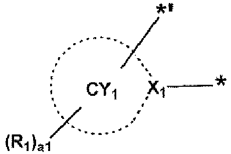 is represented by Formula A1-1, a moiety represented by 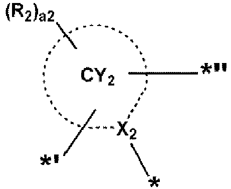 is represented by Formula A2-1 or A2-2, and T₂ is not a single bond; or
iv) X₅ is a single bond, a moiety represented by 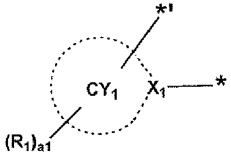 is represented by Formula A1-1, a moiety represented by 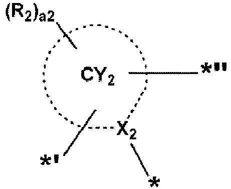 is represented by Formula A2-3, and T₂ is a single bond: 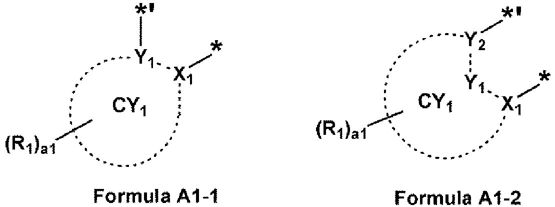 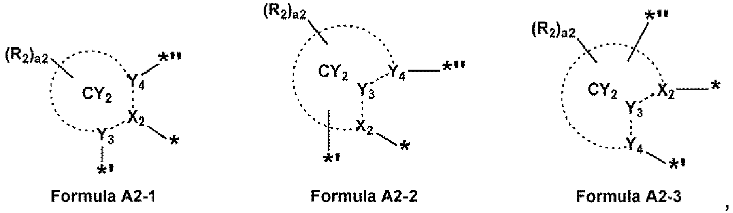 wherein, in Formulae A1-1, A1-2, and A2-1 to A2-3,
X₁, X₂, ring CY₁, ring CY₂, R₁, R₂, a1, and a2 are the same as in claim 1,
Y₁ to Y₄ are each independently N or C,
* in Formulae A1-1 and A1-2 indicates a binding site to M in Formula 1,
*' in Formulae A1-1 and A1-2 indicates a binding site to T₂ in Formula 1,
* in Formulae A2-1 to A2-3 indicates a binding site to M in Formula 1,
*' in Formulae A2-1 to A2-3 indicates a binding site to T₂ in Formula 1, and
*" in Formulae A2-1 to A2-3 indicates a binding site to ring CY₃ in Formula 1.

6. The organometallic compound of any of claims 1-5, wherein
a moiety represented by 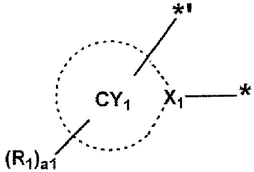 in Formula 1 is represented by one of Formulae A1-1 (1) to A1-1(26) and A1-2(1) to A1-2(76), and
a moiety represented by 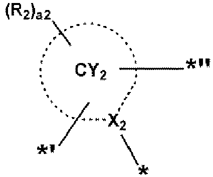 in Formula 1 is represented by one of Formulae A2-1(1) to A2-1(21), A2-2(1) to A2-2(58), and A2-3(1) to A2-3(58): 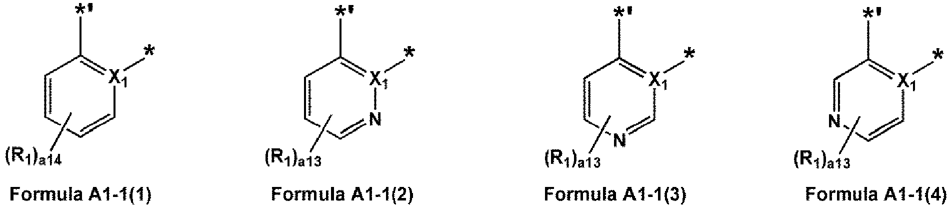 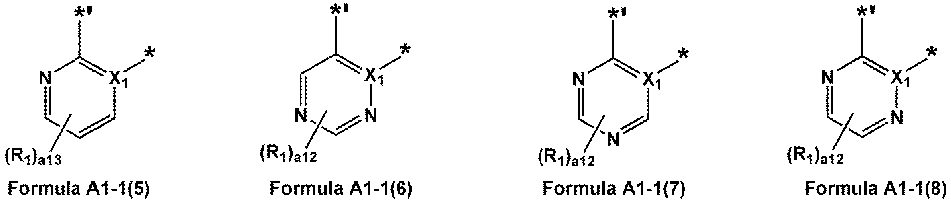 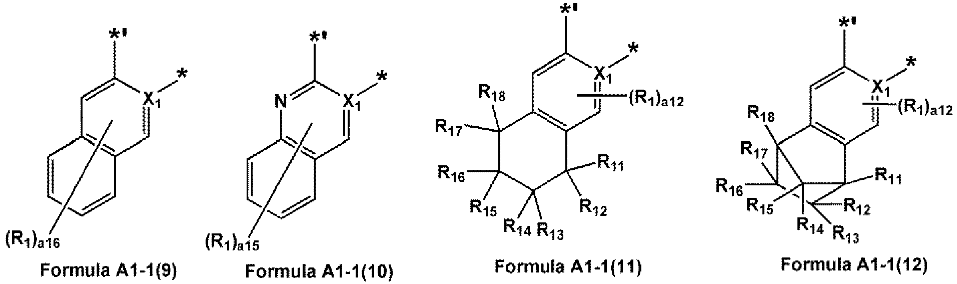 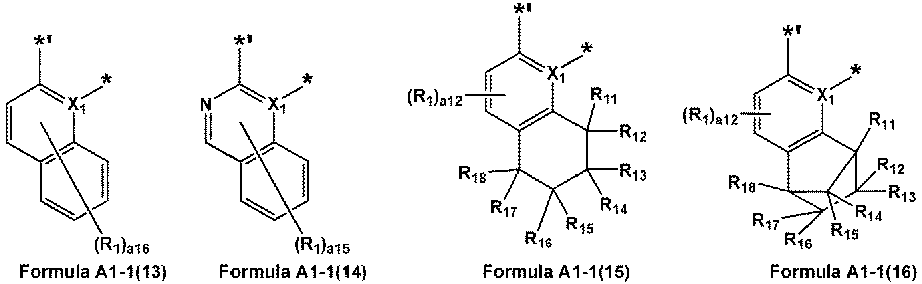 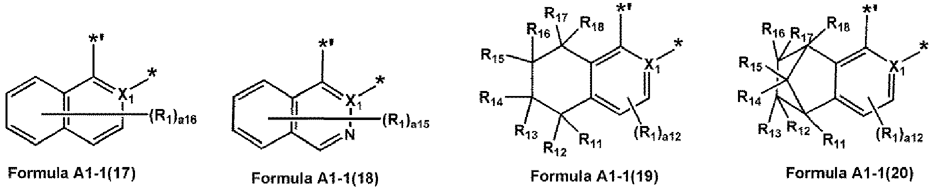 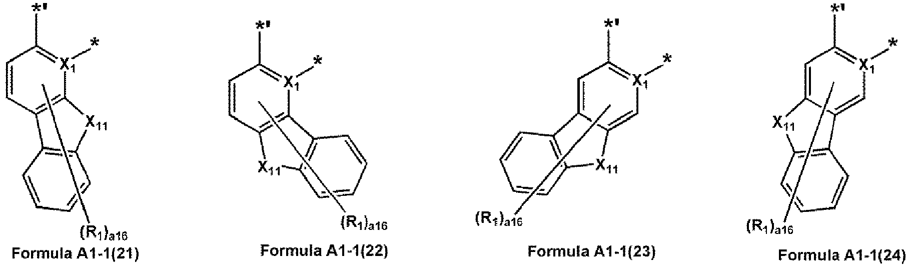 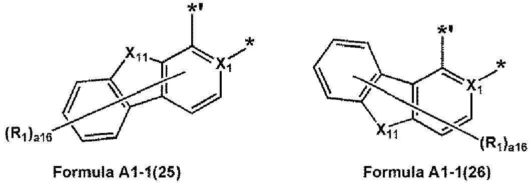 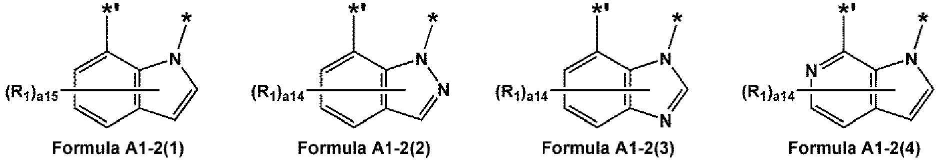 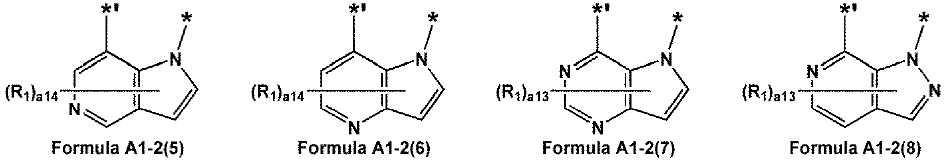 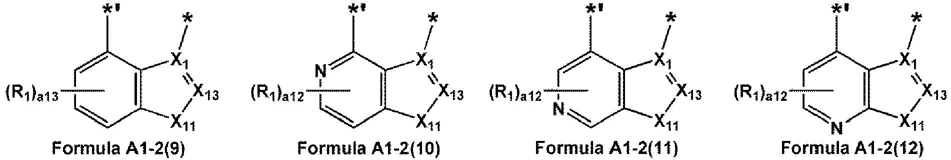 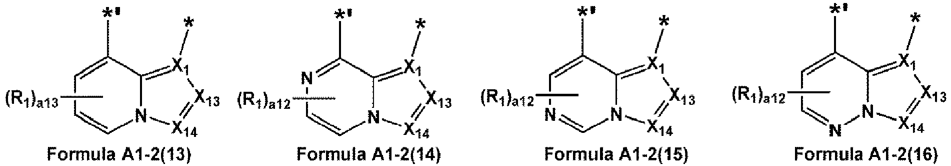 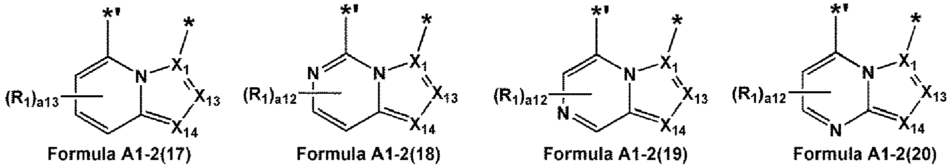 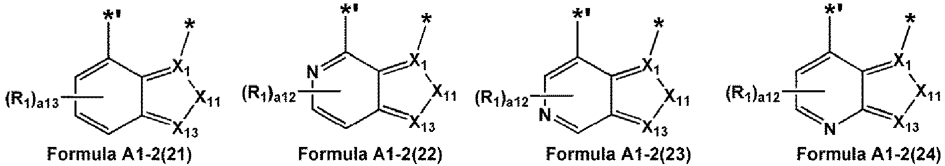 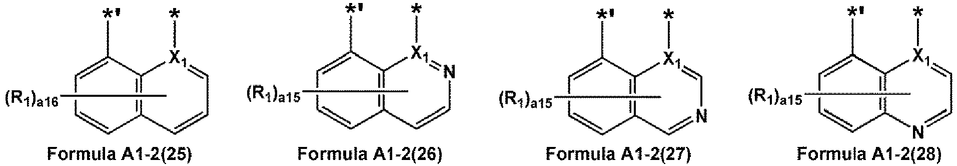 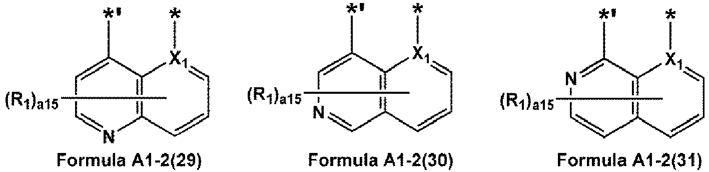 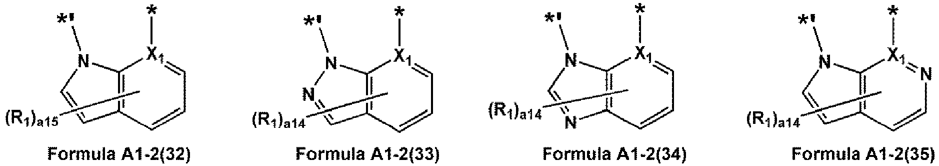 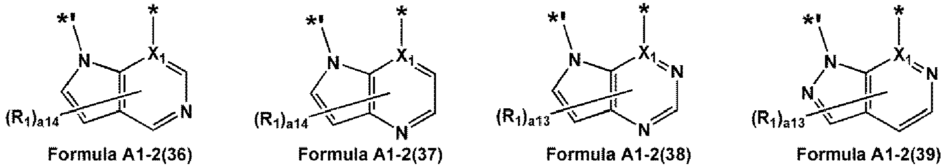 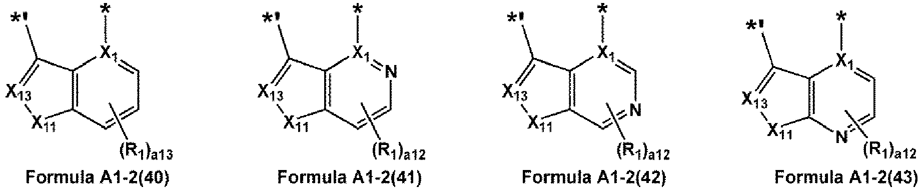 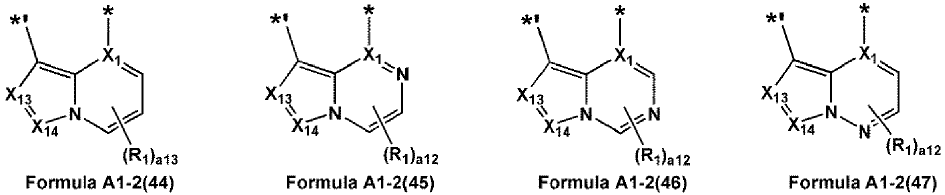 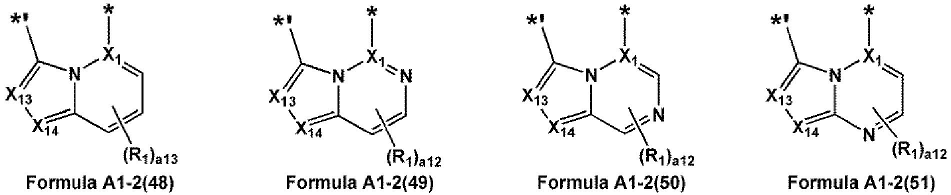 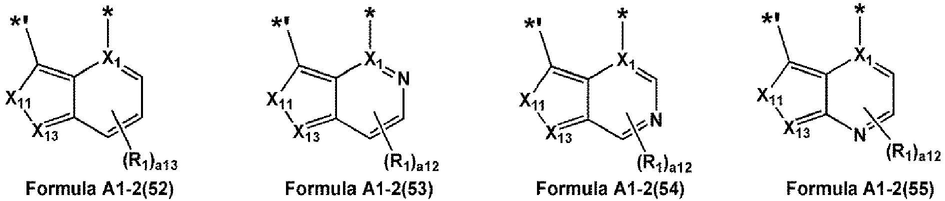 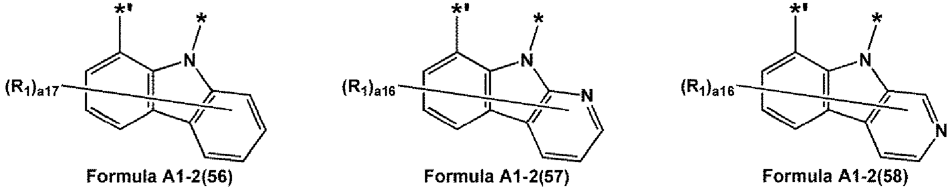 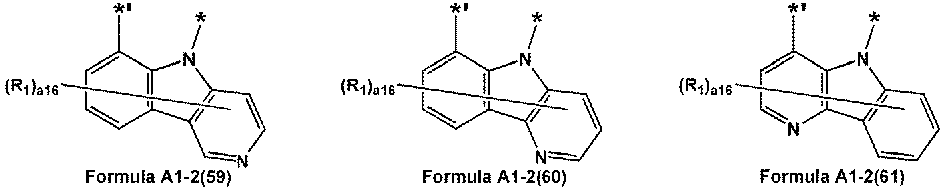 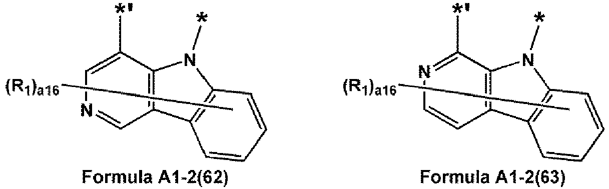 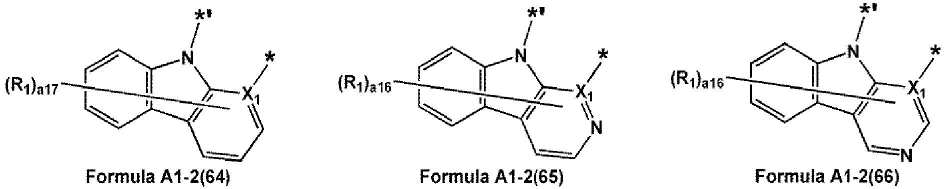 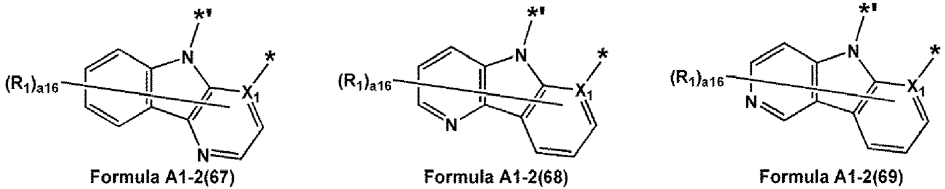 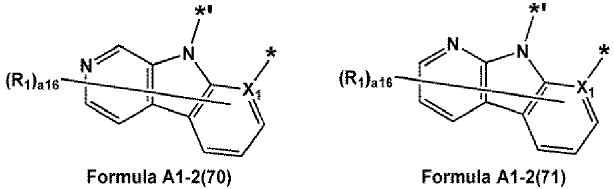 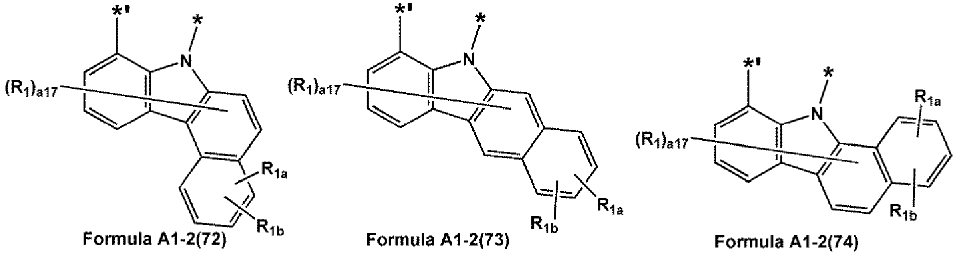 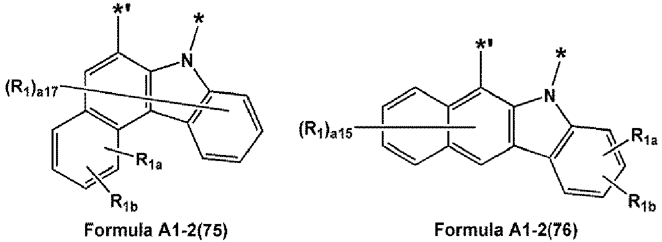 wherein, in Formulae A1-1(1) to A1-1(26) and A1-2(1) to A1-2(76),
X₁ and R₁ are the same as in claim 1,
X₁₁ is O, S, N(R₁₁), C(R₁₁)(R₁₂), or Si(R₁₁)(R₁₂),
X₁₃ is N or C(R₁₃),
X₁₄ is N or C(R₁₄),
R₁ₐ, R_{1b}, and R₁₁ to R₁₈ are the same as R₁ in claim 1, a17 is an integer from 0 to 7,
a16 is an integer from 0 to 6,
a15 is an integer from 0 to 5,
a14 is an integer from 0 to 4,
a13 is an integer from 0 to 3,
a12 is an integer from 0 to 2,
* indicates a binding site to M in Formula 1, and
*' indicates a binding site to T₂ in Formula 1: 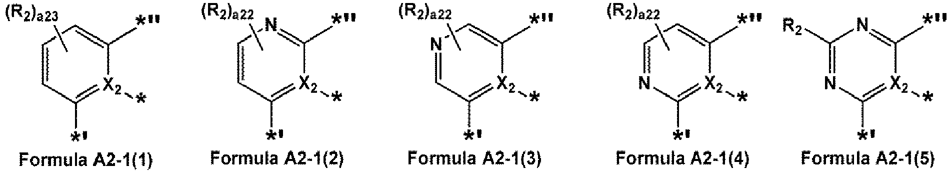 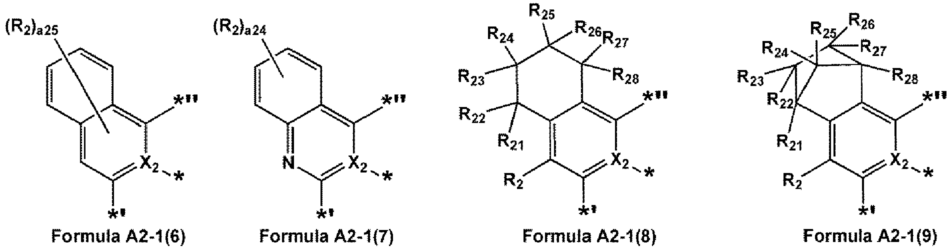 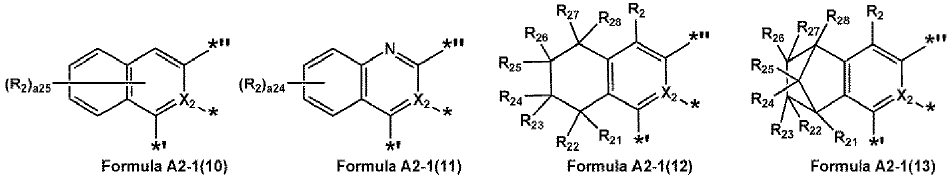 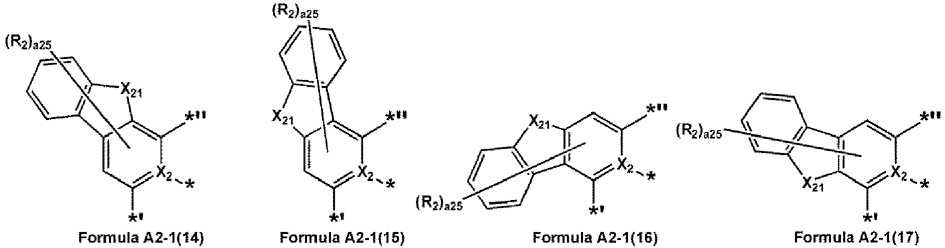 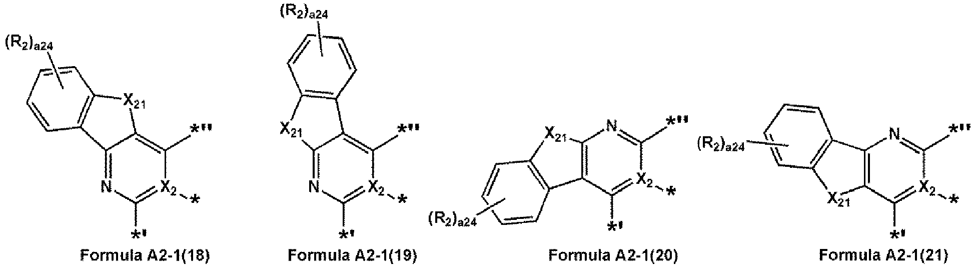 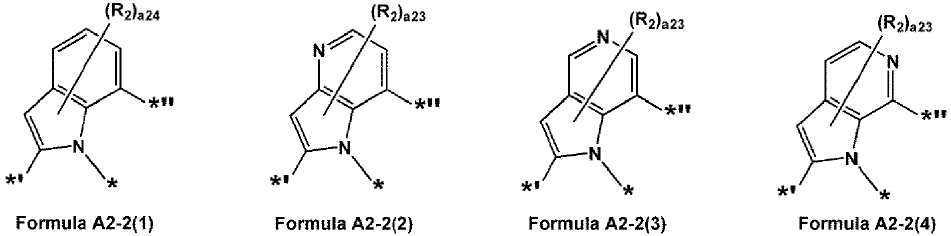 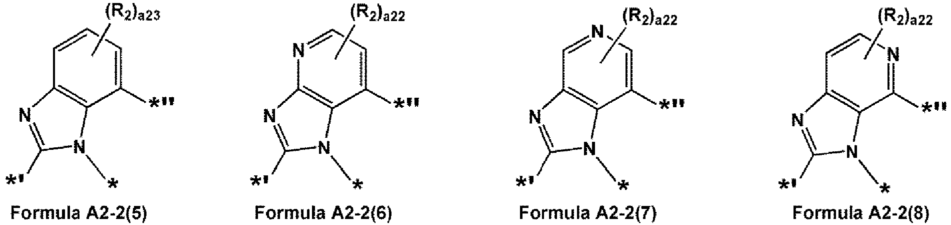 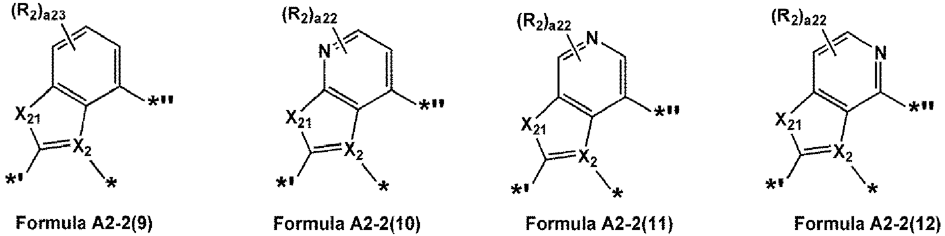 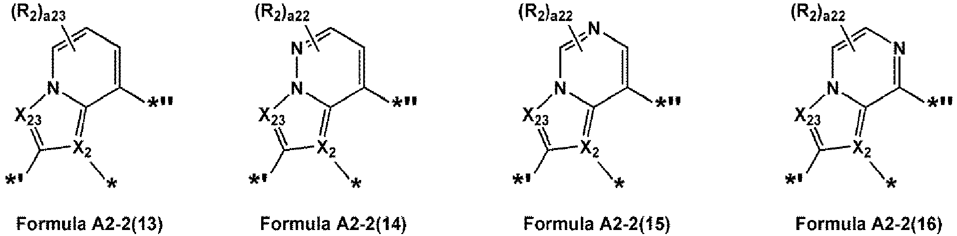 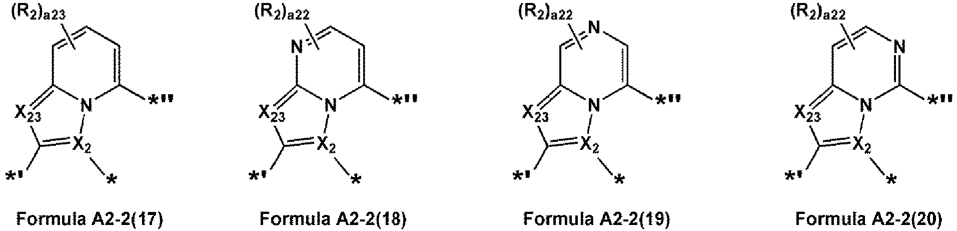 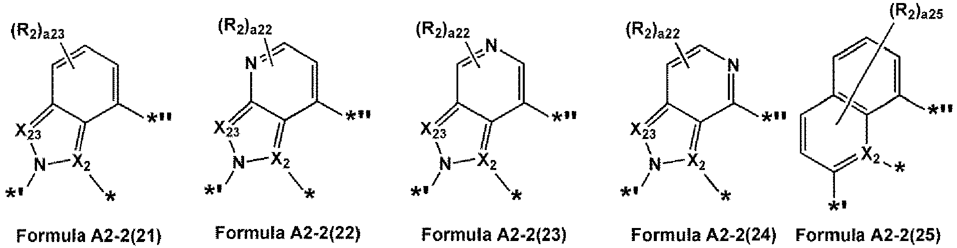 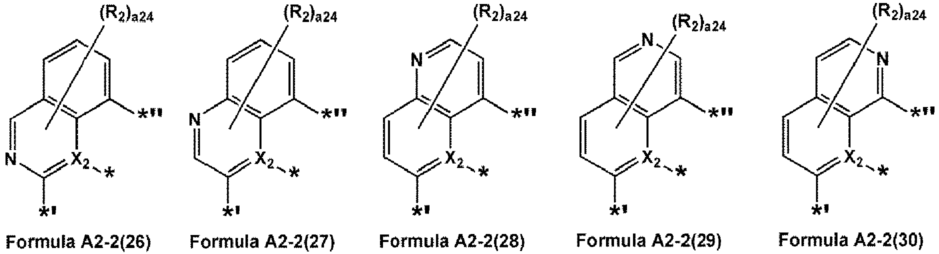 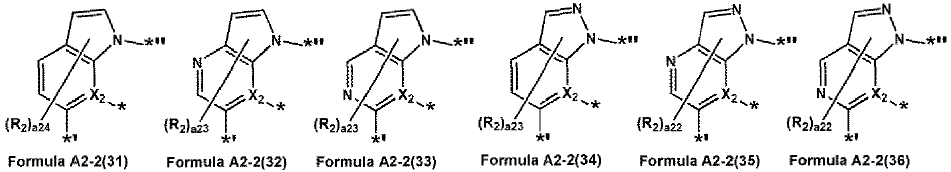 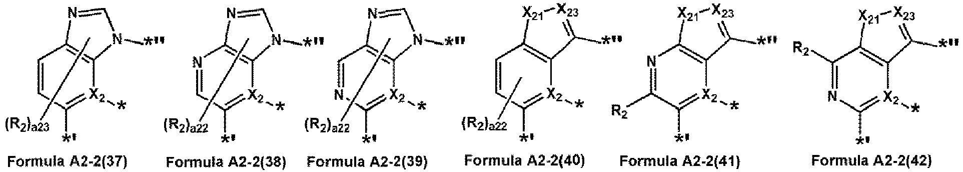 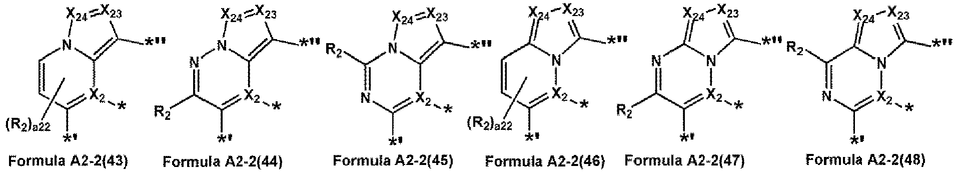 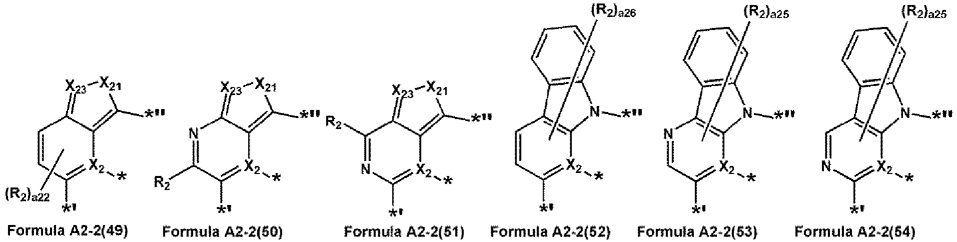 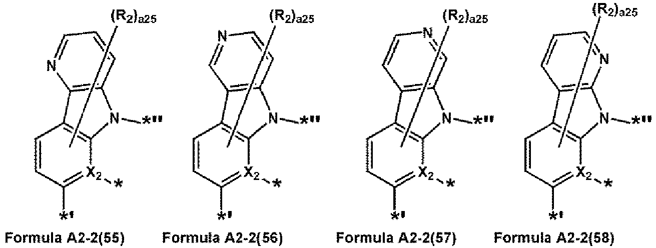 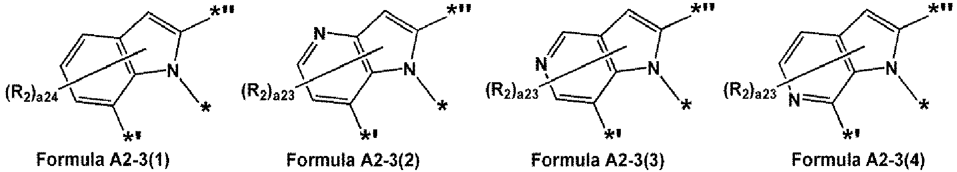 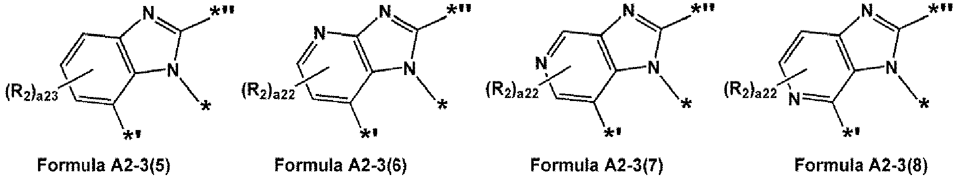 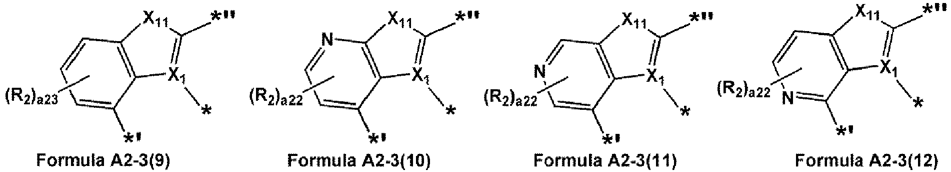 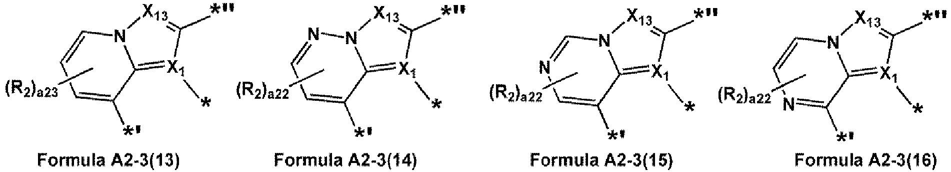 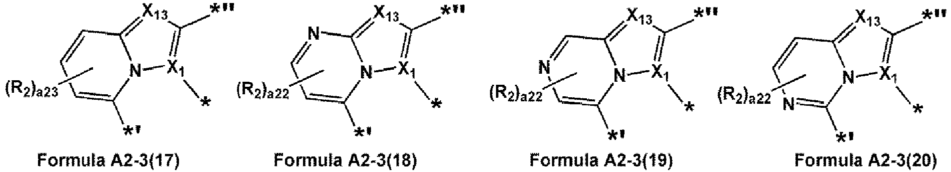 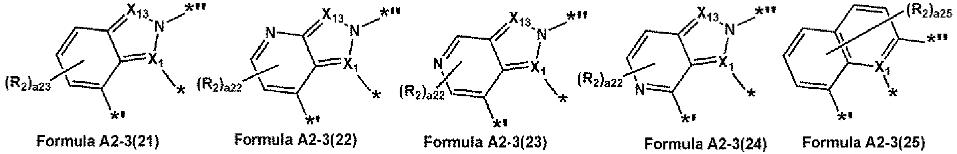 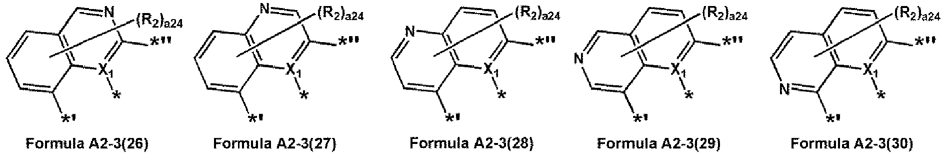 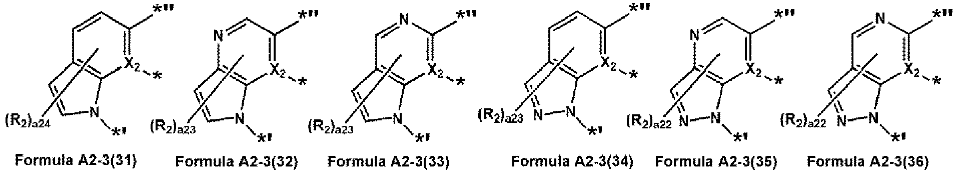 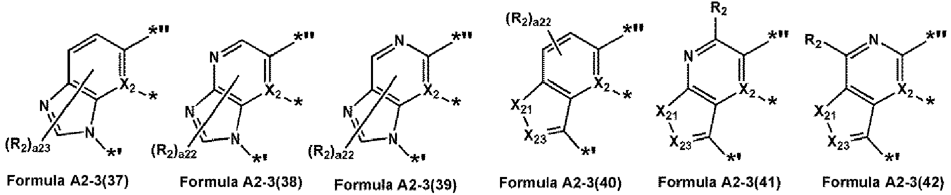 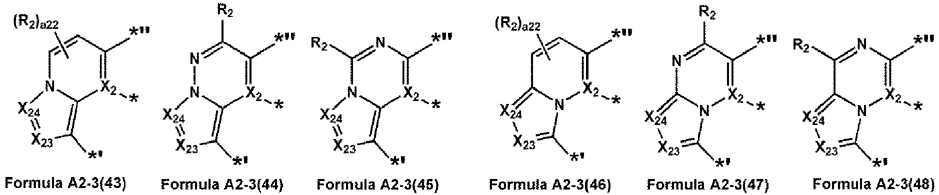 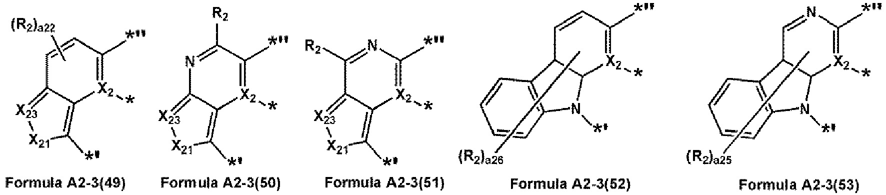 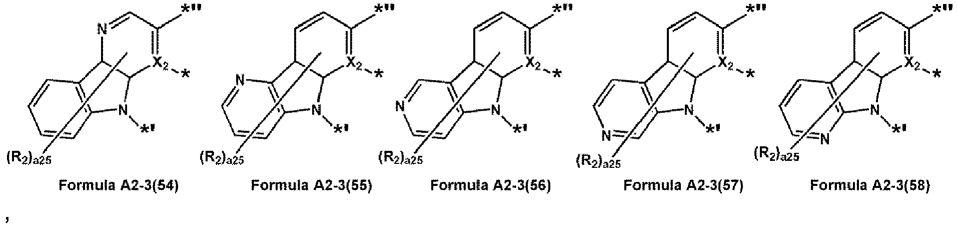
wherein, in Formulae A2-1(1) to A2-1(21), A2-2(1) to A2-2(58), and A2-3(1) to A2-3(58),
X₂ and R₂ are the same as in claim 1,
X₂₁ is O, S, N(R₂₁), C(R₂₁)(R₂₂), or Si(R₂₁)(R₂₂),
X₂₃ is N or C(R₂₃),
X₂₄ is N or C(R₂₄),
R₂₁ to R₂₈ are the same as R₂ in claim 1,
a26 is an integer from 0 to 6,
a25 is an integer from 0 to 5,
a24 is an integer from 0 to 4,
a23 is an integer from 0 to 3,
a22 is an integer from 0 to 2,
* indicates a binding site to M in Formula 1,
*' indicates a binding site to T₂ in Formula 1, and
*" indicates a binding site to ring CY₃ in Formula 1;
preferably wherein
i) X₅ is not a single bond, a moiety represented by 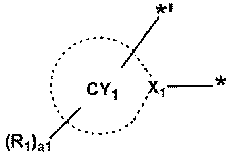 is represented by one of Formulae A1-1(1) to A1-1(26), a moiety represented by 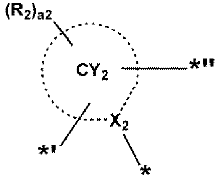 is represented by one of Formulae A2-1(1) to A2-1(21), and T₂ is a single bond;
ii) X₅ is a single bond, a moiety represented by 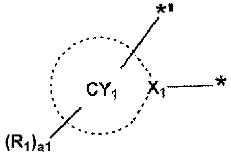 is represented by one of Formulae A1-2(1) to A1-2(76), a moiety represented by 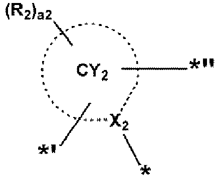 is represented by one of Formulae A2-1(1) to A2-1(21), and T₂ is a single bond;
iii) X₅ is a single bond, a moiety represented by 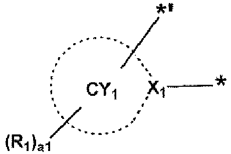 is represented by one of Formulae A1-1(1) to A1-1(26), a moiety represented by 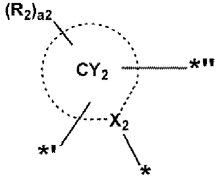 is represented by one of Formulae A2-1(1) to A2-1(21), and T₂ is not a single bond; or
iv) X₅ is a single bond, a moiety represented by 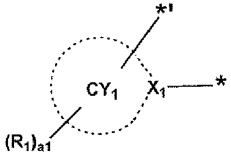 is represented by one of Formulae A1-1(1) to A1-1(26), a moiety represented by 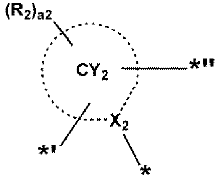 is represented by one of Formulae A2-3(1) to A2-3(58), and T₂ is a single bond.

7. The organometallic compound of any of claims 1-6, wherein
a moiety represented by 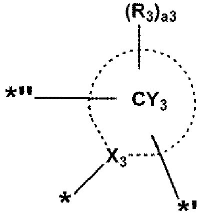 in Formula 1 is represented by one of Formulae A3-1(1) to A3-1(21) and A3-3(1) to A3-3(58): 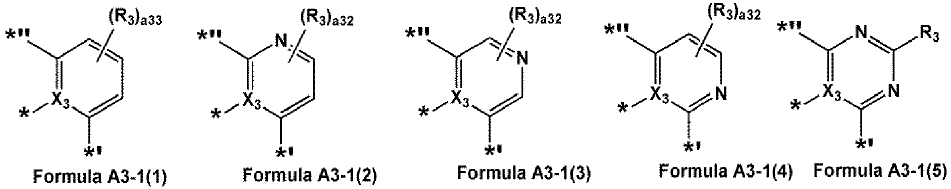 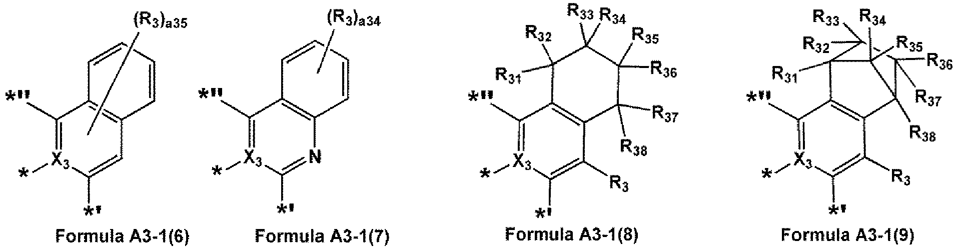 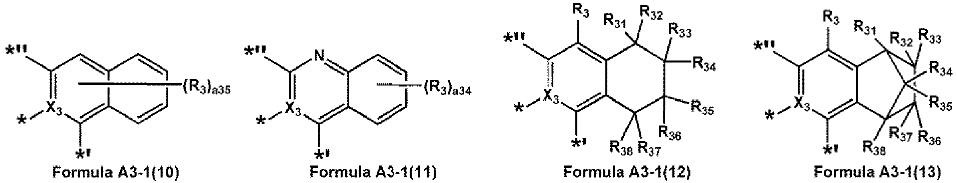 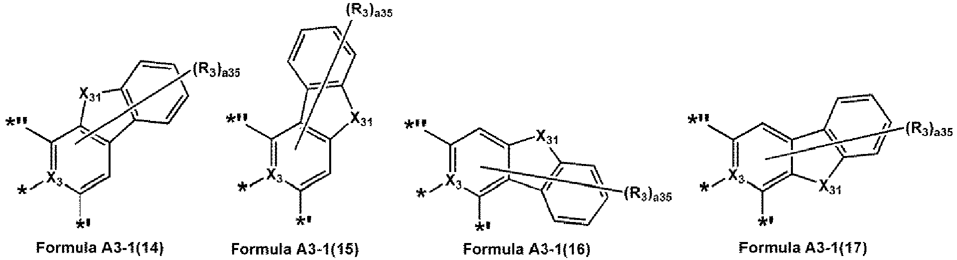 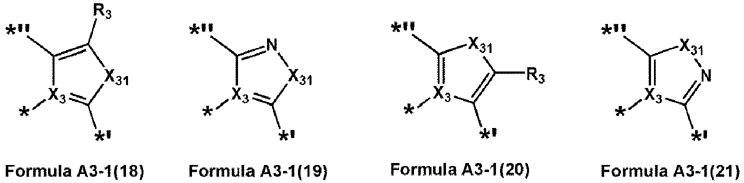 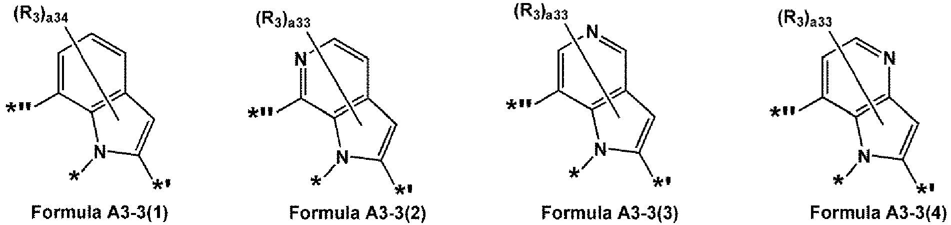 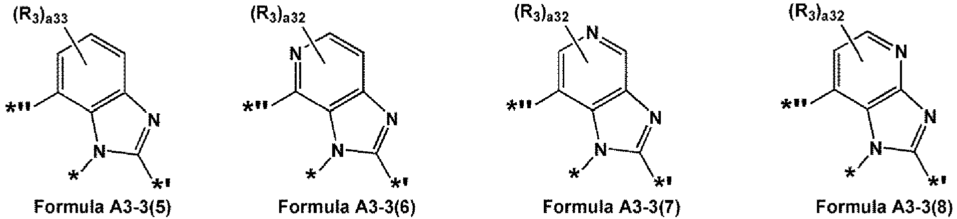 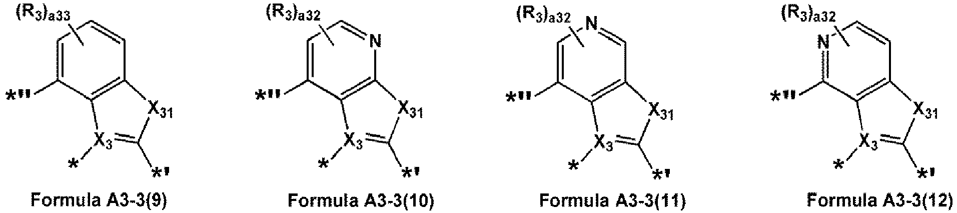 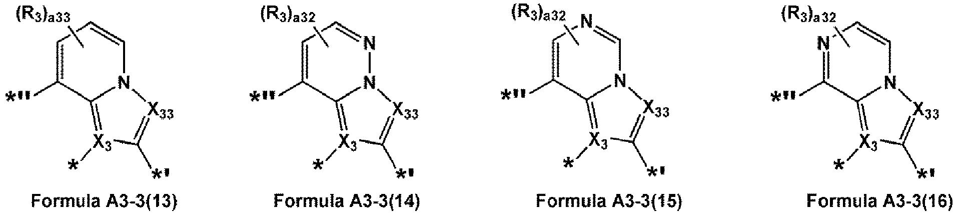 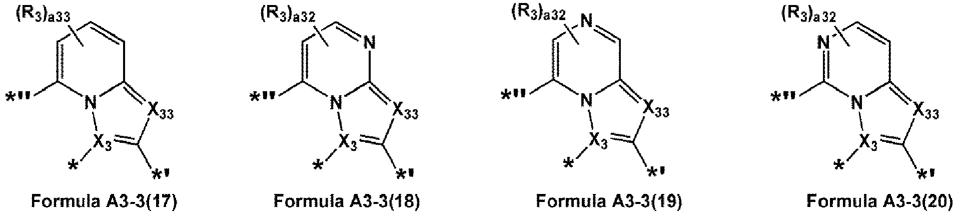 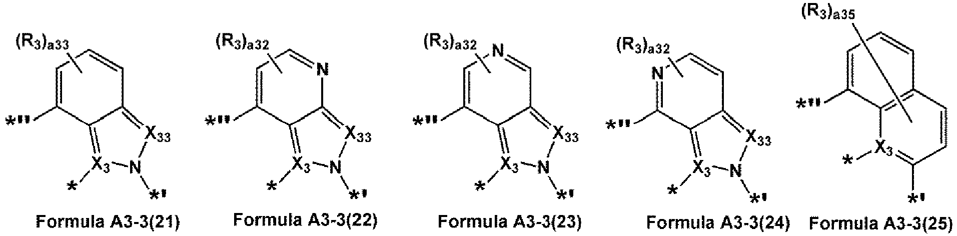 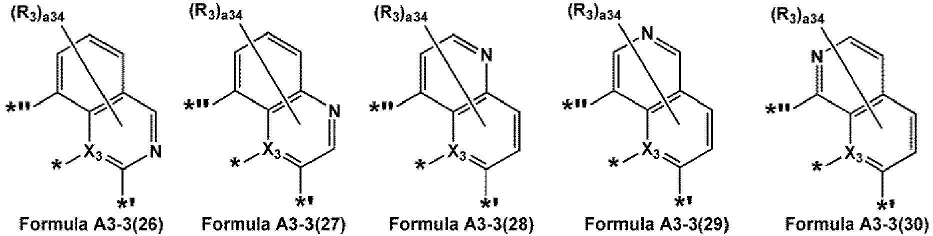 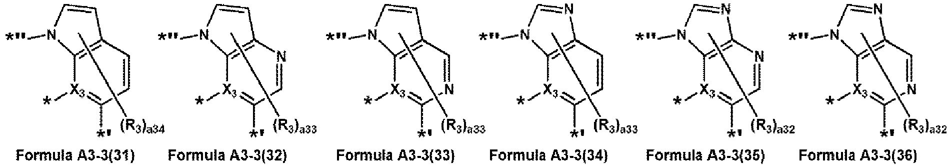 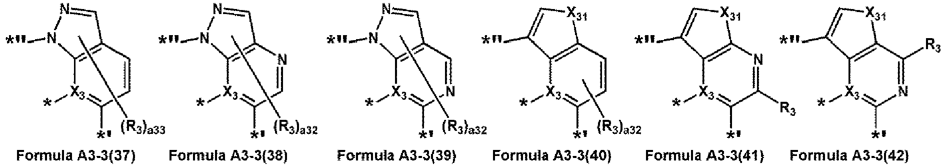 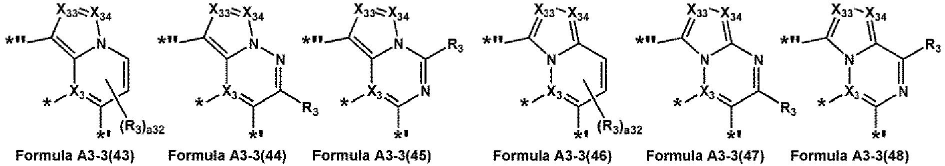 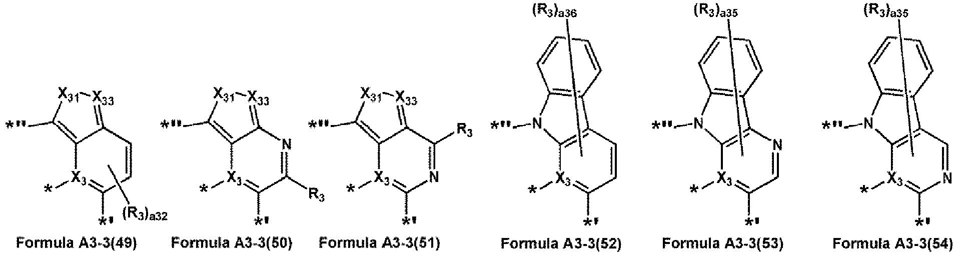 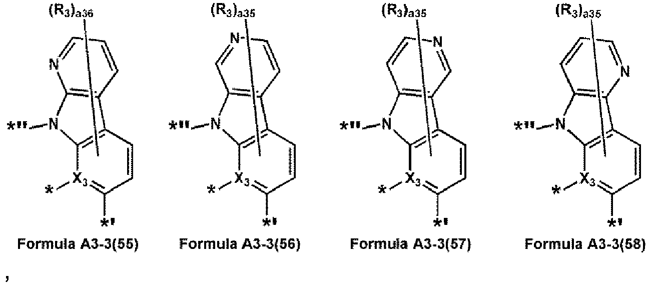 wherein, in Formulae A3-1(1) to A3-1(21) and A3-3(1) to A3-3(58),
X₃ and R₃ are the same as in claim 1,
X₃₁ is O, S, N(R₃₁), C(R₃₁)(R₃₂), or Si(R₃₁)(R₃₂),
X₃₃ is N or C(R₃₃),
X₃₄ is N or C(R₃₄),
R₃₁ to R₃₈ are the same R₃ in claim 1,
a36 is an integer from 0 to 6,
a35 is an integer from 0 to 5,
a34 is an integer from 0 to 4,
a33 is an integer from 0 to 3,
a32 is an integer from 0 to 2,
* indicates a binding site to M in Formula 1,
*" indicates a binding site to ring CY₂ in Formula 1, and
*' indicates a binding site to T₁ in Formula 1.

8. The organometallic compound of any of claims 1-7, wherein
a moiety represented by 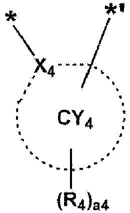 in Formula 1 is represented by one of Formulae A4-1(1) to A4-1(44): 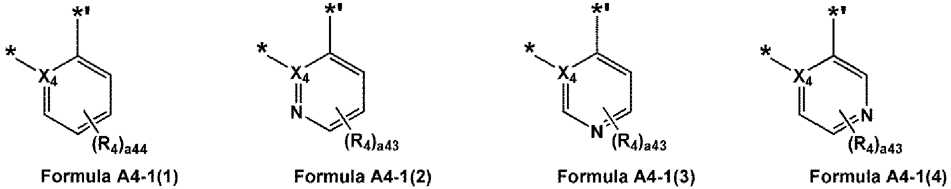 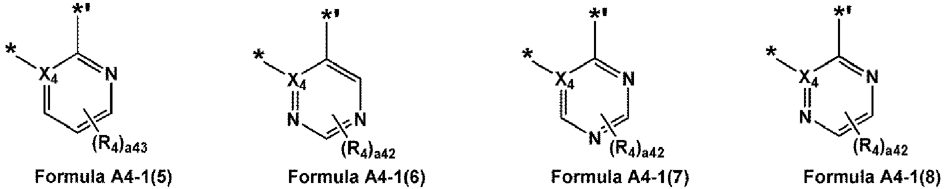 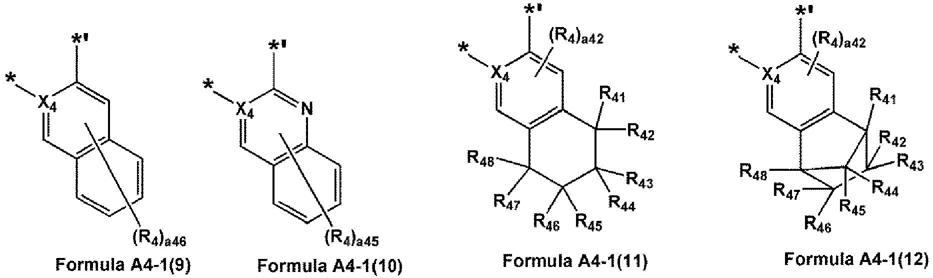 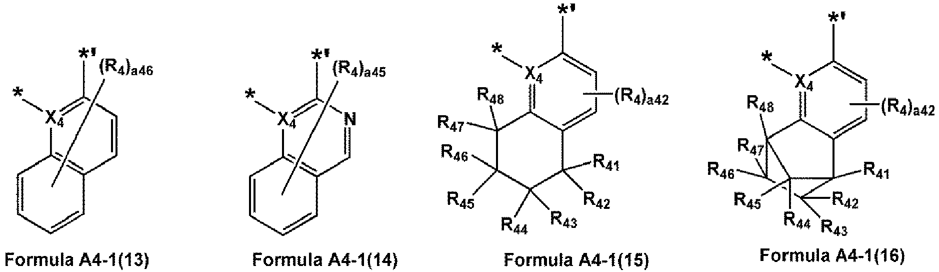 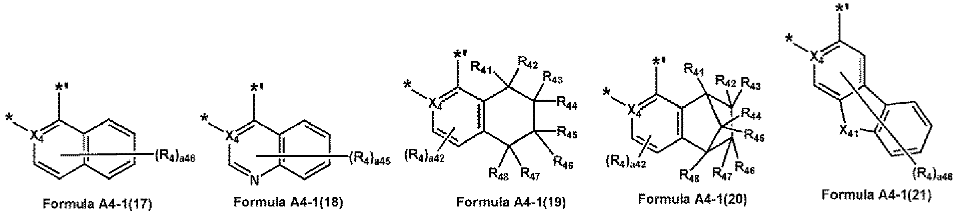 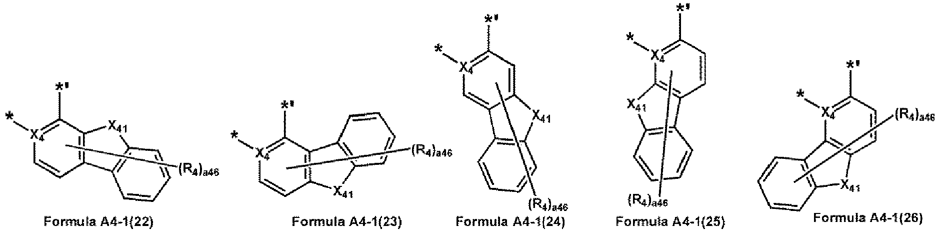 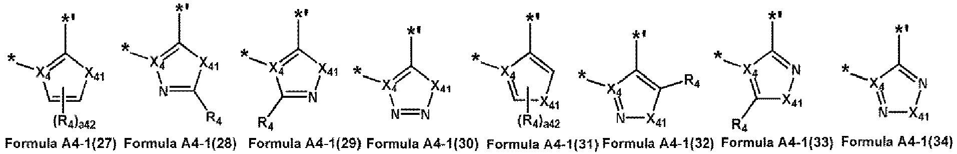 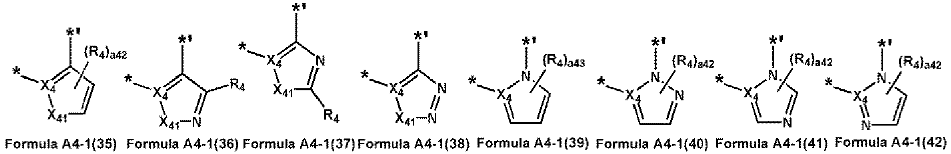 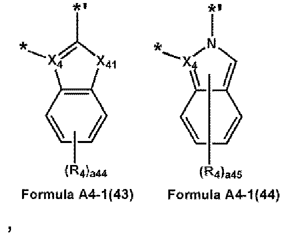 wherein, in Formulae A4-1(1) to A4-1(44),
X₄, R₄, *, and *' are the same as in claim 1,
X₄₁ is O, S, N(R₄₁), C(R₄₁)(R₄₂), or Si(R₄₁)(R₄₂),
X₄₃ is N or C(R₄₃),
X₄₄ is N or C(R₄₄),
R₄₁ to R₄₈ are the same as R₄,
a47 is an integer from 0 to 7,
a46 is an integer from 0 to 6,
a45 is an integer from 0 to 5,
a44 is an integer from 0 to 4,
a43 is an integer from 0 to 3,
a42 is an integer from 0 to 2,
* indicates a binding site to M in Formula 1, and
*' indicates a binding site to T₁ in Formula 1.

9. The organometallic compound of any of claims 1-8, wherein,
in Formula 1,
a cyclometallated ring formed by M, X₅, ring CY₁, T₂, and ring CY₂, and a cyclometallated ring formed by M, ring CY₄, T₁, and ring CY₃, are each a 6-membered ring, and
a cyclometallated ring formed by M, ring CY₂, and ring CY₃ is a 5-membered ring.

10. The organometallic compound of any of claims 1-9, wherein
the organometallic compound is represented by one of Formulae 1-1 to 1-3: 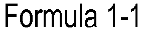 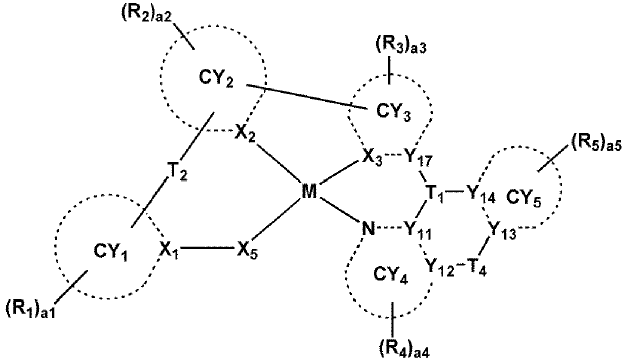 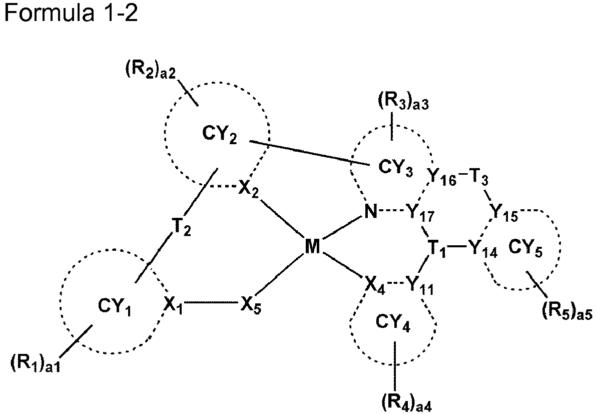 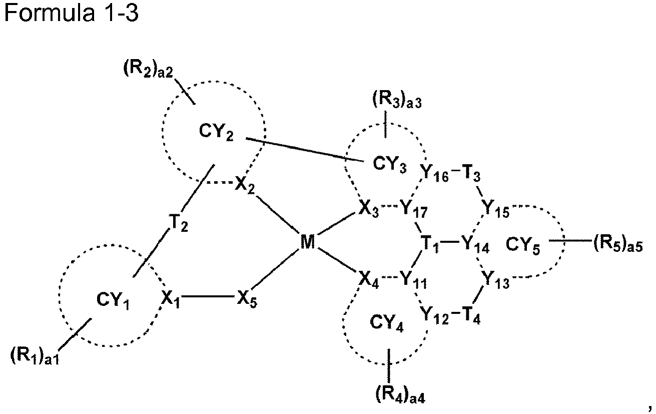
wherein, in Formulae 1-1 to 1-3,
M, X₁ to X₅, rings CY₁ to CY₅, T₁ to T₄, R₁ to R₅, and a1 to a5 are the same as in claim 1, provided that at least one of X₃ and X₄ in Formula 1-3 is N, and
Y₁₁ to Y₁₇ are each independently C or N; or
wherein
the organometallic compound is represented by one of Formulae 1A-1 to 1A-3 and 1B: 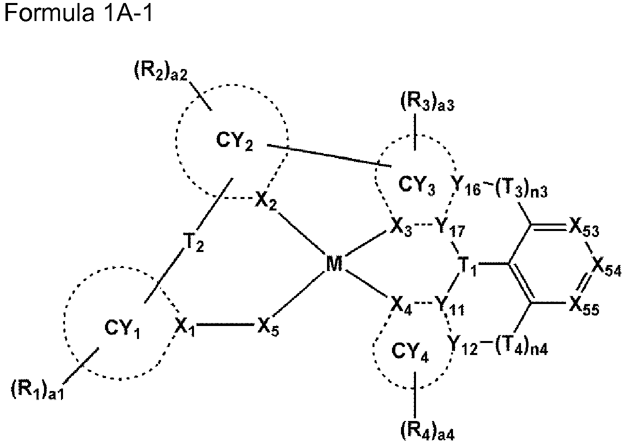 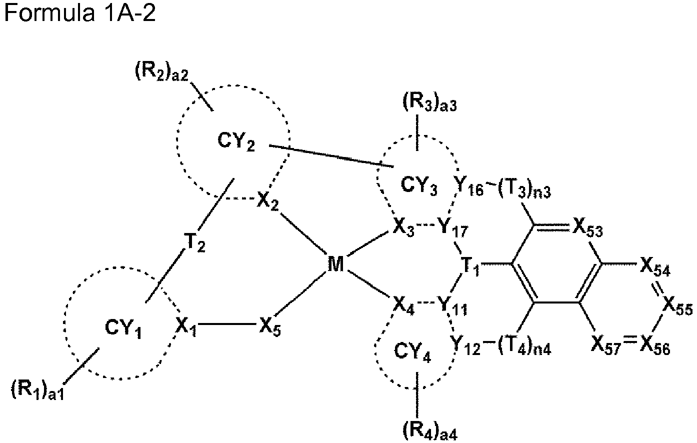 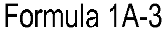 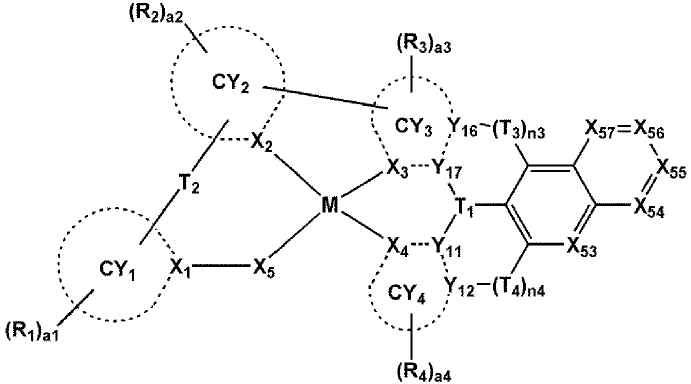 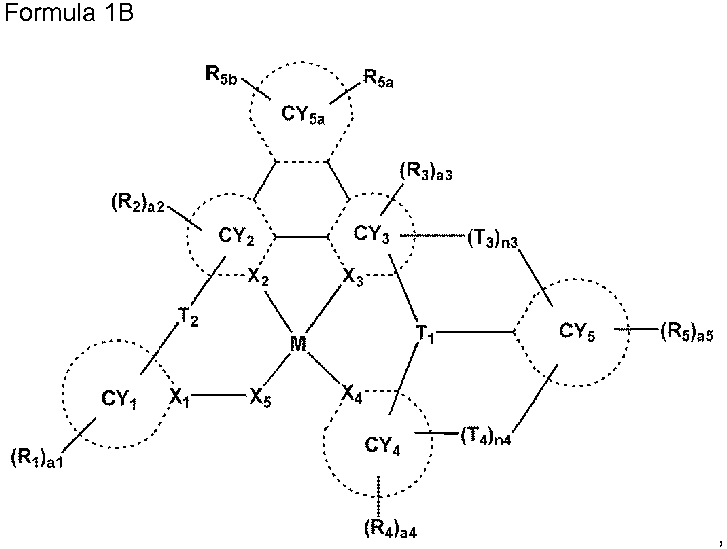
wherein, in Formulae 1A-1 to 1A-3 and 1B,
M, X₁ to X₅, ring CY₁, ring CY₂, T₁ to T₄, n3, n4, R₁, R₂, a1, and a2 are the same as in claim 1,
X₅₃ is N or C(R₅₃), X₅₄ is N or C(R₅₄), X₅₅ is N or C(R₅₅), X₅₆ is N or C(R₅₆), and X₅₇ is N or C(R₅₇),
R₅₃ to R₅₇ are the same as R₅ in claim 1,
Y₁₁, Y₁₂, Y₁₆, and Y₁₇ are each independently C or N,
CY₅, is the same as CY₅ in claim 1, and
R₅ₐ and R_{5b} are the same as R₅ in claim 1.

11. The organometallic compound of any of claims 1-10, wherein
the organometallic compound is one of Compounds 1 to 160:

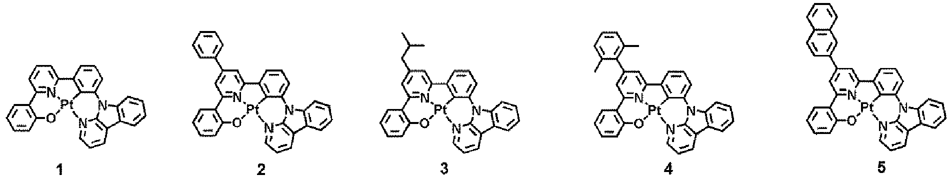

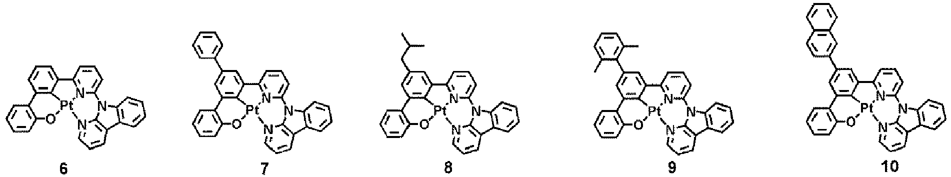

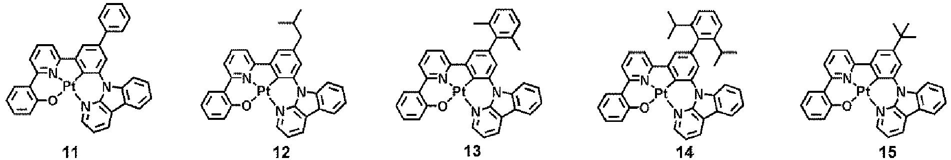

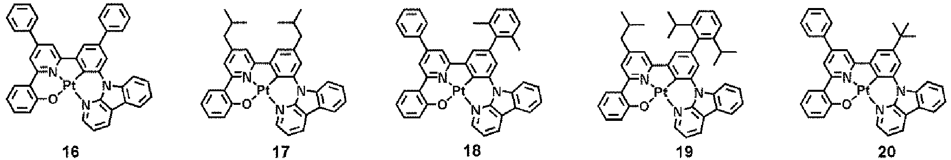

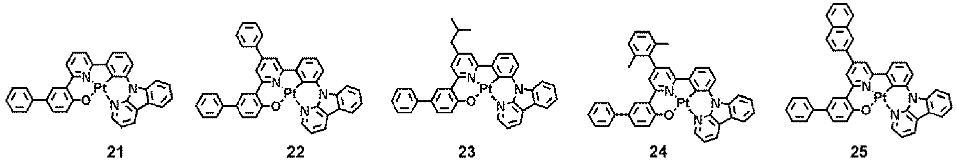

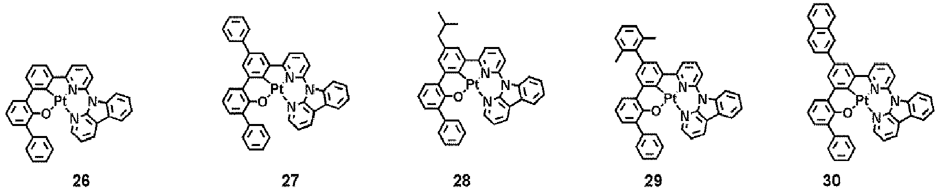

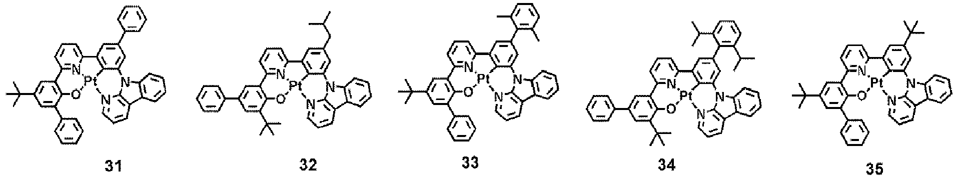

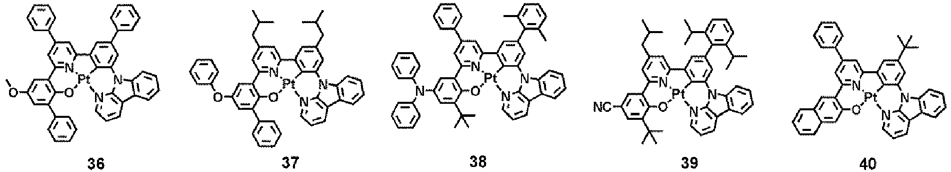

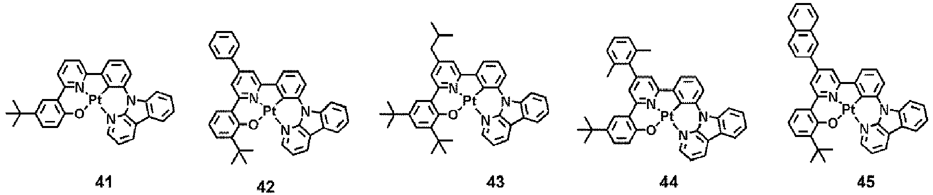

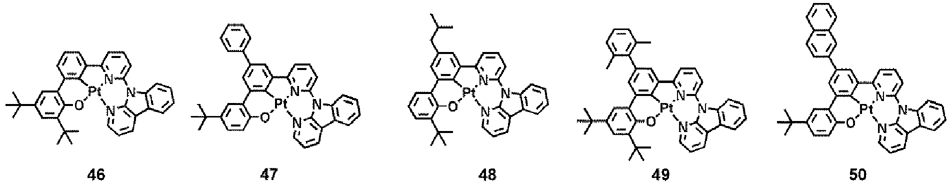

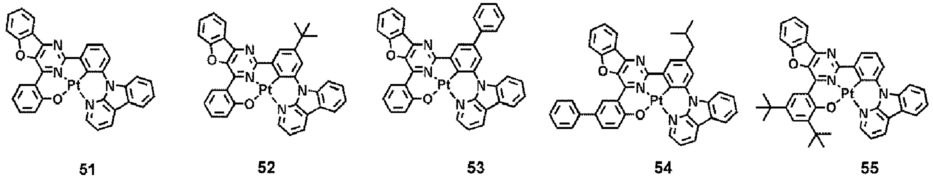

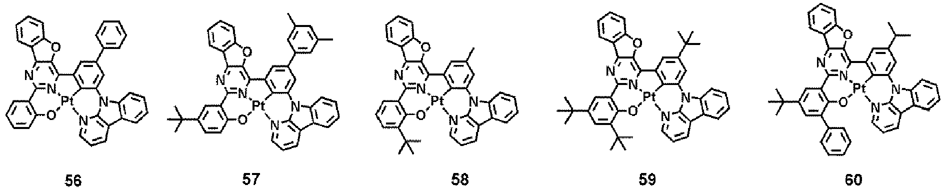

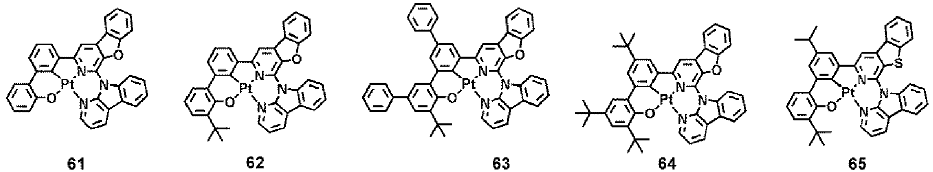

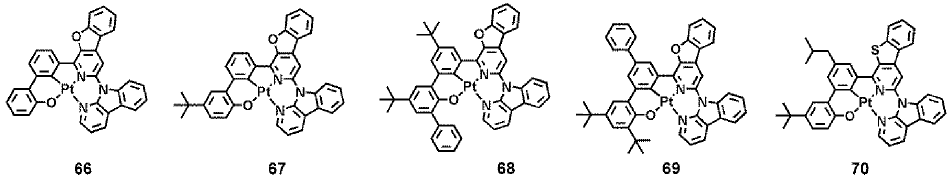

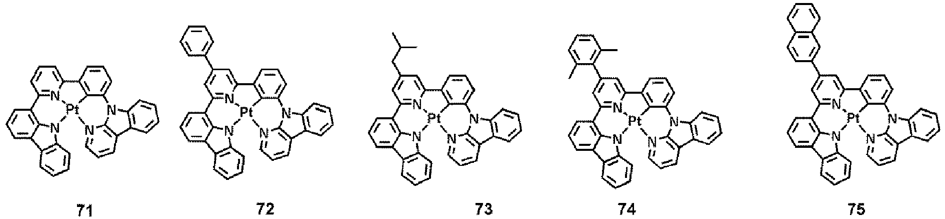

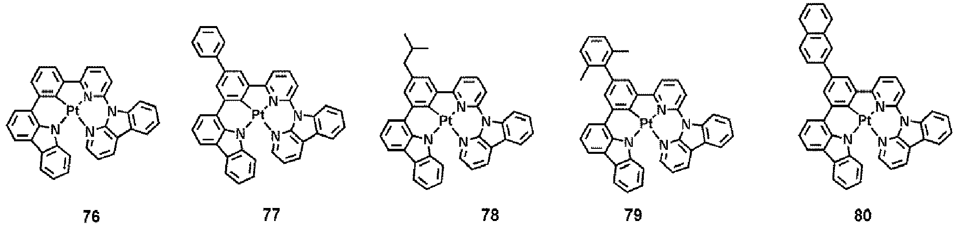

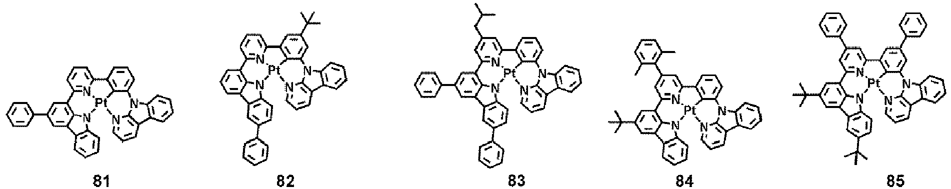

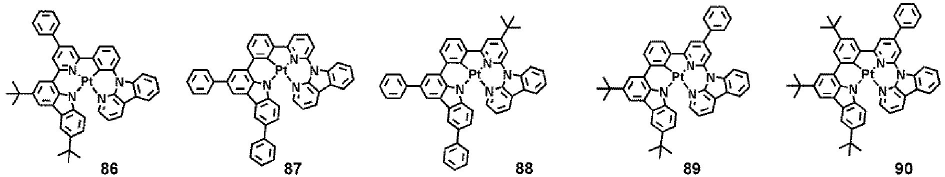

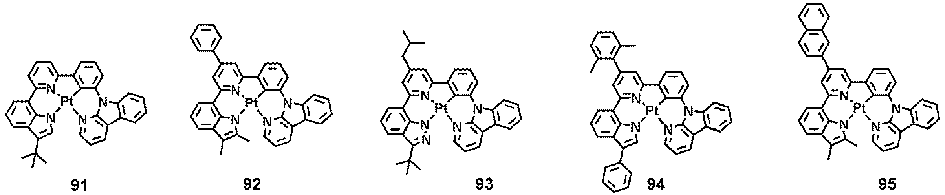

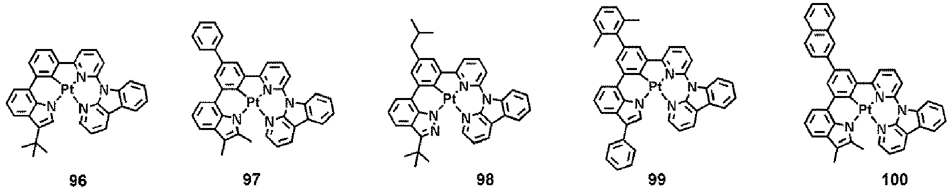

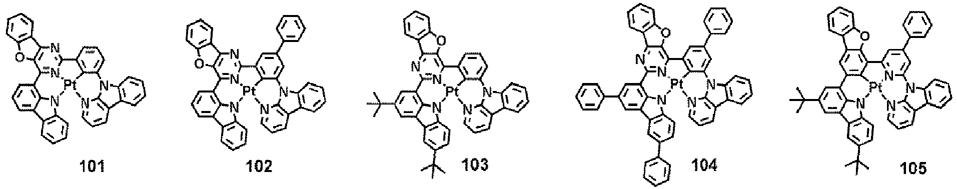

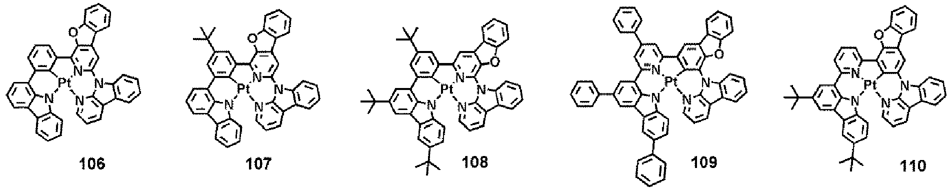

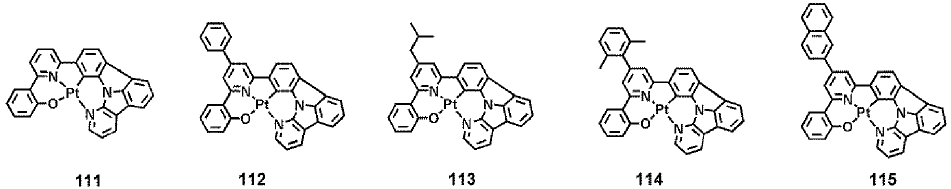

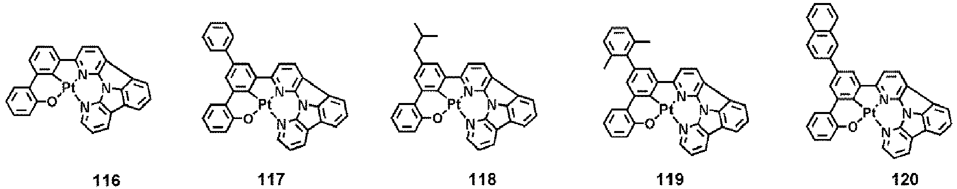

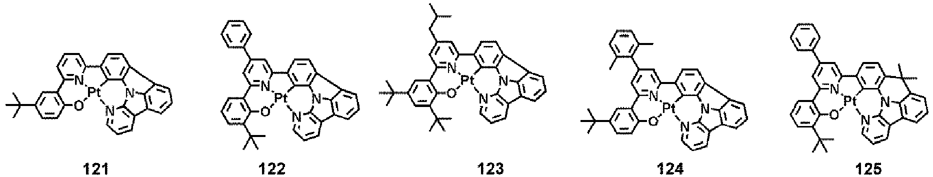

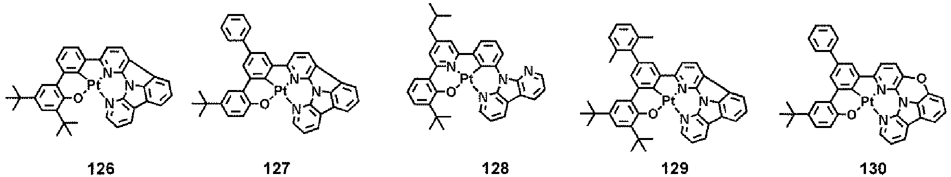

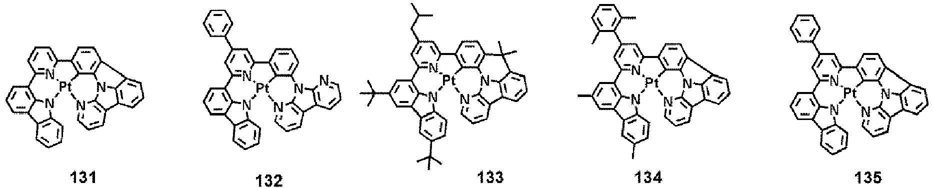

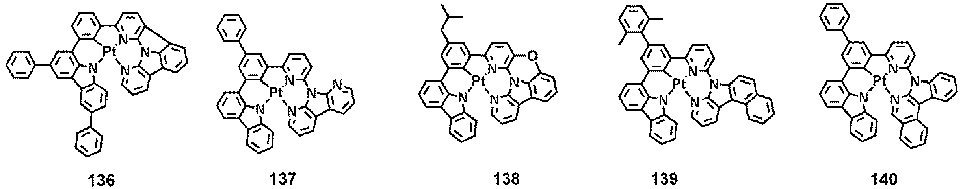

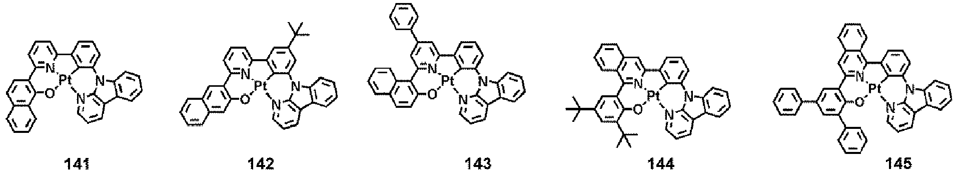

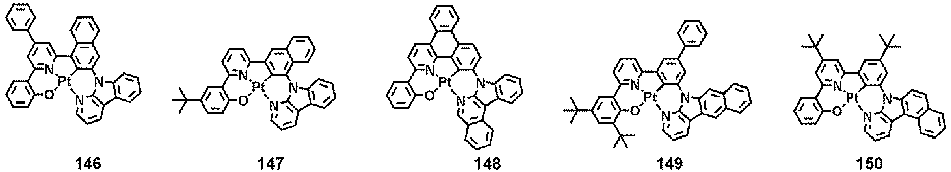

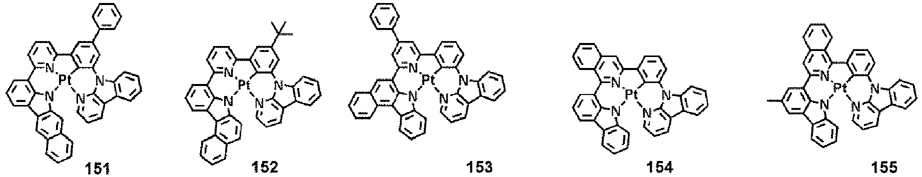

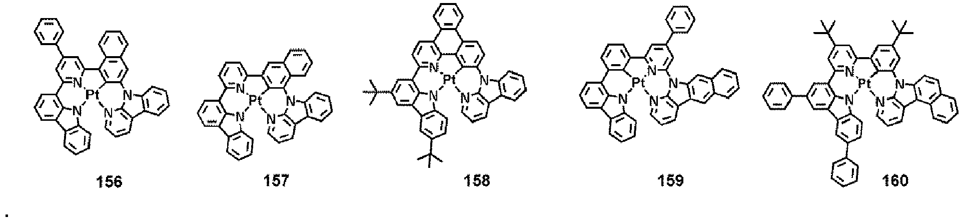

12. An organic light-emitting device comprising:
a first electrode;
a second electrode; and
an organic layer disposed between the first electrode and the second electrode, wherein the organic layer comprises an emission layer, and
wherein the organic layer comprises at least one organometallic compound of any of claims 1-11.

13. The organic light-emitting device of claim 12, wherein
the first electrode is an anode,
the second electrode is a cathode, and
the organic layer further comprises a hole transport region disposed between the first electrode and the emission layer and an electron transport region disposed between the emission layer and the second electrode,
wherein the hole transport region comprises a hole injection layer, a hole transport layer, an electron blocking layer, or any combination thereof, and
wherein the electron transport region comprises a hole blocking layer, an electron transport layer, an electron injection layer, or any combination thereof.

14. The organic light-emitting device of claims 12 or 13, wherein the emission layer comprises the organometallic compound;
preferably wherein the emission layer further comprises a host, and wherein an amount of the host is larger than an amount of the organometallic compound.

15. A diagnostic composition comprising at least one organometallic compound of any of claims 1-11.

## Patentansprüche

1. Organometallische Verbindung dargestellt durch Formel 1: 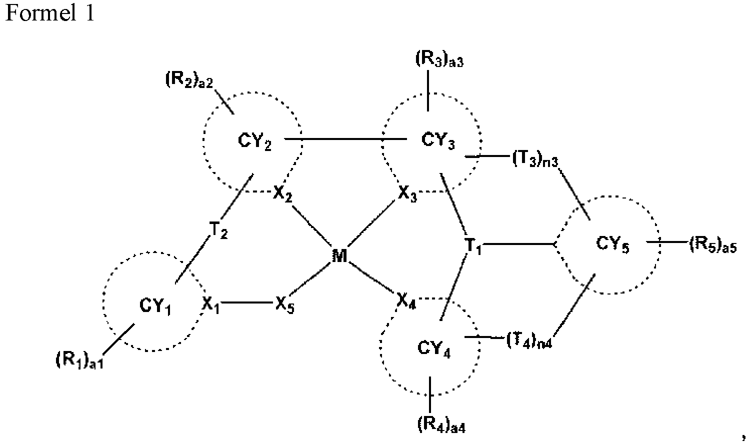 wobei in Formel 1
M Beryllium (Be), Magnesium (Mg), Aluminium (Al), Calcium (Ca), Titan (Ti), Mangan (Mn), Kobalt (Co), Kupfer (Cu), Zink (Zn), Gallium (Ga), Germanium (Ge), Zirkonium (Zr), Ruthenium (Ru), Rhodium (Rh), Palladium (Pd), Silber (Ag), Rhenium (Re), Platin (Pt) oder Gold (Au) ist,
X₁ bis X₄ jeweils unabhängig N oder C sind,
X₅ eine Einfachbindung, O, S, B(R'), N(R'), P(R'), C(R')(R"), Si(R')(R"), Ge(R')(R"), C(=O), B(R')(R"), N(R')(R") oder P(R')(R") ist,
zwei Bindungen ausgewählt aus einer Bindung zwischen X₁ oder X₅ und M, einer Bindung zwischen X₂ und M, einer Bindung zwischen X₃ und M und einer Bindung zwischen X₄ und M jeweils eine kovalente Bindung sind und die anderen Bindungen ausgewählt aus einer Bindung zwischen X₁ oder X₅ und M, einer Bindung zwischen X₂ und M, einer Bindung zwischen X₃ und M und einer Bindung zwischen X₄ und M jeweils eine koordinative Bindung sind,
CY₁ bis CY₅ jeweils unabhängig eine carbocyclische C₅-C₃₀-Gruppe oder eine heterocyclische C₁-C₃₀-Gruppe sind,
T₁ B, N oder P ist,
T₂ bis T₄ jeweils unabhängig ausgewählt sind aus einer Einfachbindung, einer Doppelbindung, *-N(R₇)-*', *-B(R₇)-*', *-P(R₇)-*', *-C(R₇)(R₈)-*', *-Si(R₇)(R₈)-*', *-Ge(R₇)(R₈)-*', *-S-*', *-Se-*', *-O-*', *-C(=O)-*', *-S(=O)-*', *-S(=O)₂-*', *-C(R₇)=*', *=C(R₇)-*', *-C(R₇)=C(R₈)-*', *-C(=S)-*' und *-C≡C-*' und * und *' jeweils eine Bindungsstelle zu einem benachbarten Atom angeben,
R₇ und R₈ optional über eine Einfachbindung, eine Doppelbindung oder eine erste Verknüpfungsgruppe verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
n3 und n4 jeweils unabhängig 0 oder 1 sind, wobei, wenn n3 0 ist, T₃ nicht existiert und CY₃ und CY₅ nicht miteinander verknüpft sind, und wenn n4 0 ist, T₄ nicht existiert und CY₄ und CY₅ nicht miteinander verknüpft sind,
die Summe von n3 und n4 1 oder 2 ist, vorausgesetzt, dass a) wenn n3 0 ist und n4 1 ist, X₄ N ist, b) wenn n3 1 ist und n4 0 ist, X₃ N ist, und c) wenn n3 und n4 1 sind, zumindest eines von X₃ und X₄ N ist,
R₁ bis R₅, R', R", R₇ und R₈ jeweils unabhängig ausgewählt sind aus Wasserstoff, Deuterium, -F, -Cl, -Br, -I, -SF₅, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polycyclischen Gruppe, einer substituierten oder unsubstituierten einwertigen nichtaromatischen kondensierten heteropolycyclischen Gruppe, -N(Q₁)(Q₂), -Si(Q₃)(Q₄)(Q₅), - B(Q₆)(Q₇) und -P(=O)(Q₈)(Q₉),
a1 bis a5 jeweils unabhängig eine ganze Zahl von 0 bis 20 sind,
zwei aus einer Vielzahl von benachbarten Gruppen R₁ optional verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei aus einer Vielzahl von benachbarten Gruppen R₂ optional verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei aus einer Vielzahl von benachbarten Gruppen R₃ optional verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei aus einer Vielzahl von benachbarten Gruppen R₄ optional verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei aus einer Vielzahl von benachbarten Gruppen R₅ optional verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr benachbarte Gruppen ausgewählt aus R₁ bis R₃ optional verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zumindest ein Substituent der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nichtaromatischen kondensierten polycyclischen Gruppe und der substituierten einwertigen nichtaromatischen kondensierten heteropolycyclischen Gruppe ausgewählt ist aus:
Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe und einer C₁-C₆₀-Alkoxygruppe,
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit zumindest einem ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -N(Q₁₁)(Q₁₂), -Si(Q₁₃)(Q₁₄)(Q₁₅), -B(Q₁₆)(Q₁₇) und - P(=O)(Q₁₈)(Q₁₉);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe, jeweils substituiert mit zumindest einem ausgewählt aus Deuterium, - F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -N(Q₂₁)(Q₂₂), -Si(Q₂₃)(Q₂₄)(Q₂₅), -B(Q₂₆)(Q₂₇) und -P(=O)(Q₂₈)(Q₂₉); und
-N(Q₃₁)(Q₃₂), -Si(Q₃₃)(Q₃₄)(Q₃₅), -B(Q₃₆)(Q₃₇) und -P(=O)(Q₃₈)(Q₃₉), und
Q₁ bis Q₉, Q₁₁ bis Q₁₉, Q₂₁ bis Q₂₉ und Q₃₁ bis Q₃₉ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₁-C₆₀-Alkylgruppe substituiert mit zumindest einem ausgewählt aus Deuterium, einer C₁-C₆₀-Alkylgruppe und einer C₆-C₆₀-Arylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit zumindest einem ausgewählt aus Deuterium, einer C₁-C₆₀-Alkylgruppe und einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe.

2. Organometallische Verbindung nach Anspruch 1, wobei
eine Bindung zwischen X₁ oder X₅ und M und eine Bindung zwischen X₃ und M jeweils eine kovalente Bindung sind und eine Bindung zwischen X₂ und M und eine Bindung zwischen X₄ und M jeweils eine koordinative Bindung sind, oder
eine Bindung zwischen X₁ oder X₅ und M und eine Bindung zwischen X₂ und M jeweils eine kovalente Bindung sind und eine Bindung zwischen X₃ und M und eine Bindung zwischen X₄ und M jeweils eine koordinative Bindung sind.

3. Organometallische Verbindung nach Anspruch 1 oder 2, wobei
Ring CY₁ bis CY₅ jeweils unabhängig ausgewählt sind aus einer Benzolgruppe, einer Naphthalengruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalengruppe, einer Furangruppe, einer Thiophengruppe, einer Silolgruppe, einer Indengruppe, einer Fluorengruppe, einer Indolgruppe, einer Carbazolgruppe, einer Benzofurangrupp, einer Dibenzofurangruppe, einer Benzothiophengruppe, einer Dibenzothiophengruppe, einer Benzosilolgruppe, einer Dibenzosilolgruppe, einer Azafluorengruppe, einer Azacarbazolgruppe, einer Azadibenzofurangruppe, einer Azadibenzothiophengruppe, einer Azadibenzosilolgruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrrolgruppe, einer Pyrazolgruppe, einer Imidazolgruppe, einer Triazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer Benzoxazolgruppe, einer Benzothiazolgruppe, einer Benzoxadiazolgruppe, einer Benzothiadiazolgruppe, einer 5,6,7,8-Tetrahydroisochinolingruppe, einer 5,6,7,8-Tetrahydrochinolingruppe, einer Indazolgruppe, einer Benzofluorengruppe, einer Benzocarbazolgruppe, einer Naphthobenzofurangruppe, einer Naphthobenzothiophengruppe und einer Naphtobenzosilolgruppe; und/oder
wobei
zumindest einer von Ring CY₁ und CY₂ ein kondensierter Ring beinhaltend zumindest einen 5-gliedrigen Ring kondensiert mit zumindest einem 6-gliedrigen Ring ist,
Ring CY₃ bis CY₅ jeweils unabhängig ein 6-gliedriger Ring oder ein kondensierter Ring beinhaltend zwei oder mehr 6-gliedrige Ringe, die miteinander kondensiert sind, sind,
der 5-gliedrige Ring ausgewählt ist aus einer Cyclopentadiengruppe, einer Furangruppe, einer Thiophengruppe, einer Pyrrolgruppe, einer Silolgruppe, einer Oxazolgruppe, einer Isoxazolgruppe, einer Oxadiazolgruppe, einer Isoxadiazolgruppe, einer Oxatriazolgruppe, einer Isoxatriazolgruppe, einer Thiazolgruppe, einer Isothiazolgruppe, einer Thiadiazolgruppe, einer Isothiadiazolgruppe, einer Thiatriazolgruppe, einer Isothiatriazolgruppe, einer Pyrazolgruppe, einer Imidazolgruppe, einer Triazolgruppe, einer Tetrazolgruppe, einer Azasilolgruppe, einer Diazasilolgruppe und einer Triazasilolgruppe, und
der 6-gliedrige Ring ausgewählt ist aus einer Cyclohexangruppe, einer Cyclohexengruppe, einer Benzolgruppe, einer Pyridingruppe, einer Pyrimidingruppe, einer Pyrazingruppe, einer Pyridazingruppe und einer Triazingruppe.

4. Organometallische Verbindung nach einem der Ansprüche 1-3, wobei
R₁ bis R₅, R', R", R₇ und R₈ jeweils unabhängig ausgewählt sind aus:
Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, -SF₅, einer C₁-C₂₀-Alkylgruppe und einer C₁-C₂₀-Alkoxygruppe,
einer C₁-C₂₀-Alkylgruppe und einer C₁-C₂₀-Alkoxygruppe, jeweils substituiert mit zumindest einem ausgewählt aus Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe, einer Phenoxygruppe und einer Naphtoxygruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe, einer Phenoxygruppe und einer Naphtoxygruppe, jeweils substituiert mit zumindest einem ausgewählt aus Deuterium, -F, -Cl, - Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe und - Si(Q₃₃)(Q₃₄)(Q₃₅); und
-N(Q₁)(Q₂), -Si(Q₃)(Q₄)(Q₅), -B(Q₆)(Q₇) und -P(=O)(Q₈)(Q₉), und
Q₁ bis Q₉ und Q₃₃ bis Q₃₅ jeweils unabhängig ausgewählt sind aus:
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit zumindest einem ausgewählt aus Deuterium, einer C₁-C₁₀-Alkylgruppe und einer Phenylgruppe;
wobei bevorzugt
R₁ bis R₅, R', R", R₇ und R₈ jeweils unabhängig ausgewählt sind aus Wasserstoff, Deuterium, -F, einer Cyanogruppe, einer Nitrogruppe, -SF₅, -CH₃, -CD₃, -CD₂H, -CDH₂, -CF₃, - CF₂H, -CFH₂, einer C₁-C₁₀-Alkoxygruppe, Gruppen dargestellt durch Formel 9-1 bis 9-19, Gruppen dargestellt durch Formel 10-1 bis 10-157, -N(Q₁)(Q₂), -Si(Q₃)(Q₄)(Q₅), -B(Q₆)(Q₇) und -P(=O)(Q₈)(Q₉): 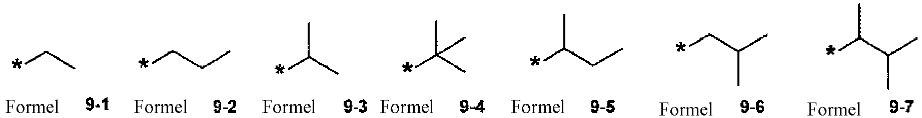 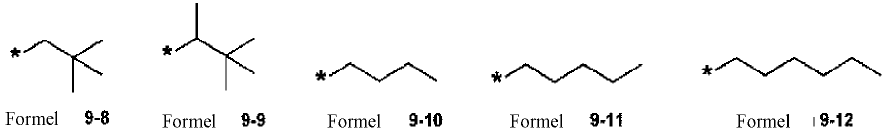 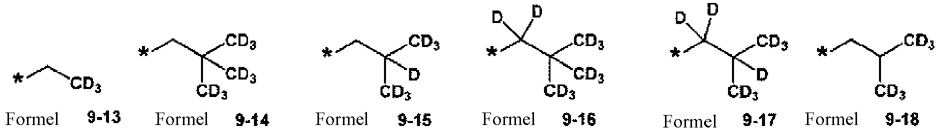 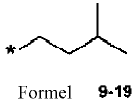 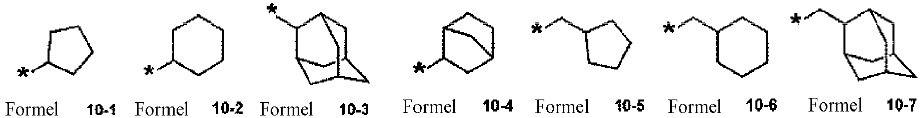 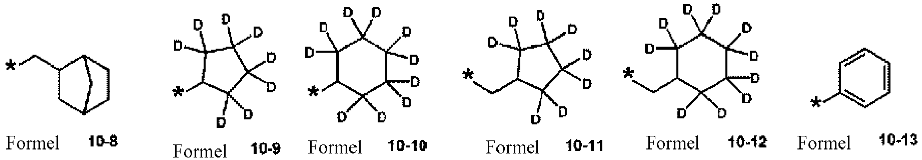 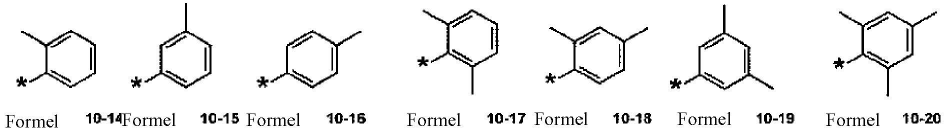 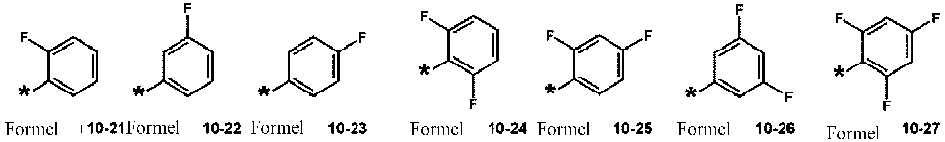 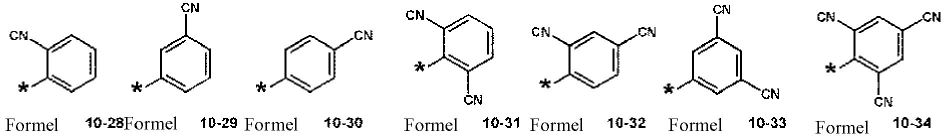 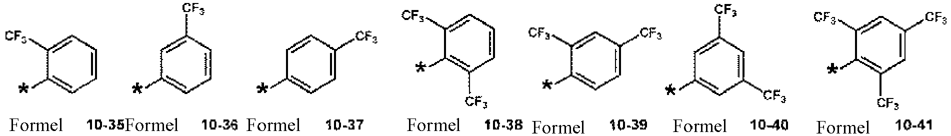 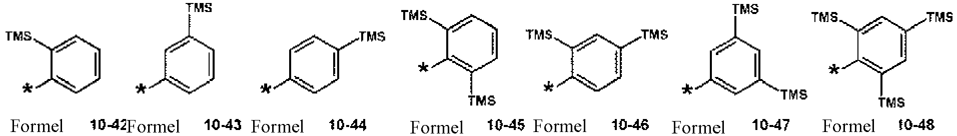 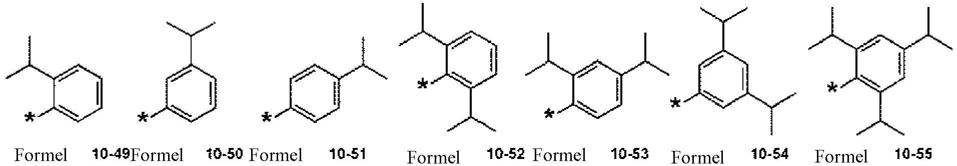 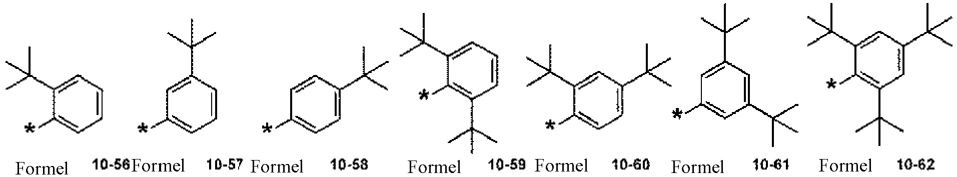 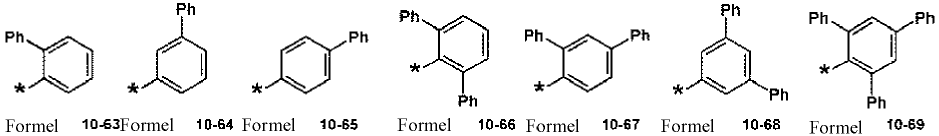 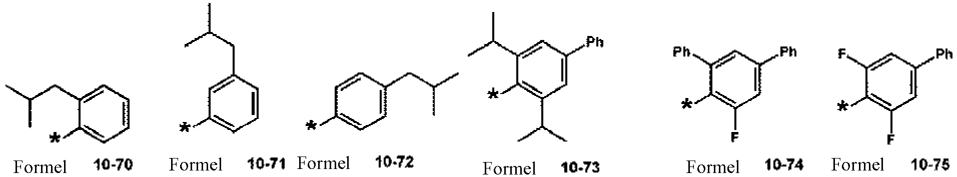 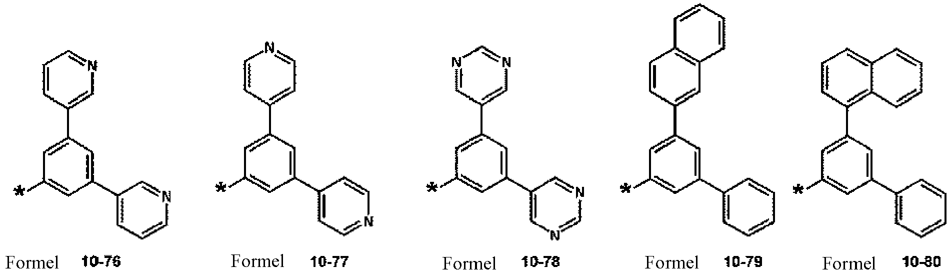 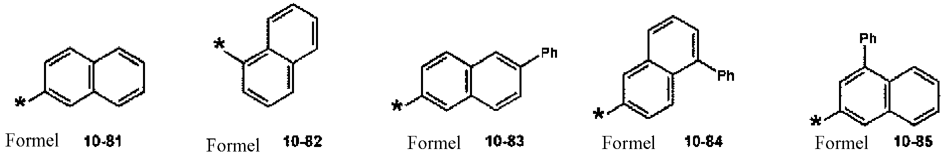 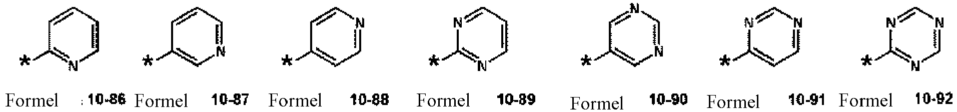 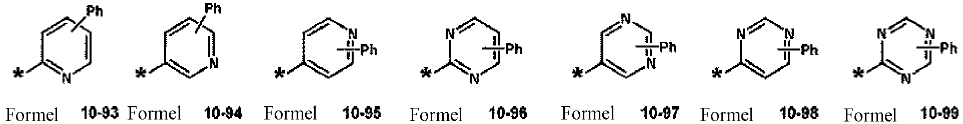 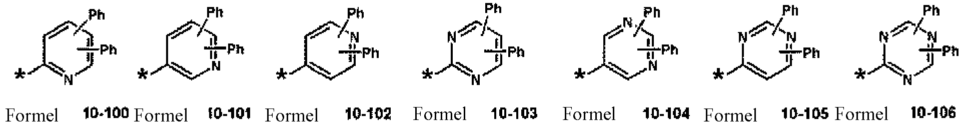 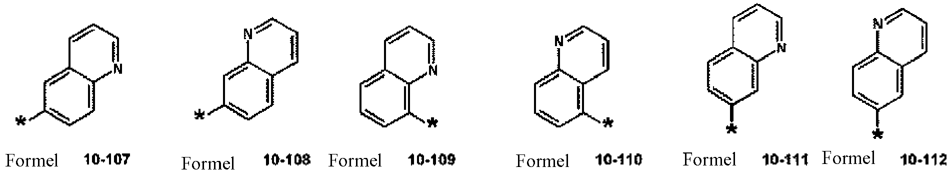 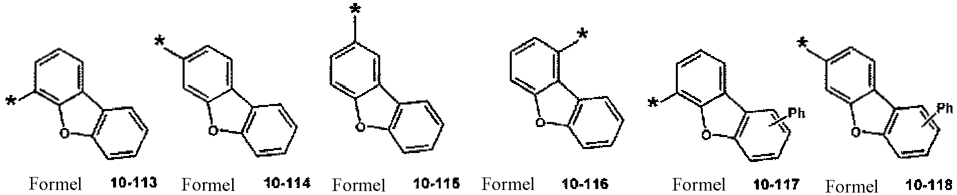 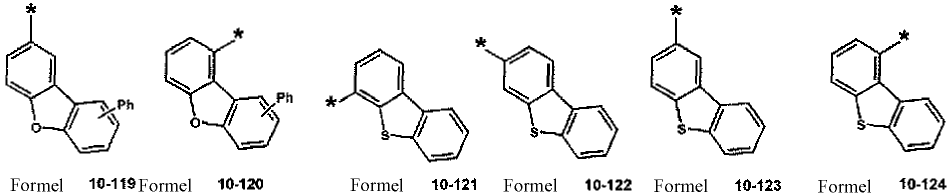 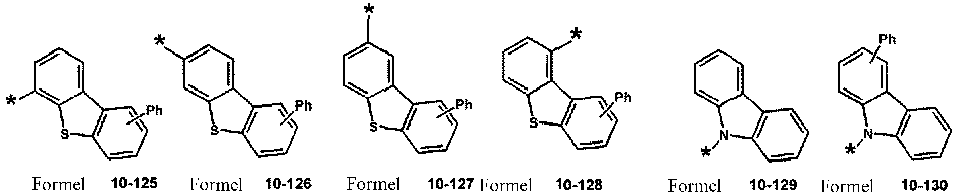 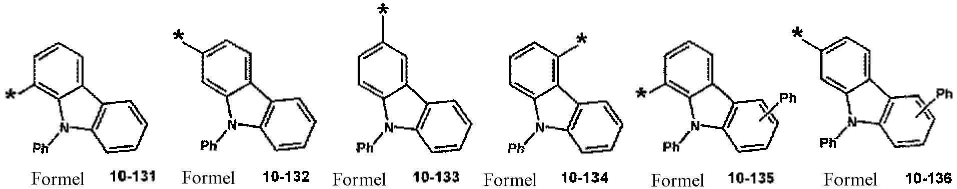 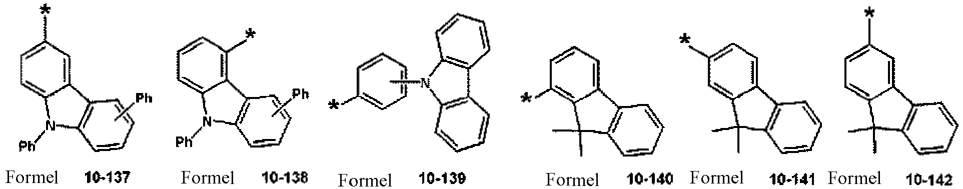 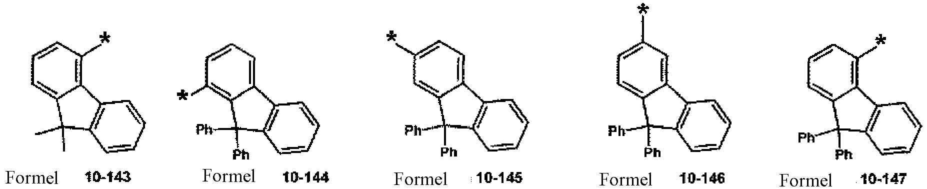 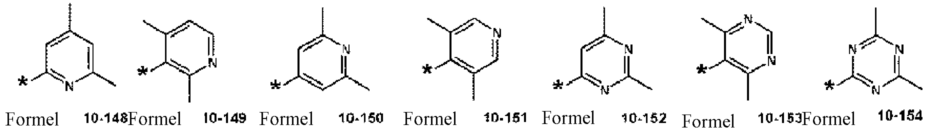 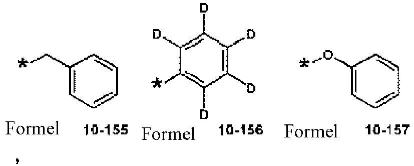
wobei in Formel 9-1 bis 9-19 und 10-1 bis 10-157 "Ph" eine Phenylgruppe angibt, "TMS" eine Trimethylsilylgruppe angibt und "*" eine Bindungsstelle zu einem benachbarten Atom angibt.

5. Organometallische Verbindung nach einem der Ansprüche 1-4, wobei
i) X₅ keine Einfachbindung ist, eine Einheit dargestellt durch 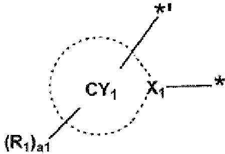 durch Formel A1-1 dargestellt ist, eine Einheit dargestellt durch 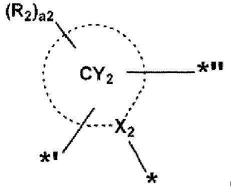 durch Formel A2-1 oder A2-2 dargestellt ist und T₂ eine Einfachbindung ist;
ii) X₅ eine Einfachbindung ist, eine Einheit dargestellt durch 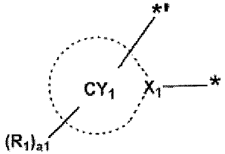 durch Formel A1-2 dargestellt ist, eine Einheit dargestellt durch 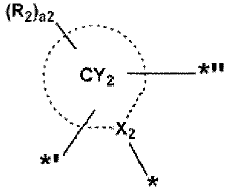 durch Formel A2-1 oder A2-2 dargestellt ist und T₂ eine Einfachbindung ist;
iii) X₅ eine Einfachbindung ist, eine Einheit dargestellt durch 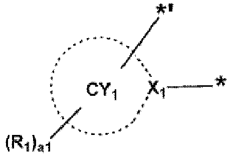 durch Formel A1-1 dargestellt ist, eine Einheit dargestellt durch 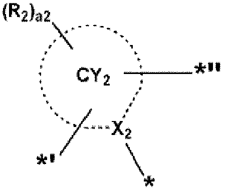 durch Formel A2-1 oder A2-2 dargestellt ist und T₂ keine Einfachbindung ist; oder
iv) X₅ eine Einfachbindung ist, eine Einheit dargestellt durch 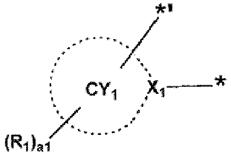 durch Formel A1-1 dargestellt ist, eine Einheit dargestellt durch 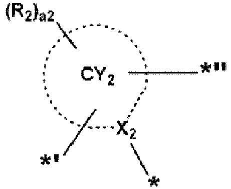 durch Formel A2-3 dargestellt ist und T₂ eine Einfachbindung ist: 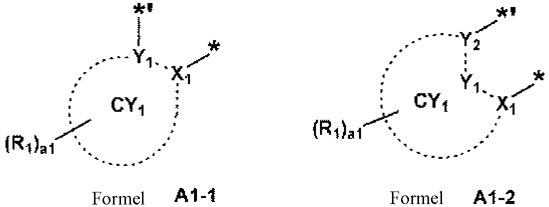 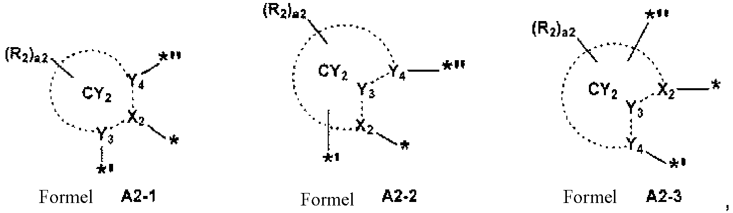 wobei in Formel A1-1, A1-2 und A2-1 bis A2-3
X₁, X₂, Ring CY₁, Ring CY₂, R₁, R₂, a1 und a2 dieselben wie in Anspruch 1 sind,
Y₁ bis Y₄ jeweils unabhängig N oder C sind,
* in Formel A1-1 und A1-2 eine Bindungsstelle zu M in Formel 1 angibt,
*' in Formel A1-1 und A1-2 eine Bindungsstelle zu T₂ in Formel 1 angibt,
* in Formel A2-1 bis A2-3 eine Bindungsstelle zu M in Formel 1 angibt,
*' in Formel A2-1 bis A2-3 eine Bindungsstelle zu T₂ in Formel 1 angibt, und
*" in Formel A2-1 bis A2-3 eine Bindungsstelle zu Ring CY₃ in Formel 1 angibt.

6. Organometallische Verbindung nach einem der Ansprüche 1-5, wobei
eine Einheit dargestellt durch 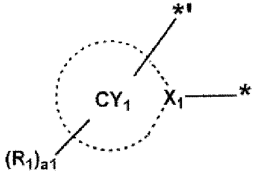 in Formel 1 dargestellt ist durch eine der Formeln A1-1(1) bis A1-1(26) und A1-2(1) bis A1-2(76), und
eine Einheit dargestellt durch 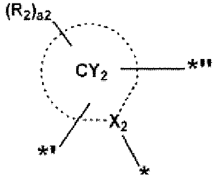 in Formel 1 dargestellt ist durch eine der Formeln A2-1(1) bis A2-1(21), A2-2(1) bis A2-2(58) und A2-3(1) bis A2-3(58): 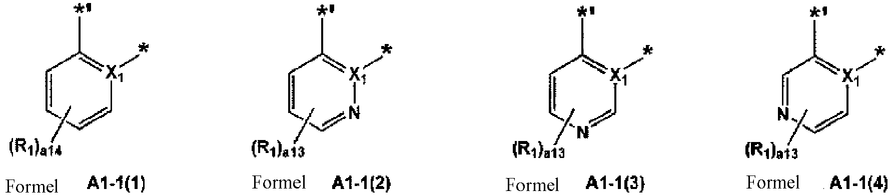 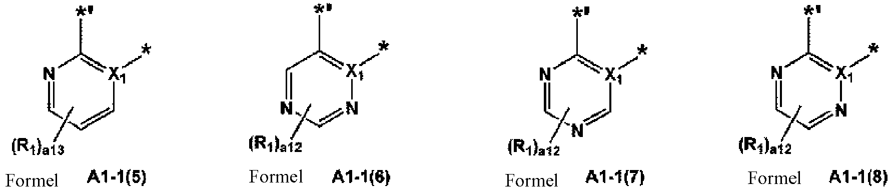 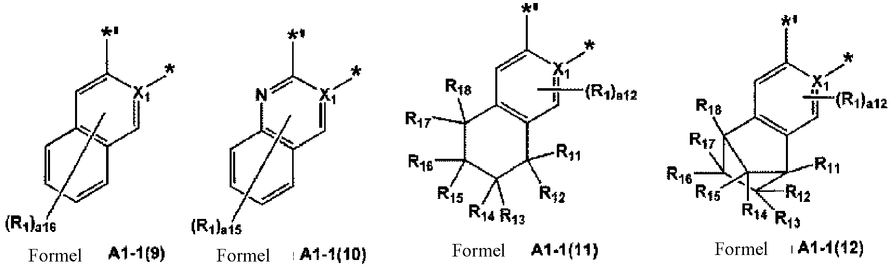 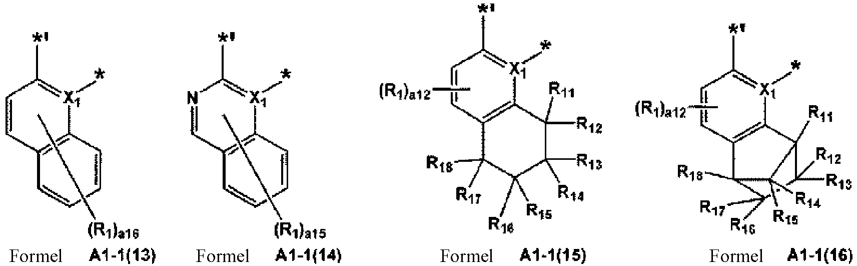 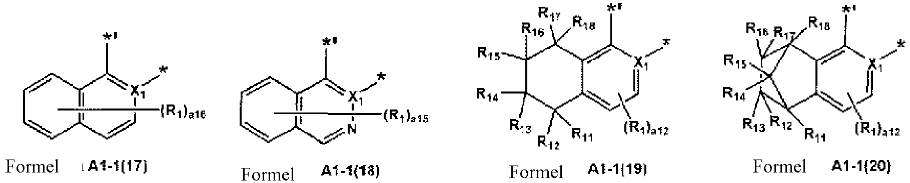 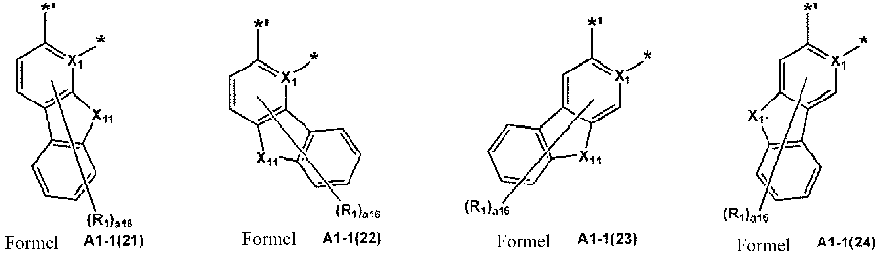 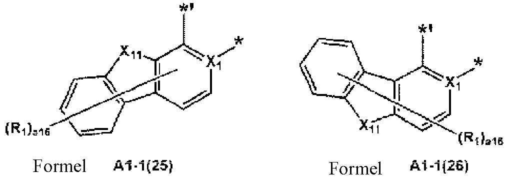 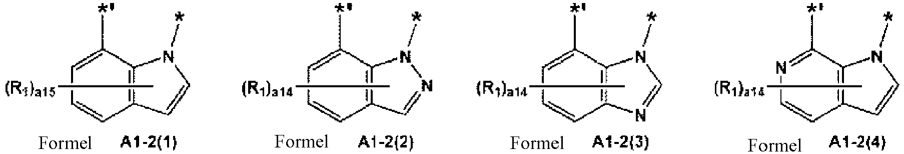 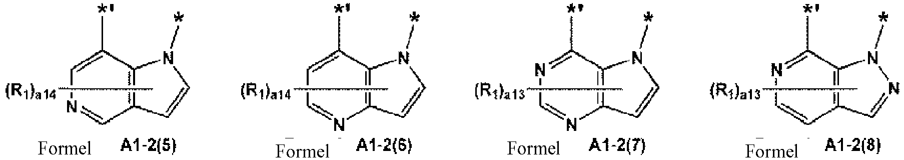 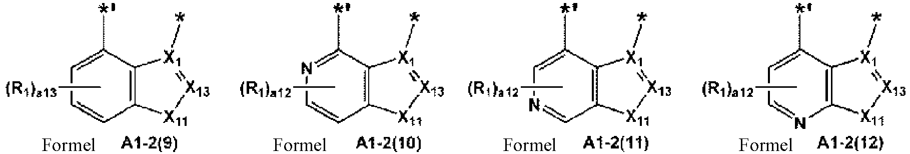 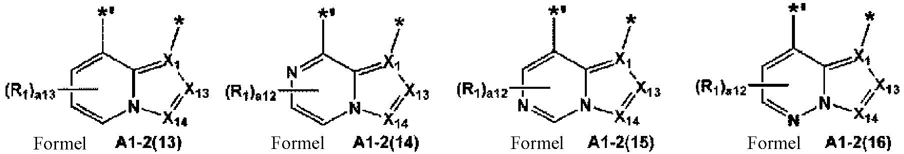 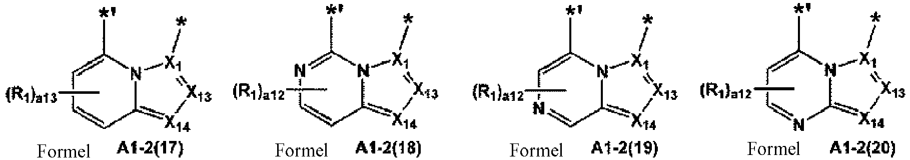 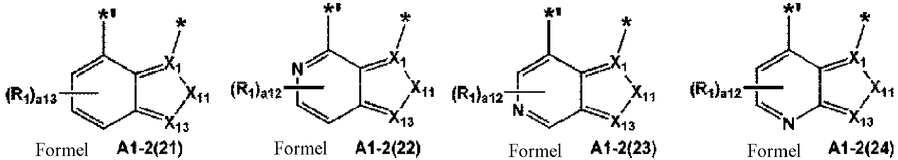 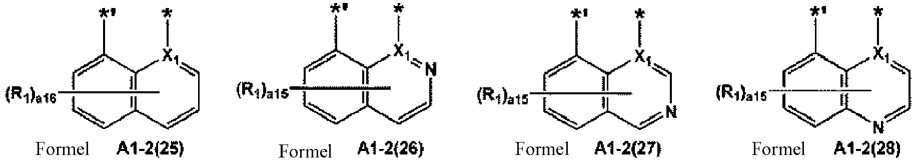 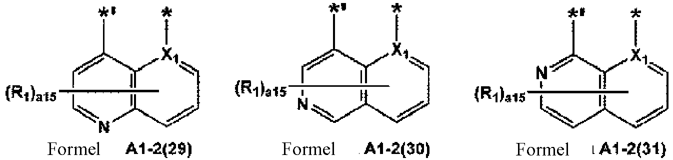 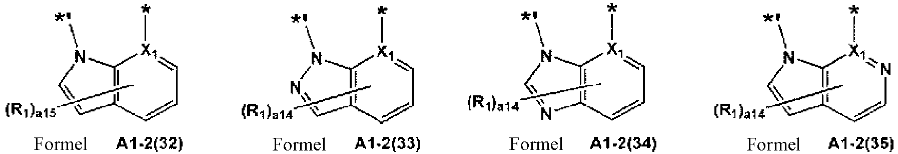 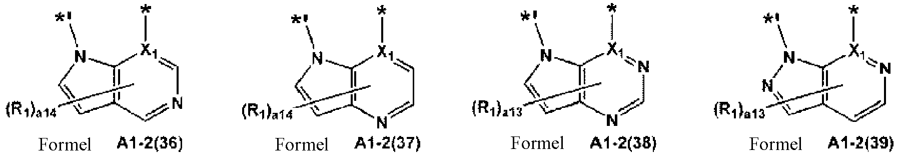 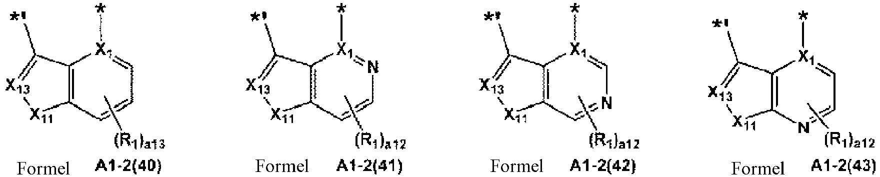 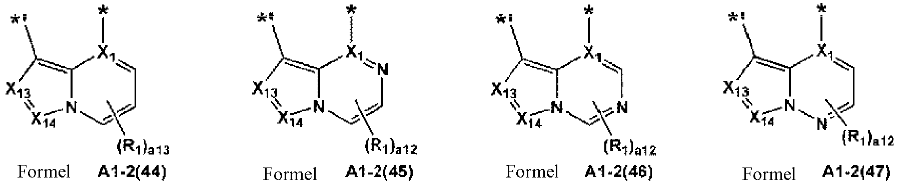 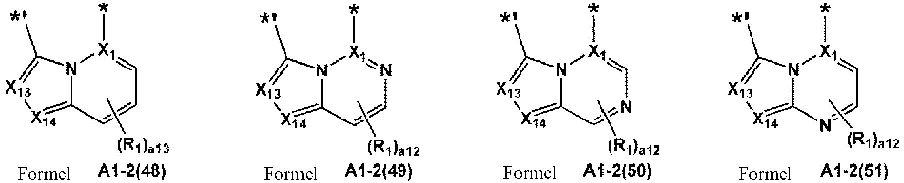 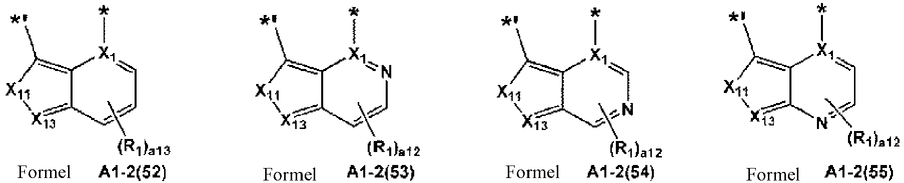 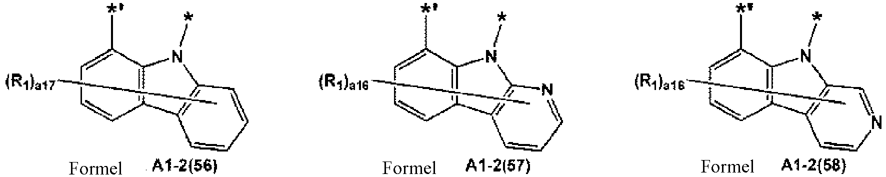 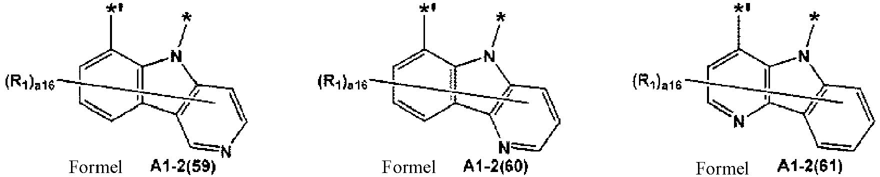 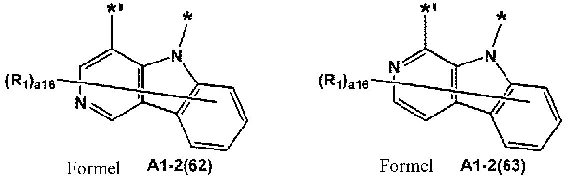 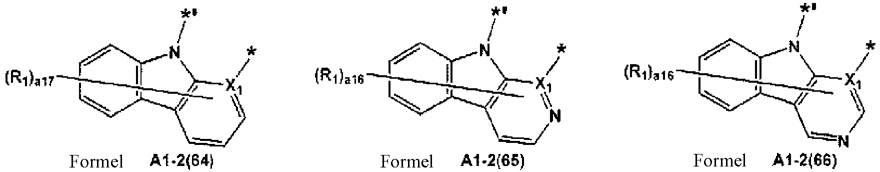 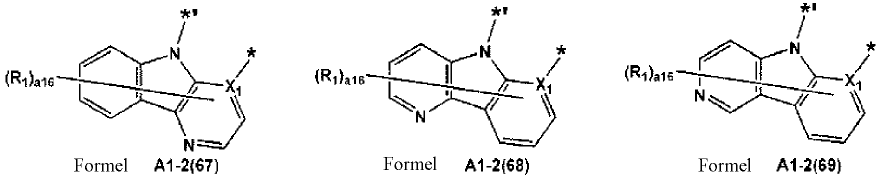 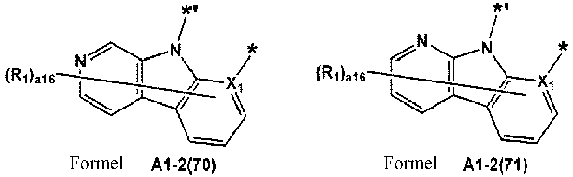 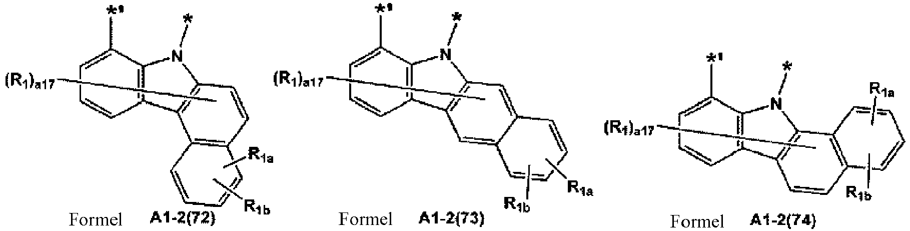 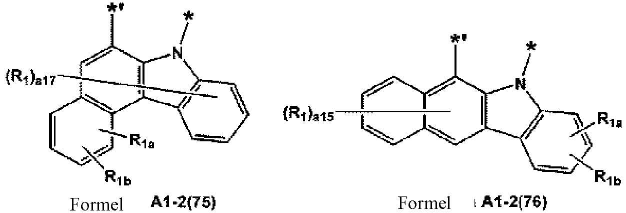
, wobei in Formel A1-1(1) bis A1-1(26) und A1-2(1) bis A1-2(76)
X₁ und R₁ dieselben wie in Anspruch 1 sind,
X₁₁ O, S, N(R₁₁), C(R₁₁)(R₁₂) oder Si(R₁₁)(R₁₂) ist,
X₁₃ N oder C(R₁₃) ist,
X₁₄ N oder C(R₁₄) ist,
R₁ₐ, R_{1b} und R₁₁ bis R₁₈ dieselben wie R₁ in Anspruch 1 sind,
a17 eine ganze Zahl von 0 bis 7 ist,
a16 eine ganze Zahl von 0 bis 6 ist,
a15 eine ganze Zahl von 0 bis 5 ist,
a14 eine ganze Zahl von 0 bis 4 ist,
a13 eine ganze Zahl von 0 bis 3 ist,
a12 eine ganze Zahl von 0 bis 2 ist,
* eine Bindungsstelle zu M in Formel 1 angibt, und
* eine Bindungsstelle zu T₂ in Formel 1 angibt: 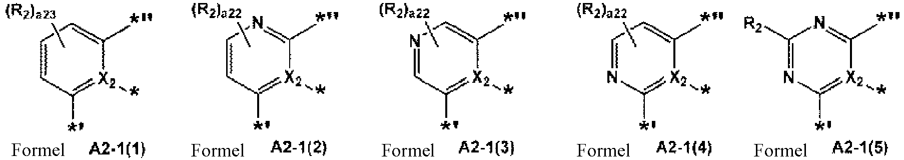 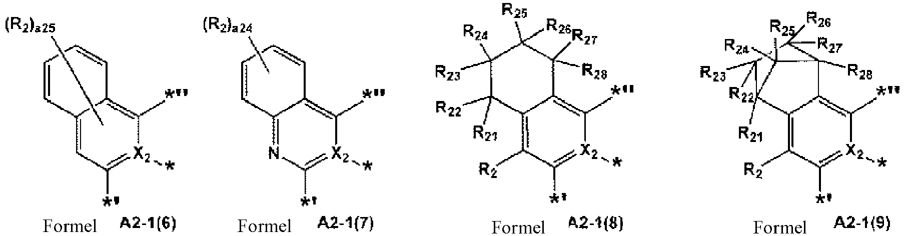 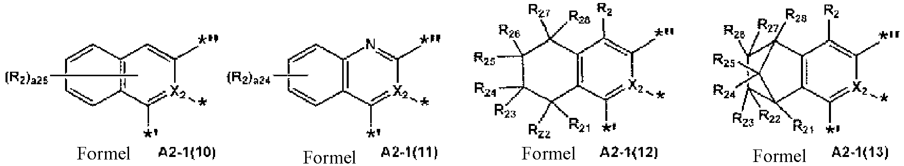 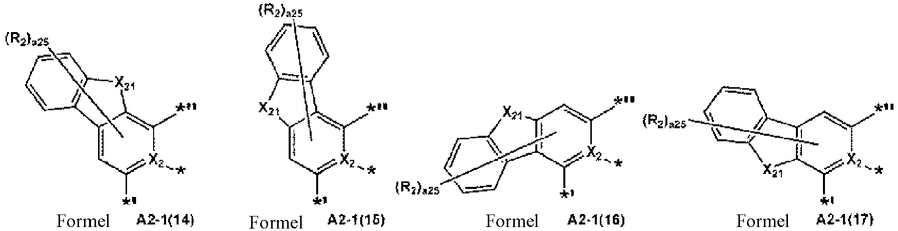 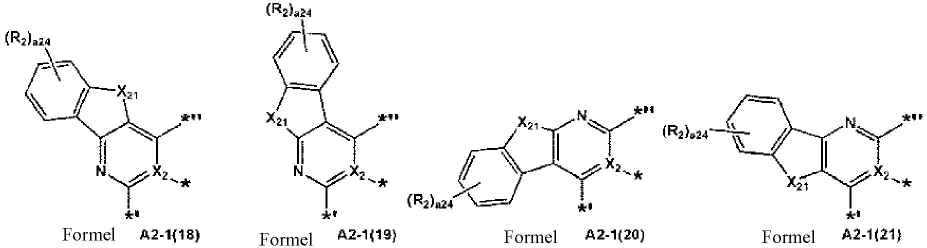 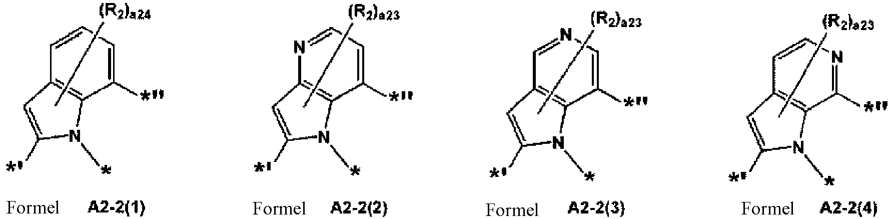 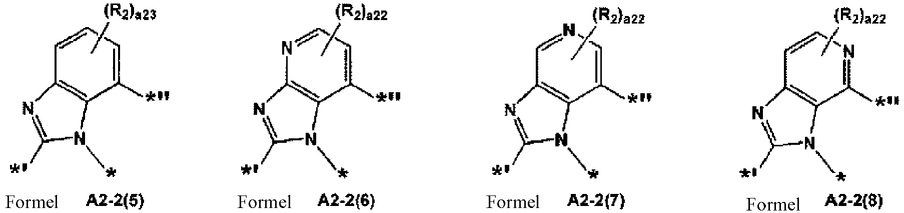 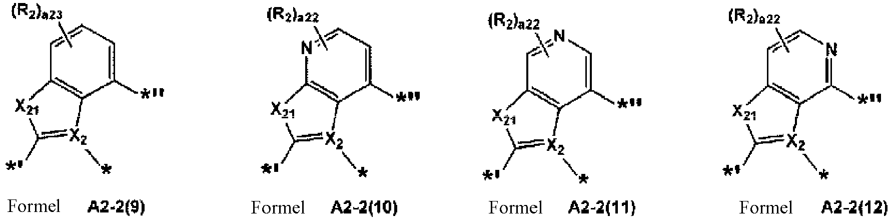 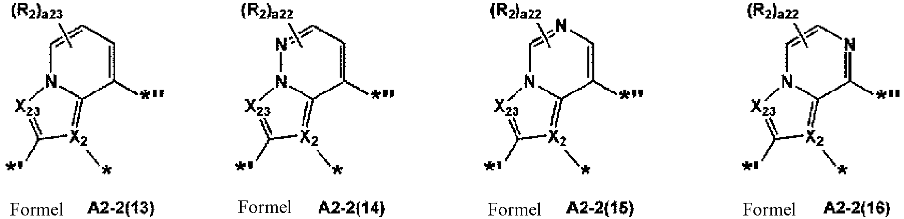 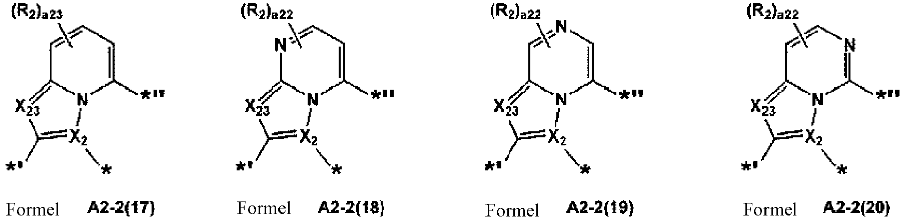 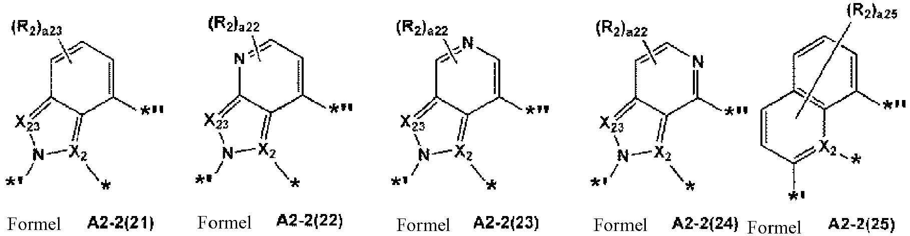 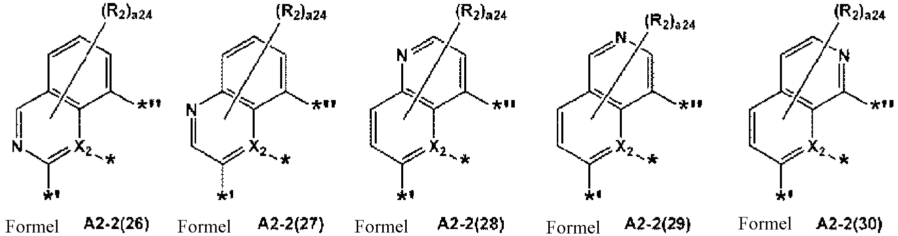 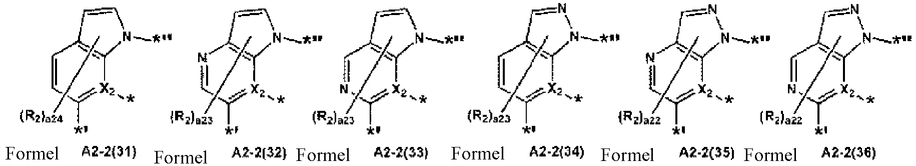 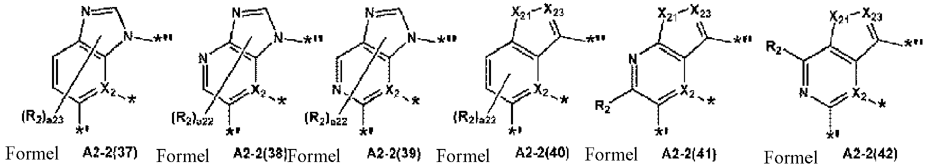 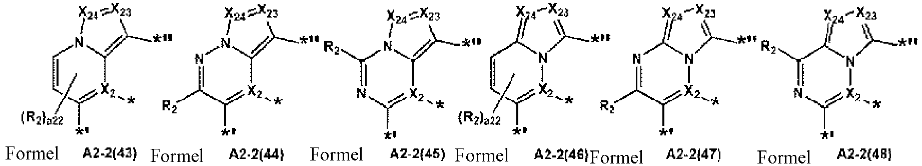 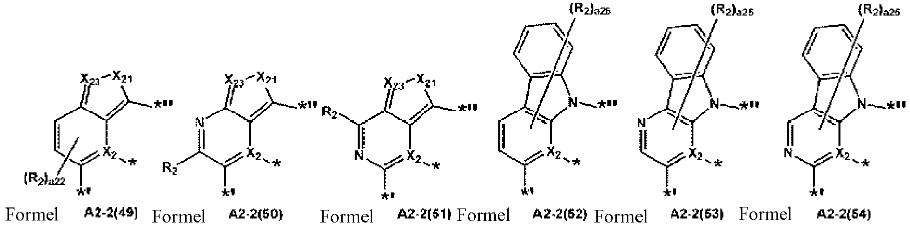 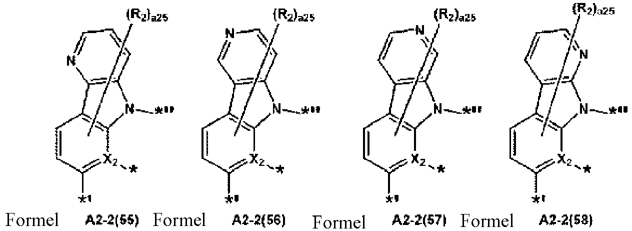 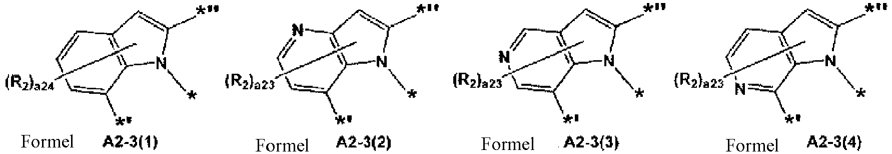 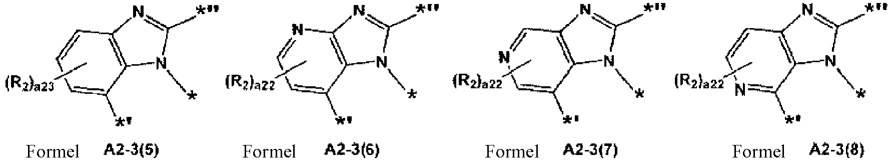 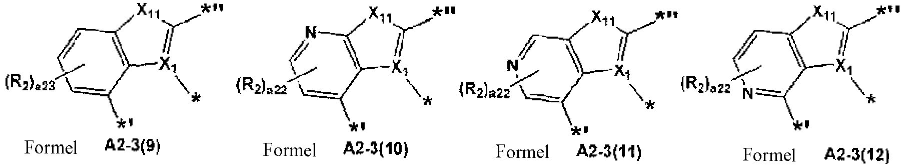 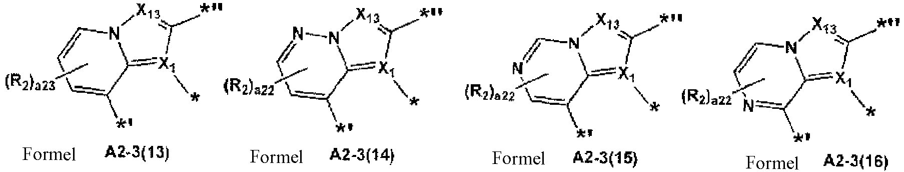 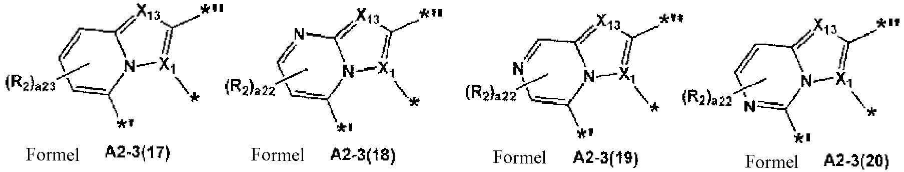 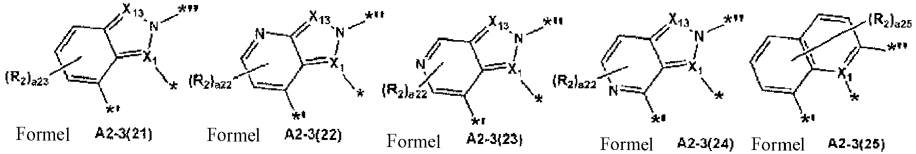 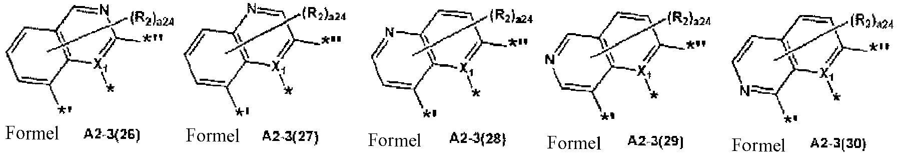 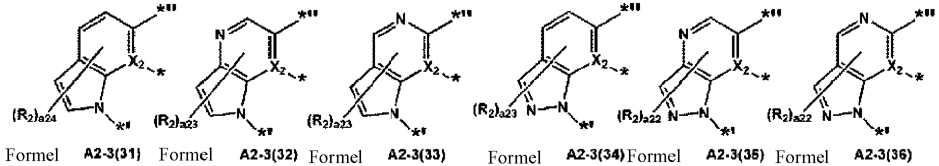 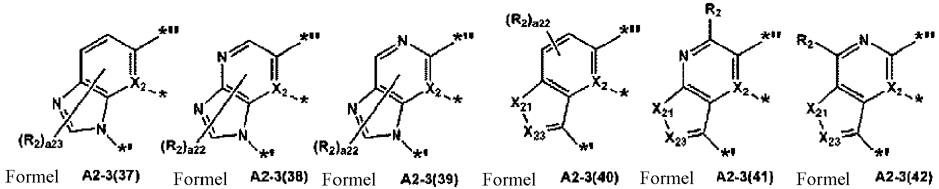 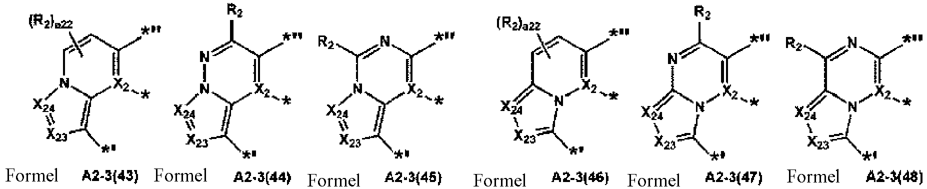 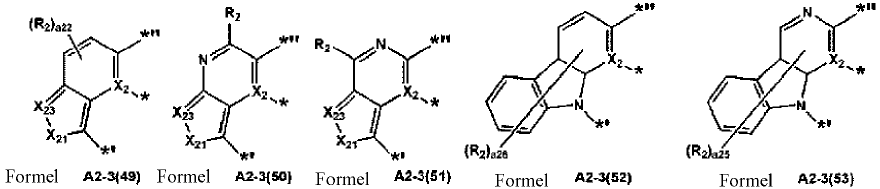 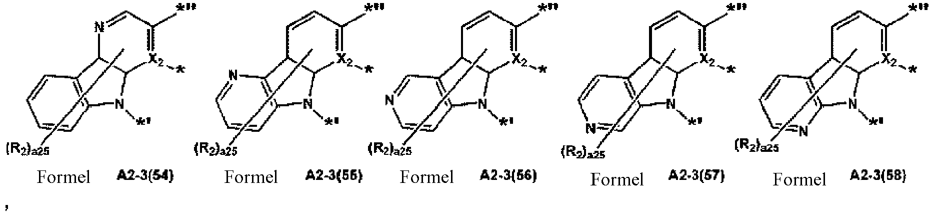
wobei in Formel A2-1 (1) bis A2-1 (21), A2-2(1) bis A2-2(58) und A2-3(1) bis A2-3(58)
X₂ und R₂ dieselben wie in Anspruch 1 sind,
X₂₁ O, S, N(R₂₁), C(R₂₁)(R₂₂) oder Si(R₂₁)(R₂₂) ist,
X₂₃ N oder C(R₂₃) ist,
X₂₄ N oder C(R₂₄) ist,
R₂₁ bis R₂₈ dieselben wie R₂ in Anspruch 1 sind,
a26 eine ganze Zahl von 0 bis 6 ist,
a25 eine ganze Zahl von 0 bis 5 ist,
a24 eine ganze Zahl von 0 bis 4 ist,
a23 eine ganze Zahl von 0 bis 3 ist,
a22 eine ganze Zahl von 0 bis 2 ist,
* eine Bindungsstelle zu M in Formel 1 angibt,
*' eine Bindungsstelle zu T₂ in Formel 1 angibt, und
*" eine Bindungsstelle zu Ring CY₃ in Formel 1 angibt;
wobei bevorzugt
i) X₅ keine Einfachbindung ist, eine Einheit dargestellt durch 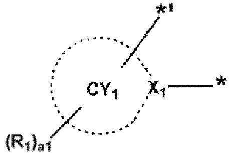 dargestellt ist durch eine der Formeln A1-1(1) bis A1-1(26), eine Einheit dargestellt durch 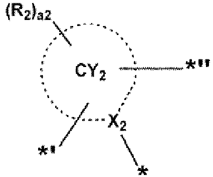 dargestellt ist durch eine der Formeln A2-1(1) bis A2-1(21) und T₂ eine Einfachbindung ist;
ii) X₅ eine Einfachbindung ist, eine Einheit dargestellt durch 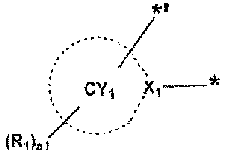 dargestellt ist durch eine der Formeln A1-2(1) bis A1-2(76), eine Einheit dargestellt durch 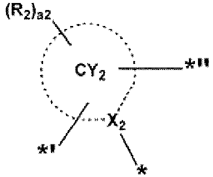 dargestellt ist durch eine der Formeln A2-1(1) bis A2-1(21) und T₂ eine Einfachbindung ist;
iii) X₅ eine Einfachbindung ist, eine Einheit dargestellt durch 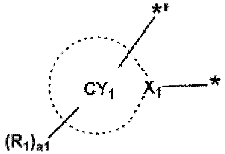 dargestellt ist durch eine der Formeln A1-1(1) bis A1-1(26), eine Einheit dargestellt durch 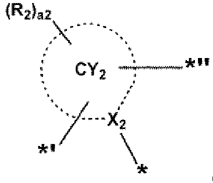 dargestellt ist durch eine der Formeln A2-1(1) bis A2-1(21) und T₂ keine Einfachbindung ist; oder
iv) X₅ eine Einfachbindung ist, eine Einheit dargestellt durch 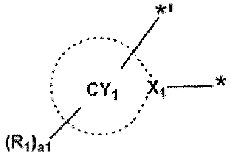 dargestellt ist durch eine der Formeln A1-1(1) bis A1-1(26), eine Einheit dargestellt durch 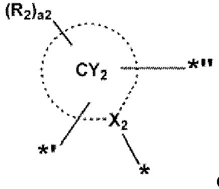 dargestellt ist durch eine der Formeln A2-3(1) bis A2-3(58) und T₂ eine Einfachbindung ist.

7. Organometallische Verbindung nach einem der Ansprüche 1-6, wobei
eine Einheit dargestellt durch 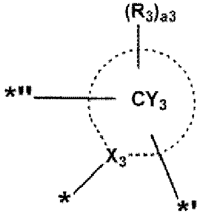 in Formel 1 dargestellt ist durch eine der Formeln A3-1(1) bis A3-1(21) und A3-3(1) bis A3-3(58): 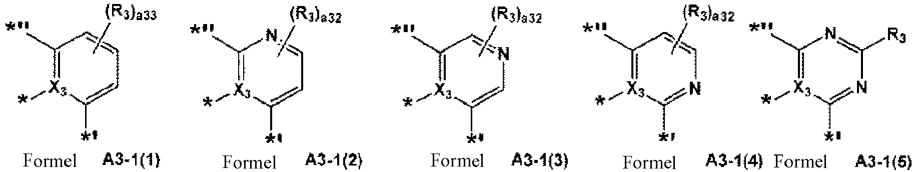 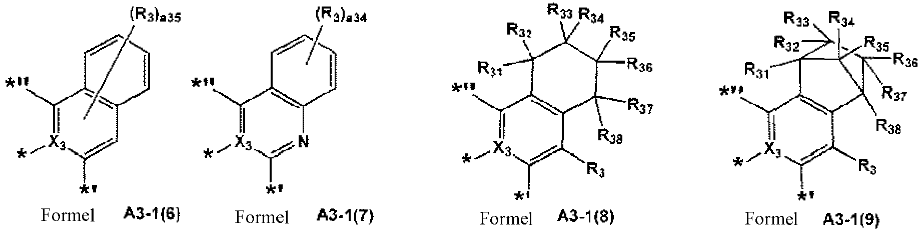 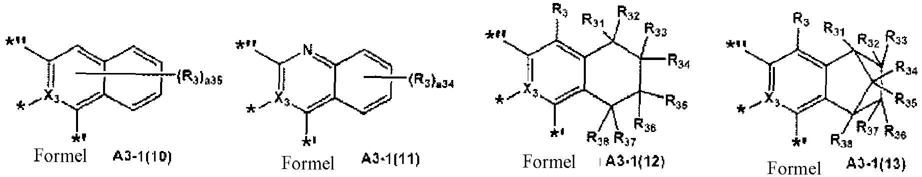 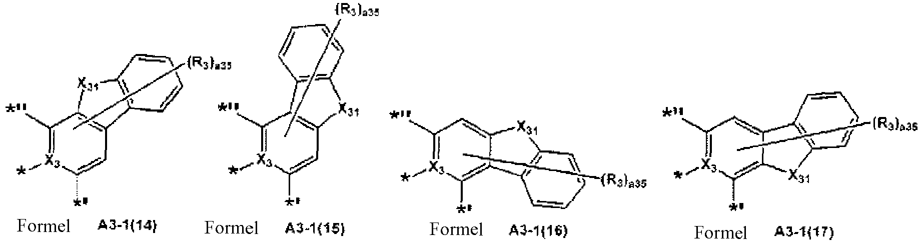 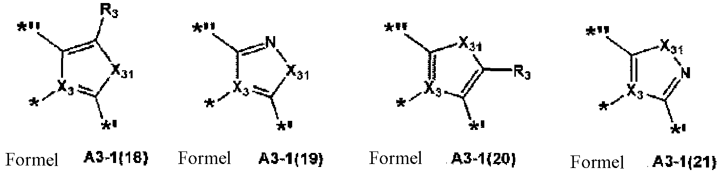 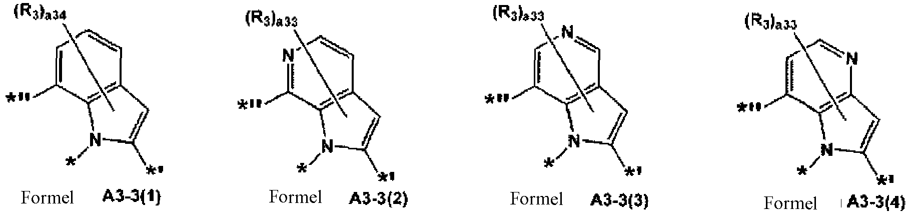 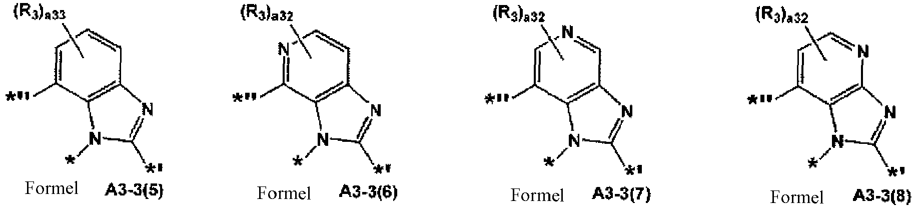 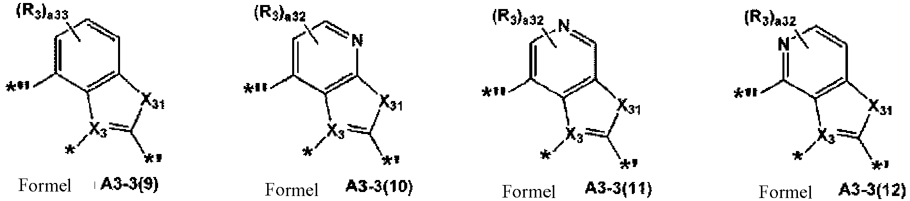 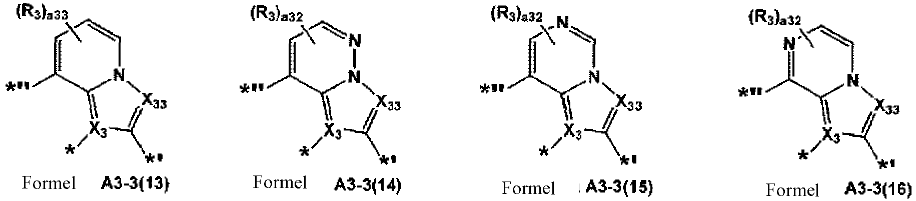 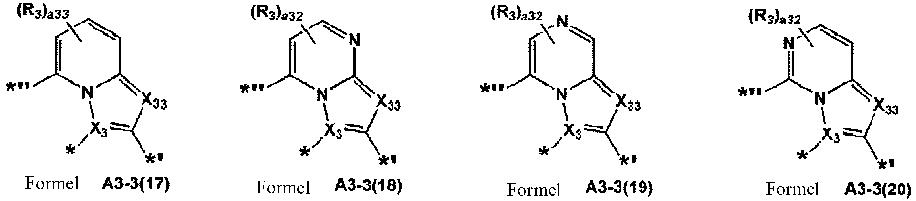 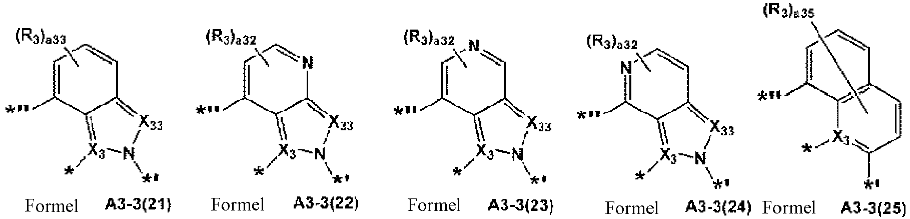 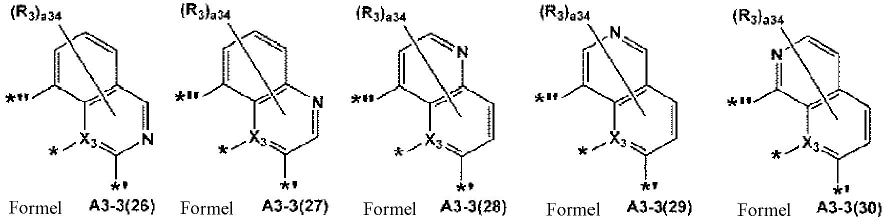 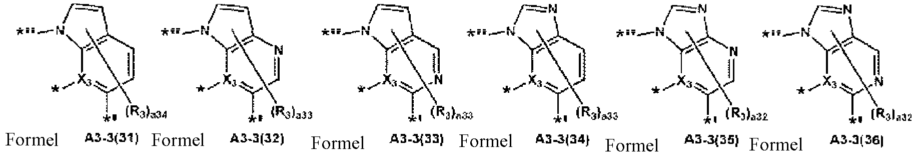 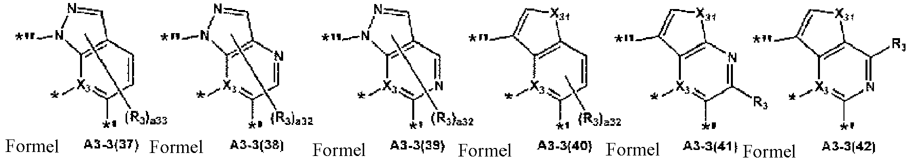 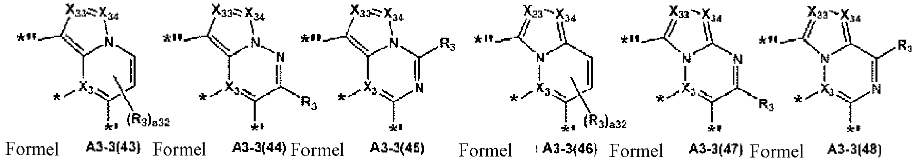 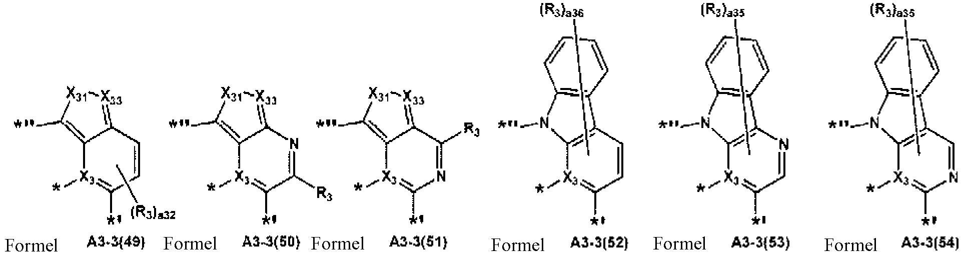 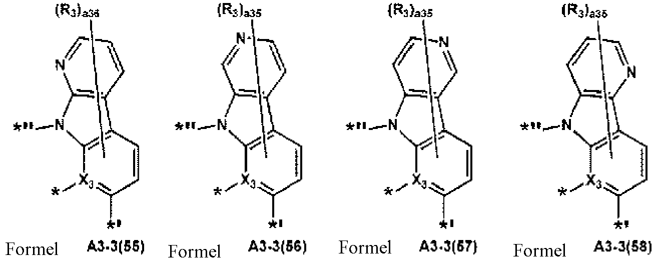 , wobei in Formel A3-1(1) bis A3-1(21) und A3-3(1) bis A3-3(58),
X₃ und R₃ dieselben wie in Anspruch 1 sind,
X₃₁ O, S, N(R₃₁), C(R₃₁)(R₃₂) oder Si(R₃₁)(R₃₂) ist,
X₃₃ N oder C(R₃₃) ist,
X₃₄ N oder C(R₃₄) ist,
R₃₁ bis R₃₈ dieselben R₃ in Anspruch 1 sind,
a36 eine ganze Zahl von 0 bis 6 ist,
a35 eine ganze Zahl von 0 bis 5 ist,
a34 eine ganze Zahl von 0 bis 4 ist,
a33 eine ganze Zahl von 0 bis 3 ist,
a32 eine ganze Zahl von 0 bis 2 ist,
* eine Bindungsstelle zu M in Formel 1 angibt,
*" eine Bindungsstelle zu Ring CY₂ in Formel 1 angibt, und
*' eine Bindungsstelle zu T₁ in Formel 1 angibt.

8. Organometallische Verbindung nach einem der Ansprüche 1-7, wobei
eine Einheit dargestellt durch 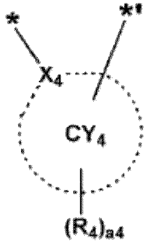 in Formel 1 dargestellt ist durch eine der Formeln A4-1(1) bis A4-1(44): 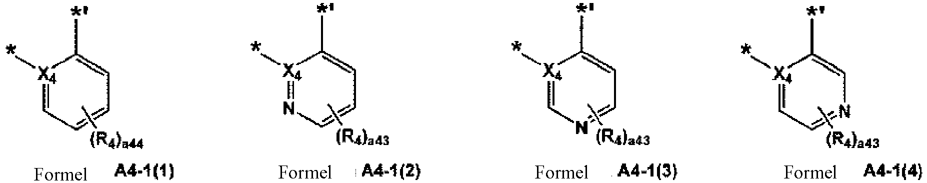 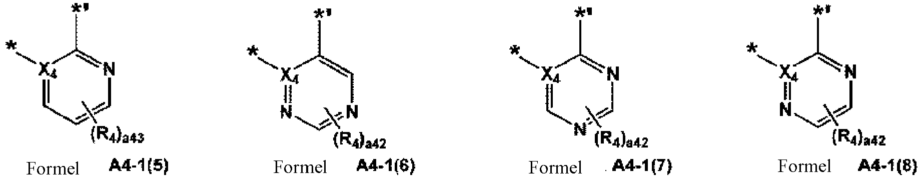 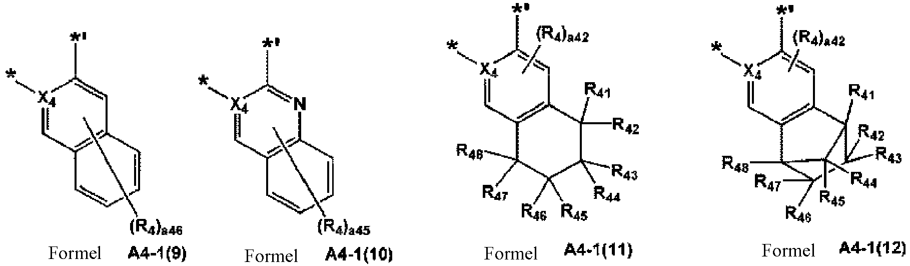 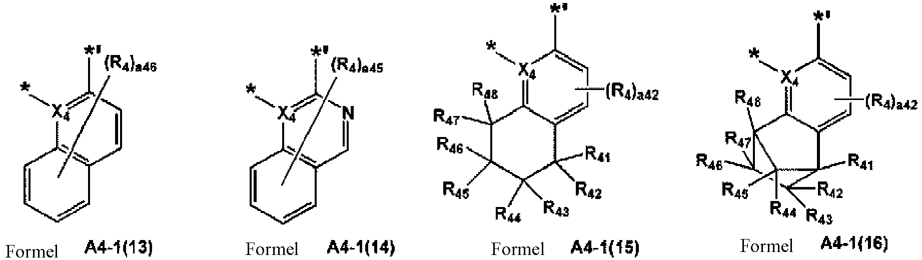 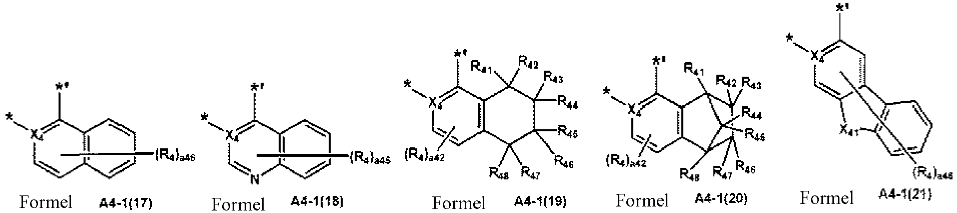 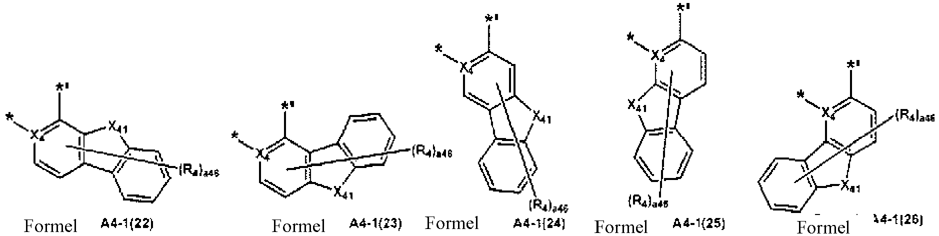 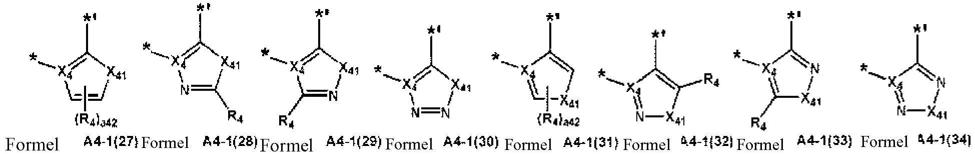 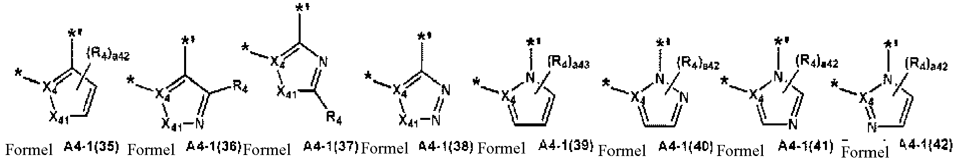 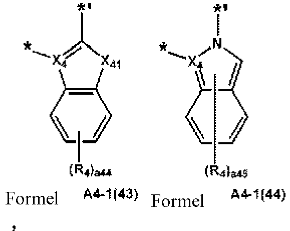 wobei in Formel A4-1(1) bis A4-1(44)
X₄, R₄, * und *' dieselben wie in Anspruch 1 sind,
X₄₁ O, S, N(R₄₁), C(R₄₁)(R₄₂) oder Si(R₄₁)(R₄₂) ist,
X₄₃ N oder C(R₄₃) ist,
X₄₄ N oder C(R₄₄) ist,
R₄₁ bis R₄₈ dieselben wie R₄ sind,
a47 eine ganze Zahl von 0 bis 7 ist,
a46 eine ganze Zahl von 0 bis 6 ist,
a45 eine ganze Zahl von 0 bis 5 ist,
a44 eine ganze Zahl von 0 bis 4 ist,
a43 eine ganze Zahl von 0 bis 3 ist,
a42 eine ganze Zahl von 0 bis 2 ist,
* eine Bindungsstelle zu M in Formel 1 angibt, und
*' eine Bindungsstelle zu T₁ in Formel 1 angibt.

9. Organometallische Verbindung nach einem der Ansprüche 1-8, wobei
in Formel 1
ein cyclometallierter Ring gebildet durch M, X₅, Ring CY₁, T₂ und Ring CY₂ und ein cyclometallierter Ring gebildet durch M, Ring CY₄, T₁ und Ring CY₃ jeweils ein 6-gliedriger Ring sind, und
ein cyclometallierter Ring gebildet durch M, Ring CY₂ und Ring CY₃ ein 5-gliedriger Ring ist.

10. Organometallische Verbindung nach einem der Ansprüche 1-9, wobei
die organometallische Verbindung dargestellt ist durch eine der Formeln 1-1 bis 1-3: 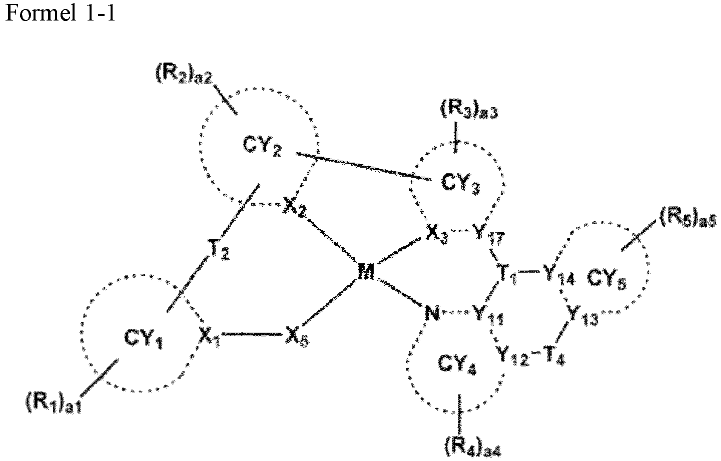 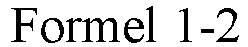 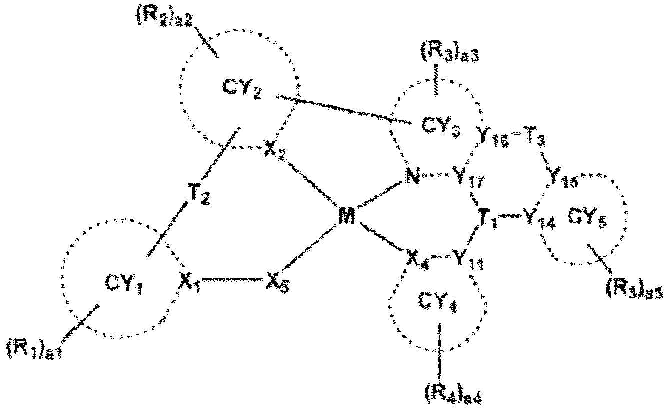 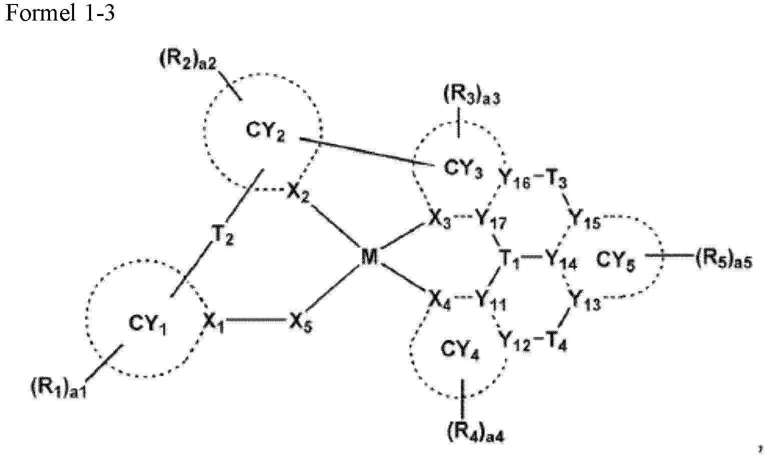 wobei in Formel 1-1 bis 1-3
M, X₁ bis X₅, Ring CY₁ bis CY₅, T₁ bis T₄, R₁ bis R₅ und a1 bis a5 dieselben wie in Anspruch 1 sind, vorausgesetzt, dass zumindest eines von X₃ und X₄ in Formel 1-3 N ist, und
Y₁₁ und Y₁₇ jeweils unabhängig C oder N sind; oder
wobei
die organometallische Verbindung dargestellt ist durch eine der Formeln 1A-1 bis 1A-3 und 1B: 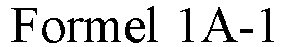 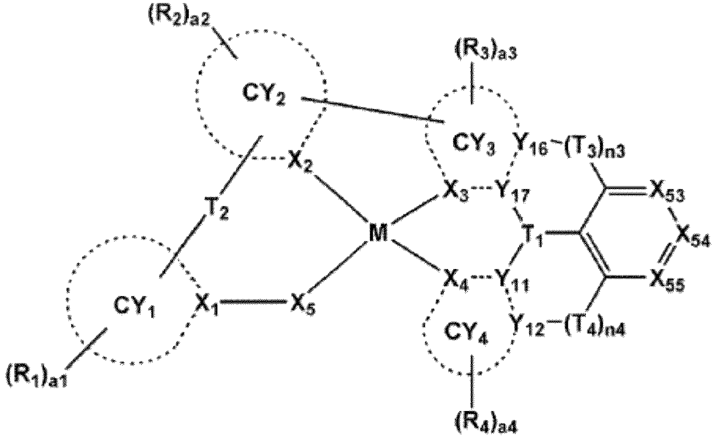 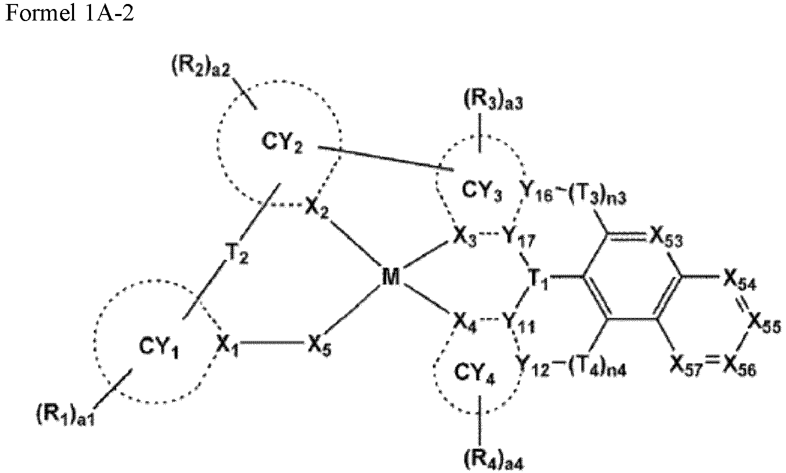 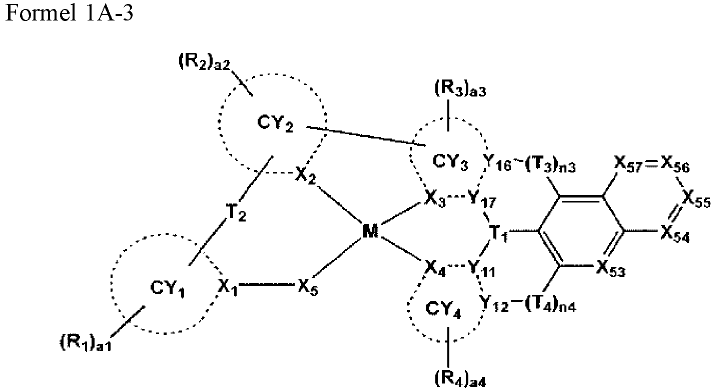 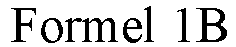 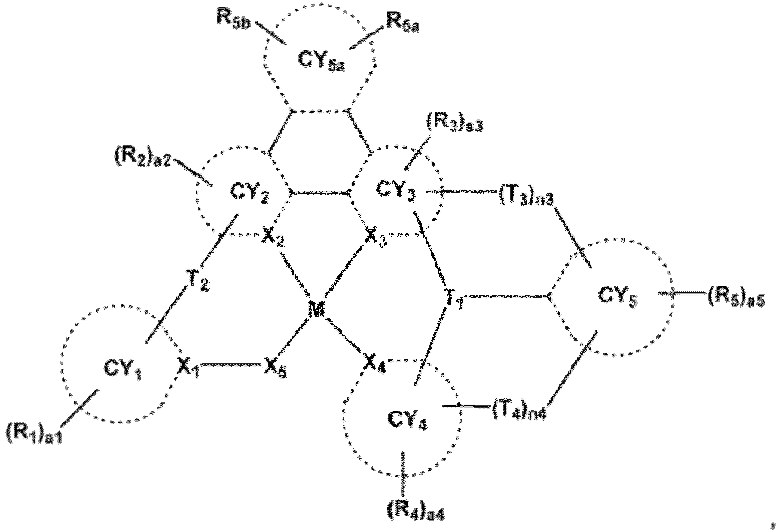 wobei in Formel 1A-1 bis 1A-3 und 1B
M, X₁ bis X₅, Ring CY₁, Ring CY₂, T₁ bis T₄, n3, n4, R₁, R₂, a1 und a2 dieselben wie in Anspruch 1 sind,
X₅₃ N oder C(R₅₃) ist, X₅₄ N oder C(R₅₄) ist, X₅₅ N oder C(R₅₅) ist, X₅₆ N oder C(R₅₆) ist und X₅₇ N oder C(R₅₇) ist,
R₅₃ bis R₅₇ dieselben wie R₅ in Anspruch 1 sind,
Y₁₁, Y₁₂, Y₁₆ und Y₁₇ jeweils unabhängig C oder N sind,
CY₅ₐ dasselbe wie CY₅ in Anspruch 1 ist, und
R₅ₐ und R_{5b} dieselben wie R₅ in Anspruch 1 sind.

11. Organometallische Verbindung nach einem der Ansprüche 1-10, wobei die organometallische Verbindung eine der Verbindungen 1 bis 160 ist:

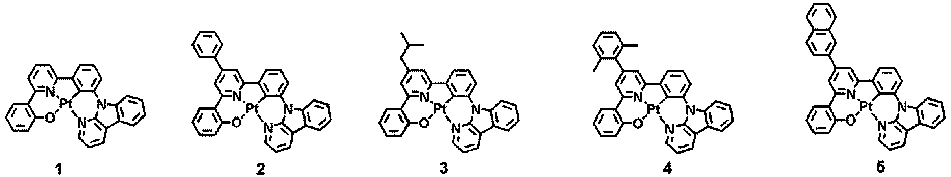

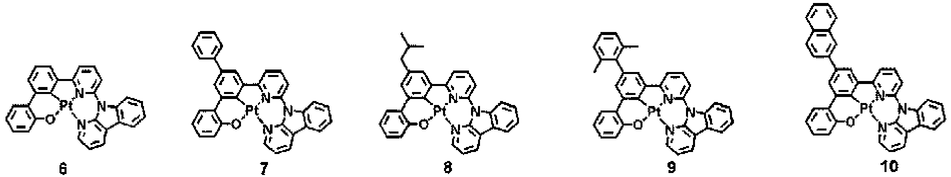

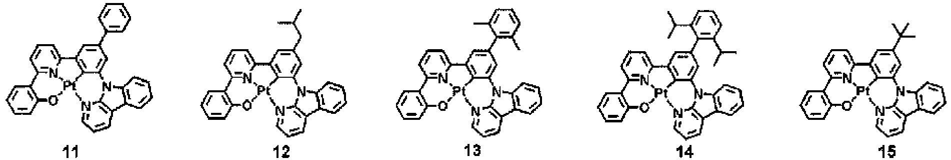

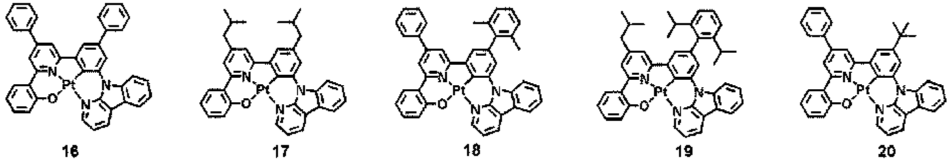

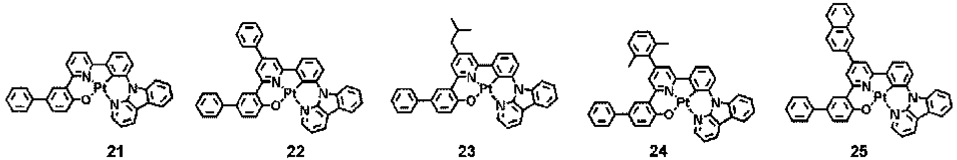

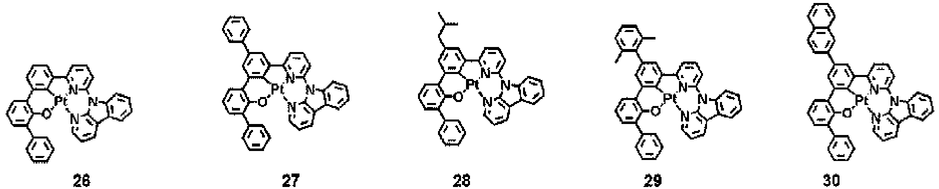

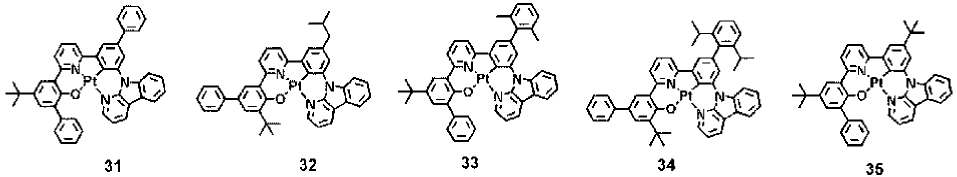

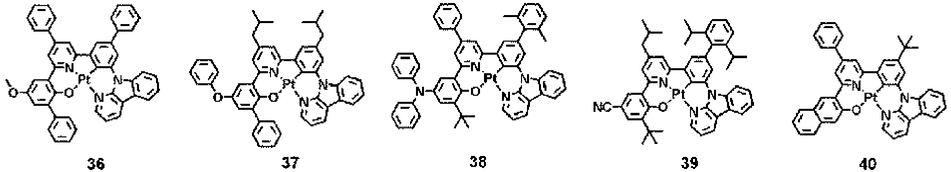

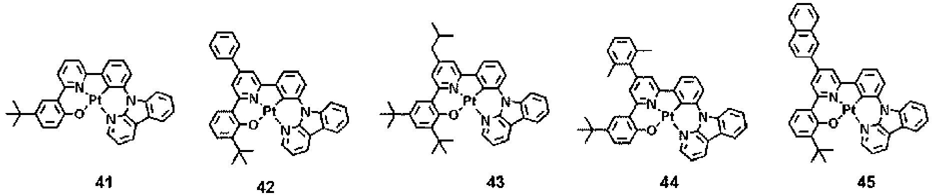

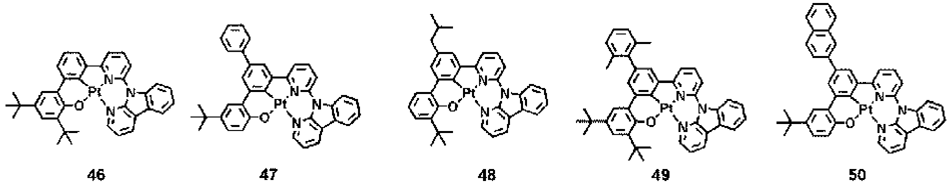

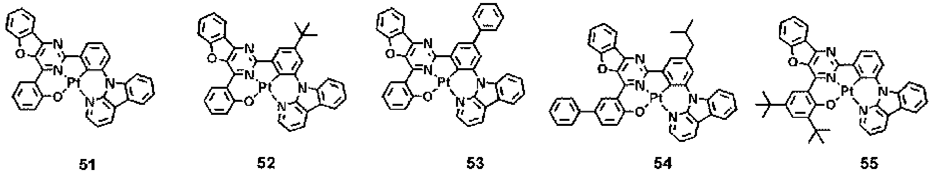

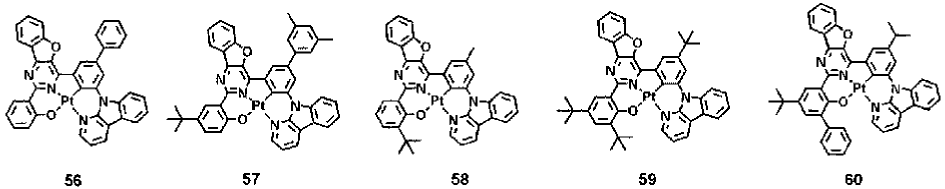

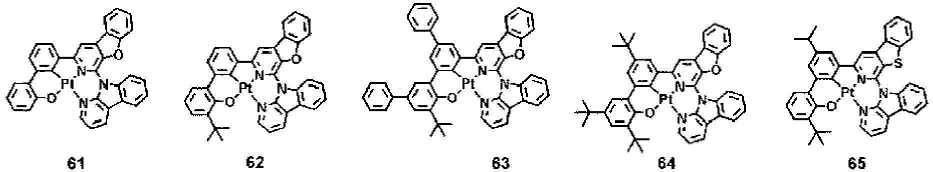

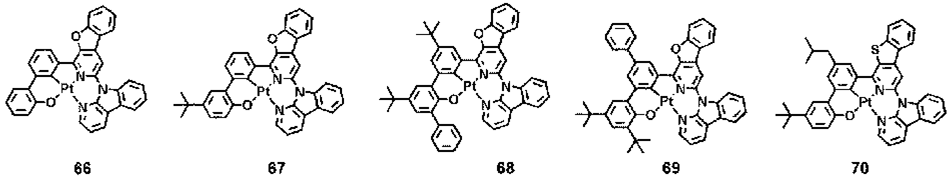

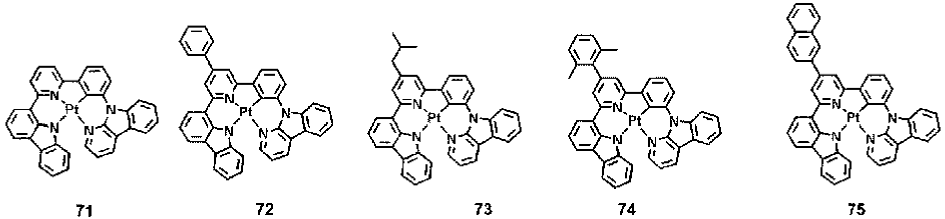

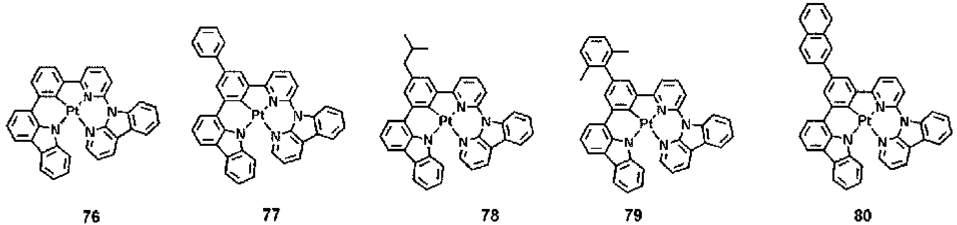

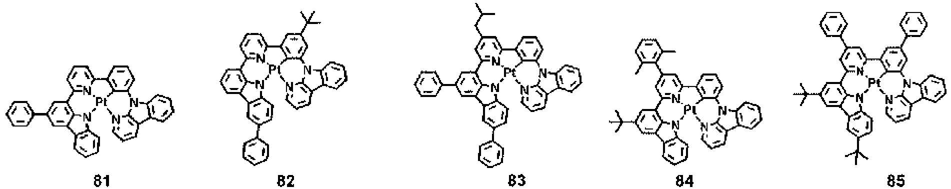

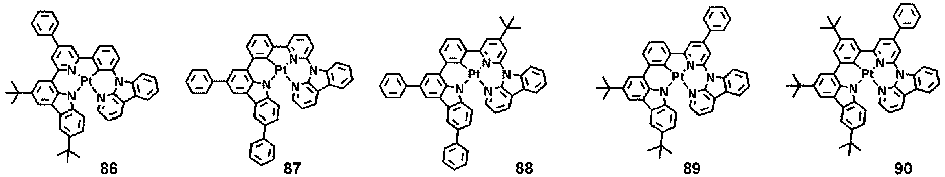

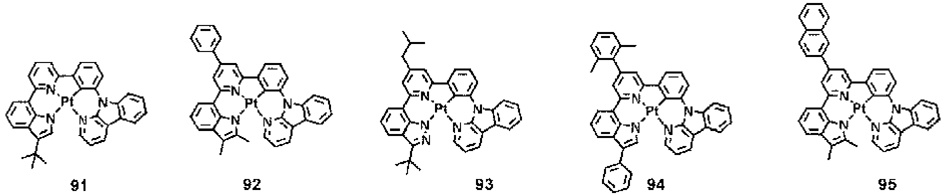

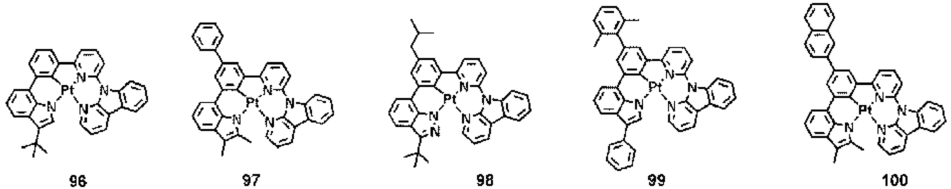

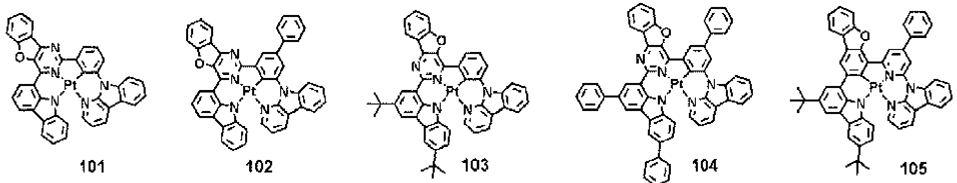

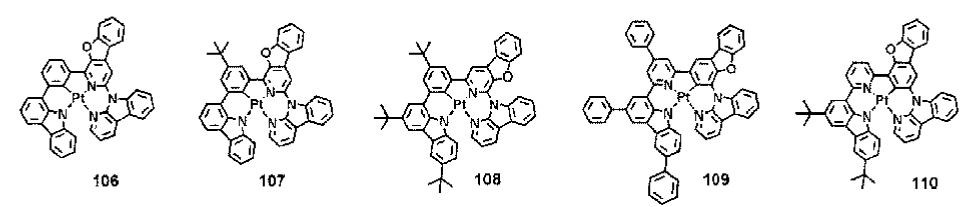

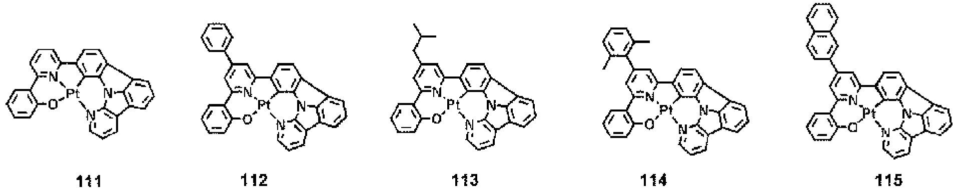

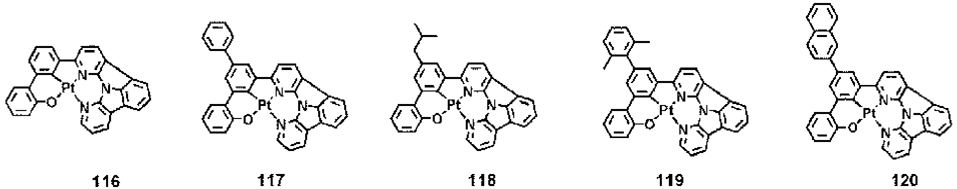

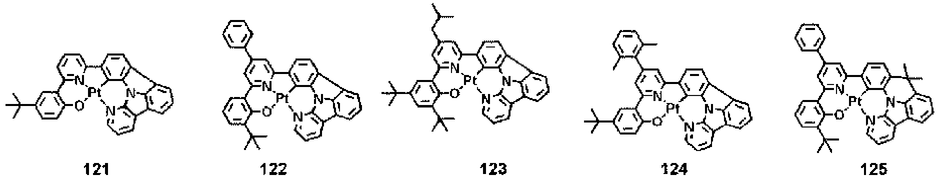

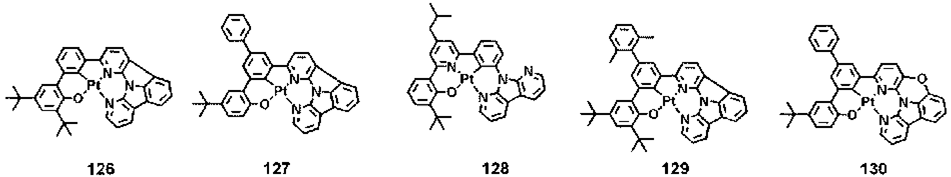

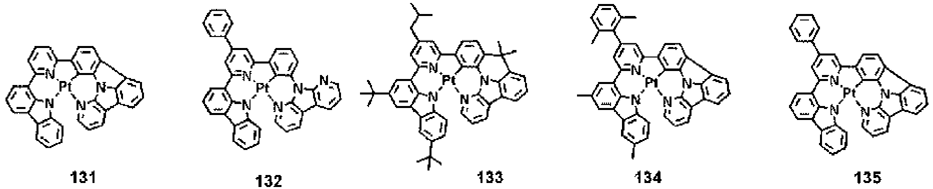

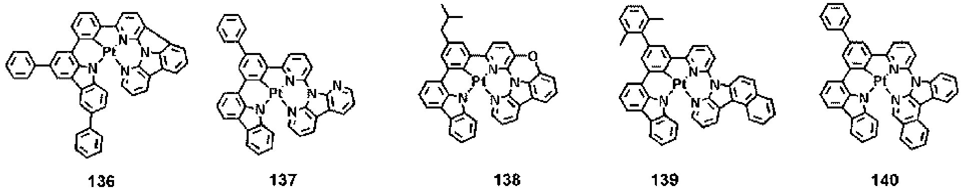

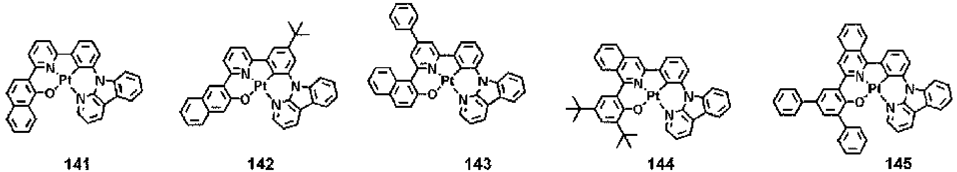

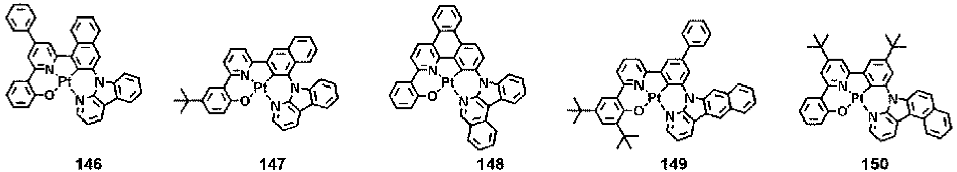

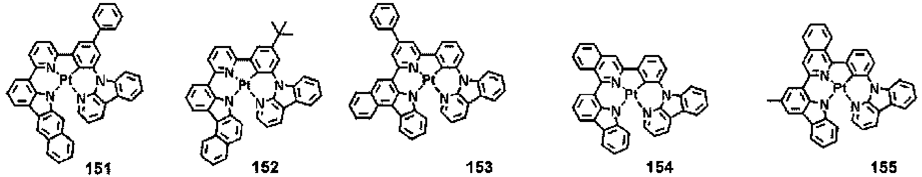

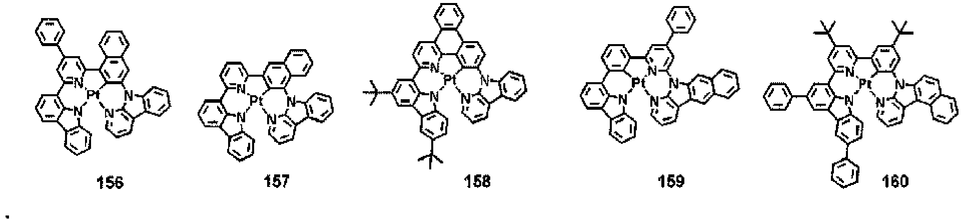

12. Organische lichtemittierende Vorrichtung, umfassend:
eine erste Elektrode;
eine zweite Elektrode; und
eine organische Schicht, die zwischen der ersten Elektrode und der zweiten Elektrode angeordnet ist, wobei die organische Schicht eine Emissionsschicht umfasst; und
wobei die organische Schicht zumindest eine organometallische Verbindung nach einem der Ansprüche 1-11 umfasst.

13. Organische lichtemittierende Vorrichtung nach Anspruch 12, wobei
die erste Elektrode eine Anode ist,
die zweite Elektrode eine Kathode ist, und
die organische Schicht ferner eine Lochtransportregion, die zwischen der ersten Elektrode und der Emissionsschicht angeordnet ist, und eine Elektronentransportregion, die zwischen der Emissionsschicht und der zweiten Elektrode angeordnet ist, umfasst,
wobei die Lochtransportregion eine Lochinjektionsschicht, eine Lochtransportschicht, eine Elektronenblockierschicht oder eine beliebige Kombination davon umfasst, und
wobei die Elektronentransportregion eine Lochblockierschicht, eine Elektronentransportschicht, eine Elektroneninjektionsschicht oder eine beliebige Kombination davon umfasst.

14. Organische lichtemittierende Vorrichtung nach Anspruch 12 oder 13, wobei die Emissionsschicht die organometallische Verbindung umfasst;
wobei bevorzugt die Emissionsschicht ferner einen Wirt umfasst und wobei eine Menge des Wirts größer als eine Menge der organometallischen Verbindung ist.

15. Diagnostische Zusammensetzung, umfassend zumindest eine organometallische Verbindung nach einem der Ansprüche 1-11.

## Revendications

1. Composé organométallique représenté par la Formule 1 : 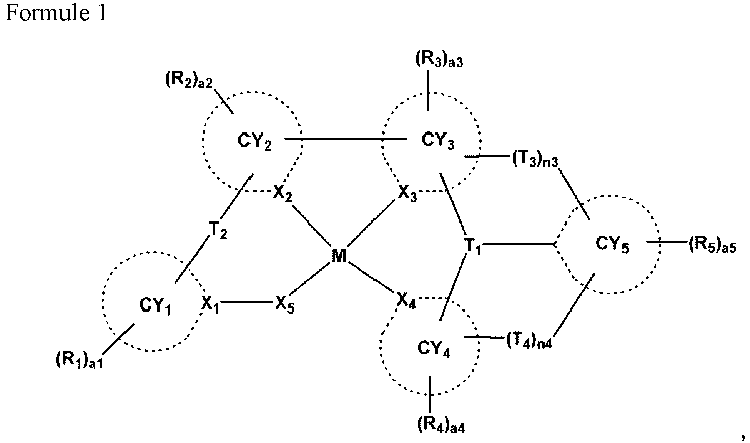 dans lequel, dans la Formule 1,
M est béryllium (Be), magnésium (Mg), aluminium (Al), calcium (Ca), titane (Ti), manganèse (Mn), cobalt (Co), cuivre (Cu), zinc (Zn), gallium (Ga), germanium (Ge), zirconium (Zr), ruthénium (Ru), rhodium (Rh), palladium (Pd), argent (Ag), rhénium (Re), platine (Pt) ou or (Au),
X₁ à X₄ sont chacun indépendamment N ou C,
X₅ est une liaison simple, O, S, B(R'), N(R'), P(R'), C(R')(R"), Si(R')(R"), Ge(R')(R"), C(=O), B(R')(R"), N(R')(R") ou P(R')(R"),
deux liaisons choisies parmi une liaison entre X₁ ou X₅ et M, une liaison entre X₂ et M, une liaison entre X₃ et M, et une liaison entre X₄ et M sont chacune une liaison covalente, et les autres liaisons choisies parmi une liaison entre X₁ ou X₅ et M, une liaison entre X₂ et M, une liaison entre X₃ et M, et une liaison entre X₄ et M sont chacune une liaison de coordination,
CY₁ à CY₅ sont chacun indépendamment un groupe C₅-C₃₀ carbocyclique ou un groupe C₁-C₃₀ hétérocyclique,
T₁ est B, N ou P,
T₂ à T₄ sont chacun indépendamment choisis parmi une liaison simple, une liaison double, *-N(R₇)-*', *-B(R₇)-*', *-P(R₇)-*', *-C(R₇)(R₈)-*', *-Si(R₇)(R₈)-*', *-Ge(R₇)(R₈)-*', *-S-*', *-Se-*', *-O-*', *-C(=O)-*', *-S(=O)-*', *-S(=O)₂-*', *-C(R₇)=*', *=C(R₇)-*', *-C(R₇)=C(R₈)-*', *-C(=S)-*', et *-C=C-*', et * et *' indiquent chacun un site de liaison à un atome voisin,
R₇ et R₈ sont éventuellement liés par l'intermédiaire d'une liaison simple, d'une liaison double ou d'un premier groupe de liaison pour former un groupe C₅-C₃₀ carbocyclique substitué ou non substitué ou un groupe C₁-C₃₀ hétérocyclique substitué ou non substitué,
n3 et n4 sont chacun indépendamment 0 ou 1, dans lequel, quand n3 est 0, T₃ n'existe pas et CY₃ et CY₅ ne sont pas liés entre eux, et quand n4 est 0, T₄ n'existe pas et CY₄ et CY₅ ne sont pas liés entre eux,
la somme de n3 et n4 est 1 ou 2, à condition que a) quand n3 est 0 et n4 est 1, X₄ est N, b) quand n3 est 1 et n4 est 0, X₃ est N, et c) quand n3 et n4 sont 1, au moins l'un de X₃ et X₄ est N,
R₁ à R₅, R', R", R₇, et R₈ sont chacun indépendamment choisis parmi hydrogène, deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle substitué ou non substitué, un groupe C₂-C₆₀ alcényle substitué ou non substitué, un groupe C₂-C₆₀ alkynyle substitué ou non substitué, un groupe C₁-C₆₀ alkoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -B(Q₆)(Q₇) et -P(=O)(Q₈)(Q₉),
a1 à a5 sont chacun indépendamment un nombre entier de 0 à 20,
deux d'une pluralité de groupes voisins R₁ sont éventuellement liés pour former un groupe C₅-C₃₀ carbocyclique substitué ou non substitué ou un groupe C₁-C₃₀ hétérocyclique substitué ou non substitué,
deux d'une pluralité de groupes voisins R₂ sont éventuellement liés pour former un groupe C₅-C₃₀ carbocyclique substitué ou non substitué ou un groupe C₁-C₃₀ hétérocyclique substitué ou non substitué,
deux d'une pluralité de groupes voisins R₃ sont éventuellement liés pour former un groupe C₅-C₃₀ carbocyclique substitué ou non substitué ou un groupe C₁-C₃₀ hétérocyclique substitué ou non substitué,
deux d'une pluralité de groupes voisins R₄ sont éventuellement liés pour former un groupe C₅-C₃₀ carbocyclique substitué ou non substitué ou un groupe C₁-C₃₀ hétérocyclique substitué ou non substitué,
deux d'une pluralité de groupes voisins R₅ sont éventuellement liés pour former un groupe C₅-C₃₀ carbocyclique substitué ou non substitué ou un groupe C₁-C₃₀ hétérocyclique substitué ou non substitué,
au moins deux d'une pluralité de groupes voisins choisis parmi R₁ à R₃ sont éventuellement liés pour former un groupe C₅-C₃₀ carbocyclique substitué ou non substitué ou un groupe C₁-C₃₀ hétérocyclique substitué ou non substitué,
au moins un substituant du groupe C₅-C₃₀ carbocyclique substitué, du groupe C₁-C₃₀ hétérocyclique substitué, du groupe C₁-C₆₀ alkyle substitué, du groupe C₂-C₆₀ alcényle substitué, du groupe C₂-C₆₀ alkynyle substitué, du groupe C₁-C₆₀ alkoxy substitué, du groupe C₃-C₁₀ cycloalkyle substitué, du groupe C₁-C₁₀ hétérocycloalkyle substitué, du groupe C₃-C₁₀ cycloalcényle substitué, du groupe C₁-C₁₀ hétérocycloalcényle substitué, du groupe C₆-C₆₀ aryle substitué, du groupe C₆-C₆₀ aryloxy substitué, du groupe C₆-C₆₀ arylthio substitué, du groupe C₁-C₆₀ hétéroaryle substitué, du groupe polycyclique condensé non aromatique monovalent substitué et du groupe hétéropolycyclique condensé non aromatique monovalent substitué est choisi parmi :
deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle , un groupe C₂-C₆₀ alcényle, un groupe C₂-C₆₀ alkynyle et un groupe C₁-C₆₀ alkoxy ;
un groupe C₁-C₆₀ alkyle, un groupe C₂-C₆₀ alcényle, un groupe C₂-C₆₀ alkynyle et un groupe C₁-C₆₀ alkoxy, chacun étant substitué par au moins un élément choisi parmi deutérium, - F, -Cl, -Br, -I, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), - B(Q₁₆)(Q₁₇) et -P(=O)(Q₁₈)(Q₁₉) ;
un groupe C₃-C₁₀ cycloalkyle , un groupe C₁-C₁₀ hétérocycloalkyle , un groupe C₃-C₁₀ cycloalcényle, un groupe C₁-C₁₀ hétérocycloalcényle, un groupe C₆-C₆₀ aryle , un groupe C₆-C₆₀ aryloxy, un groupe C₆-C₆₀ arylthio, un groupe C₁-C₆₀ hétéroaryle, un groupe polycyclique condensé non aromatique monovalent et un groupe hétéropolycyclique condensé non aromatique monovalent ;
un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent et un groupe hétéropolycyclique condensé non aromatique monovalent, chacun étant substitué par au moins un élément choisi parmi deutérium, - F, -Cl, -Br, -I, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alcényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅), - B(Q₂₆)(Q₂₇) et -P(=O)(Q₂₈)(Q₂₉) ; et
-N(Q₃₁)(Q₃₂), -Si(Q₃₃)(Q₃₄)(Q₃₅), -B(Q₃₆)(Q₃₇) et -P(=O)(Q₃₈)(Q₃₉), et
Q₁ à Q₉, Q₁₁ à Q₁₉, Q₂₁ à Q₂₉ et Q₃₁ à Q₃₉ sont chacun indépendamment choisis parmi hydrogène, deutérium, -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₁-C₆₀ alkyle substitué par au moins un élément choisi parmi deutérium, un groupe C₁-C₆₀ alkyle et un groupe C₆-C₆₀ aryle, un groupe C₂-C₆₀ alcényle, un groupe C₂-C₆₀ alkynyle, un groupe C₁-C₆₀ alkoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryle substitué par au moins un élément choisi parmi deutérium, un groupe C₁-C₆₀ alkyle et un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent et un groupe hétéropolycyclique condensé non aromatique monovalent.

2. Composé organométallique selon la revendication 1, dans lequel
une liaison entre X₁ ou X₅ et M et une liaison entre X₃ et M sont chacune une liaison covalente, et une liaison entre X₂ et M et une liaison entre X₄ et M sont chacune une liaison de coordination, ou
une liaison entre X₁ ou X₅ et M et une liaison entre X₂ et M sont chacune une liaison covalente, et une liaison entre X₃ et M et une liaison entre X₄ et M sont chacune une liaison de coordination.

3. Composé organométallique selon la revendication 1 ou 2, dans lequel
les cycles CY₁ à CY₅ sont chacun indépendamment choisis parmi un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphthalène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe azafluorène, un groupe azacarbazole, un groupe azadibenzofurane, un groupe azadibenzothiophène, un groupe azadibenzosilole, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrrole, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoline, un groupe 5,6,7,8-tétrahydroquinoline, un groupe indazole, un groupe benzofluorène, un groupe benzocarbazole, un groupe naphthobenzofurane, un groupe naphthobenzothiophène et un groupe naphtobenzosilole ; et/ou
dans lequel
au moins un des cycles CY₁ et CY₂ est un cycle condensé comprenant au moins un cycle à 5 chaînons condensé avec au moins un cycle à 6 chaînons,
les cycles CY₃ à CY₅ sont chacun indépendamment un cycle à 6 chaînons ou un cycle condensé comprenant au moins deux cycles à 6 chaînons condensés l'un avec l'autre,
le cycle à 5 chaînons est choisi parmi un groupe cyclopentadiène, un groupe furane, un groupe thiophène, un groupe pyrrole, un groupe silole, un groupe oxazole, un groupe isoxazole, un groupe oxadiazole, un groupe isoxadiazole, un groupe oxatriazole, un groupe isoxatriazole, un groupe thiazole, un groupe isothiazole, un groupe thiadiazole, un groupe isothiadiazole, un groupe thiatriazole, un groupe isothiatriazole, un groupe pyrazole, un groupe imidazole, un groupe triazole, un groupe tétrazole, un groupe azasilole, un groupe diazasilole et un groupe triazasilole, et
le cycle à 6 chaînons est choisi parmi un groupe cyclohexane, un groupe cyclohexène, un groupe benzène, un groupe pyridine, un groupe pyrimidine, un groupe pyrazine, un groupe pyridazine et un groupe triazine.

4. Composé organométallique selon l'une quelconque des revendications 1 à 3, dans lequel
R₁ à R₅, R', R", R₇ et R₈ sont chacun indépendamment choisis parmi :
hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, -SF₅, un groupe C₁-C₂₀ alkyle et un groupe C₁-C₂₀ alkoxy ;
un groupe C₁-C₂₀ alkyle et un groupe C₁-C₂₀ alkoxy, chacun étant substitué par au moins un élément choisi parmi deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle C₁-C₁₀, un groupe cyclopentyle, un groupe cyclohexyle, un groupe cycloheptyle, un groupe cyclooctyle, un groupe adamantanyle, un groupe norbornanyle, un groupe norboményle, un groupe cyclopentényle, un groupe cyclohexényle, un groupe cycloheptényle, un groupe phényle, un groupe naphthyle, un groupe pyridinyle et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norboményle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle, un groupe phénoxy et un groupe naphtoxy ;
un groupe cyclopentyle, un groupe cyclohexyle, un groupe cycloheptyle, un groupe cyclooctyle, un groupe adamantanyle, un groupe norbornanyle, un groupe norboményle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle, un groupe phénoxy et un groupe naphtoxy, chacun étant substitué par au moins un élément choisi parmi deutérium, -F, -Cl, -Br, -I, -CD₃, -CD₂H, -CDH₂, -CF₃, - CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₂₀ alkyle, un groupe C₁-C₂₀ alkoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle et - Si(Q₃₃)(Q₃₄)(Q₃₅) ; et
-N(Q₁)(Q₂), -Si(Q₃)(Q₄)(Q₅), -B(Q₆)(Q₇) et -P(=O)(Q₈)(Q₉), et
Q₁ à Q₉ et Q₃₃ à Q₃₅ sont chacun indépendamment choisis parmi :
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H et -CD₂CDH₂ ;
un groupe n-propyle, un groupe iso-propyle, un groupe n-butyle, un groupe iso-butyle, un groupe sec-butyle, un groupe tert-butyle, un groupe n-pentyle, un groupe isopentyle, un groupe sec- pentyle, un groupe tert-pentyle, un groupe phényle et un groupe naphthyle ; et
un groupe n-propyle, un groupe iso-propyle, un groupe n-butyle, un groupe iso-butyle, un groupe sec-butyle, un groupe tert-butyle, un groupe n-pentyle, un groupe isopentyle, un groupe sec-pentyle, un groupe tert-pentyle, un groupe phényle et un groupe naphthyle, chacun étant substitué par au moins un élément choisi parmi deutérium, un groupe C₁-C₁₀ alkyle et un groupe phényle ;
de préférence dans lequel
R₁ à R₅, R', R", R₇ et R₈ sont chacun indépendamment choisis parmi hydrogène, deutérium, -F, un groupe cyano, un groupe nitro, -SF₅, -CH₃, -CD₃, -CD₂H, -CDH₂, -CF₃, -CF₂H, -CFH₂, un groupe C₁-C₁₀ alkoxy, les groupes représentés par les Formules 9-1 à 9-19, les groupes représentés par les Formules 10-1 à 10-157, -N(Q₁)(Q₂), -Si(Q₃)(Q₄)(Q₅), -B(Q₆)(Q₇) et -P(=O)(Q₈)(Q₉) : 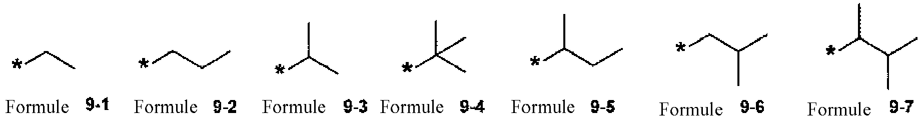 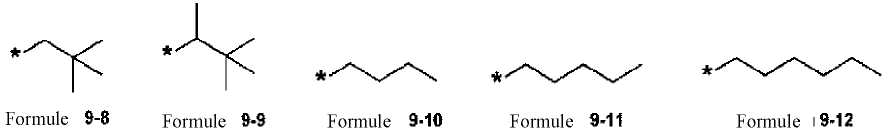 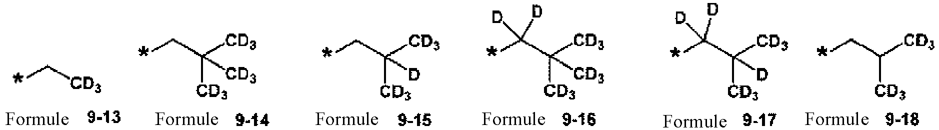 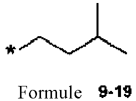 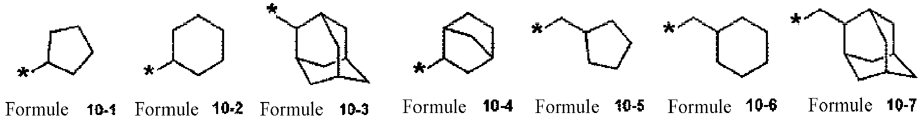 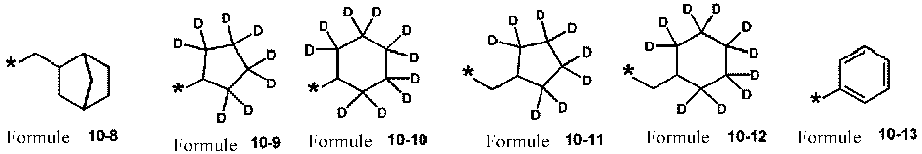 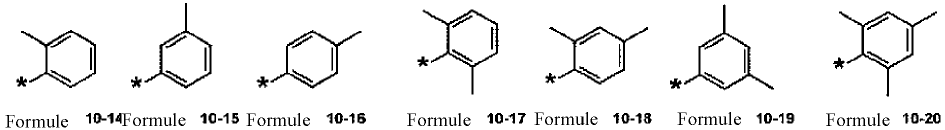 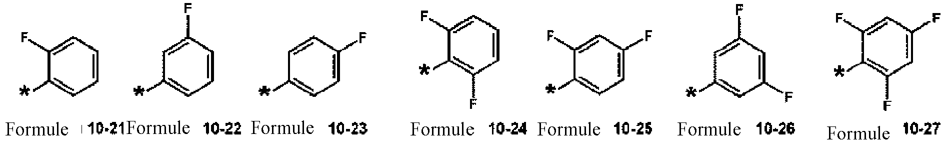 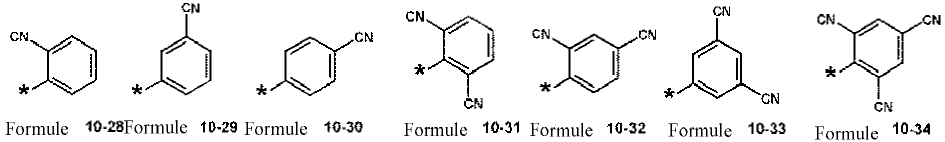 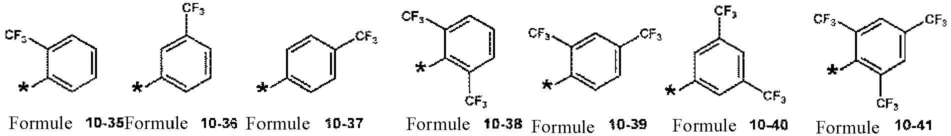 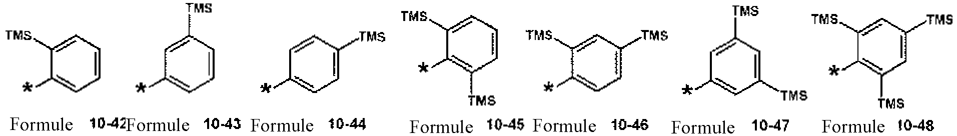 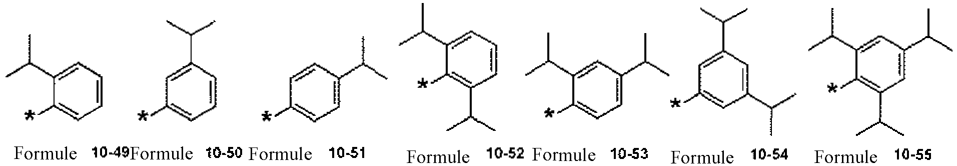 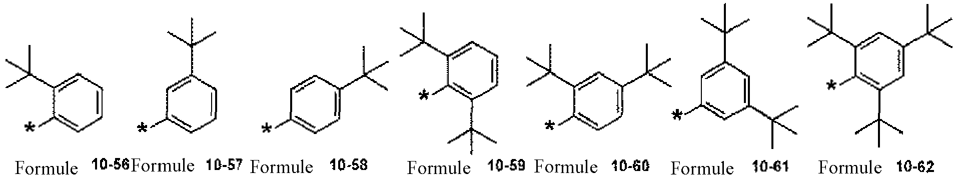 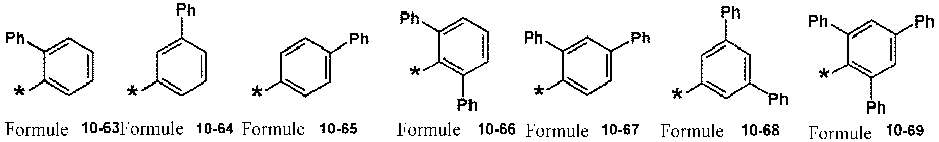 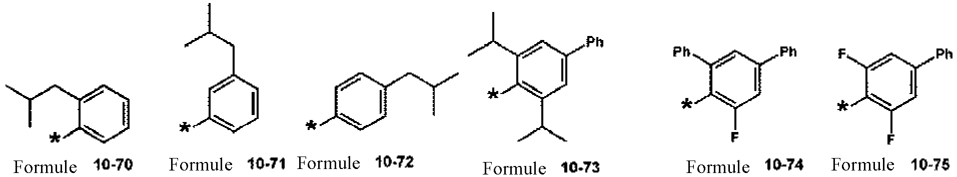 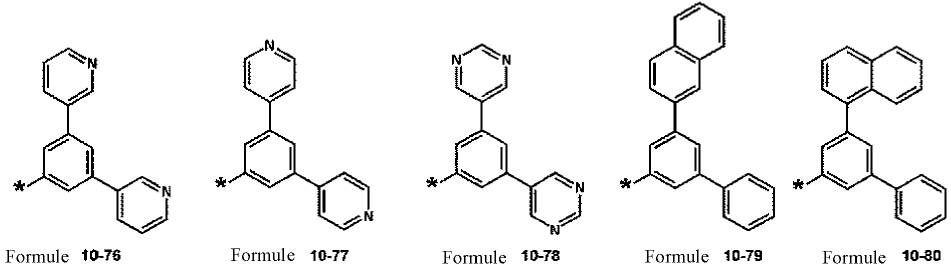 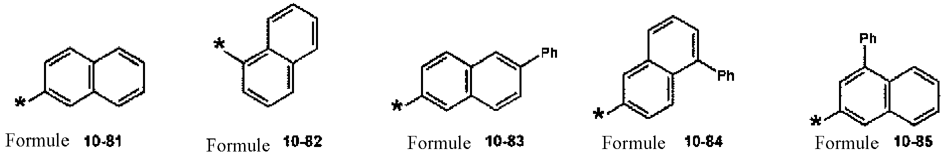 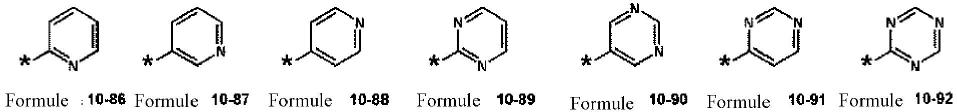 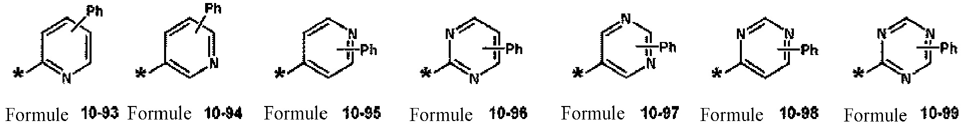 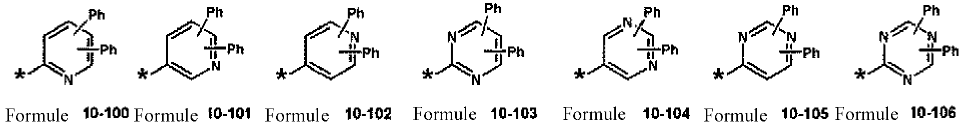 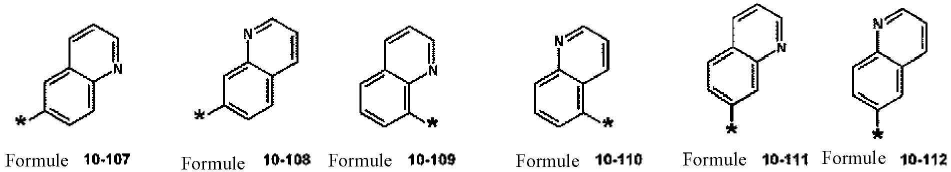 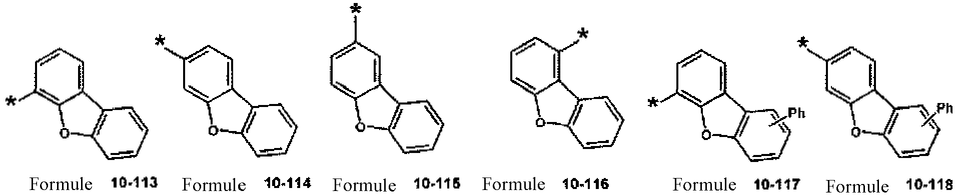 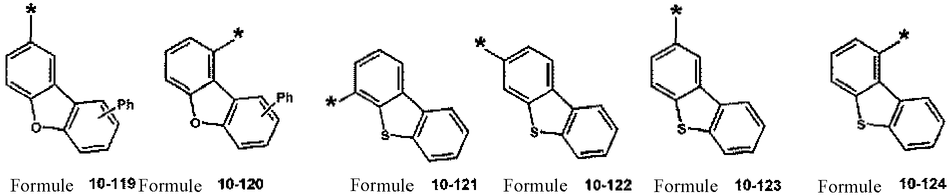 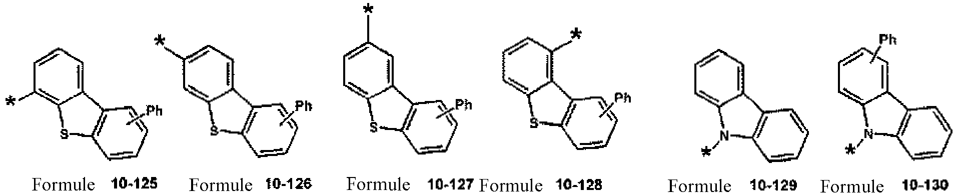 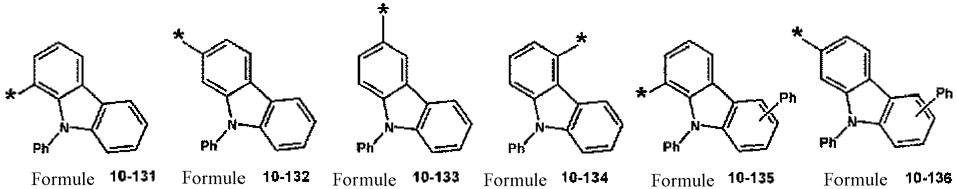 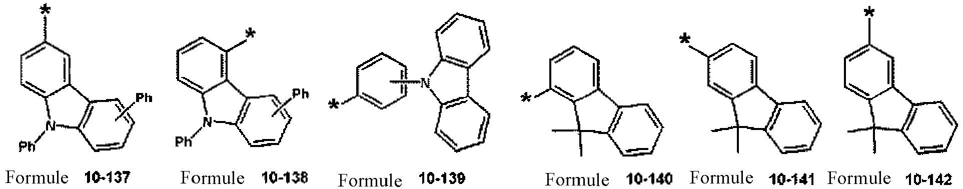 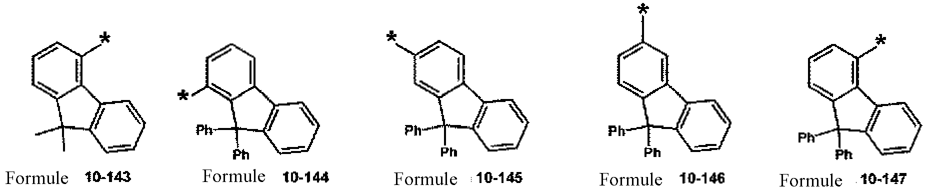 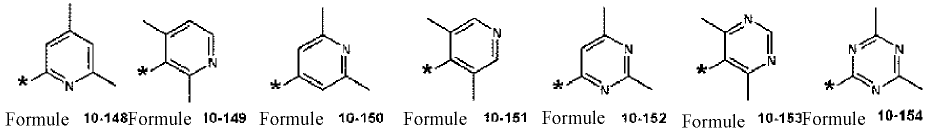 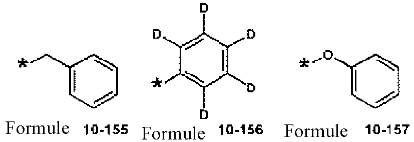 , dans lequel, dans les Formules 9-1 à 9-19 et 10-1 à 10-157, « Ph » indique un groupe phényle, « TMS » indique un groupe triméthylsilyle et « * » indique un site de liaison à un atome voisin.

5. Composé organométallique selon l'une quelconque des revendications 1 à 4, dans lequel
i) X₅ n'est pas une liaison simple, une fraction représentée par 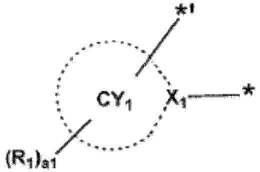 est représentée par la Formule A1-1, une fraction représentée par 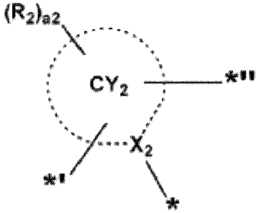 est représentée par la Formule A2-1 ou A2-2, et T₂ est une liaison simple ;
ii) X₅ est une liaison simple, une fraction représentée par 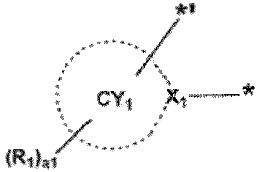 est représentée par la Formule A1-2, une fraction représentée par 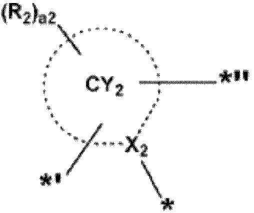 est représentée par la Formule A2-1 ou A2-2, et T₂ est une liaison simple ;
iii) X₅ est une liaison simple, une fraction représentée par 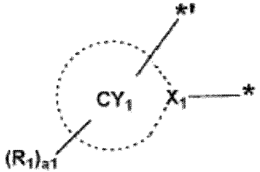 est représentée par la Formule A1-1, une fraction représentée par 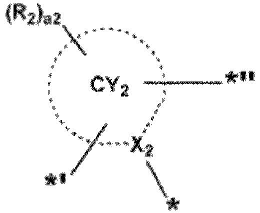 est représentée par la Formule A2-1 ou A2-2, et T₂ n'est pas une liaison simple ; ou
iv) X₅ est une liaison simple, une fraction représentée par 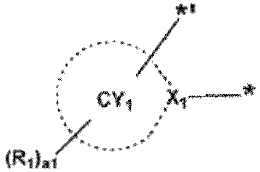 est représentée par la Formule A1-1, une fraction représentée par 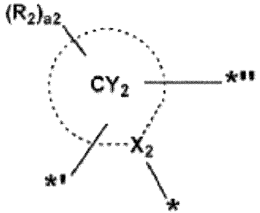 est représentée par la Formule A2-3 et T₂ est une liaison simple : 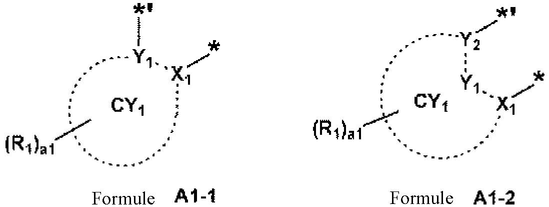 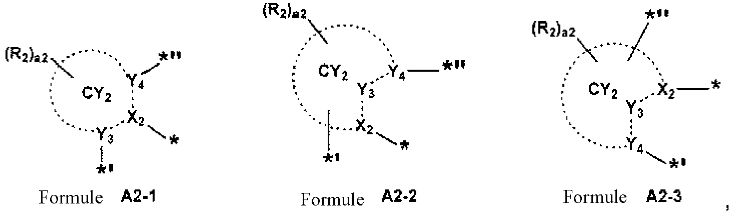 dans lequel, dans les Formules A1-1, A1-2 et A2-1 à A2-3,
X₁, X₂, le cycle CY₁, le cycle CY₂, R₁, R₂, a1 et a2 sont les mêmes que dans la revendication 1,
Y₁ à Y₄ sont chacun indépendamment N ou C,
* dans les Formules A1-1 et A1-2 indique un site de liaison à M dans la Formule 1,
*' dans les Formules A1-1 et A1-2 indique un site de liaison à T₂ dans la Formule 1,
* dans les Formules A2-1 à A2-3 indique un site de liaison à M dans la Formule 1,
*' dans les Formules A2-1 à A2-3 indique un site de liaison à T₂ dans la Formule 1, et
*" dans les Formules A2-1 à A2-3 indique un site de liaison à CY₃ dans la Formule 1.

6. Composé organométallique selon l'une quelconque des revendications 1 à 5, dans lequel
une fraction représentée par 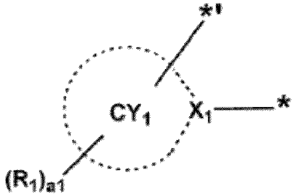 dans la Formule 1 est représentée par l'une des Formules A1-1(1) à A1-1(26) et A1-2(1) à A1-2(76), et
une fraction représentée par 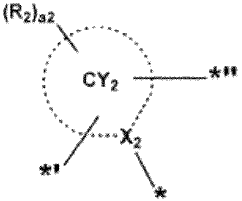 dans la Formule 1 est représentée par l'une des Formules A2-1(1) à A2-1(21), A2-2(1) à A2-2(58) et A2-3(1) à A2-3(58) : 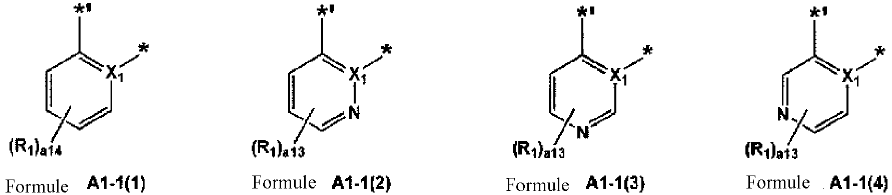 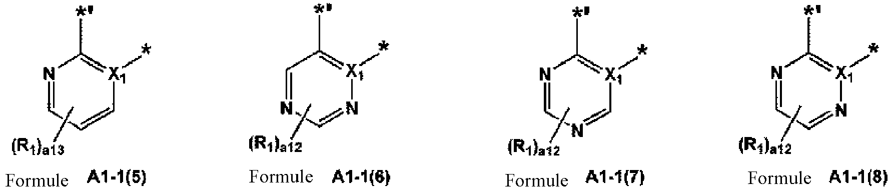 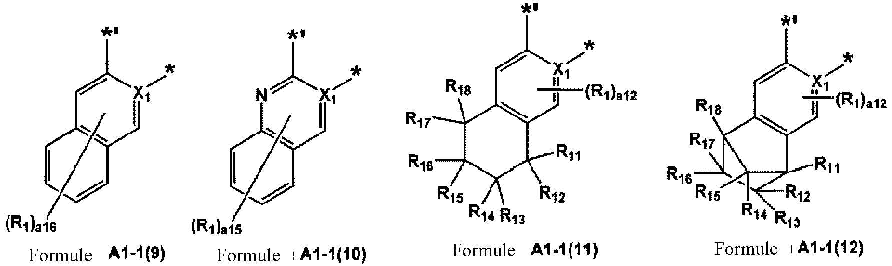 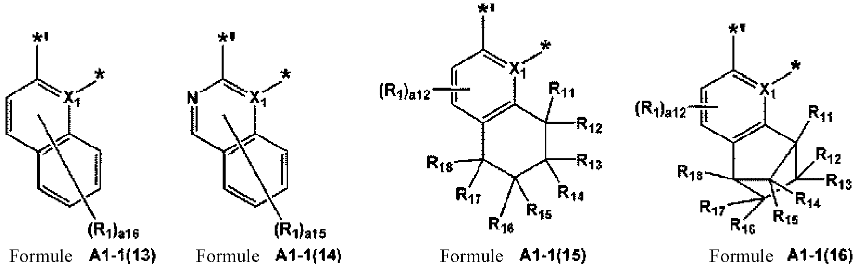 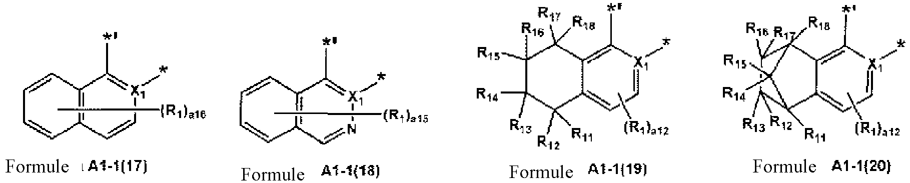 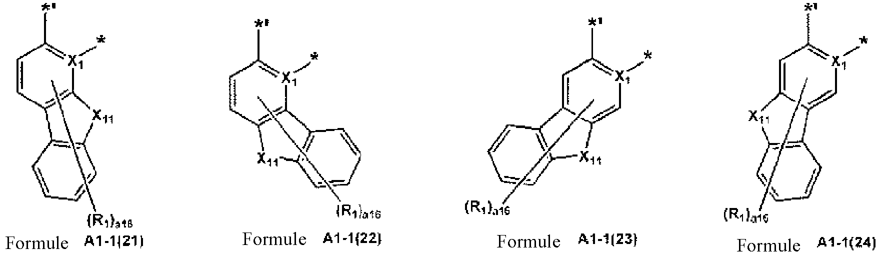 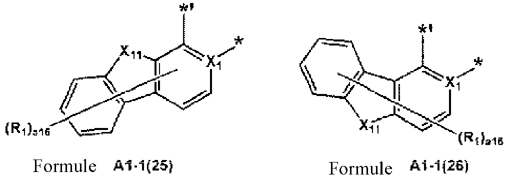 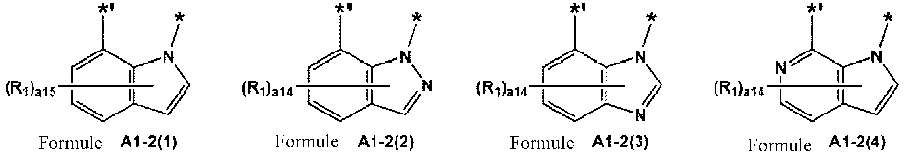 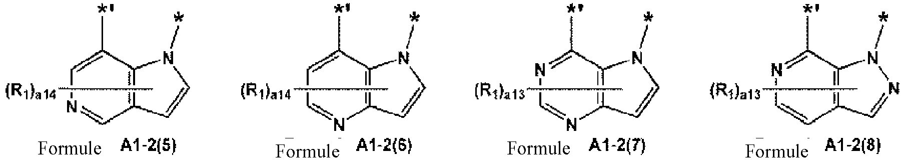 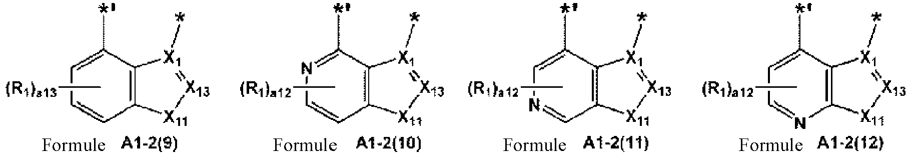 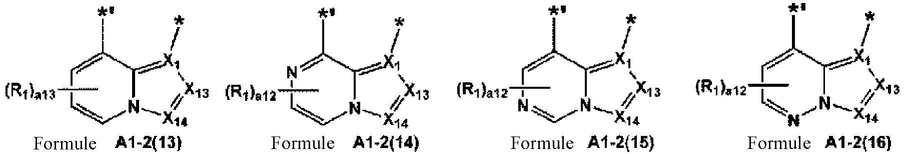 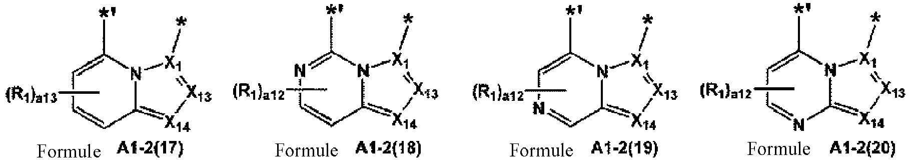 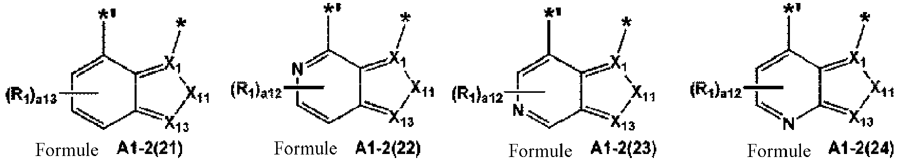 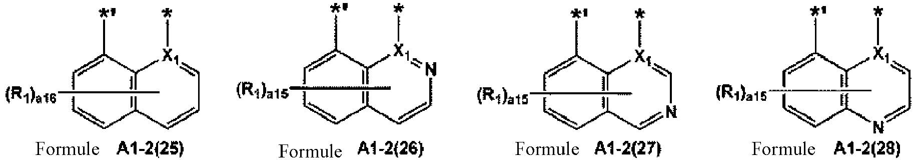 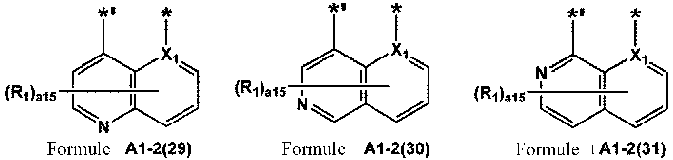 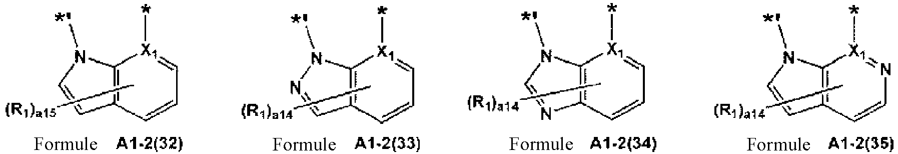 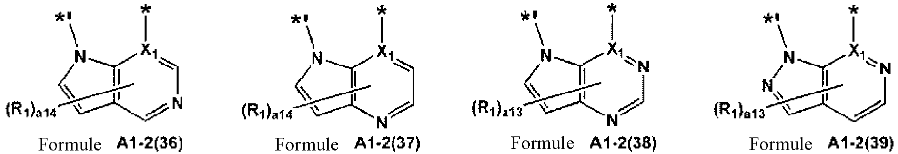 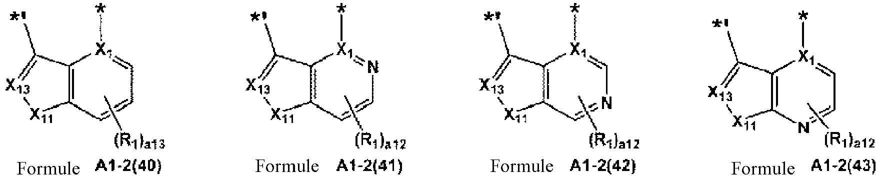 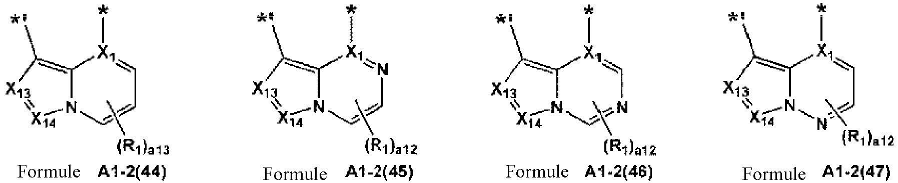 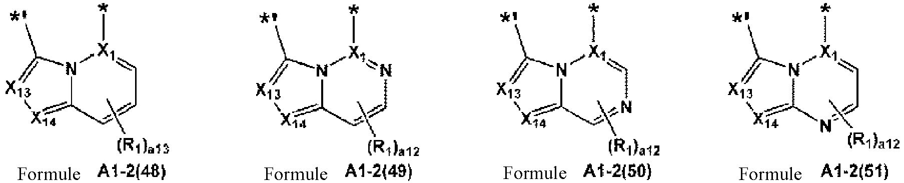 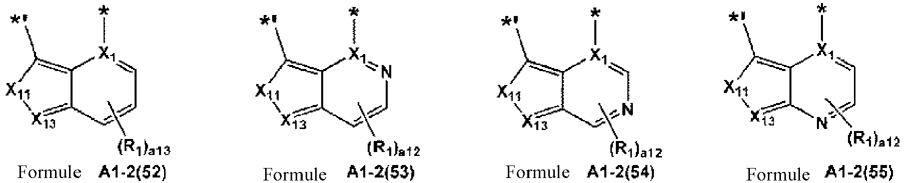 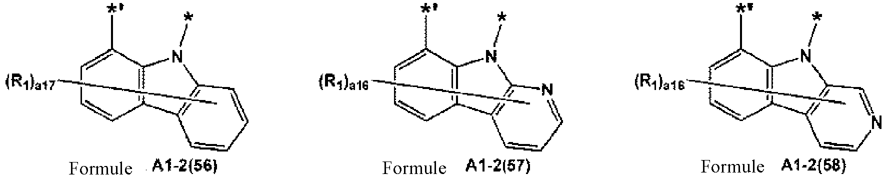 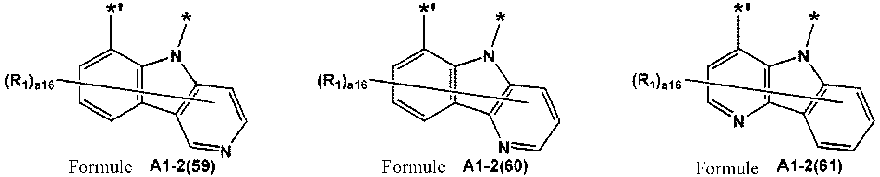 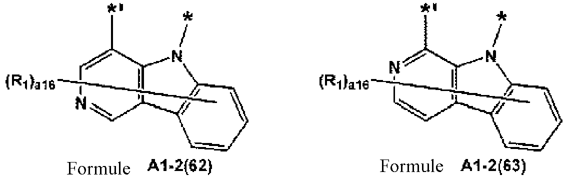 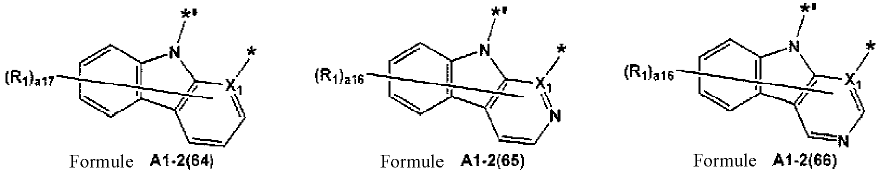 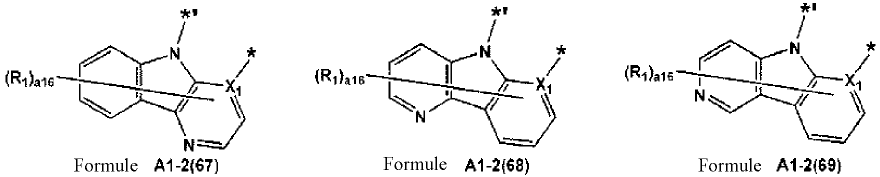 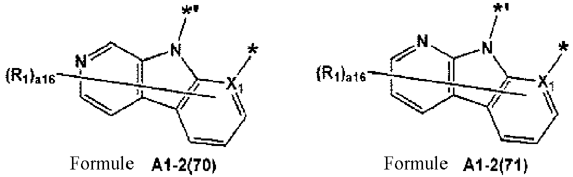 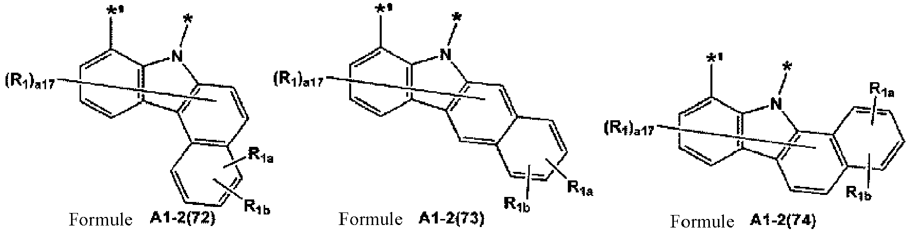 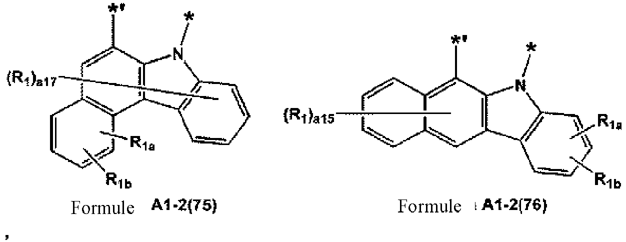 dans lequel, dans les Formules A1-1(1) à A1-1(26) et A1-2(1) à A1-2(76),
X₁ et R₁ sont les mêmes que dans la revendication 1,
X₁₁ est O, S, N(R₁₁), C(R₁₁)(R₁₂) ou Si(R₁₁)(R₁₂),
X₁₃ est N ou C(R₁₃),
X₁₄ est N ou C(R₁₄),
R₁ₐ, R_{1b} et R₁₁ à R₁₈ sont identiques à R₁ dans la revendication 1,
a17 est un nombre entier de 0 à 7,
a16 est un nombre entier de 0 à 6,
a15 est un nombre entier de 0 à 5,
a14 est un nombre entier de 0 à 4,
a13 est un nombre entier de 0 à 3,
a12 est un nombre entier de 0 à 2,
* indique un site de liaison à M dans la Formule 1, et
*' indique un site de liaison à T₂ dans la Formule 1 : 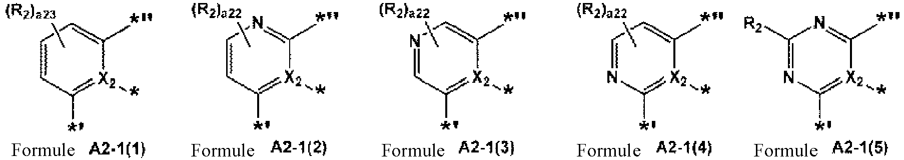 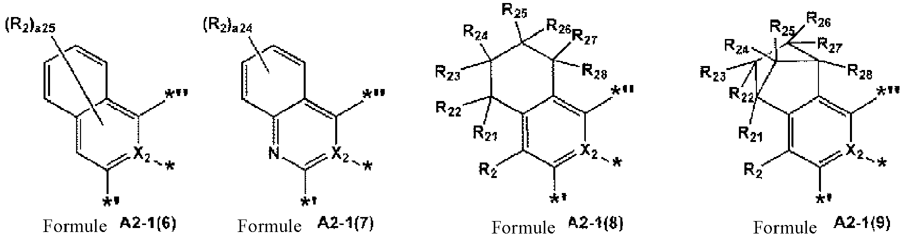 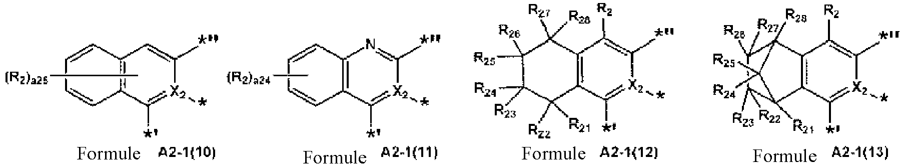 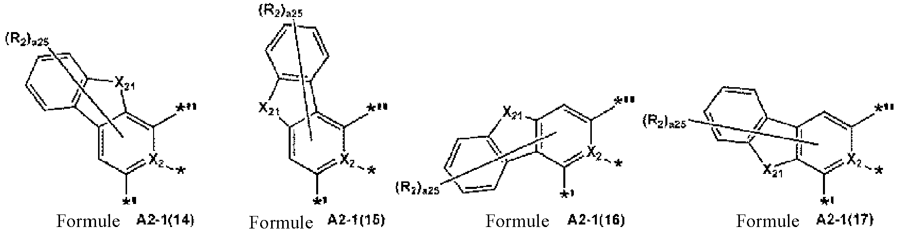 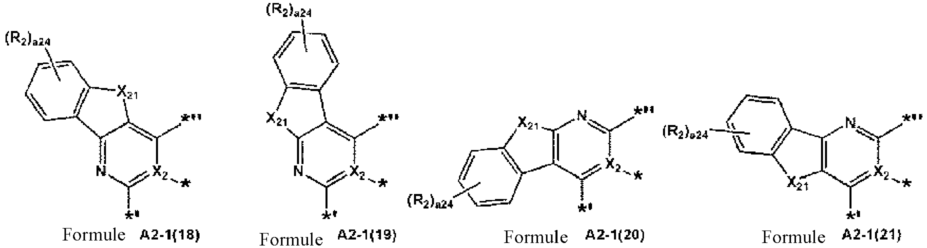 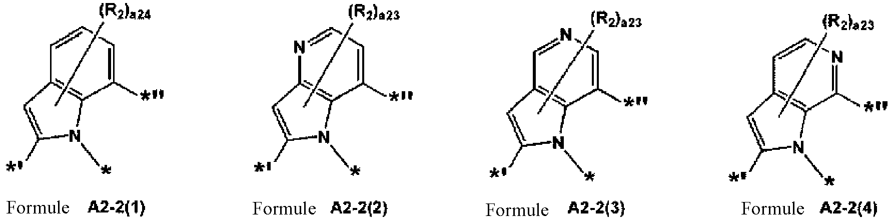 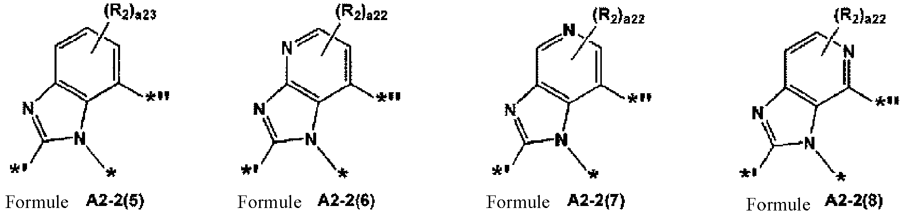 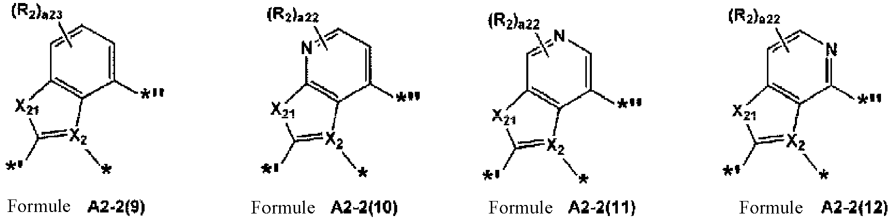 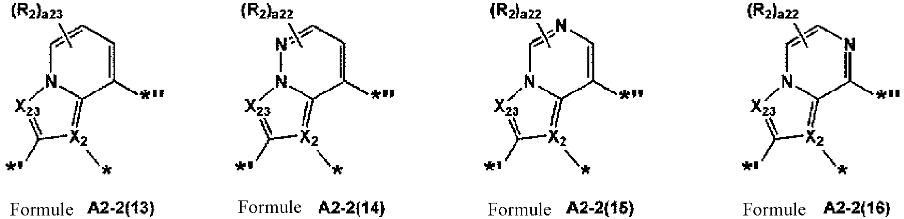 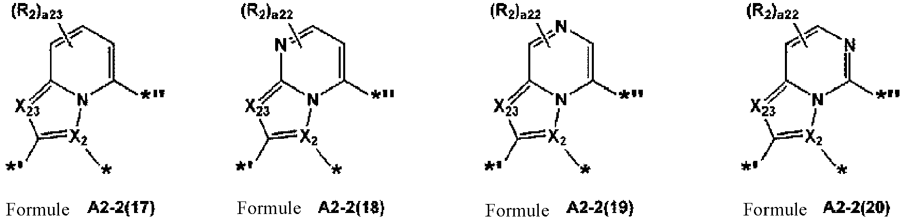 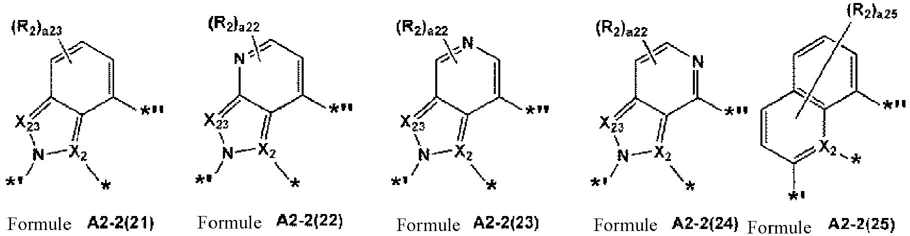 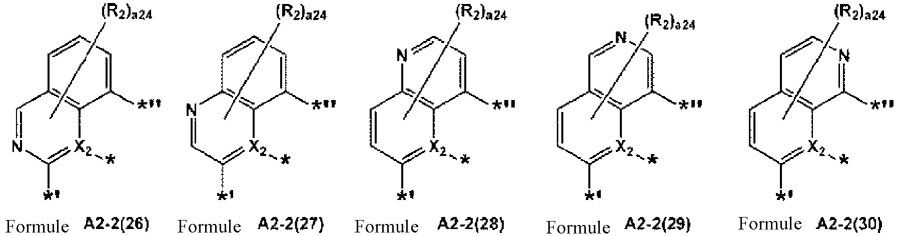 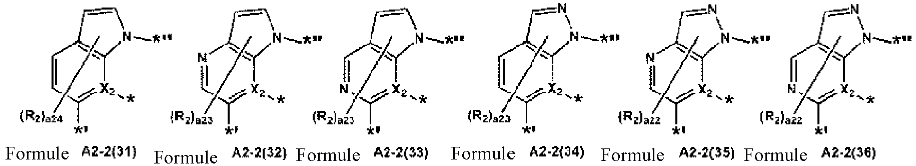 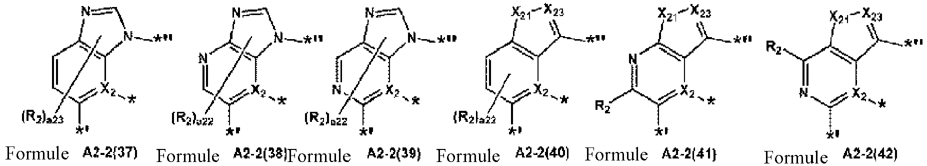 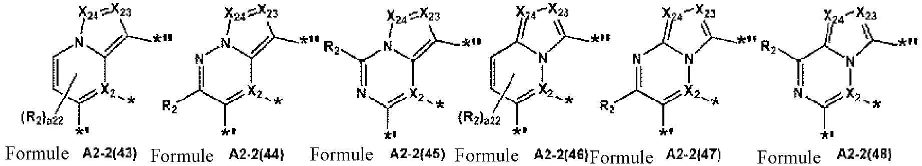 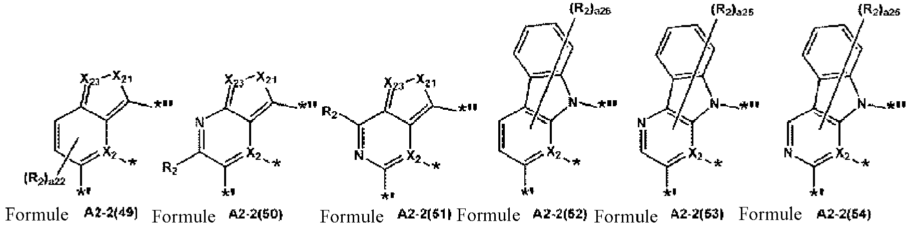 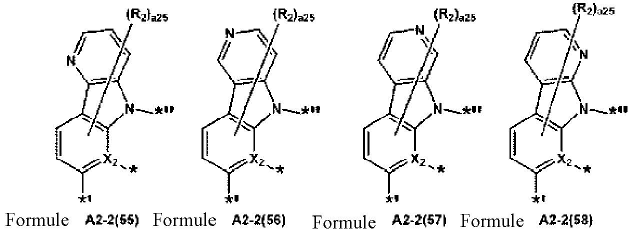 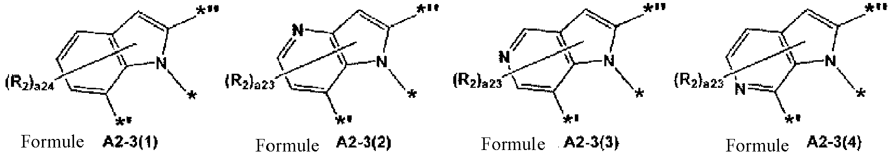 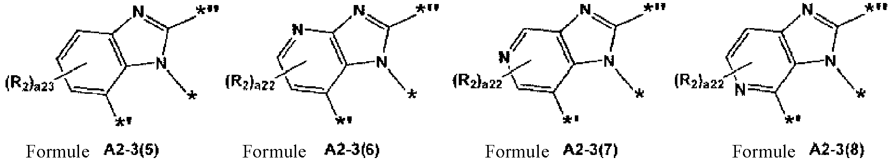 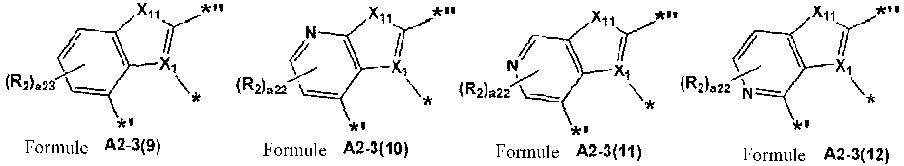 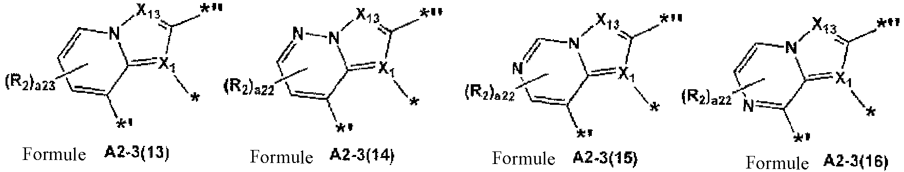 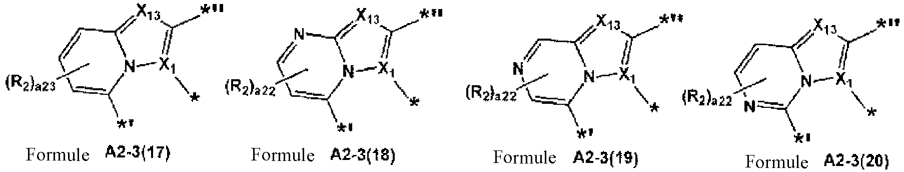 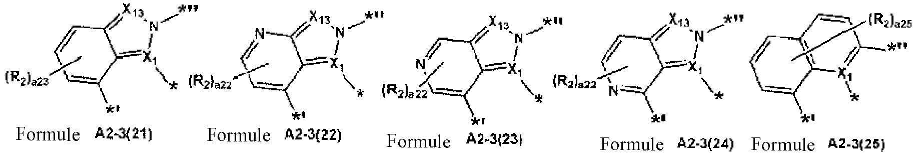 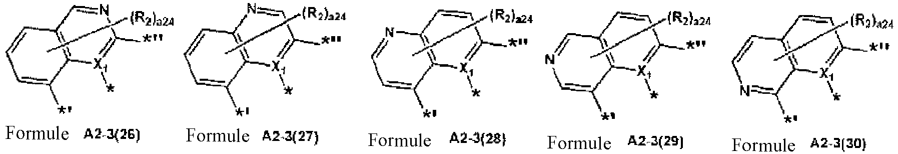 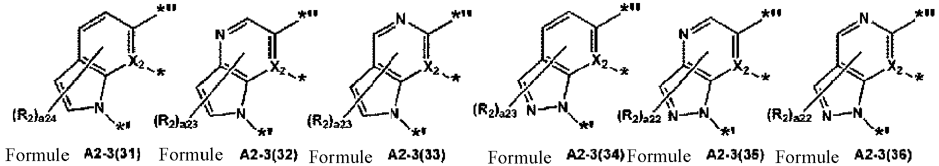 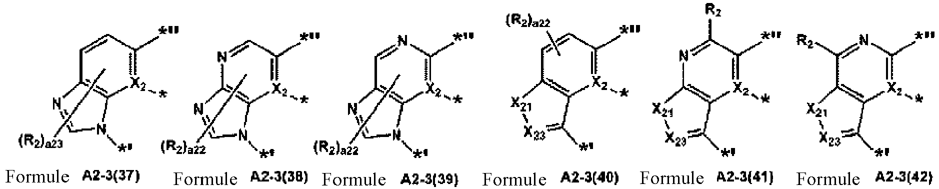 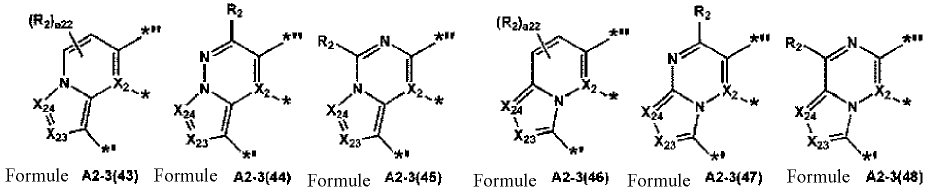 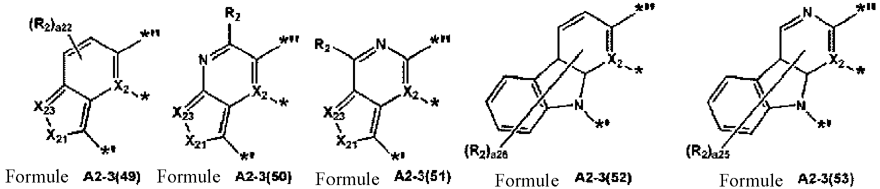 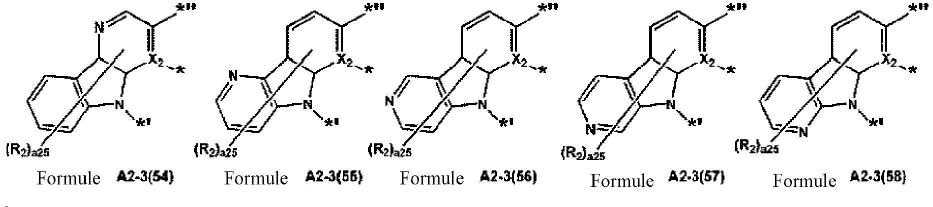 , dans lequel, dans les Formules A2-1(1) à A2-1(21), A2-2(1) à A2-2(58) et A2-3(1) à A2-3(58),
X₂ et R₂ sont les mêmes que dans la revendication 1,
X₂₁ est O, S, N(R₂₁), C(R₂₁)(R₂₂) ou Si(R₂₁)(R₂₂),
X₂₃ est N ou C(R₂₃),
X₂₄ est N ou C(R₂₄),
R₂₁ à R₂₈ sont identiques à R₂ dans la revendication 1,
a26 est un nombre entier de 0 à 6,
a25 est un nombre entier de 0 à 5,
a24 est un nombre entier de 0 à 4,
a23 est un nombre entier de 0 à 3,
a22 est un nombre entier de 0 à 2,
* indique un site de liaison à M dans la Formule 1,
*' indique un site de liaison à T₂ dans la Formule 1, et
*" indique un site de liaison au cycle CY₃ dans la Formule 1 ;
de préférence dans lequel
i) X₅ n'est pas une liaison simple, une fraction représentée par 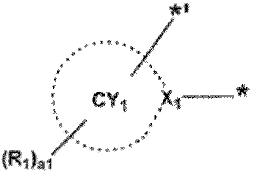 est représentée par l'une des Formules A1-1(1) à A1-1(26), une fraction représentée par 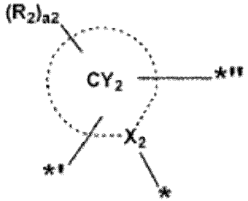 est représentée par l'une des Formules A2-1(1) à A2-1(21), et T₂ est une liaison simple ;
ii) X₅ est une liaison simple, une fraction représentée par 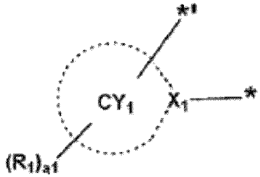 est représentée par l'une des Formules A1-2(1) à A1-2(76), une fraction représentée par 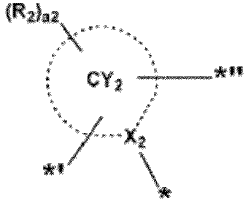 est représentée l'une des Formules A2-1(1) à A2-1(21), et T₂ est une liaison simple ;
iii) X₅ est une liaison simple, une fraction représentée par 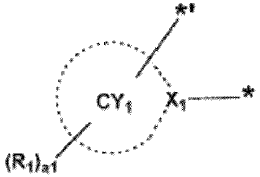 est représentée par l'une des Formules A1-1(1) à A1-1(26), une fraction représentée par 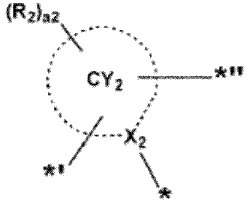 est représentée par l'une des Formules A2-1(1) à A2-1(21), et T₂ n'est pas une liaison simple ; ou
iv) X₅ est une liaison simple, une fraction représentée par 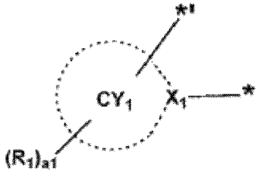 est représentée par l'une des Formules A1-1(1) à A1-1(26), une fraction représentée par 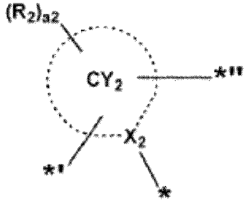 est représentée par l'une des Formules A2-3(1) à A2-3(58), et T₂ est une liaison simple.

7. Composé organométallique selon l'une quelconque des revendications 1 à 6, dans lequel
une fraction représentée par 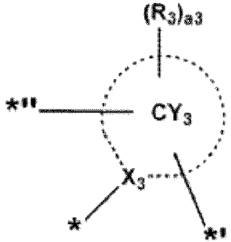 dans la Formule 1 est représentée par l'une des Formules A3-1(1) à A3-1(21) et A3-3(1) à A3-3(58) : 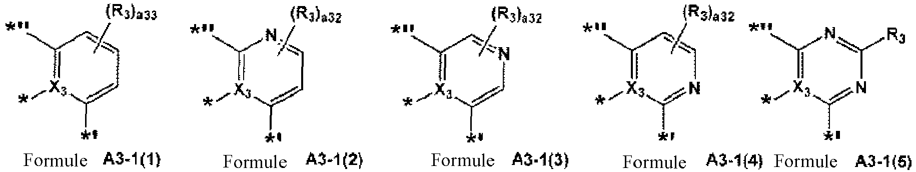 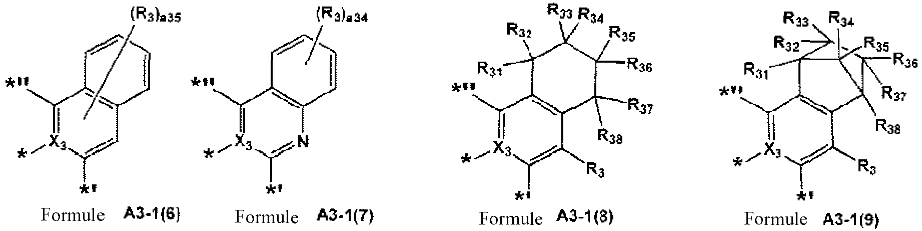 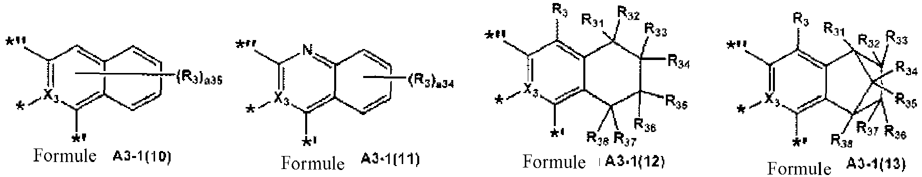 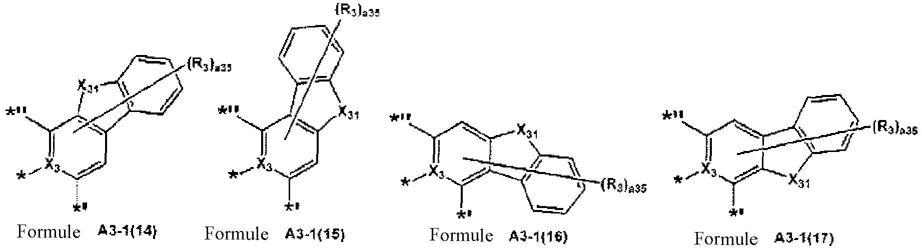 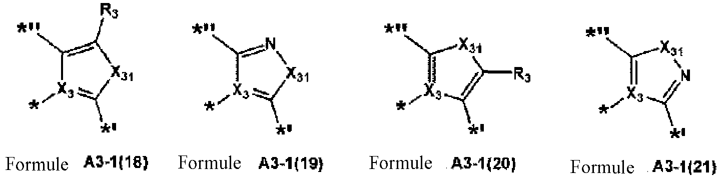 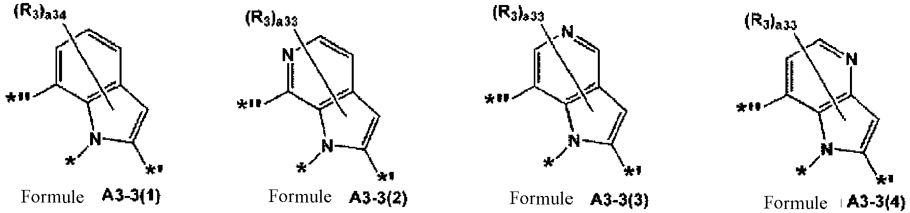 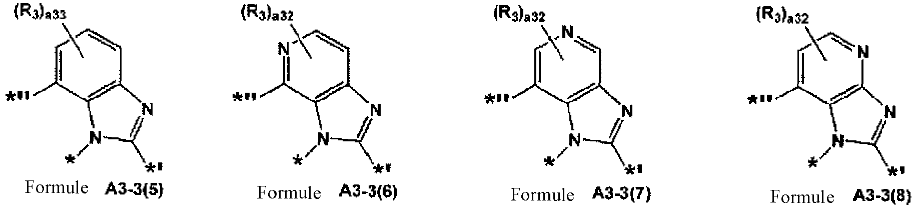 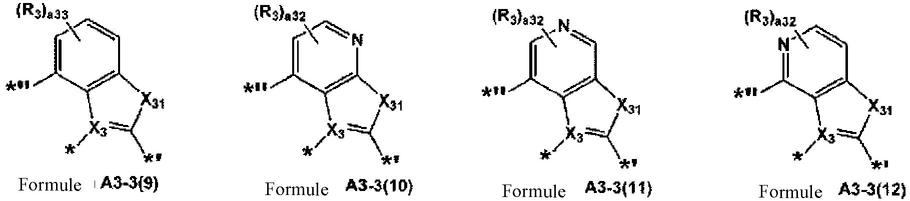 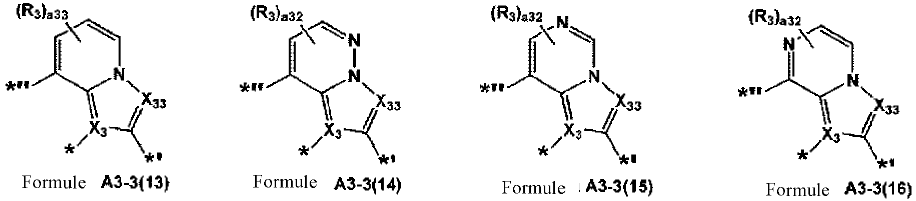 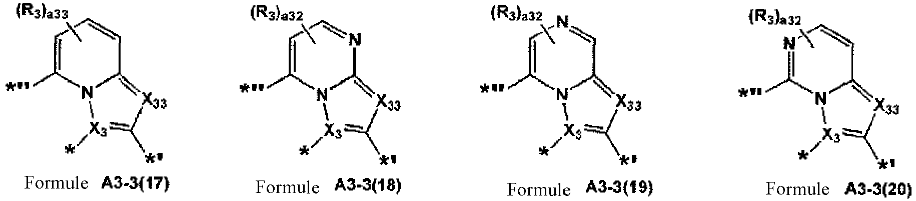 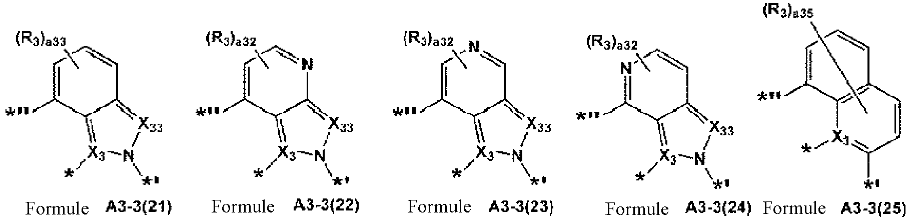 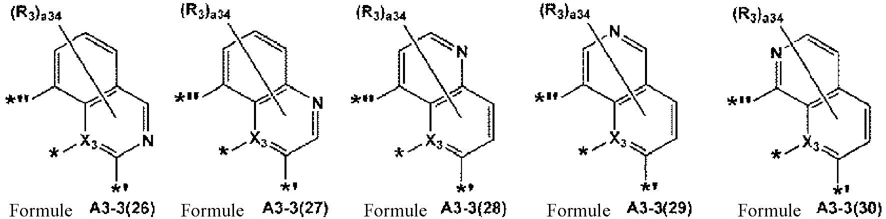 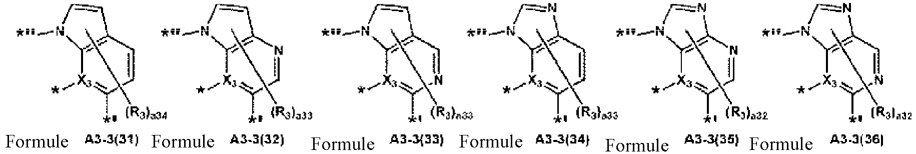 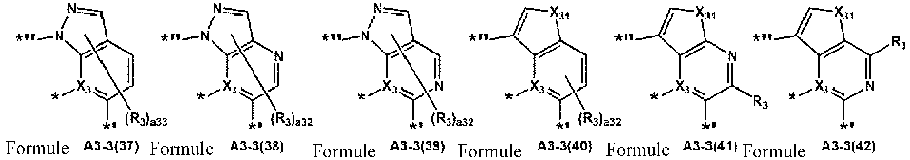 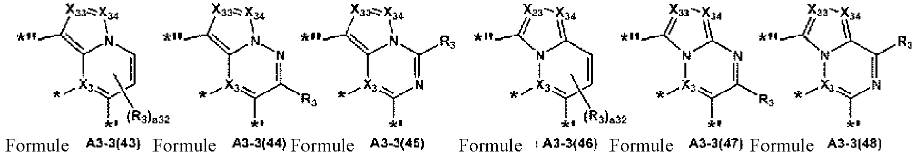 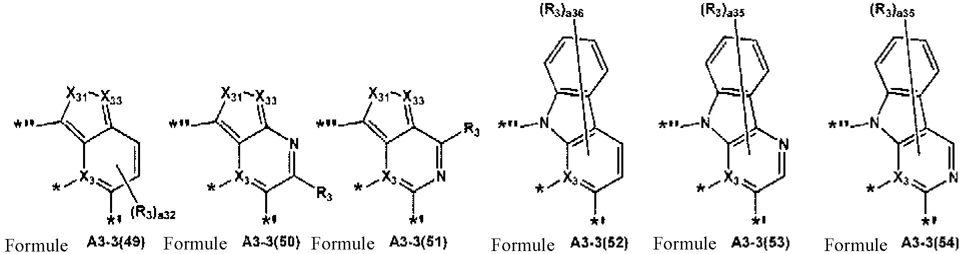 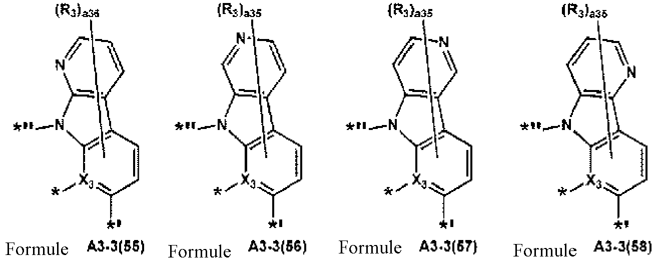 , dans lequel, dans les Formules A3-1(1) à A3-1(21) et A3-3(1) à A3-3(58),
X₃ et R₃ sont les mêmes que dans la revendication 1,
X₃₁ est O, S, N(R₃₁), C(R₃₁)(R₃₂) ou Si(R₃₁)(R₃₂),
X₃₃ est N ou C(R₃₃),
X₃₄ est N ou C(R₃₄),
R₃₁ à R₃₈ sont identiques à R₃ dans la revendication 1,
a36 est un nombre entier de 0 à 6,
a35 est un nombre entier de 0 à 5,
a34 est un nombre entier de 0 à 4,
a33 est un nombre entier de 0 à 3,
a32 est un nombre entier de 0 à 2,
* indique un site de liaison à M dans la Formule 1,
*" indique un site de liaison au cycle CY₂ dans la Formule 1, et
*' indique un site de liaison à T₁ dans la Formule 1.

8. Composé organométallique selon l'une quelconque des revendications 1 à 7, dans lequel
une fraction représentée par 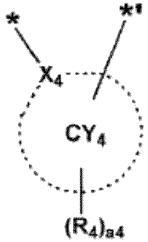 dans la Formule 1 est représentée par l'une des Formules A4-1(1) à A4-1(44) : 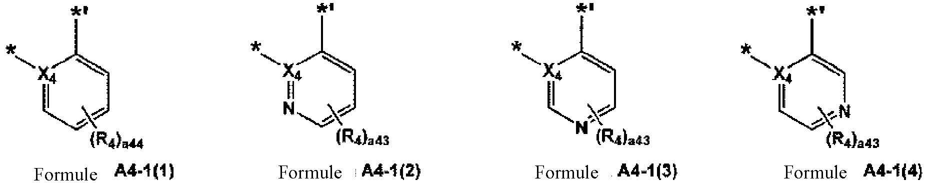 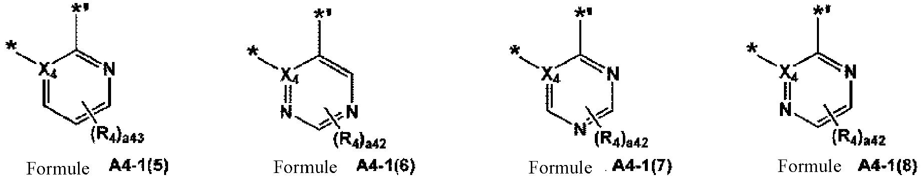 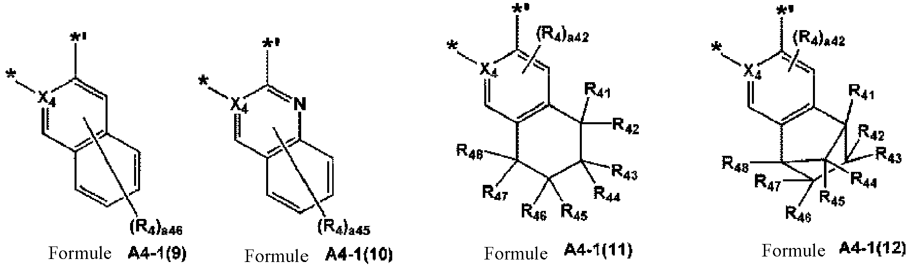 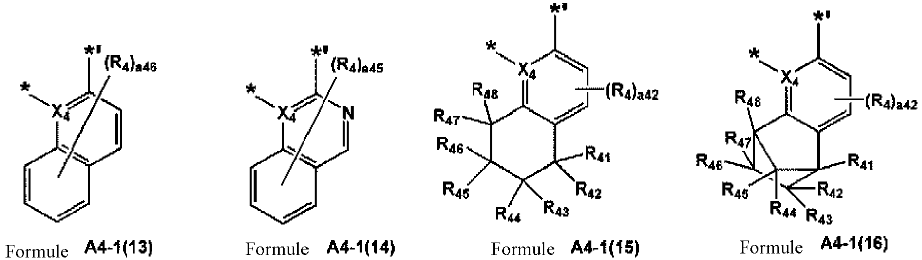 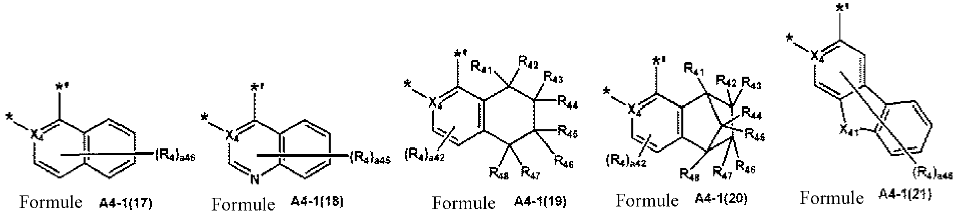 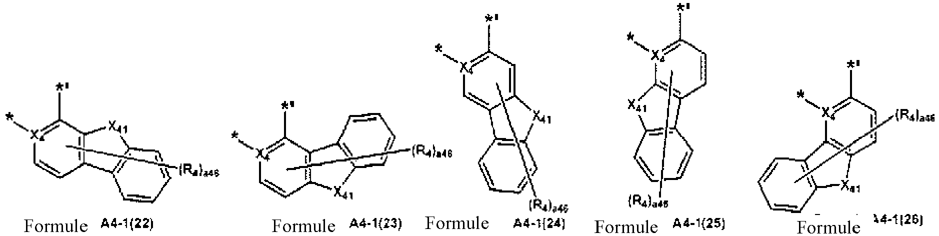 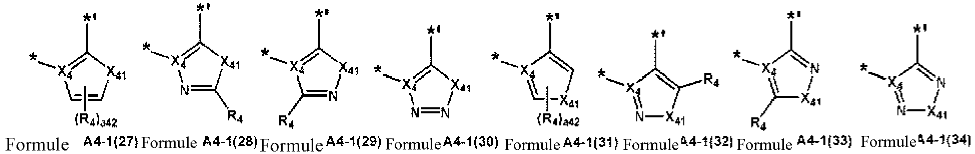 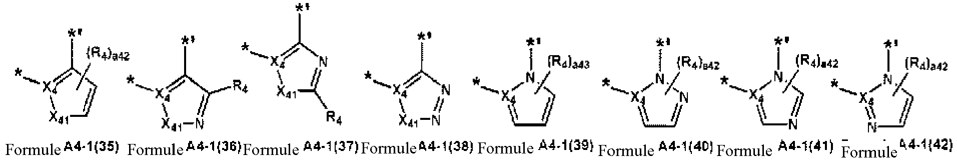 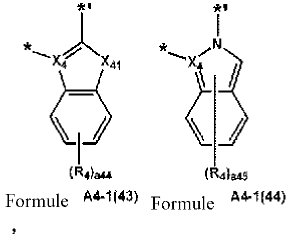 dans lequel, dans les Formules A4-1(1) à A4-1(44),
X₄, R₄, * et '* sont les mêmes que dans la revendication 1,
X₄₁ est O, S, N(R₄₁), C(R₄₁)(R₄₂) ou Si(R₄₁)(R₄₂),
X₄₃ est N ou C(R₄₃),
X₄₄ est N ou C(R₄₄),
R₄₁ à R₄₈ sont identiques à R₄,
a47 est un nombre entier de 0 à 7,
a46 est un nombre entier de 0 à 6,
a45 est un nombre entier de 0 à 5,
a44 est un nombre entier de 0 à 4,
a43 est un nombre entier de 0 à 3,
a42 est un nombre entier de 0 à 2,
* indique un site de liaison à M dans la Formule 1, et
*' indique un site de liaison à T₁ dans la Formule 1.

9. Composé organométallique selon l'une quelconque des revendications 1 à 8, dans lequel, dans la Formule 1,
un cycle cyclométallé formé par M, X₅, le cycle CY₁, T₂ et le cycle CY₂, et un cycle cyclométallé formé par M, le cycle CY₄, T₁ et le cycle CY₃, sont chacun un cycle à 6 chaînons, et
un cycle cyclométallé formé par M, le cycle CY₂ et le cycle CY₃ est un cycle à 5 chaînons.

10. Composé organométallique selon l'une quelconque des revendications 1 à 9, dans lequel
le composé organométallique est représenté par l'une des Formules 1-1 à 1-3 : 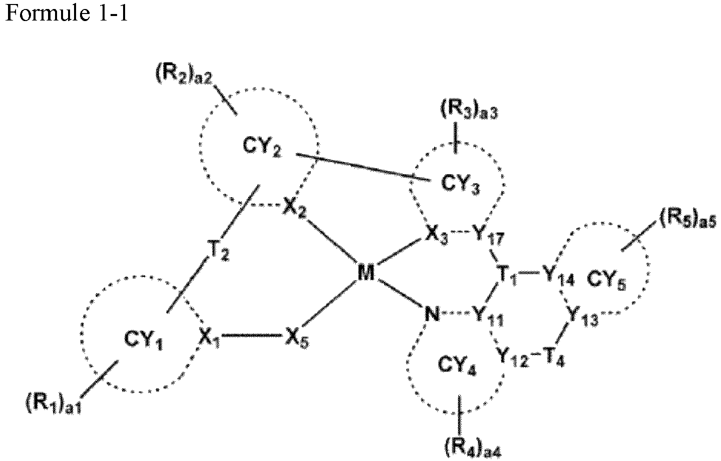 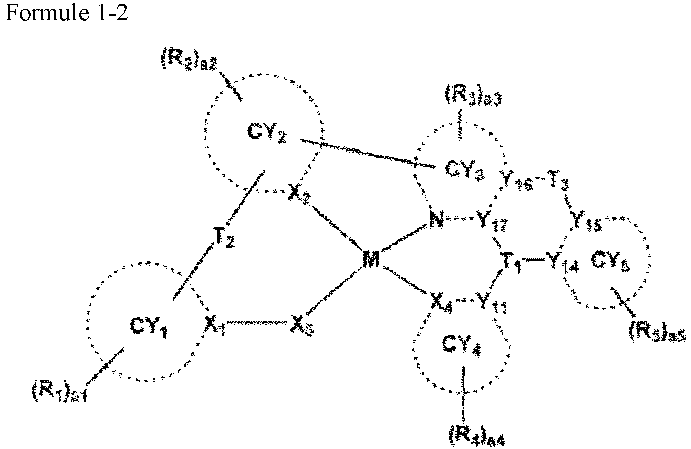 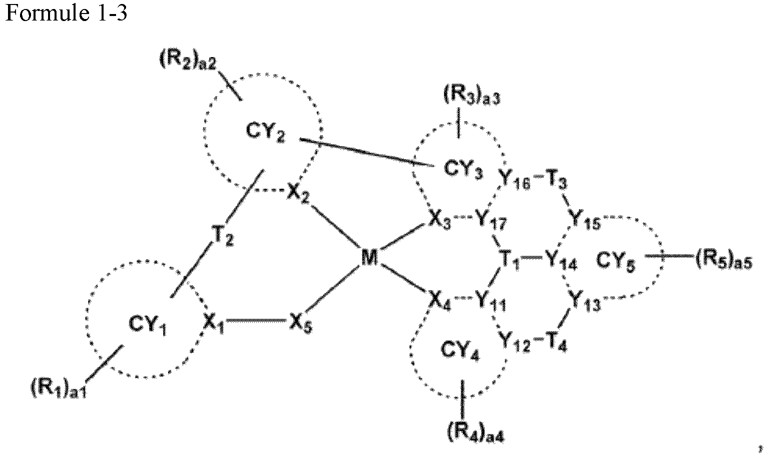 dans lequel, dans les Formules 1-1 à 1-3,
M, X₁ à X₅, les cycles CY₁ à CY₅, T₁ à T₄, R₁ à R₅, et a1 à a5 sont les mêmes que dans la revendication 1, à condition qu'au moins l'un de X₃ et X₄ dans la Formule 1-3 soit N, et
Y₁₁ à Y₁₇ sont chacun indépendamment C ou N ; ou
dans lequel
le composé organométallique est représenté par l'une des Formules 1A-1 à 1A-3 et 1B : 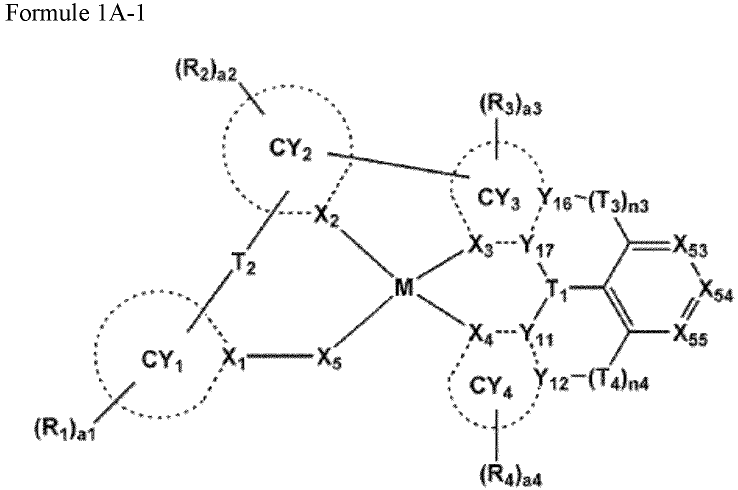 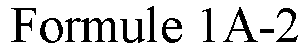 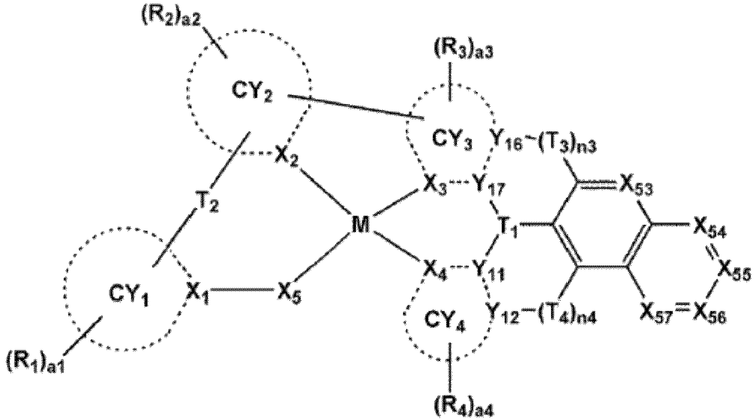 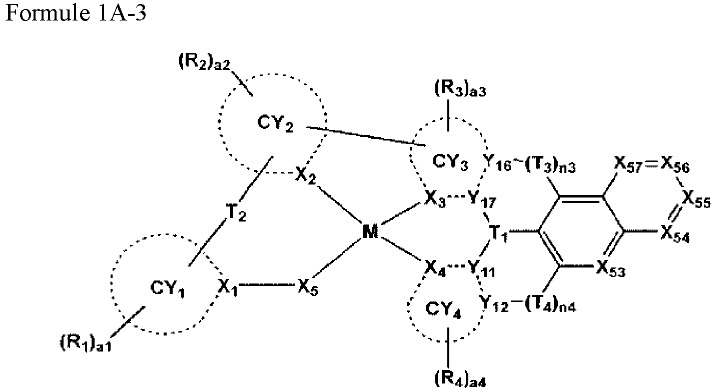 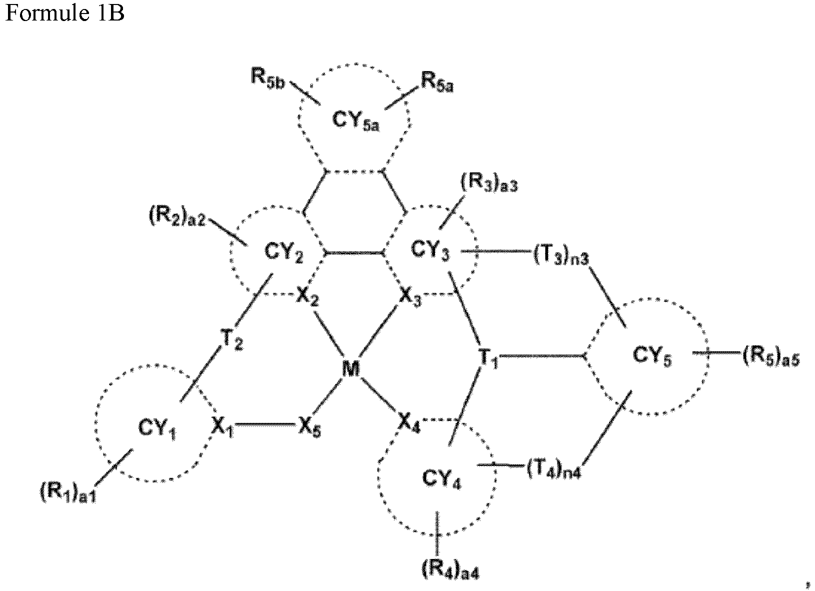
dans lequel, dans les Formules 1A-1 à 1A-3 et 1B,
M, X₁ à X₅, le cycle CY₁, le cycle CY₂, T₁ à T₄, n3, n4, R₁, R₂, a1 et a2 sont les mêmes que dans la revendication 1,
X₅₃ est N ou C(R₅₃), X₅₄ est N ou C(Rs₄), X₅₅ est N ou C(R₅₅), X₅₆ est N ou C(R₅₆) et X₅₇ est N ou C(R₅₇),
R₅₃ à R₅₇ sont identiques à R₅ dans la revendication 1,
Y₁₁, Y₁₂, Y₁₆ et Y₁₇ sont chacun indépendamment C ou N,
CY₅ₐ est identique à CY₅ dans la revendication 1, et
R₅ₐ et R_{5b} sont identiques à R₅ dans la revendication 1.

11. Composé organométallique selon l'une quelconque des revendications 1 à 10, ledit composé organométallique étant l'un des composés 1 à 160 :

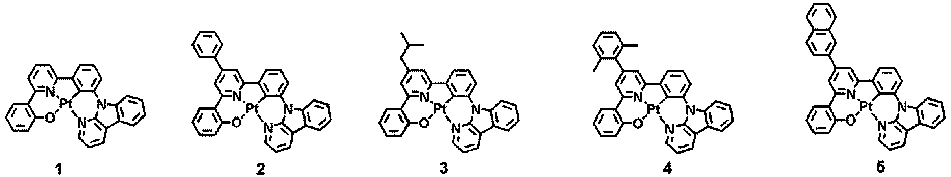

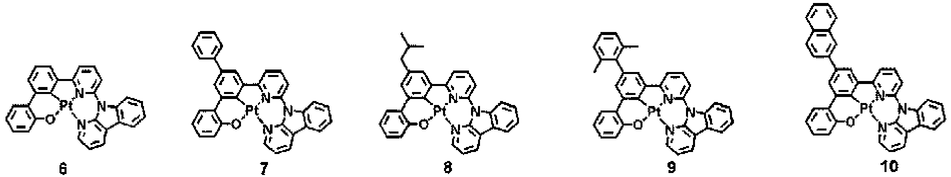

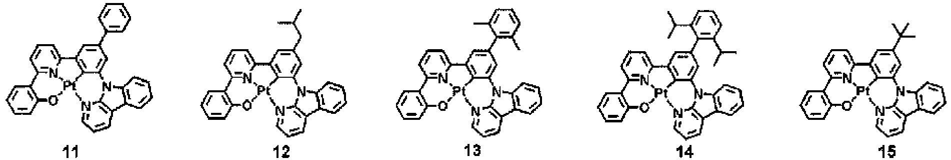

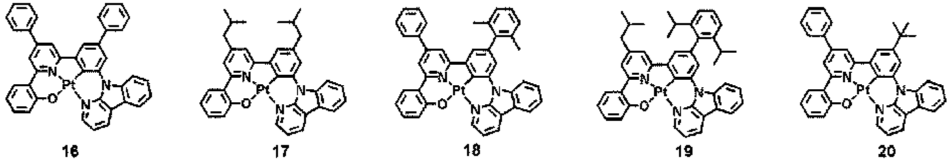

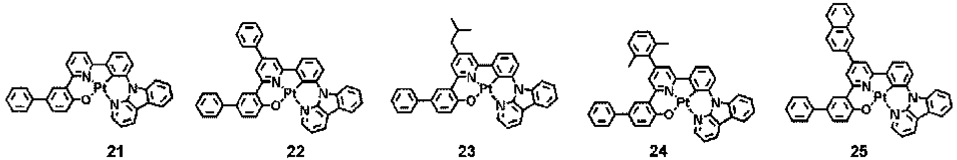

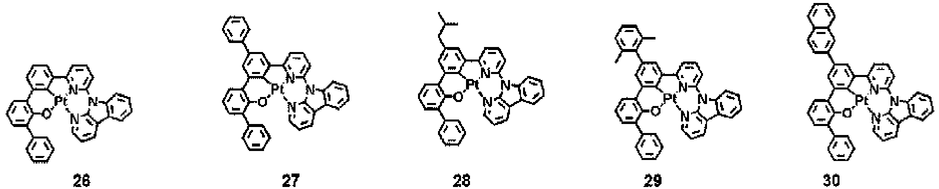

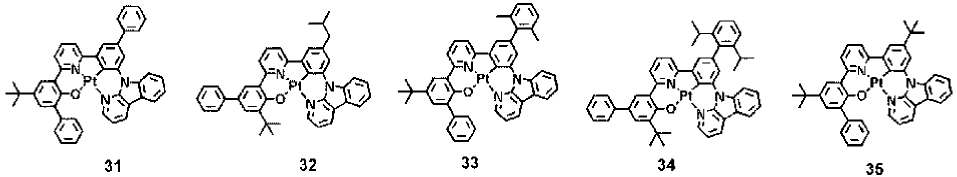

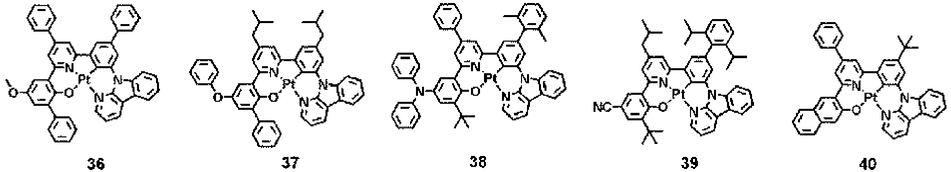

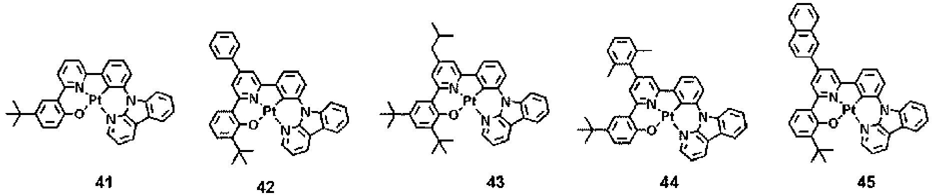

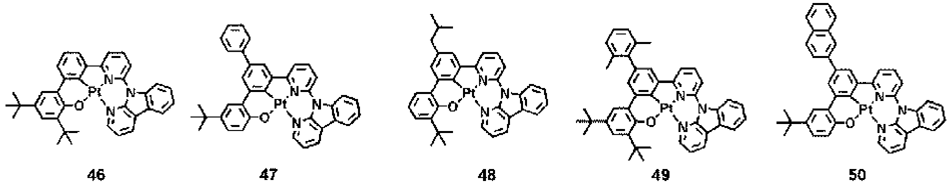

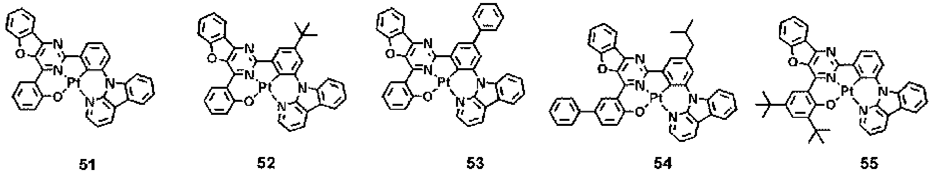

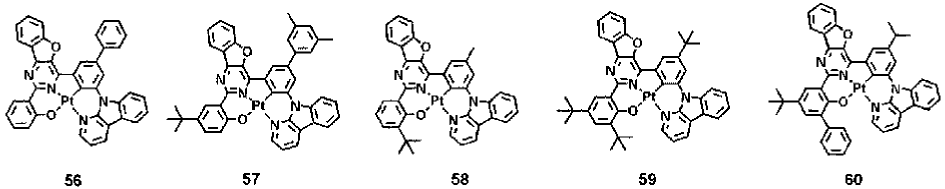

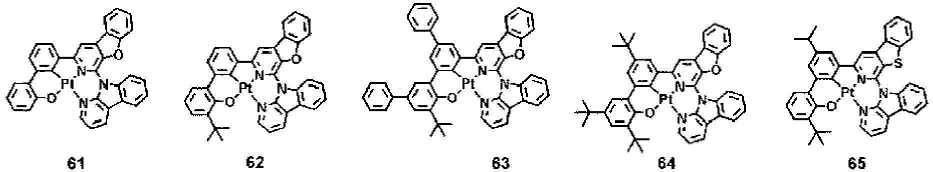

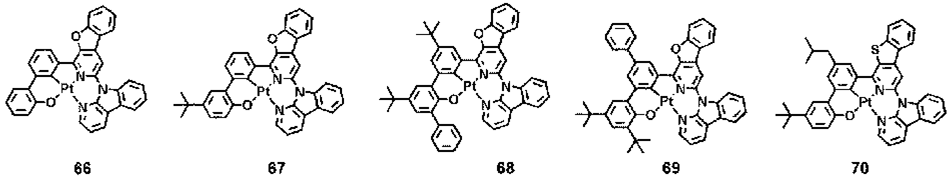

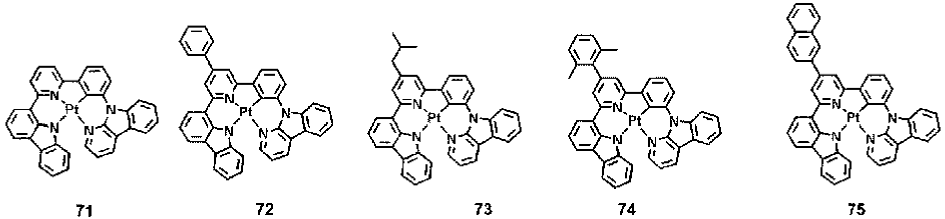

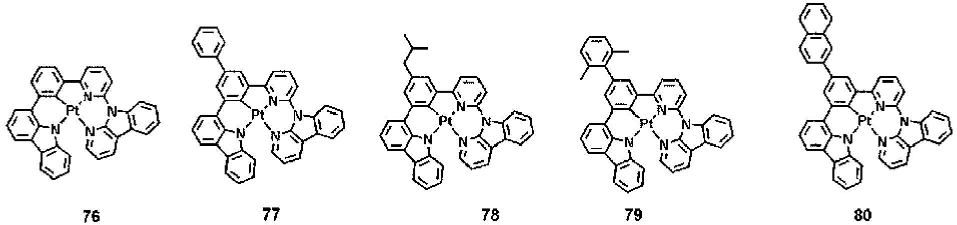

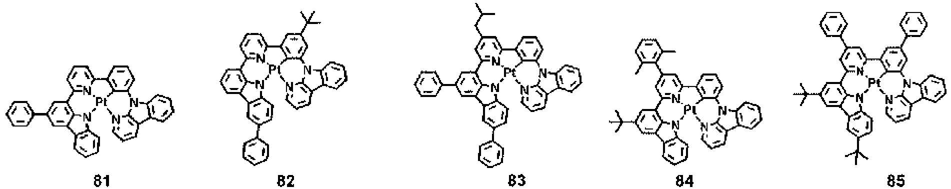

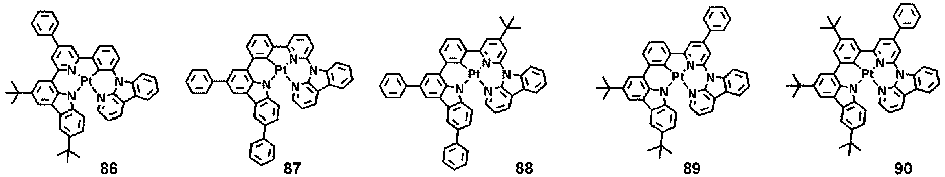

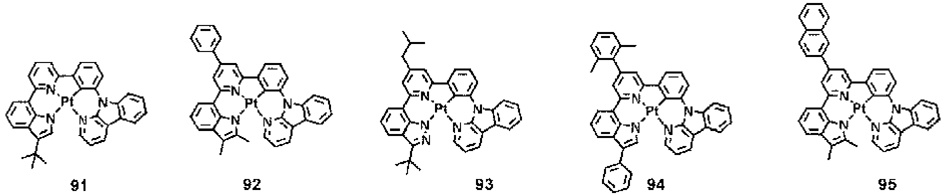

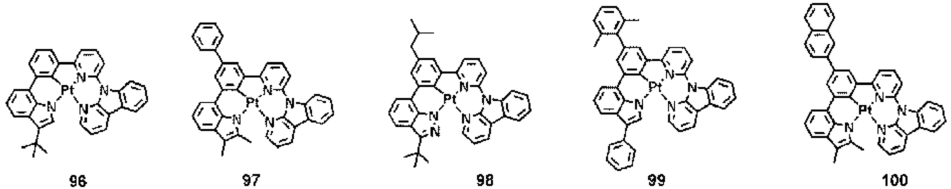

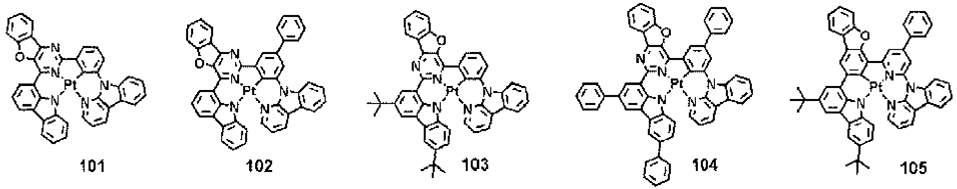

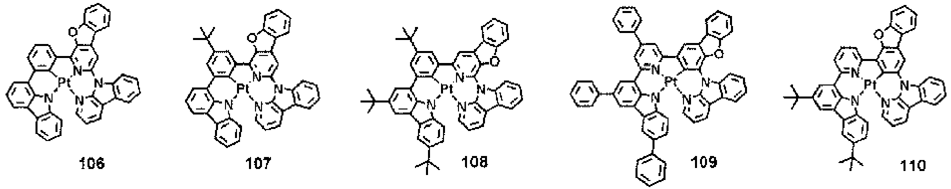

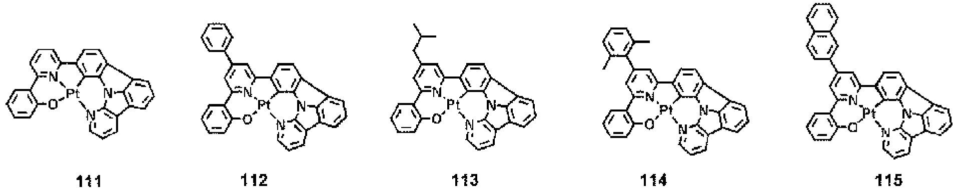

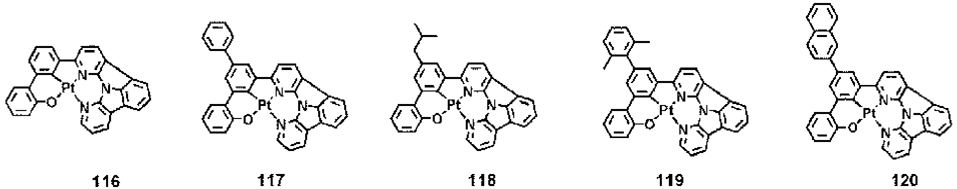

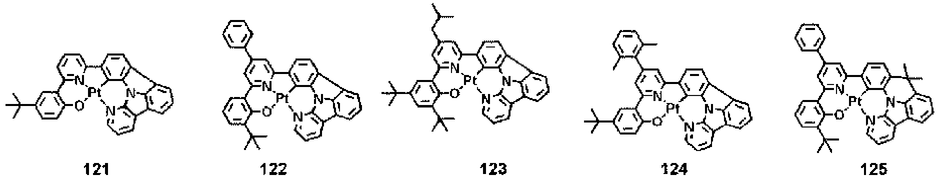

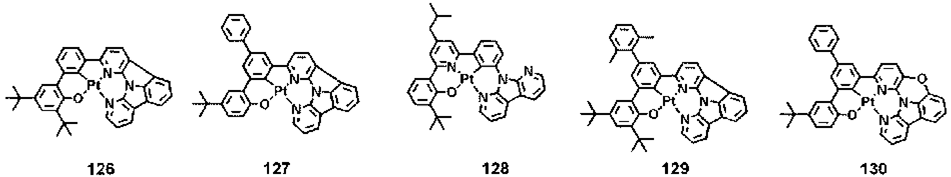

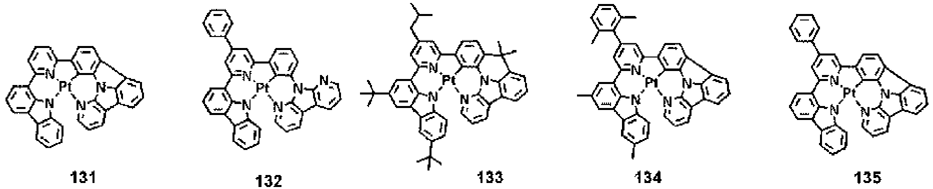

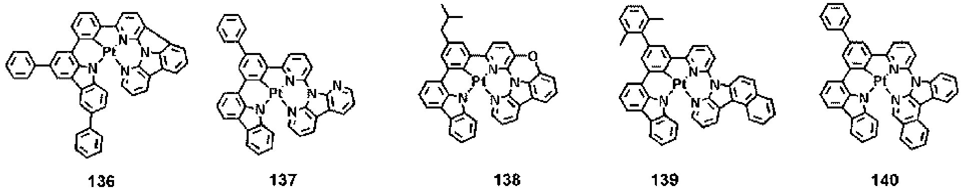

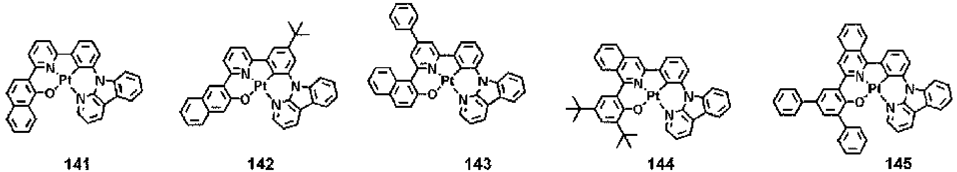

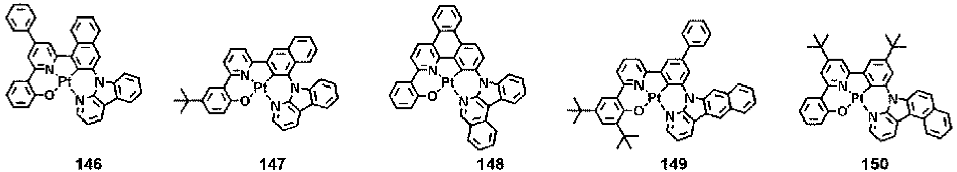

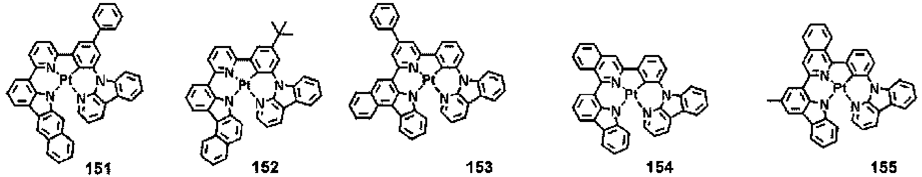

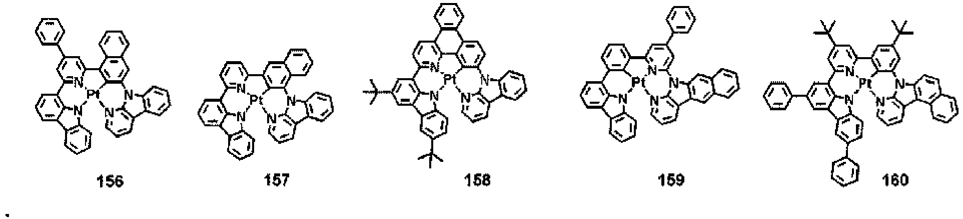

12. Dispositif électroluminescent organique comprenant :
une première électrode ;
une deuxième électrode ; et
une couche organique disposée entre la première électrode et la deuxième électrode, ladite couche organique comprenant une couche d'émission, et
ladite couche organique comprenant au moins un composé organométallique selon l'une quelconque des revendications 1 à 11.

13. Dispositif électroluminescent organique selon la revendication 12, dans lequel
la première électrode est une anode,
la deuxième électrode est une cathode, et
la couche organique comprend en outre une région de transport de trous disposée entre la première électrode et la couche d'émission et une région de transport d'électrons disposée entre la couche d'émission et la deuxième électrode,
ladite région de transport de trous comprenant une couche d'injection de trous, une couche de transport de trous, une couche de blocage d'électrons, ou une quelconque combinaison de ceux-ci, et
ladite région de transport comprenant une couche de blocage de trous, une couche de transport d'électrons, une couche d'injection d'électrons, ou une quelconque combinaison de ceux-ci.

14. Dispositif électroluminescent organique selon la revendication 12 ou 13, dans lequel la couche d'émission comprend le composé organométallique ;
de préférence, la couche d'émission comprenant en outre un hôte, et une quantité de l'hôte étant supérieure à une quantité du composé organométallique.

15. Composition de diagnostic comprenant au moins un composé organométallique selon l'une quelconque des revendications 1 à 11.
